# EUROPEAN PATENT SPECIFICATION

(11) **EP 3 185 330 B1**
(45) Date of publication and mention of the grant of the patent: **16.08.2023**
(21) Application number: 16191373.6
(22) Date of filing: 29.09.2016
(51) Int. Cl.: H10K 50/11, H10K 50/15, H10K 50/16, H10K 85/60

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 22.12.2015 KR 20150184072
(43) Date of publication of application: 28.06.2017
(73) Proprietor: Samsung Display Co., Ltd., Gyeonggi-Do (KR)
(72) Inventor: KIM, Younsun, Gyeonggi-do, (KR); KIM, Seulong, Gyeonggi-do, (KR); SHIN, Dongwoo, Gyeonggi-do, (KR); LEE, Jungsub, Gyeonggi-do, (KR); ITO, Naoyuki, Gyeonggi-do, (KR); LIM, Jino, Gyeonggi-do, (KR); JEONG, Hyein, Gyeonggi-do, (KR)
(74) Representative: Russell, Tim

(56) References cited:
- EP-A1- 3 185 325
- EP-A1- 3 185 328
- EP-A1- 3 185 329
- EP-A1- 3 185 331
- WO-A1-2015/093812
- WO-A1-2015/133804
- WO-A2-2015/082046

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and/or excellent brightness, driving voltage, and/or response speed characteristics, and may produce full-color images.

An organic light-emitting device may comprise a first electrode on a substrate, and a hole transport region, an emission layer, an electron transport region, and a second electrode sequentially positioned on the first electrode. Holes provided from the first electrode may move toward the emission layer through the hole transport region, and electrons provided from the second electrode may move toward the emission layer through the electron transport region. Carriers (such as holes and electrons) may recombine in the emission layer to produce excitons. These excitons may transition (e.g., radiatively decay) from an excited state to the ground state to thereby generate light.

WO 2015/082046 A2 describes a class of organic compounds, compositions and formulations containing them and their production and optoelectronic devices containing the compounds.

WO 2015/093812 A1 describes a compound capable of being used as an organic material layer material of an organic electroluminescence device, specifically a light emitting layer material, a life improving layer material, a light emitting auxiliary layer material, or an electron transporting layer material.

### SUMMARY OF THE INVENTION

The present invention provides an organic light-emitting device that has a low driving voltage and high efficiency.

Accordingly, the organic light-emitting device of the present invention comprises:
a first electrode;
a second electrode facing the first electrode;
an emission layer between the first electrode and the second electrode;
a hole transport region between the first electrode and the emission layer; and
an electron transport region between the emission layer and the second electrode;
wherein the electron transport region comprises a first compound,
at least one selected from the hole transport region and the electron transport region comprises a second compound,
the first compound is represented by one selected from Formulae 1A or 1B, and
the second compound is represented by Formula 2A or 2B:

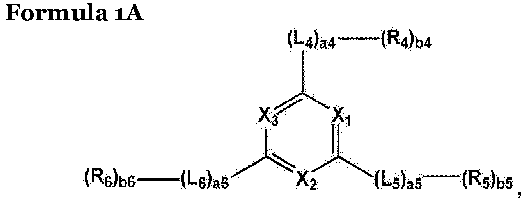

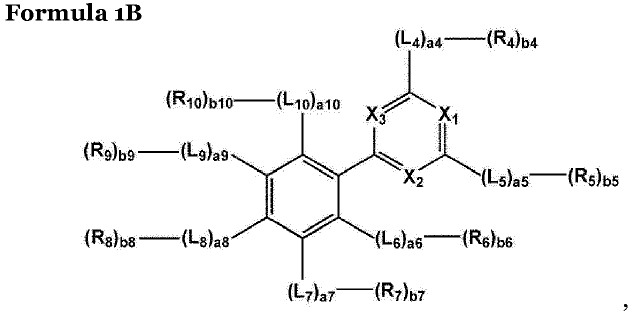

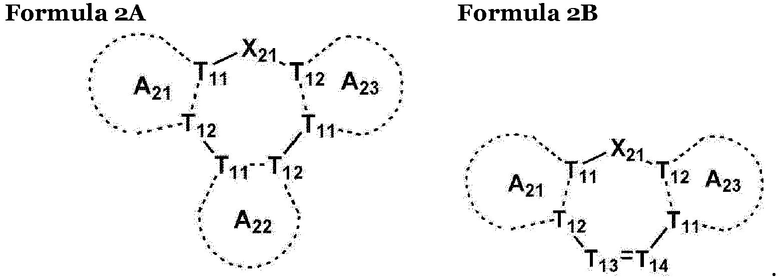

In Formulae 1A, 1B, 2A, and 2B,
rings A₂₁, A₂₂, and A₂₃ are each independently a C₅-C₆₀ carbocyclic group or a C₁-C₃₀ heterocyclic group, each substituted with at least one ^{∗}-[(L₂₂)ₐ₂₂-(R₂₂)_{b22}], in which * is a bonding site to the A₂₁, A₂₂, or A₂₃ ring,
each T₁₁ is independently carbon (C) or nitrogen (N),
each T₁₂ is independently carbon (C) or nitrogen (N),
T₁₃ is N or C(R₂₇),
T₁₄ is N or C(R₂₈),
each bond between T₁₁ and T₁₂ represented as a dashed line in formulae 2A and 2B may be a single bond or a double bond;
the six atoms represented by the three T₁₁(s) and three T₁₂(s) in Formula 2A are not all nitrogen, and the six atoms represented by the two T₁₁(s), two T₁₂(s), T₁₃, and T₁₄ in Formula 2B are not all nitrogen,
rings A₂₁, A₂₂, and A₂₃ are each be condensed (e.g., fused) with the central 7-membered ring in Formulae 2A and 2B, such that they each share a T₁₁ and a T₁₂ with the central *7*-membered ring,
X₁ is N or C-(L₁)ₐ₁-(R₁)_{b1}, X₂ is N or C-(L₂)ₐ₂-(R₂)_{b2}, X₃ is N or C-(L₃)ₐ₃-(R₃)_{b3}, and at least one selected from X₁ to X₃ is N,
X₂₁ is N-[(L₂₁)ₐ₂₁-(R₂₁)_{b21}],
or X₂₁ is O, S, Se, C(R₂₃)(R₂₄), or Si(R₂₃)(R₂₄) and at least one selected from rings A₂₁, A₂₂, and A₂₃ in Formula 2A and at least one selected from rings A₂₁ and A₂₃ in Formula 2B are each independently selected from groups represented by Formulae 2-1 to 2-3, 2-10 to 2-27, and 2-33 to 2-36, wherein in Formulae 2-1 to 2-3, 2-10 to 2-27, and 2-33 to 2-36 at least one of X₂₂ and X₂₃ is N-[(L₂₂)ₐ₂₂-(R₂₂)_{b22}], 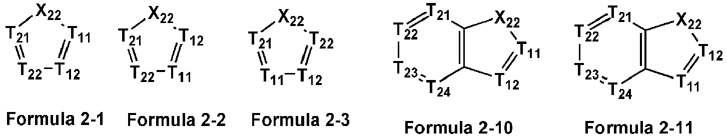 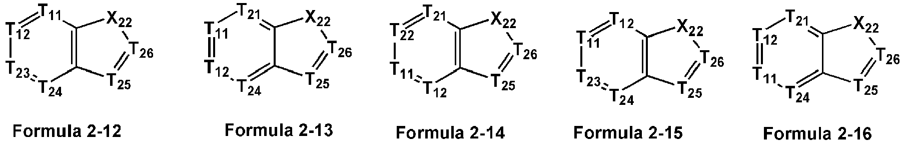 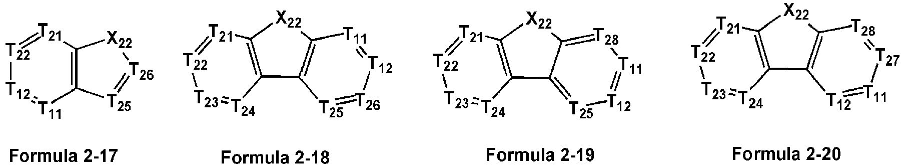 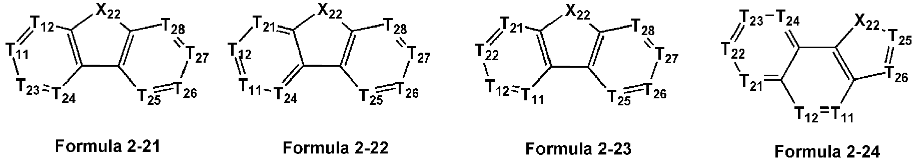 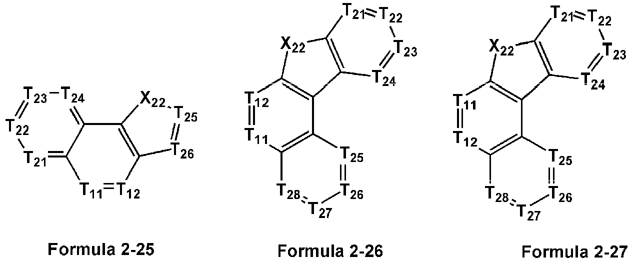 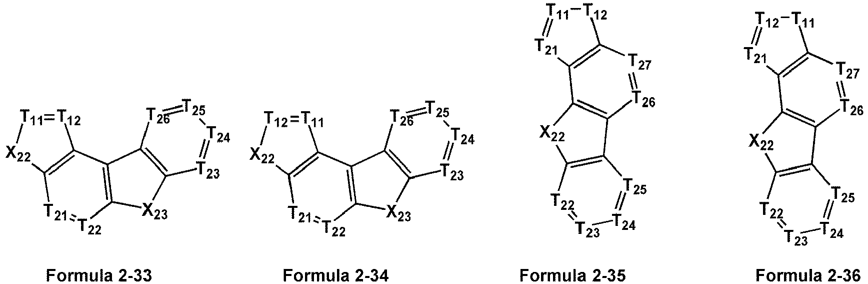
X₂₂ and X₂₃ are each independently O, S, Se, or a moiety comprising C, N, and/or Si, and
T₂₁ to T₂₈ are each independently N or a moiety comprising C,
L₁ to L₁₀, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8- C60 polycyclic group, and a substituted or unsubstituted divalent non-aromatic condensed 8- to 60-membered heteropolycyclic group,
a₁ to a10, a21, and a22 are each independently an integer selected from 0 to 5,
R₂, R₃ and R₆ to R₁₀, R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
b1 to b10, b21, and b22 are each independently an integer selected from 1 to 4, provided that each of b1 to b10, b21, and b22 is 1 when each respective a1 to a10, a21, or a22 is zero,
R₁ and R₄ are each independently as defined for R₂, or when a1 and a4 are both 0, may may optionally be connected (e.g., coupled) to form a C₅-C₆₀ carbocyclic group or a C₁-C₃₀ heterocyclic group, and R₅ is as defined for R₂, or when a1 and a5 are both 0 and when R₁ and R₄ are not linked to form a cyclic group, R₅ may may be optionally connected (e.g., coupled) to R₁ to form a C₅-C₆₀ carbocyclic group or a C₁-C₃₀ heterocyclic group, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8- C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8- C60 polycyclic group, and the substituted monovalent non-aromatic condensed 8- to 60-membered heteropolycyclic group is each independently substituted with one or more substituents selected from the group consisting of:
   deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8- to 60-membered heteropolycyclic group, -Sᵢ(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8-to 60-membered heteropolycyclic group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), and -P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
   wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8- C60 polycyclic group, and a monovalent non-aromatic condensed 8- to 60-membered heteropolycyclic group.

### BRIEF DESCRIPTION OF THE DRAWINGS

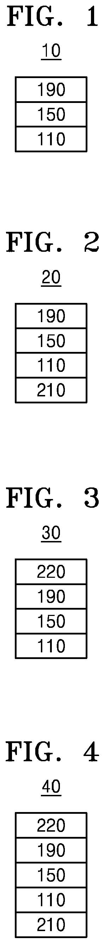

FIGS. 1 to 6 are schematic views of organic light-emitting devices according to one or more embodiments of the present disclosure.

### DETAILED DESCRIPTION OF THE INVENTION

Expressions such as "at least one selected from", "one of', and "selected from", when preceding a list of elements, modify the entire list of elements and do not modify the individual elements of the list.

The thicknesses of layers, films, panels, regions, etc., may be exaggerated in the drawings for clarity. It will be understood that when an element such as a layer, film, region, or substrate is referred to as being "on" another element, it can be directly on the other element or intervening element(s) may also be present. In contrast, when an element is referred to as being "directly on" another element, no intervening elements are present.

The organic light-emitting device of the present disclosure comprises a first electrode, a second electrode facing the first electrode, an emission layer between the first electrode and the second electrode, a hole transport region between the first electrode and the emission layer, and an electron transport region between the emission layer and the second electrode, wherein the electron transport region comprises a first compound, and at least one selected from the hole transport region and the electron transport region comprises a second compound.

The first compound is represented by one selected from Formulae 1A or 1B, and the second compound is represented by Formula 2A or 2B:

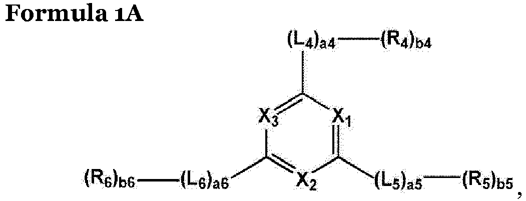

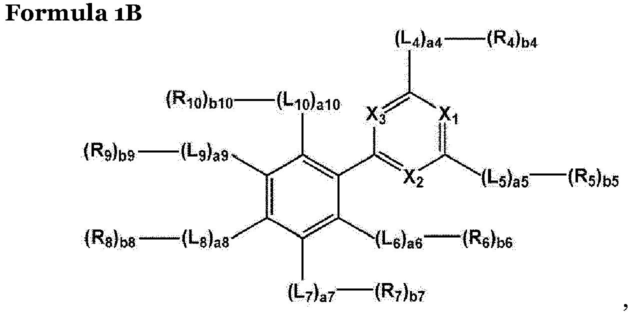

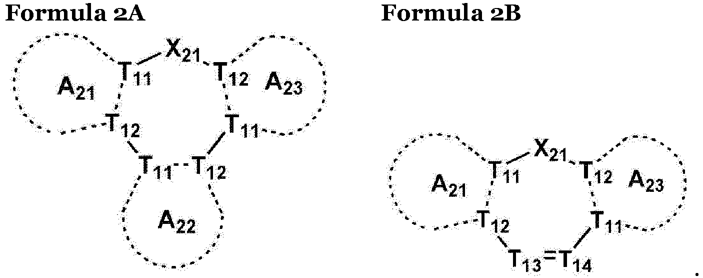

Rings A₂₁, A₂₂, and A₂₃ in Formulae 2A and 2B are each independently a C₅-C₆₀ carbocyclic group or a C₁-C₃₀ heterocyclic group, each substituted with at least one *-[(L₂₂)ₐ₂₂-(R₂₂)_{b22}]. L₂₂, a22, R₂₂, and b22 are described below.

Each T₁₁ and each T₁₂ in Formulae 2A and 2B is independently carbon or nitrogen. Any one of the three T11s in formula 2A may be different from each of the other two T11s, identical to each of the other two T11s, or identical to one of the other two T11s and different from one of the other two T11s. Any one of the three T12s in formula 2A may be different from each of the other two T12s, identical to each of the other two T12s, or identical to one of the other two T12s and different from one of the other two T12s. Any one of the two T11s in Formula 2B may be different from the other T11 or identical to the other T11. Any one of the two T12s in Formula 2B may be different from the other T12 or identical to the other T12. T₁₃ is N or C(R₂₇), and T₁₄ is N or C(R₂₈). Each bond between T₁₁ and T₁₂ represented as a dashed line in formulae 2A and 2B is a single bond or a double bond. The six atoms represented by the three T₁₁(s) and three T₁₂(s) in Formula 2A are not all nitrogen, and the six atoms represented by the two T₁₁(s), two T₁₂(s), T₁₃, and T₁₄ in Formula 2B are all not nitrogen. Rings A₂₁, A₂₂, and A₂₃ are each condensed (e.g., fused) with the central *7*-membered ring in Formulae 2A and 2B (i.e. the *7*-membered ring formed by the three T11s, three T12s and X21 in formula 2A; and the *7*-membered ring formed by the two T11s, two T12s, T₁₃, T14 and X21 in formula 2B), such that rings A₂₁, A₂₂, and A₂₃ each share a T₁₁ and a T₁₂ with the central *7*-membered ring.

Each ^{∗}-[(L₂₂)ₐ₂₂-(R₂₂)_{b22}] substituted in ring A₂₁, ^{∗}-[(L₂₂)ₐ₂₂-(R₂₂)_{b22}] substituted in ring A₂₂, and ^{∗}-[(L₂₂)ₐ₂₂-(R₂₂)_{b22}] substituted in ring A₂₃ may be identical to or different from one another.

In some embodiments, when the number of ^{∗}-[(L₂₂)ₐ₂₂-(R₂₂)_{b22}](s) substituted in A₂₁ is two or more, two or more ^{∗}-[(L₂₂)ₐ₂₂-(R₂₂)_{b22}](s) may be identical to or different from each other; when the number of ^{∗}-[(L₂₂)ₐ₂₂-(R₂₂)_{b22}](s) substituted in A₂₂ is two or more, two or more ^{∗}-[(L₂₂)ₐ₂₂-(R₂₂)_{b22}](s) may be identical to or different from each other; and when the number of ^{∗}-[(L₂₂)ₐ₂₂-(R₂₂)_{b22}](s) substituted in A₂₃ is two or more, two or more ^{∗}-[(L₂₂)ₐ₂₂-(R₂₂)_{b22}](s) may be identical to or different from each other.

In one or more embodiments, rings A₂₁, A₂₂, and A₂₃ in Formulae 2A and 2B may each independently be selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenophene group, a naphthofuran group, a naphthothienophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and an naphthoindole group, each substituted with at least one *-[(L₂₂)ₐ₂₂-(R₂₂)_{b22}].

In one or more embodiments, rings A₂₁, A₂₂, and A₂₃ in Formulae 2A and 2B may each independently be selected from groups represented by Formulae 2-1 to 2-36, each substituted with at least one ^{∗}-[(L₂₂)ₐ₂₂-(R₂₂)_{b22}]:

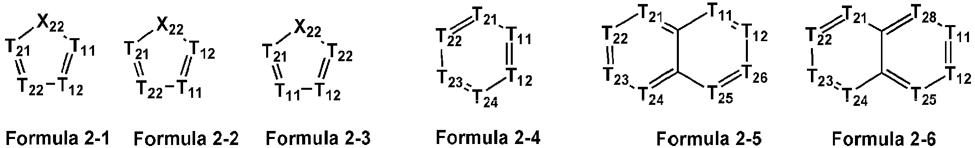

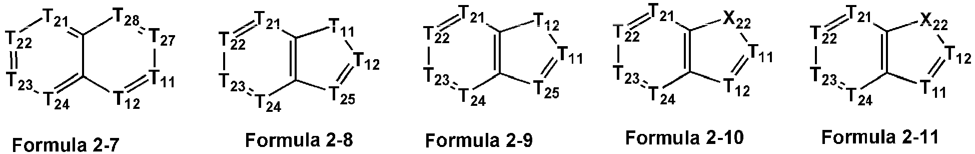

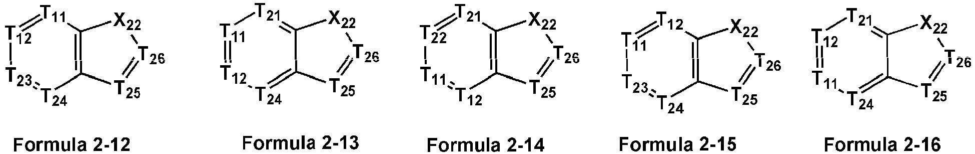

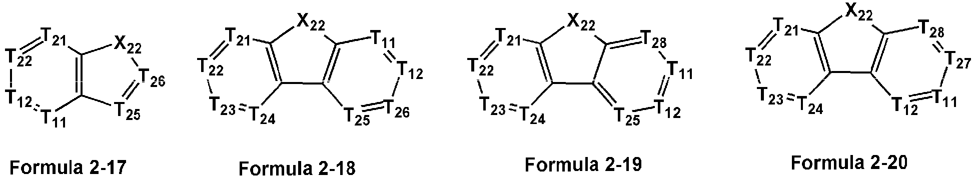

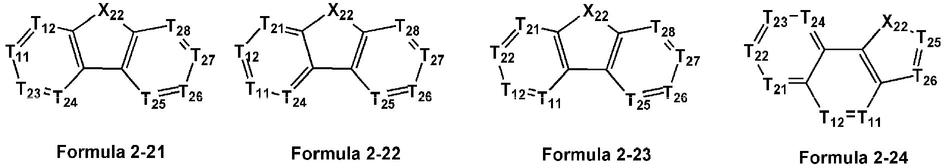

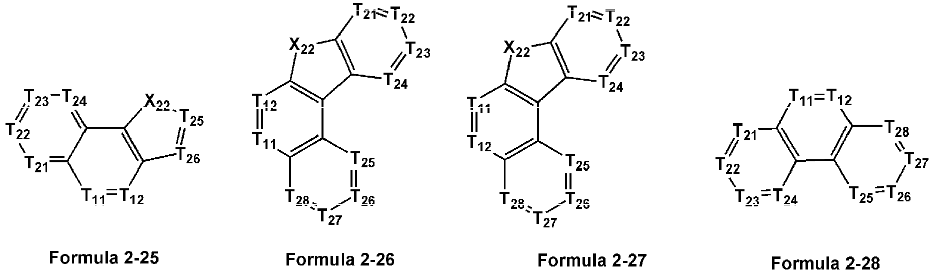

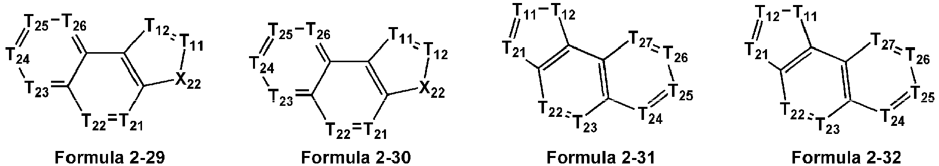

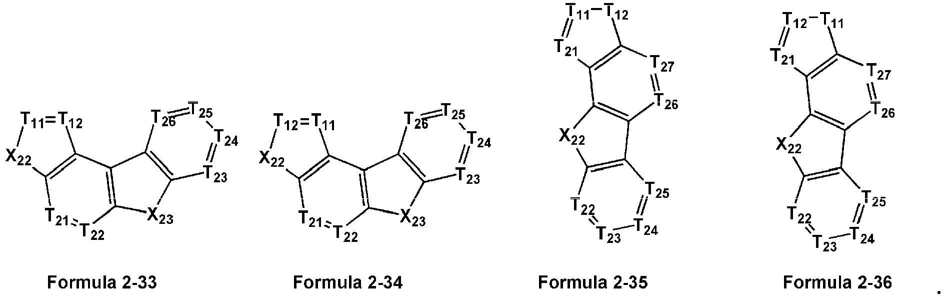

In Formulae 2-1 to 2-36,
T₁₁ and T₁₂ may each independently be the same as described herein,
X₂₂ and X₂₃ may each independently be oxygen (O), sulfur (S), selenium (Se), or a moiety comprising C, N, and/or silicon (Si), and
T₂₁ to T₂₈ may each independently be N or a moiety comprising C.

For example, in Formulae 2-1 to 2-36, X₂₂ and X₂₃ may each independently be selected from O, S, Se, C(R₂₅)(R₂₆), N-[(L₂₂)ₐ₂₂-(R₂₂)_{b22}], and Si(R₂₅)(R₂₆), and T₂₁ to T₂₈ may each independently be N or C-[(L₂₂)ₐ₂₂-(R₂₂)_{b22}]. R₂₅, R₂₆, and R₃₀ may each independently be selected from groups represented by ^{∗}-[(L₂₂)ₐ₂₂-(R₂₂)_{b22})] as described herein.

In one or more embodiments, rings A₂₁, A₂₂, and A₂₃ in Formulae 2A and 2B may each independently be selected from groups represented by Formulae 2-101 to 2-229:

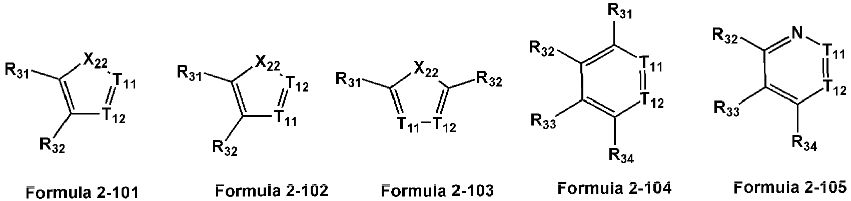

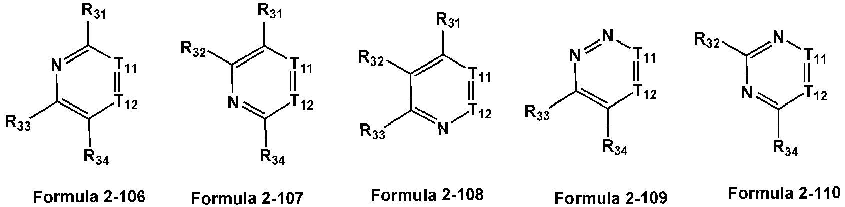

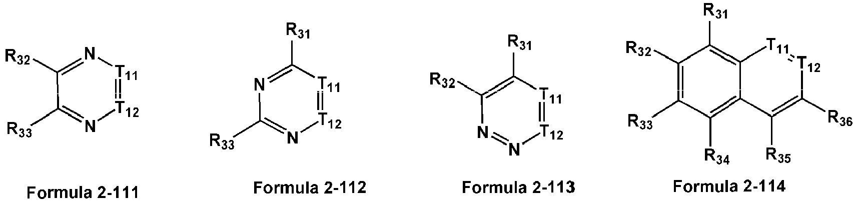

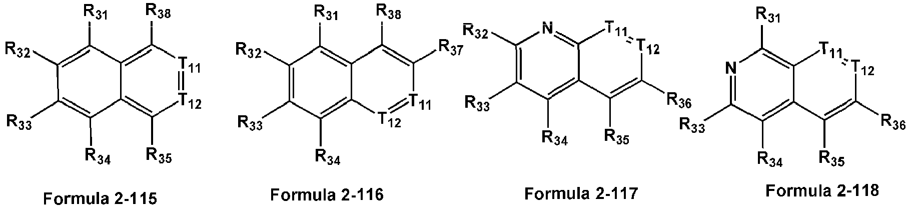

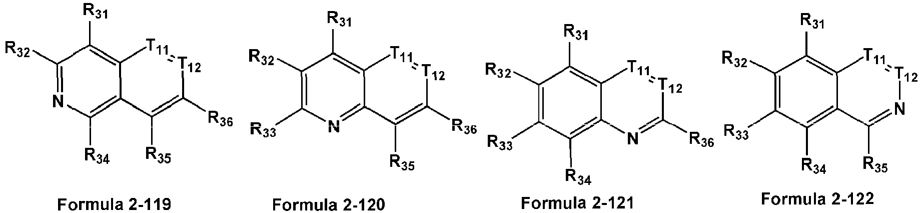

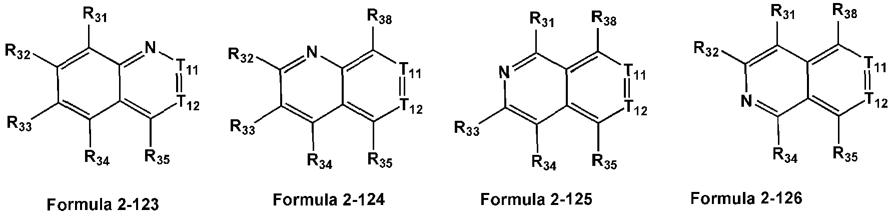

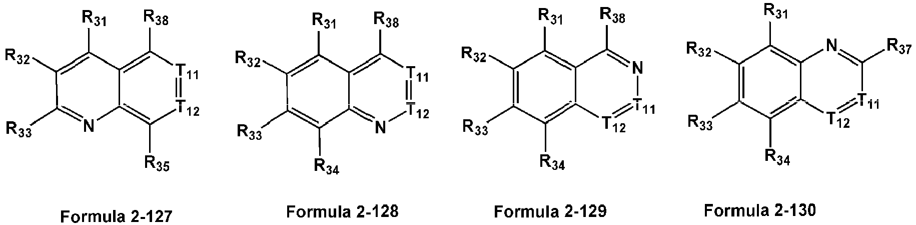

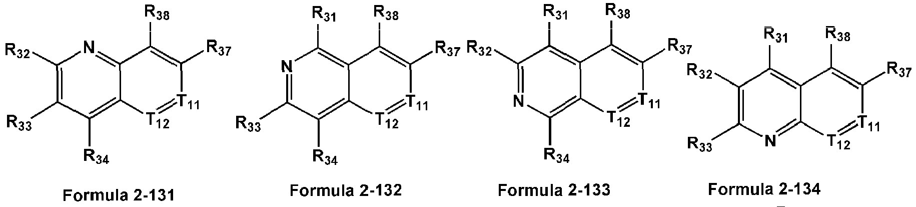

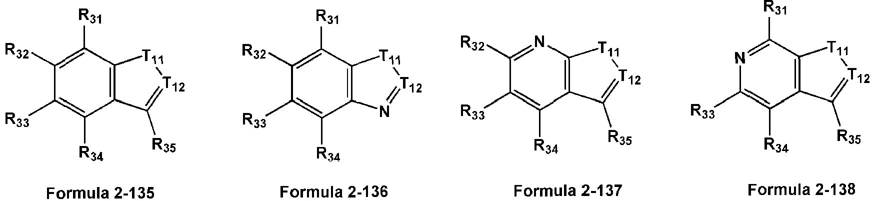

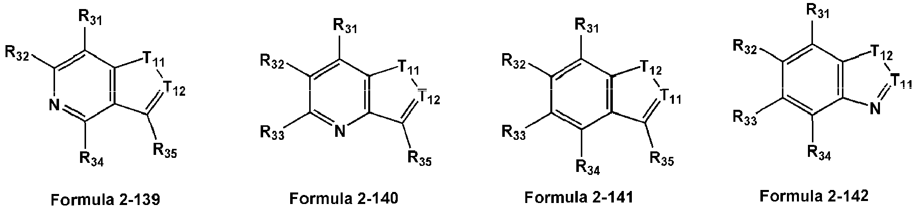

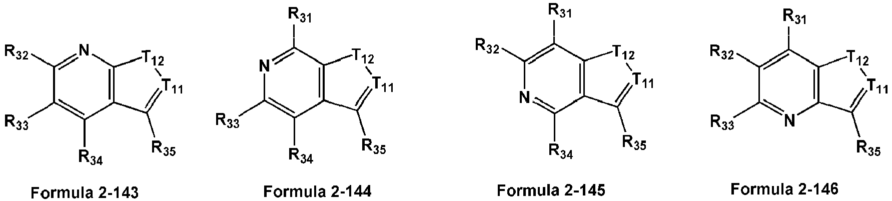

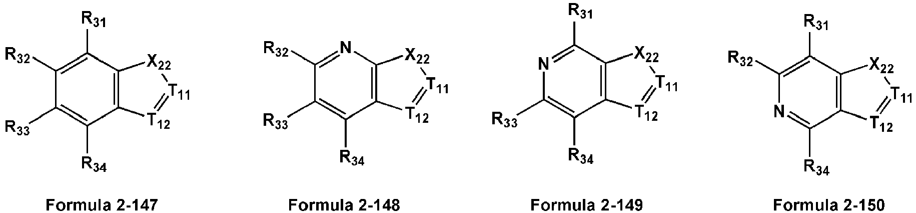

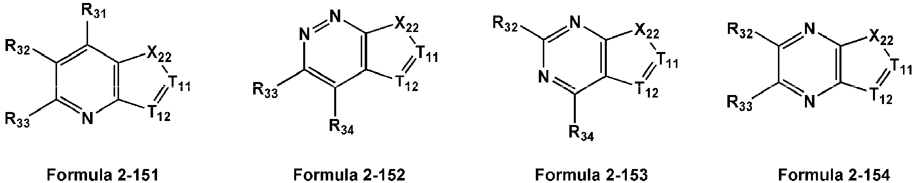

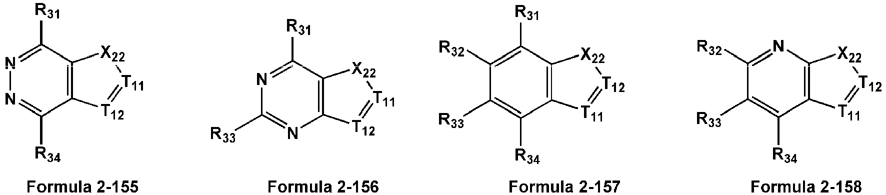

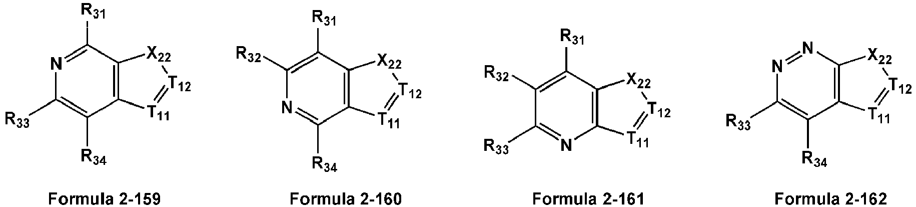

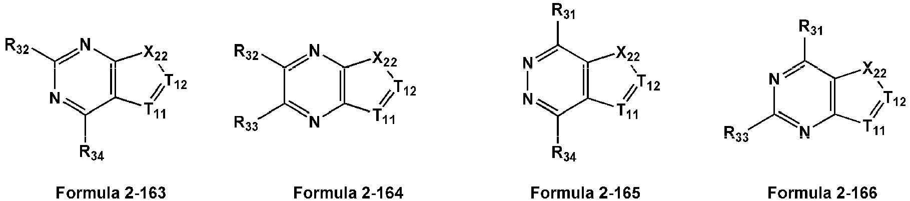

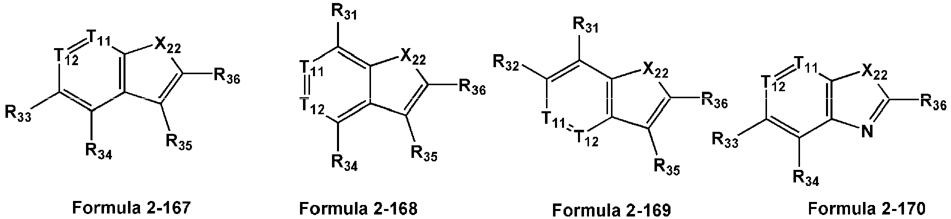

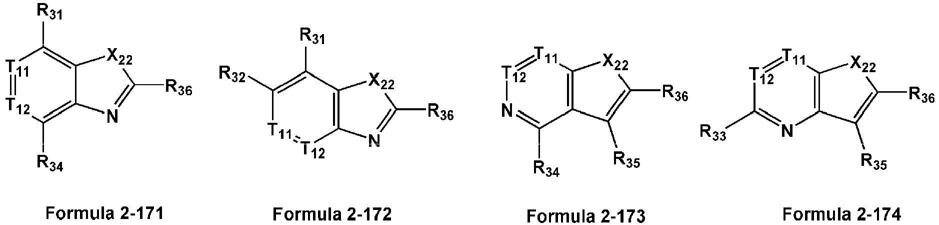

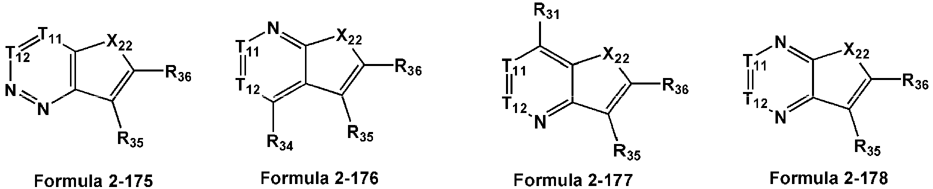

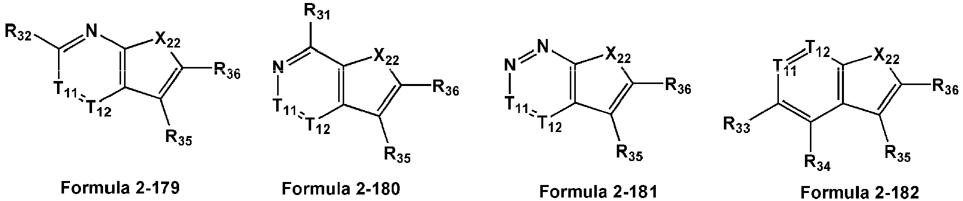

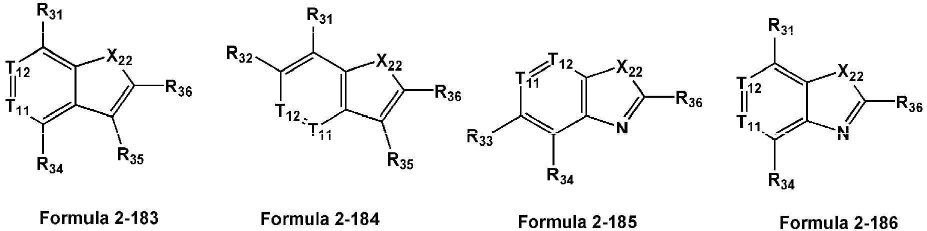

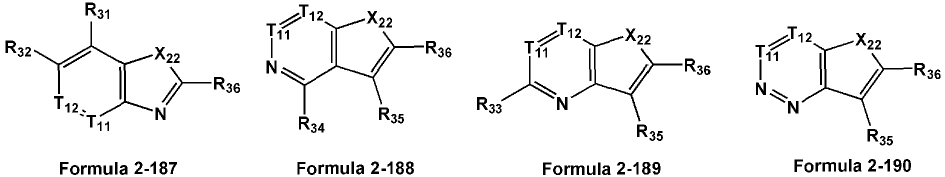

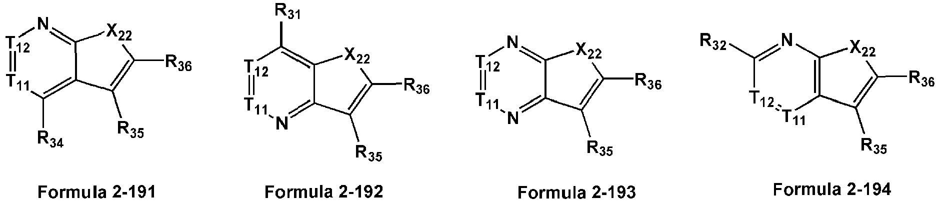

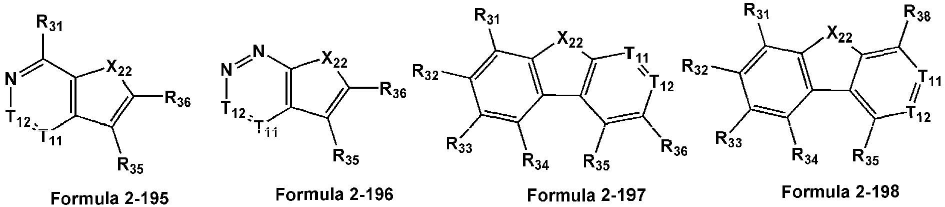

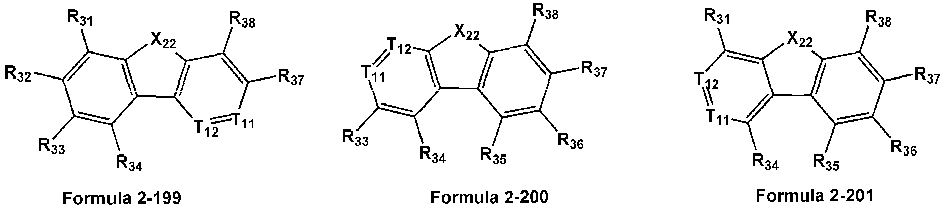

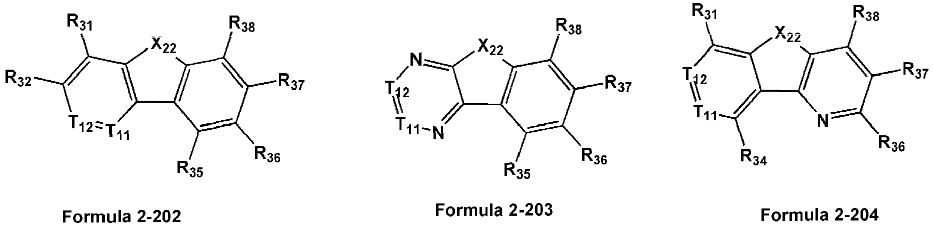

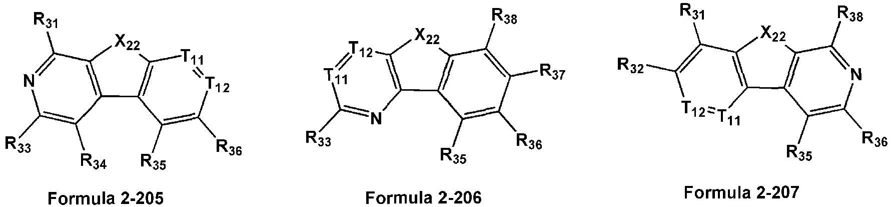

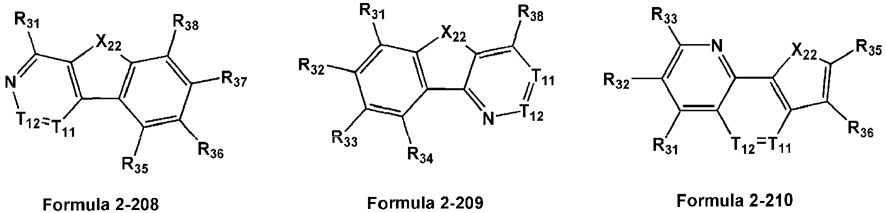

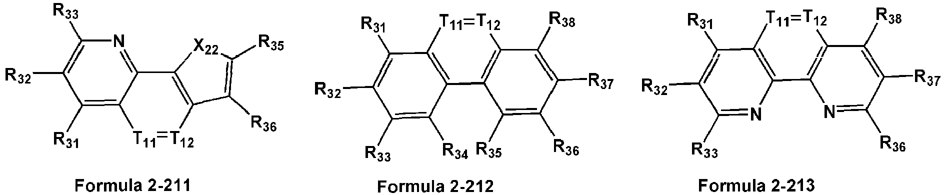

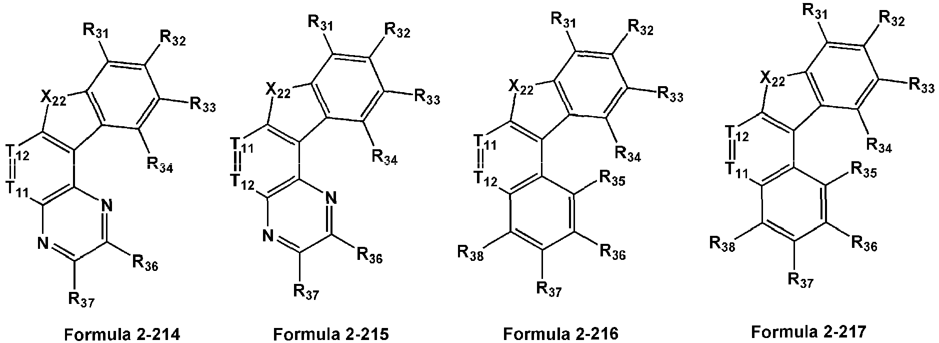

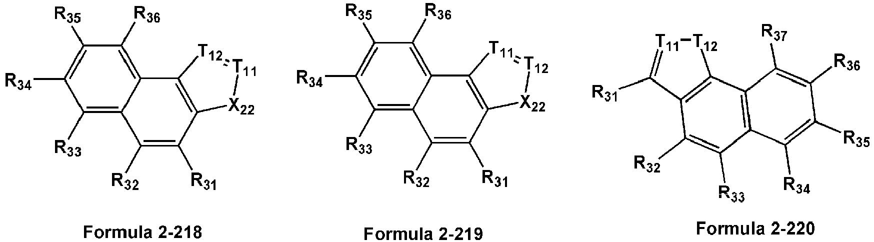

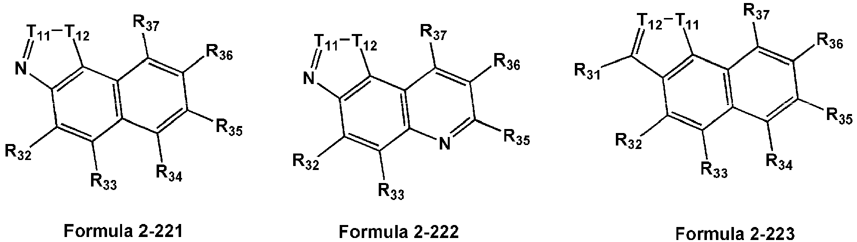

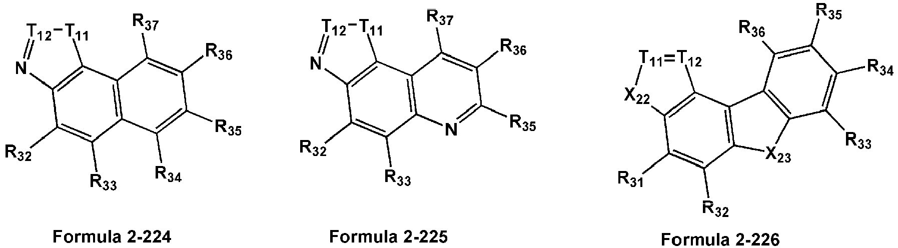

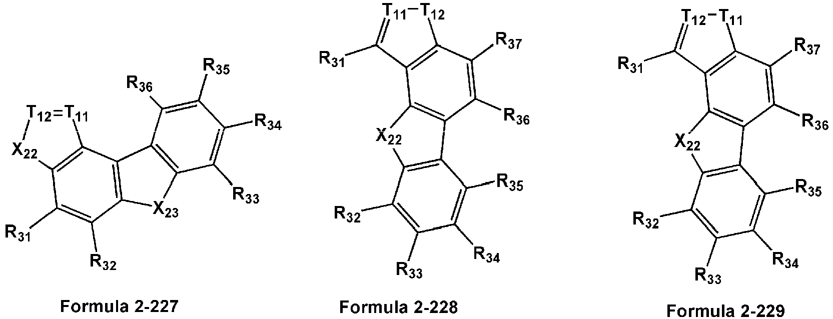

In Formulae 2-101 to 2-229,
T₁₁ and T₁₂ may each independently be the same as described herein,
X₂₂ and X₂₃ may each independently be O, S, Se, or a moiety comprising C, N, and/or Si, and
R₃₁ to R₃₈ may each independently be selected from substituents represented by ^{∗}-[(L₂₂)ₐ₂₂-(R₂₂)_{b22}] as described herein.

In some embodiments, when the number of ^{∗}-[(L₂₂)ₐ₂₂-(R₂₂)_{b22}](s) in R₃₁ to R38 is 2 or more, no more than 2 ^{∗}-[(L22)a22-(R22)b22](s) is a cyclic group or contains a cyclic group. In some embodiments, when the number of ^{∗}-[(L₂₂)ₐ₂₂-(R₂₂)_{b22}](s) in R31 to R38 is 2 or more, no more than 1 ^{∗}-[(L₂₂)ₐ₂₂-(R₂₂)_{b22}] is a cyclic group or contains a cyclic group. In some embodiments, when the number of *-[(L22)a22-(R22)b22](s) in R31 to R38 is 2 or more, no more than 2 ^{∗}-[(L₂₂)ₐ₂₂-(R₂₂)_{b22}](s) is other than hydrogen. In some embodiments, when the number of ^{∗}-[(L22)a22-(R22)b22](s) in R31 to R38 is 2 or more, no more than 1 ^{∗}-[(L22)a22-(R22)b22] is other than hydrogen.

In the following, "embodiments of the present disclosure" has to be understood as being within the scope of the appended claims.

In one or more embodiments, the second compound may be represented by one selected from Formulae 2-201A to 2-269A (denoting a structure based on Formula 2A), and rings A₂₁, A₂₂, and A₂₃ in Formulae 2-201A to 2-269A may each independently be selected from the Formulae shown in Table 1.

**Table 1**

| Formula No. | Formula No. of ring A₂₁ | Formula No. of ring A₂₂ | Formula No. of ring A₂₃ |
|---|---|---|---|
| 2-201A | 2-2 | 2-4 | 2-4 |
| 2-202A | 2-4 | 2-4 | 2-1 |
| 2-203A | 2-4 | 2-4 | 2-2 |
| 2-204A | 2-4 | 2-4 | 2-3 |
| 2-205A | 2-4 | 2-1 | 2-4 |
| 2-206A | 2-4 | 2-2 | 2-4 |
| 2-207A | 2-4 | 2-4 | 2-10 |
| 2-208A | 2-11 | 2-4 | 2-4 |
| 2-209A | 2-4 | 2-4 | 2-11 |
| 2-210A | 2-4 | 2-10 | 2-4 |
| 2-211A | 2-4 | 2-4 | 2-8 |
| 2-212A | 2-4 | 2-9 | 2-4 |
| 2-213A | 2-4 | 2-4 | 2-14 |
| 2-214A | 2-17 | 2-4 | 2-4 |
| 2-215A | 2-4 | 2-4 | 2-15 |
| 2-216A | 2-13 | 2-4 | 2-4 |
| 2-217A | 2-4 | 2-4 | 2-16 |
| 2-218A | 2-4 | 2-4 | 2-13 |
| 2-219A | 2-16 | 2-4 | 2-4 |
| 2-220A | 2-4 | 2-4 | 2-12 |
| 2-221A | 2-4 | 2-4 | 2-17 |
| 2-222A | 2-4 | 2-16 | 2-4 |
| 2-223A | 2-4 | 2-15 | 2-4 |
| 2-224A | 2-4 | 2-14 | 2-4 |
| 2-225A | 2-4 | 2-17 | 2-4 |
| 2-226A | 2-19 | 2-4 | 2-4 |
| 2-227A | 2-22 | 2-4 | 2-4 |
| 2-228A | 2-18 | 2-4 | 2-4 |
| 2-229A | 2-23 | 2-4 | 2-4 |
| 2-230A | 2-21 | 2-4 | 2-4 |
| 2-231A | 2-20 | 2-4 | 2-4 |
| 2-232A | 2-4 | 2-23 | 2-4 |
| 2-233A | 2-4 | 2-18 | 2-4 |
| 2-234A | 2-4 | 2-21 | 2-4 |
| 2-235A | 2-4 | 2-19 | 2-4 |
| 2-236A | 2-5 | 2-2 | 2-4 |
| 2-237A | 2-5 | 2-1 | 2-4 |
| 2-238A | 2-2 | 2-2 | 2-4 |
| 2-239A | 2-4 | 2-23 | 2-1 |
| 2-240A | 2-6 | 2-10 | 2-4 |
| 2-241A | 2-4 | 2-4 | 2-29 |
| 2-242A | 2-7 | 2-4 | 2-10 |
| 2-243A | 2-11 | 2-4 | 2-10 |
| 2-244A | 2-4 | 2-10 | 2-6 |
| 2-245A | 2-11 | 2-11 | 2-4 |
| 2-246A | 2-11 | 2-11 | 2-5 |
| 2-247A | 2-11 | 2-11 | 2-10 |
| 2-248A | 2-7 | 2-9 | 2-4 |
| 2-249A | 2-4 | 2-4 | 2-25 |
| 2-250A | 2-11 | 2-15 | 2-4 |
| 2-251A | 2-18 | 2-28 | 2-4 |
| 2-252A | 2-23 | 2-10 | 2-4 |
| 2-253A | 2-4 | 2-27 | 2-4 |
| 2-254A | 2-6 | 2-18 | 2-4 |
| 2-255A | 2-4 | 2-23 | 2-5 |
| 2-256A | 2-23 | 2-4 | 2-14 |
| 2-257A | 2-17 | 2-4 | 2-14 |
| 2-258A | 2-14 | 2-4 | 2-12 |
| 2-259A | 2-17 | 2-4 | 2-12 |
| 2-260A | 2-14 | 2-16 | 2-2 |
| 2-261A | 2-17 | 2-5 | 2-14 |
| 2-262A | 2-17 | 2-13 | 2-17 |
| 2-263A | 2-17 | 2-14 | 2-12 |
| 2-264A | 2-17 | 2-12 | 2-12 |
| 2-265A | 2-5 | 2-1 | 2-18 |
| 2-266A | 2-4 | 2-29 | 2-4 |
| 2-267A | 2-4 | 2-31 | 2-4 |
| 2-268A | 2-4 | 2-33 | 2-4 |
| 2-269A | 2-4 | 2-35 | 2-4 |

In one or more embodiments, the second compound may be represented by one selected from Formulae 2-201B to 2-215B (denoting a structure based on Formula 2B), and rings A₂₁ and A₂₃ in Formulae 2-201B to 2-215B may each independently be selected from the Formulae shown in Table 2.

**Table 2**

| Formula No. | Formula No. or ring A₂₁ | Formula No. or ring A₂₂ | Formula No. or ring A₂₃ |
|---|---|---|---|
| 2-201B | 2-4 | - | 2-19 |
| 2-202B | 2-4 | - | 2-22 |
| 2-203B | 2-4 | - | 2-18 |
| 2-204B | 2-4 | - | 2-23 |
| 2-205B | 2-4 | - | 2-21 |
| 2-206B | 2-4 | - | 2-20 |
| 2-207B | 2-5 | - | 2-23 |
| 2-208B | 2-7 | - | 2-23 |
| 2-209B | 2-4 | - | 2-26 |
| 2-210B | 2-7 | - | 2-22 |
| 2-211B | 2-13 | - | 2-16 |
| 2-212B | 2-5 | - | 2-19 |
| 2-213B | 2-7 | - | 2-20 |
| 2-214B | 2-19 | - | 2-18 |
| 2-215B | 2-18 | - | 2-18 |

In one or more embodiments, the second compound may be represented by one selected from Formulae 2-301A to 2-419A and 2-421A to 2-432A (denoting a structure based on Formula 2A), and rings A₂₁, A₂₂, and A₂₃ in Formulae 2-301A to 2-419A and 2-421A to 2-432A may each independently be selected from the Formulae shown in Table 3.

**Table 3**

| Formula No. | Formula No. or ring A₂₁ | Formula No. or ring A₂₂ | Formula No. or ring A₂₃ |
|---|---|---|---|
| 2-301A | 2-104 | 2-147 | 2-104 |
| 2-302A | 2-102 | 2-104 | 2-104 |
| 2-303A | 2-104 | 2-104 | 2-101 |
| 2-304A | 2-104 | 2-104 | 2-102 |
| 2-305A | 2-104 | 2-104 | 2-103 |
| 2-306A | 2-104 | 2-101 | 2-104 |
| 2-307A | 2-104 | 2-102 | 2-104 |
| 2-308A | 2-104 | 2-104 | 2-147 |
| 2-309A | 2-157 | 2-104 | 2-104 |
| 2-310A | 2-104 | 2-104 | 2-157 |
| 2-311A | 2-104 | 2-147 | 2-107 |
| 2-312A | 2-104 | 2-149 | 2-104 |
| 2-313A | 2-104 | 2-156 | 2-104 |
| 2-314A | 2-107 | 2-147 | 2-106 |
| 2-315A | 2-104 | 2-151 | 2-104 |
| 2-316A | 2-104 | 2-147 | 2-106 |
| 2-317A | 2-104 | 2-148 | 2-104 |
| 2-318A | 2-104 | 2-150 | 2-104 |
| 2-319A | 2-106 | 2-147 | 2-104 |
| 2-320A | 2-104 | 2-106 | 2-147 |
| 2-321A | 2-157 | 2-107 | 2-104 |
| 2-322A | 2-106 | 2-104 | 2-147 |
| 2-323A | 2-104 | 2-107 | 2-147 |
| 2-324A | 2-107 | 2-104 | 2-147 |
| 2-325A | 2-104 | 2-104 | 2-160 |
| 2-326A | 2-104 | 2-111 | 2-157 |
| 2-327A | 2-108 | 2-104 | 2-158 |
| 2-328A | 2-111 | 2-104 | 2-157 |
| 2-329A | 2-107 | 2-147 | 2-104 |
| 2-330A | 2-104 | 2-104 | 2-135 |
| 2-331A | 2-104 | 2-141 | 2-104 |
| 2-332A | 2-104 | 2-142 | 2-104 |
| 2-333A | 2-107 | 2-104 | 2-135 |
| 2-334A | 2-104 | 2-111 | 2-135 |
| 2-335A | 2-104 | 2-143 | 2-104 |
| 2-336A | 2-106 | 2-142 | 2-104 |
| 2-337A | 2-107 | 2-142 | 2-106 |
| 2-338A | 2-104 | 2-104 | 2-169 |
| 2-339A | 2-184 | 2-104 | 2-104 |
| 2-340A | 2-104 | 2-104 | 2-182 |
| 2-341A | 2-168 | 2-104 | 2-104 |
| 2-342A | 2-104 | 2-104 | 2-183 |
| 2-343A | 2-104 | 2-104 | 2-168 |
| 2-344A | 2-183 | 2-104 | 2-104 |
| 2-345A | 2-104 | 2-104 | 2-167 |
| 2-346A | 2-104 | 2-104 | 2-184 |
| 2-347A | 2-104 | 2-183 | 2-104 |
| 2-348A | 2-104 | 2-182 | 2-104 |
| 2-349A | 2-104 | 2-169 | 2-104 |
| 2-350A | 2-104 | 2-184 | 2-104 |
| 2-351A | 2-107 | 2-104 | 2-179 |
| 2-352A | 2-111 | 2-104 | 2-169 |
| 2-353A | 2-104 | 2-111 | 2-182 |
| 2-354A | 2-106 | 2-104 | 2-185 |
| 2-355A | 2-171 | 2-104 | 2-104 |
| 2-356A | 2-104 | 2-104 | 2-115 |
| 2-357A | 2-104 | 2-104 | 2-178 |
| 2-358A | 2-104 | 2-106 | 2-167 |
| 2-359A | 2-108 | 2-105 | 2-167 |
| 2-360A | 2-105 | 2-104 | 2-167 |
| 2-361A | 2-112 | 2-104 | 2-184 |
| 2-362A | 2-104 | 2-192 | 2-104 |
| 2-363A | 2-107 | 2-182 | 2-106 |
| 2-364A | 2-104 | 2-169 | 2-105 |
| 2-365A | 2-105 | 2-184 | 2-104 |
| 2-366A | 2-105 | 2-169 | 2-105 |
| 2-367A | 2-198 | 2-104 | 2-104 |
| 2-368A | 2-201 | 2-104 | 2-104 |
| 2-369A | 2-197 | 2-104 | 2-104 |
| 2-370A | 2-202 | 2-104 | 2-104 |
| 2-371A | 2-200 | 2-104 | 2-104 |
| 2-372A | 2-199 | 2-104 | 2-104 |
| 2-373A | 2-104 | 2-202 | 2-104 |
| 2-374A | 2-104 | 2-197 | 2-104 |
| 2-375A | 2-104 | 2-200 | 2-104 |
| 2-376A | 2-104 | 2-198 | 2-104 |
| 2-377A | 2-209 | 2-104 | 2-104 |
| 2-378A | 2-207 | 2-104 | 2-104 |
| 2-379A | 2-200 | 2-106 | 2-104 |
| 2-380A | 2-104 | 2-208 | 2-104 |
| 2-381A | 2-105 | 2-198 | 2-108 |
| 2-382A | 2-202 | 2-102 | 2-104 |
| 2-383A | 2-202 | 2-101 | 2-106 |
| 2-384A | 2-102 | 2-102 | 2-107 |
| 2-385A | 2-104 | 2-202 | 2-101 |
| 2-386A | 2-123 | 2-147 | 2-104 |
| 2-387A | 2-104 | 2-104 | 2-218 |
| 2-388A | 2-116 | 2-104 | 2-147 |
| 2-389A | 2-157 | 2-104 | 2-147 |
| 2-390A | 2-107 | 2-147 | 2-115 |
| 2-391A | 2-157 | 2-157 | 2-104 |
| 2-392A | 2-157 | 2-157 | 2-114 |
| 2-393A | 2-157 | 2-157 | 2-147 |
| 2-394A | 2-116 | 2-147 | 2-104 |
| 2-395A | 2-104 | 2-104 | 2-210 |
| 2-396A | 2-157 | 2-182 | 2-104 |
| 2-397A | 2-197 | 2-213 | 2-104 |
| 2-398A | 2-202 | 2-167 | 2-104 |
| 2-399A | 2-104 | 2-216 | 2-104 |
| 2-400A | 2-124 | 2-197 | 2-104 |
| 2-401A | 2-104 | 2-202 | 2-114 |
| 2-402A | 2-168 | 2-104 | 2-169 |
| 2-403A | 2-184 | 2-104 | 2-169 |
| 2-404A | 2-169 | 2-104 | 2-167 |
| 2-405A | 2-184 | 2-106 | 2-167 |
| 2-406A | 2-169 | 2-183 | 2-102 |
| 2-407A | 2-184 | 2-114 | 2-169 |
| 2-408A | 2-184 | 2-168 | 2-184 |
| 2-409A | 2-184 | 2-104 | 2-167 |
| 2-410A | 2-184 | 2-167 | 2-167 |
| 2-411A | 2-114 | 2-101 | 2-197 |
| 2-412A | 2-104 | 2-149 | 2-104 |
| 2-413A | 2-106 | 2-104 | 2-147 |
| 2-414A | 2-104 | 2-104 | 2-168 |
| 2-415A | 2-200 | 2-106 | 2-104 |
| 2-416A | 2-104 | 2-104 | 2-183 |
| 2-417A | 2-104 | 2-104 | 2-101 |
| 2-418A | 2-105 | 2-169 | 2-105 |
| 2-419A | 2-104 | 2-147 | 2-107 |
| 2-421A | 2-104 | 2-218 | 2-104 |
| 2-422A | 2-104 | 2-226 | 2-104 |
| 2-423A | 2-104 | 2-222 | 2-104 |
| 2-424A | 2-104 | 2-228 | 2-104 |
| 2-425A | 2-104 | 2-151 | 2-104 |
| 2-426A | 2-106 | 2-147 | 2-107 |
| 2-427A | 2-104 | 2-147 | 2-106 |
| 2-428A | 2-107 | 2-150 | 2-104 |
| 2-429A | 2-104 | 2-143 | 2-104 |
| 2-430A | 2-107 | 2-142 | 2-106 |
| 2-431A | 2-104 | 2-142 | 2-104 |
| 2-432A | 2-104 | 2-104 | 2-104 |

In one or more embodiments, the second compound may be represented by one selected from Formulae 2-301B to 2-320B (denoting a structure based on Formula 2B), and rings A₂₁ and A₂₃ in Formulae 2-301B to 2-320B may each independently be selected from the Formulae shown in Table 4.

**Table 4**

| Formula No. | Formula No. or ring A₂₁ | Formula No. of ring A₂₂ | Formula No. of ring A₂₃ |
|---|---|---|---|
| 2-301B | 2-104 | - | 2-198 |
| 2-302B | 2-104 | - | 2-201 |
| 2-303B | 2-104 | - | 2-197 |
| 2-304B | 2-104 | - | 2-202 |
| 2-305B | 2-104 | - | 2-200 |
| 2-306B | 2-104 | - | 2-199 |
| 2-307B | 2-104 | - | 2-203 |
| 2-308B | 2-104 | - | 2-204 |
| 2-309B | 2-106 | - | 2-205 |
| 2-310B | 2-104 | - | 2-206 |
| 2-311B | 2-112 | - | 2-199 |
| 2-312B | 2-114 | - | 2-202 |
| 2-313B | 2-116 | - | 2-202 |
| 2-314B | 2-104 | - | 2-214 |
| 2-315B | 2-130 | - | 2-201 |
| 2-316B | 2-168 | - | 2-183 |
| 2-317B | 2-114 | - | 2-198 |
| 2-318B | 2-116 | - | 2-199 |
| 2-319B | 2-198 | - | 2-197 |
| 2-320B | 2-197 | - | 2-197 |

In Formulae 1A or 1B, X₁ is N or C-(L₁)ₐ₁-(R₁)_{b1}, X₂ is N or C-(L₂)ₐ₂-(R₂)_{b2}, X₃ is N or C-(L₃)ₐ₃-(R₃)_{b3}, and at least one selected from X₁ to X₃ is N.

For example, i) in Formulae 1A and 1B,
X₁ may be N, X₂ may be C-(L₂)ₐ₂-(R₂)_{b2}, and X₃ may be C-(L₃)ₐ₃-(R₃)_{b3},
X₁ may be N, X₂ may be N, and X₃ may be C-(L₃)ₐ₃-(R₃)_{b3}, or
X₁, X₂, and X₃ may be N.

In one or more embodiments, X₂₁ in Formulae 2A and 2B may be N[(L₂₁)ₐ₂₁-(R₂₁)_{b21}].

In one or more embodiments, X₂₁ in Formulae 2A and 2B may be selected from O, S, Se, C(R₂₃)(R₂₄), and Si(R₂₃)(R₂₄), and
at least one selected from rings A₂₁, A₂₂, and A₂₃ in Formula 2A and at least one selected from rings A₂₁ and A₂₃ in Formula 2B may each independently be selected from groups represented by Formulae 2-1 to 2-3, 2-10 to 2-27, and 2-33 to 2-36, and X₂₂ or X₂₃ in Formulae 2-1 to 2-3, 2-10 to 2-27, and 2-33 to 2-36 may be N-[(L₂₂)ₐ₂₂-(R₂₂)_{b22}].

In one or more embodiments, X₂₁ in Formulae 2A and 2B may be selected from O, S, Se, C(R₂₃)(R₂₄), and Si(R₂₃)(R₂₄), and
at least one selected from rings A₂₁, A₂₂, and A₂₃ in Formula 2A and at least one selected from rings A₂₁ and A₂₃ in Formula 2B may be selected from groups represented by Formulae 2-101 to 2-103, 2-147 to 2-211, 2-214 to 2-219, and 2-226 to 2-229, and X₂₂ or X₂₃ in Formulae 2-101 to 2-103, 2-147 to 2-211, 2-214 to 2-219, and 2-226 to 2-229 may be N-[(L₂₂)ₐ₂₂-(R₂₂)_{b22}], but embodiments of the present disclosure are not limited thereto.

L₂₁, L₂₂, a₂₁, a₂₂; R₂₁ to R₂₆, b21, and b22 are described below.

L₁ to L₁₀, L₂₁, and L₂₂ in Formulae 1A, 1B, 2A, and 2B are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group.

For example, in Formulae 1A, 1B, 2A, and 2B,

L₁ to L₁₀ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyridinylene group, a pyrazinylene group, a pyrimidinylene group, a pyridazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a triazinylene group, a dibenzofuranylene group, a dibenzothiophenylene group, a dibenzosilolylene group, a carbazolylene group, a benzocarbazolylene group, a dibenzocarbazolylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyridinylene group, a pyrazinylene group, a pyrimidinylene group, a pyridazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a triazinylene group, a dibenzofuranylene group, a dibenzothiophenylene group, a dibenzosilolylene group, a carbazolylene group, a benzocarbazolylene group, a dibenzocarbazolylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), and

L₂₁ and L₂₂ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein and Q₃₁ to Q₃₃ may each independently be selected from the group consisting of:
   a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
   a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
   but embodiments of the present disclosure are not limited thereto.

In one or more embodiments, L₁ to L₁₀ in Formulae 1A or 1B may each independently be selected from groups represented by Formulae 3-1 to 3-14, 3-17 to 3-99 and 3-101, and
L₂₁ and L₂₂ in Formulae 2A and 2B may each independently be selected from groups represented by Formulae 3-1 to 3-99 and 3-101:

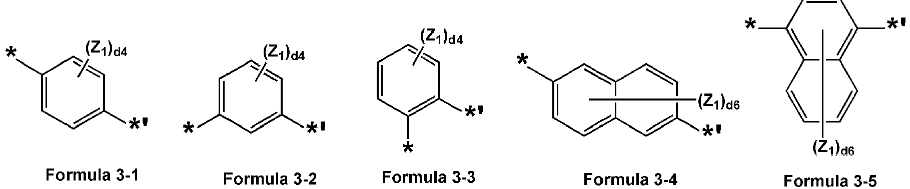

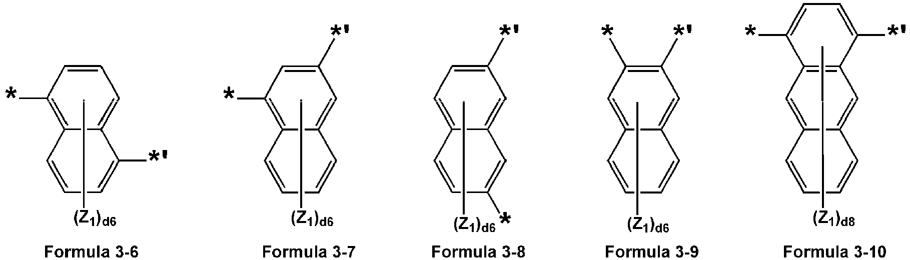

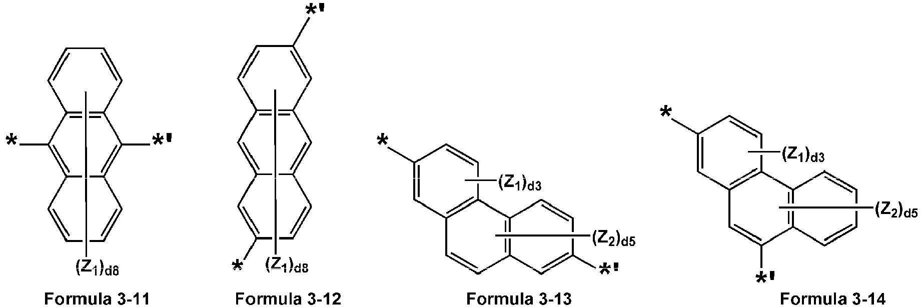

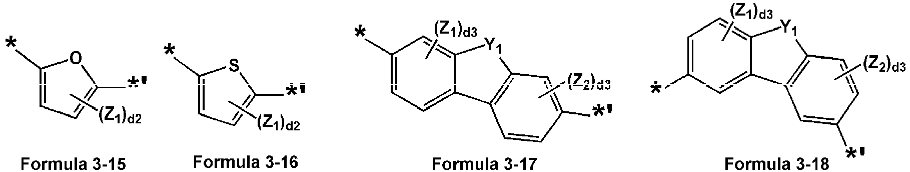

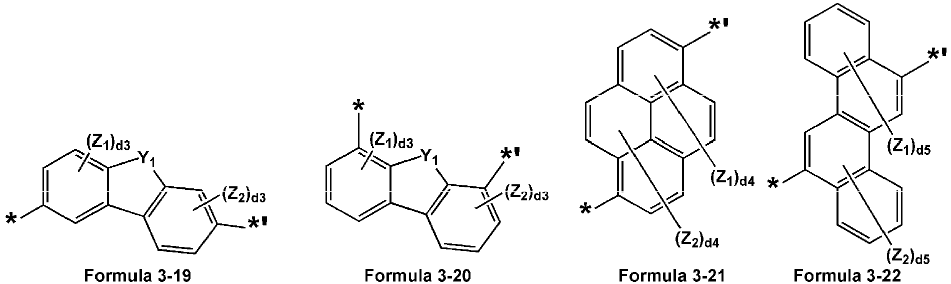

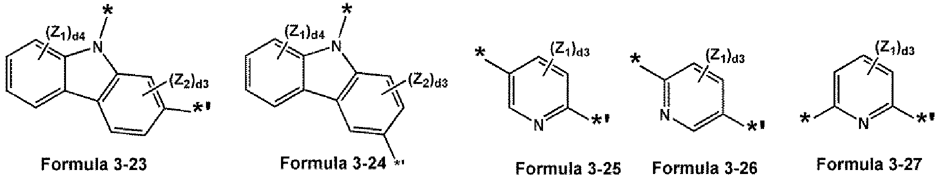

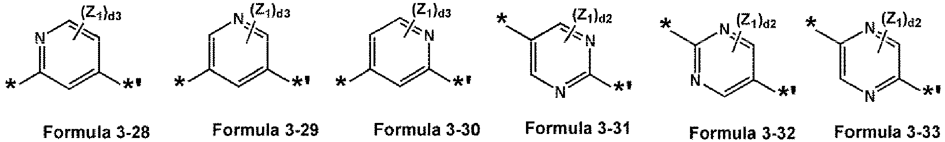

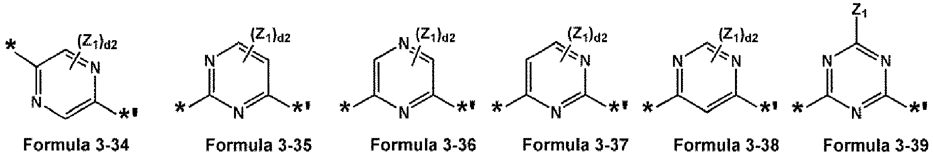

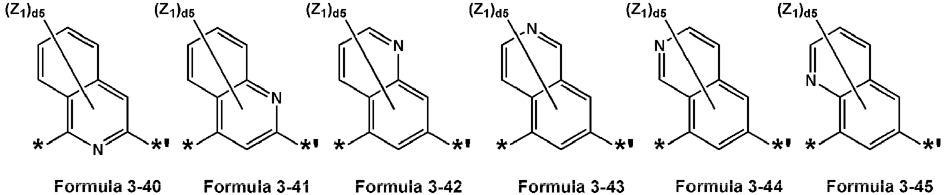

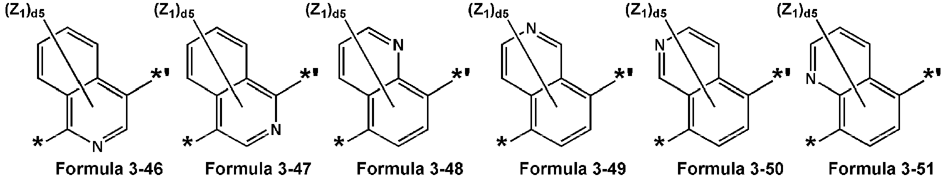

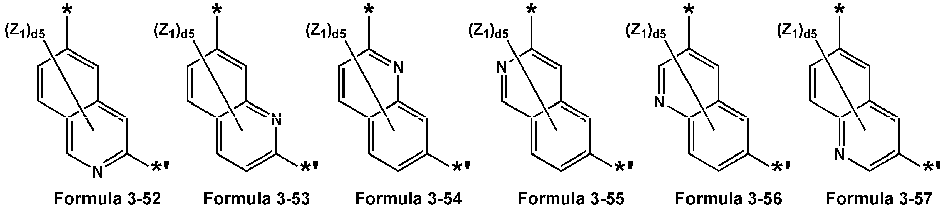

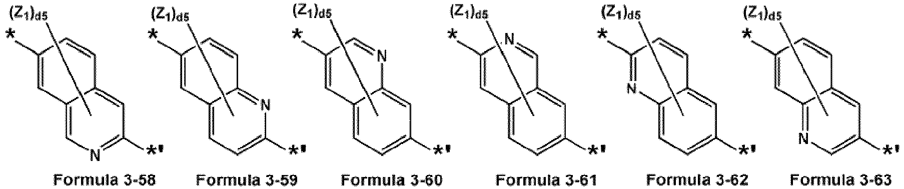

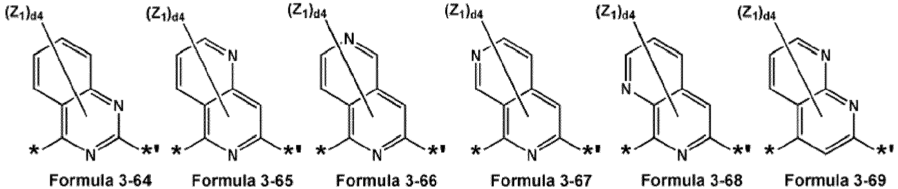

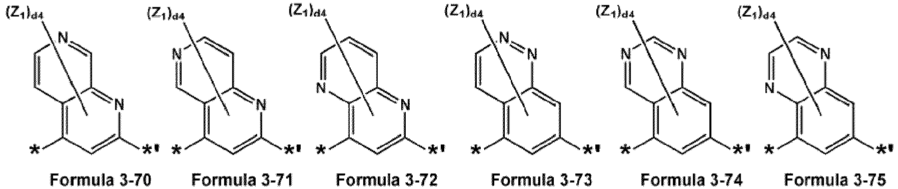

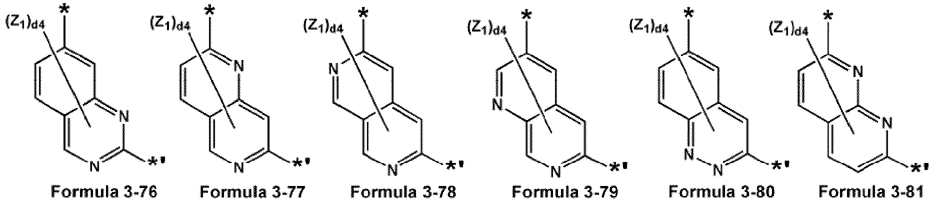

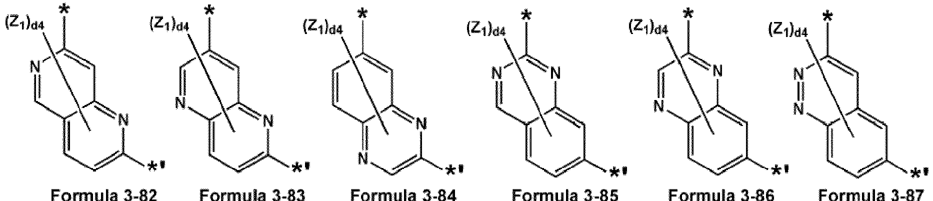

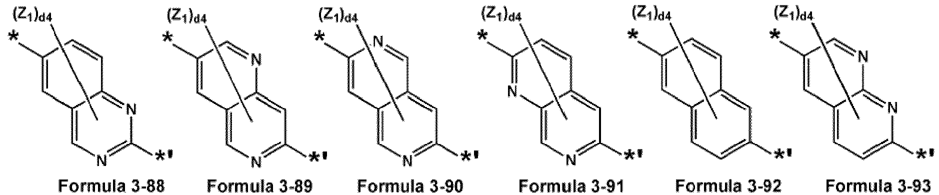

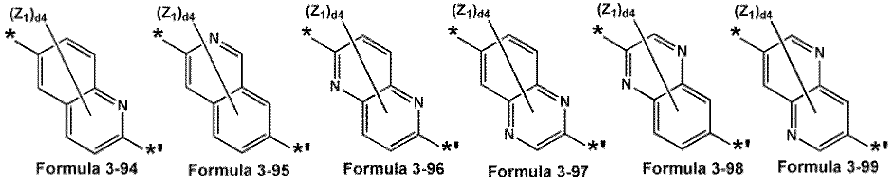

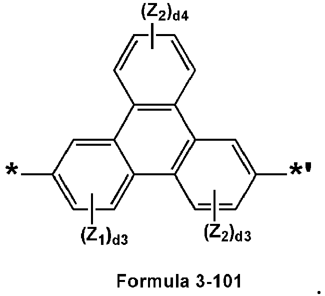

In Formulae 3-1 to 3-99 and 3-101,
Y₁ may be selected from O, S, C(Z₄)(Z₅), N(Z₆), and Si(Z₇)(Z₈),
Z₁ to Z₈ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
Z₄ and Z₅ may be optionally connected (e.g., coupled) to form a saturated or unsaturated ring,
Q₃₁ to Q₃₃ may each independently be the same as described herein,
d2 may be an integer selected from 0 to 2,
d3 may be an integer selected from 0 to 3,
d4 may be an integer selected from 0 to 4,
d5 may be an integer selected from 0 to 5,
d6 may be an integer selected from 0 to 6,
d8 may be an integer selected from 0 to 8, and
^{∗} and ^{∗}' may each independently indicate a binding site to a neighboring atom.
a1 in Formulae 1A, 1B, 2A, and 2B indicates the number of L₁(s), and may be an integer selected from 0 to 5. When a1 is zero, ^{∗}-(L₁)ₐ₁-^{∗}' may be a single bond, and when a1 is two or more, two or more L₁(s) may be identical to or different from each other. a2 to a10, a21, and a22 may each independently be the same as described herein in connection with a1 and the structures of Formulae 1A, 1B, 2A, and 2B.

For example, a1 to a10, a21, and a22 may each independently be 0, 1, 2, or 3.

R₁ to R₁₀, R₂₁ to R₂₄, R₂₇, and R₂₈ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂).

For example, R₁ to R₁₀ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, and a hydrazono group;
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a tetraphenyl group, a pyridinyl group, a pyrazinyl group, a pyrimidinyl group, a pyridazinyl group, a quinolinyl group, an isoquinolinyl group, a benzoquinolinyl group, a phthalazinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, a benzocarbazolyl group, a dibenzocarbazolyl group, a dibenzosilolyl group, an azafluorenyl group, an azaspiro-bifluorenyl group, an azacarbazolyl group, an azadibenzofuranyl group, an azadibenzothiophenyl group, an azadibenzosilolyl group, a benzofuranopyrimidinyl group, a benzothiophenopyrimidyl group, a pyrimidinoquinoxalinyl group, and an azaindenopyridinyl group; and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a tetraphenyl group, a pyridinyl group, a pyrazinyl group, a pyrimidinyl group, a pyridazinyl group, a quinolinyl group, an isoquinolinyl group, a benzoquinolinyl group, a phthalazinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, a benzocarbazolyl group, a dibenzocarbazolyl group, a dibenzosilolyl group, an azafluorenyl group, an azaspiro-bifluorenyl group, an azacarbazolyl group, an azadibenzofuranyl group, an azadibenzothiophenyl group, an azadibenzosilolyl group, a benzofuranopyrimidinyl group, a benzothienopyrimidyl group, a pyrimidinoquinoxalinyl group, and an azaindenopyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁ to Q₃ and Q₃₁ to Q₃₃ may each independently be the same as described herein.

In one or more embodiments,
R₂₁ to R₂₄, R₂₇, and R₂₈ may each independently be selected from the group consisting of:
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), or
R₂₂ may be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₁)(Q₂)(Q₃), -S(=O)₂(Q₁), and -P(=O)(Q₁)(Q₂),
wherein Q₁ to Q₃ and Q₃₁ to Q₃₃ may each independently be the same as described herein.

In one or more embodiments,
R₁ to R₁₀ in Formulae 1A or 1B may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, and a group represented by any of Formulae 5-1 to 5-48, 6-1 to 6-49, and 6-78 to 6-122,
R₂₁, R₂₃, R₂₄, R₂₇, and R₂₈ in Formulae 2A and 2B may each independently be selected from groups represented by Formulae 5-1 to 5-48 and 6-1 to 6-124, and
R₂₂ may be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 5-1 to 5-48 and 6-1 to 6-124, -Si(Q₁)(Q₂)(Q₃), -S(=O)₂(Q₁), and - P(=O)(Q₁)(Q₂), but embodiments of the present disclosure are not limited thereto:

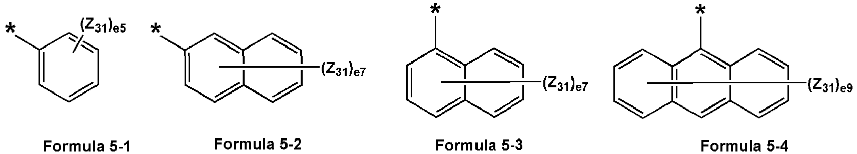

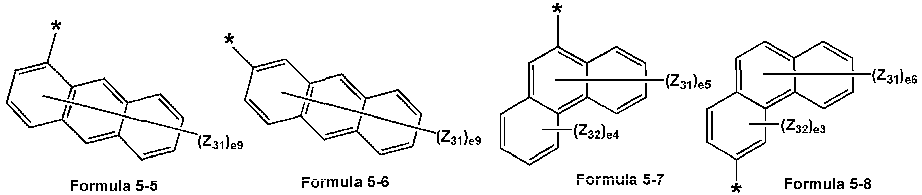

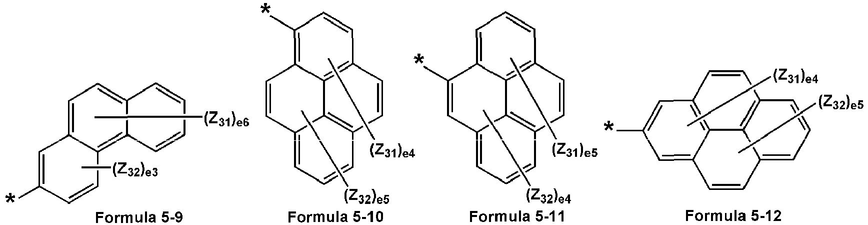

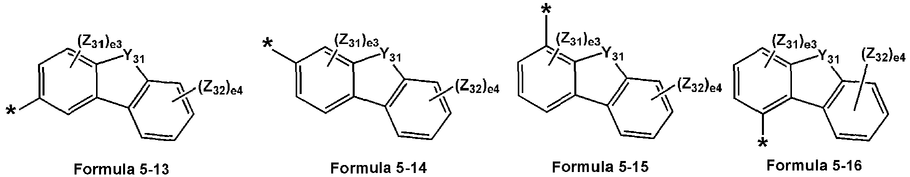

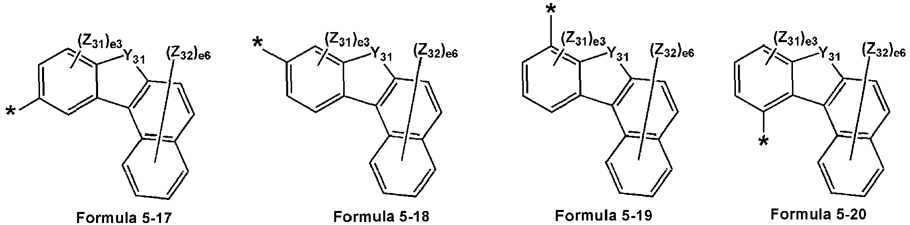

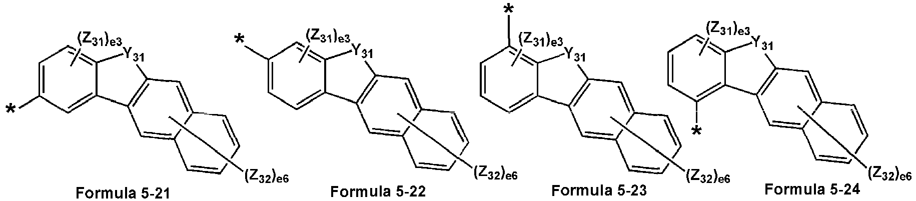

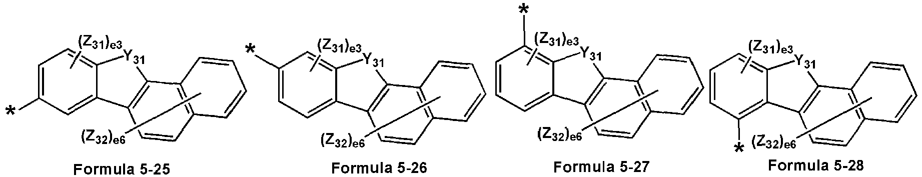

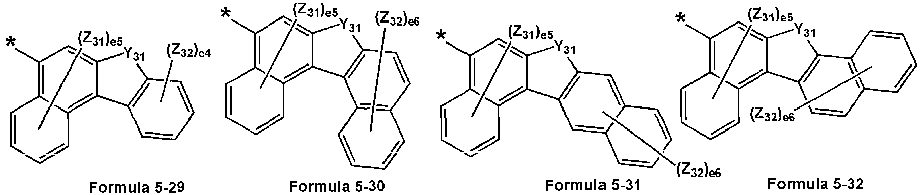

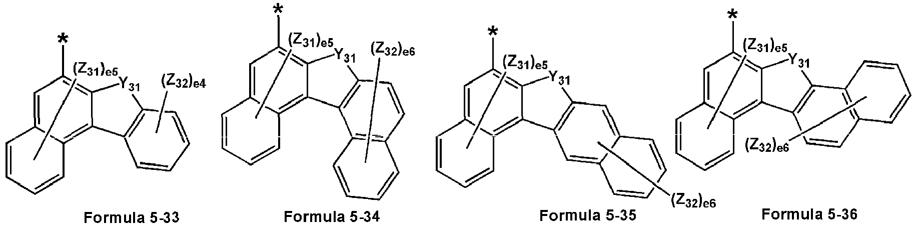

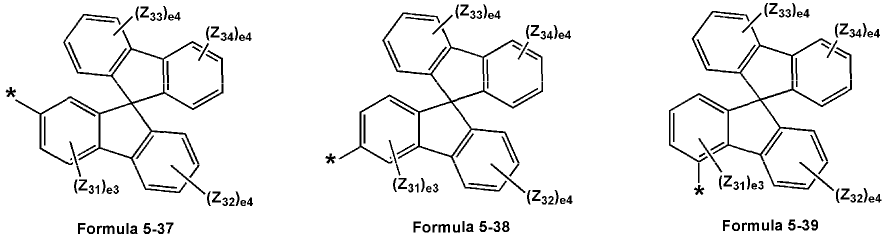

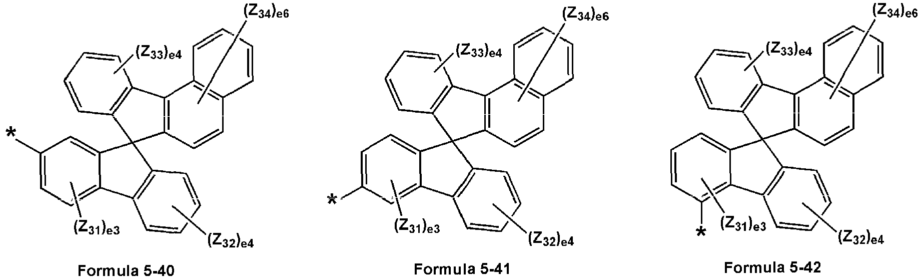

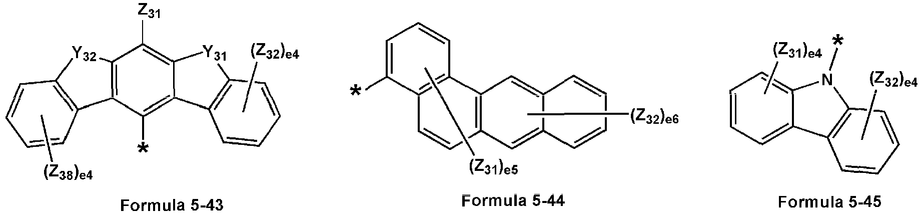

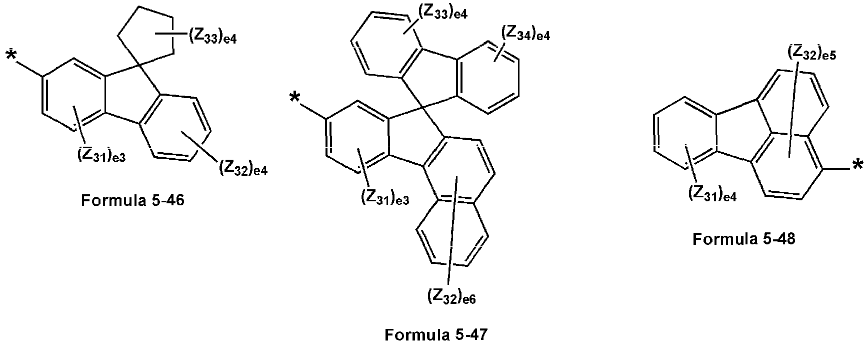

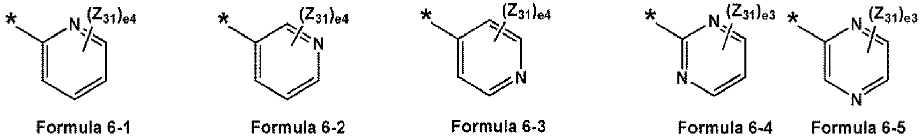

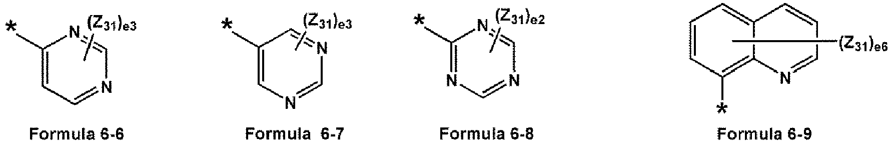

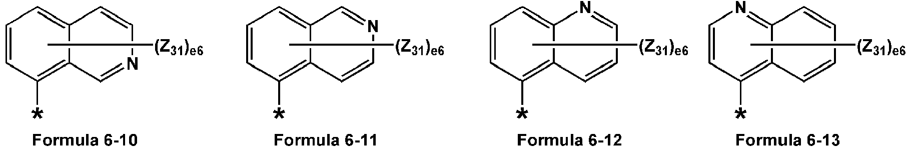

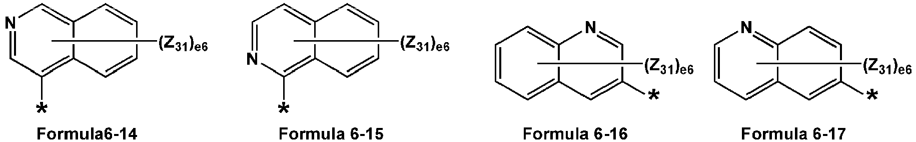

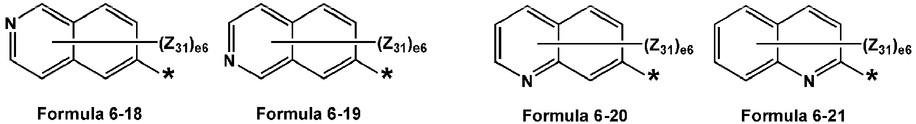

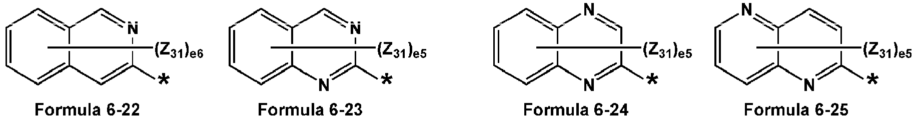

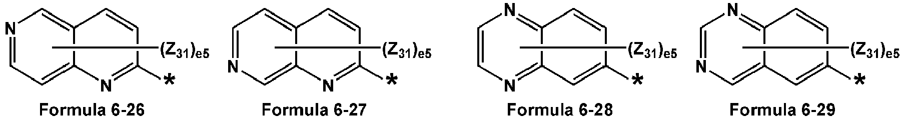

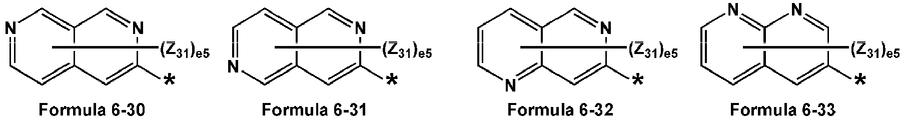

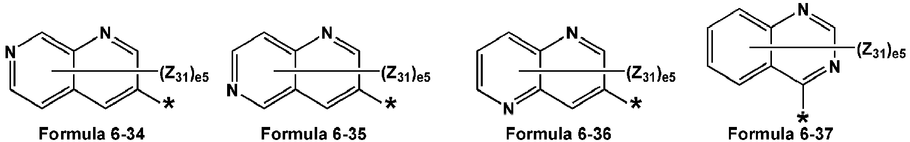

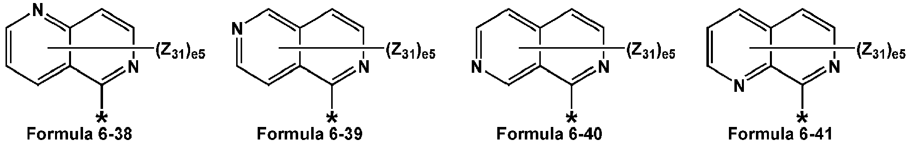

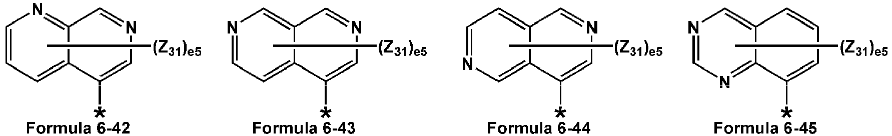

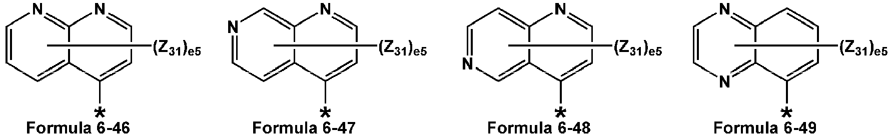

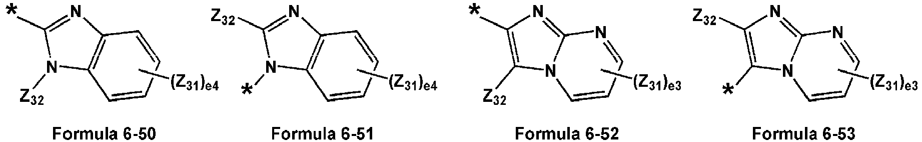

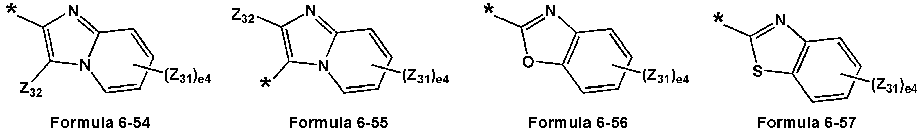

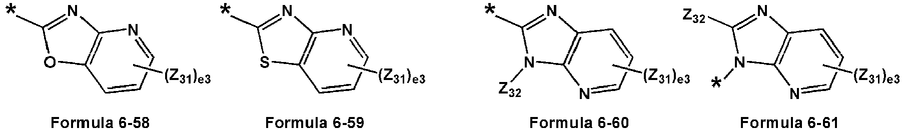

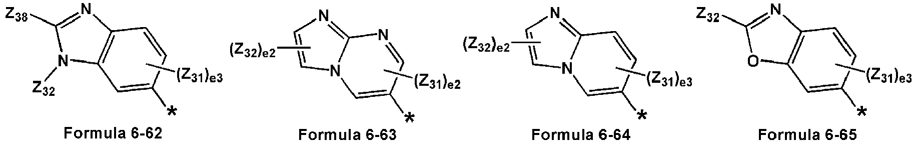

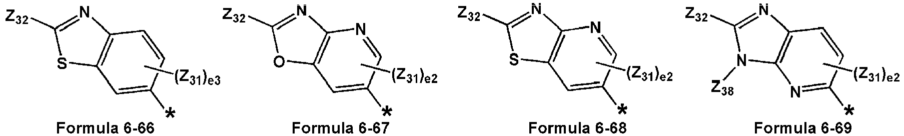

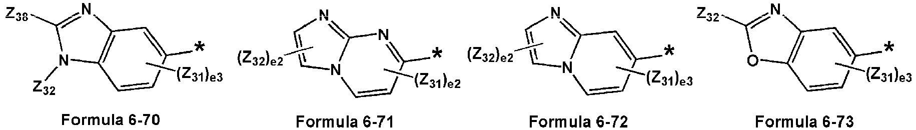

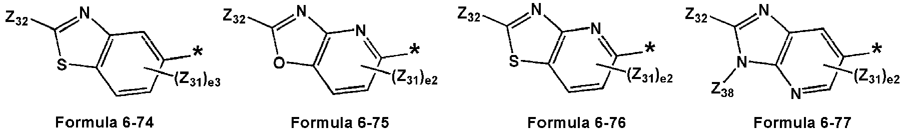

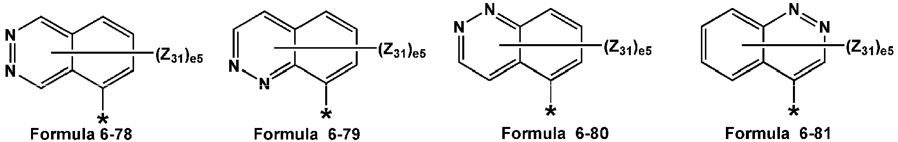

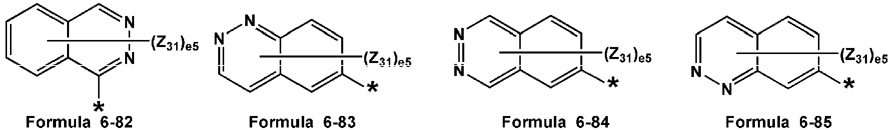

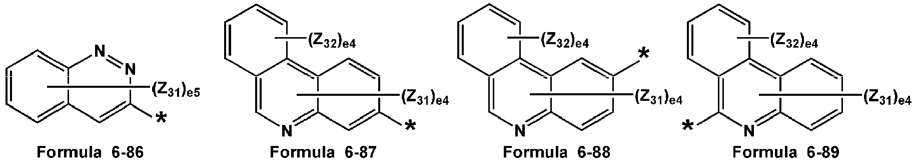

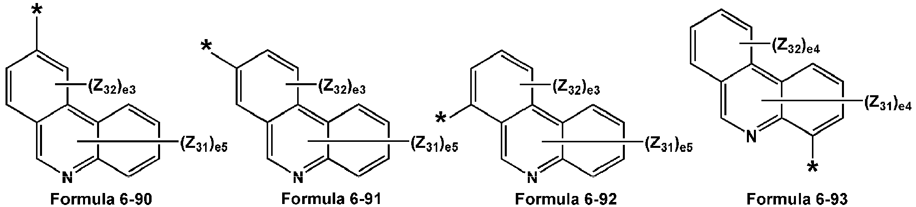

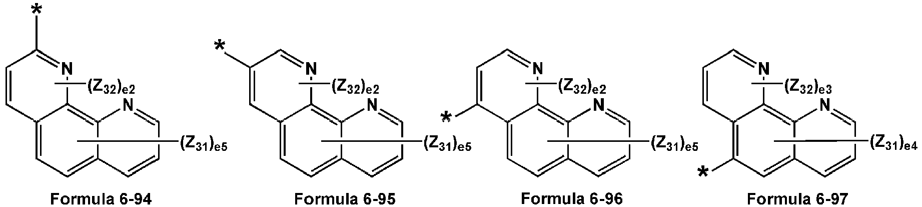

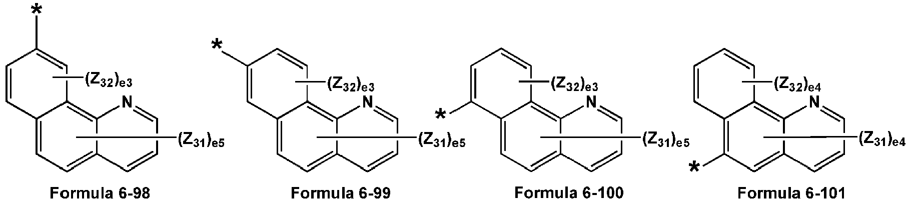

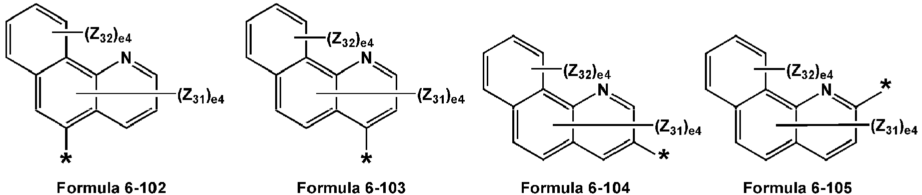

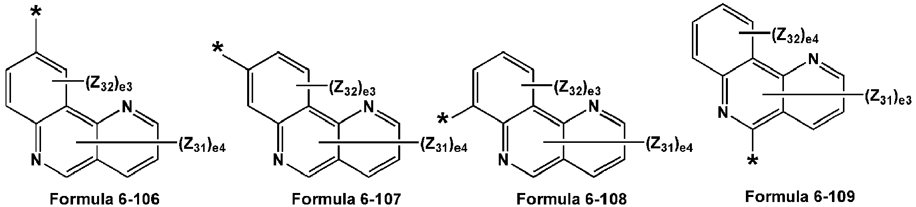

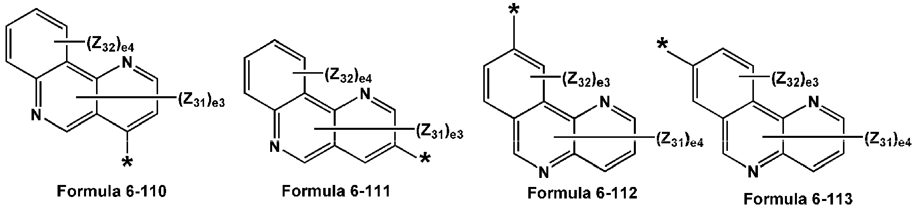

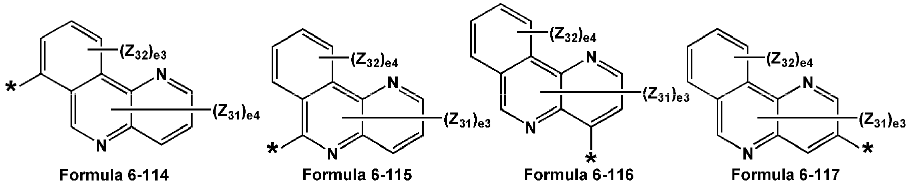

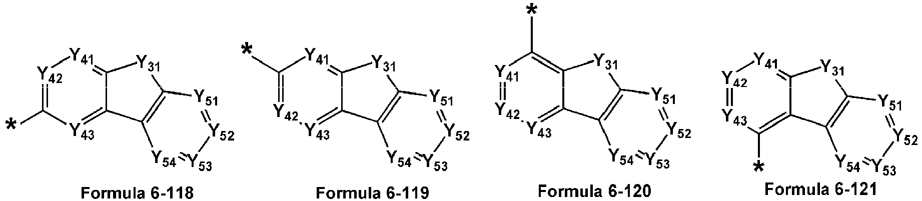

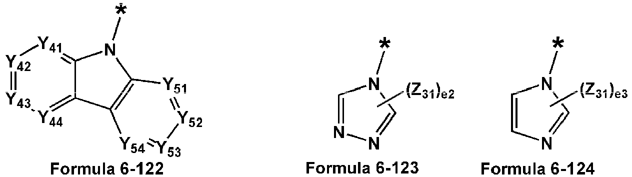

In Formulae 5-1 to 5-48 and 6-1 to 6-124,
Y₃₁ and Y₃₂ may each independently be selected from O, S, C(Z₃₃)(Z₃₄), N(Z₃₅), and Si(Z₃₆)(Z₃₇),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₅₂ may be N or C(Z₅₂), Y₅₃ may be N or C(Z₅₃), Y₅₄ may be N or C(Z₅₄), at least one selected from Y₄₁ to Y₄₃ and Y₅₁ to Y₅₄ in Formulae 6-118 to 6-121 may be N, and at least one selected from Y₄₁ to Y₄₄ and Y₅₁ to Y₅₄ in Formula 6-122 may be N,
Z₃₁ to Z₃₈, Z₄₁ to Z₄₄, and Z₅₁ to Z₅₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₃₁)(Q₃₂)(Q₃₃), and -P(=O)(Q₃₁)(Q₃₂),
Q₃₁ to Q₃₃ may each independently be the same as described herein, and Q₁ to Q₃ may each independently be the same as described herein in connection with Q₃₁,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
* may indicate a binding site to a neighboring atom.

In one or more embodiments,
R₁ to R₁₀ in Formulae 1A or 1B may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, and a group represented by any of Formulae 9-1 to 9-100, 10-1 to 10-105, and 10-112 to 10-121,
R₂₁, R₂₃, R₂₄, R₂₇, and R₂₈ in Formulae 2A and 2B may each independently be selected from groups represented by Formulae 9-1 to 9-100 and 10-1 to 10-121, and
R₂₂ in Formulae 2A and 2B may be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 9-1 to 9-100 and 10-1 to 10-121, -Si(Q₁)(Q₂)(Q₃), -S(=O)₂(Q₁), and - P(=O)(Q₁)(Q₂), but embodiments of the present disclosure are not limited thereto:

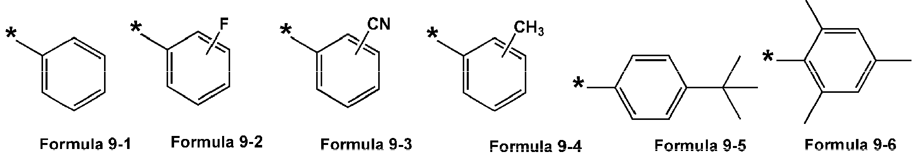

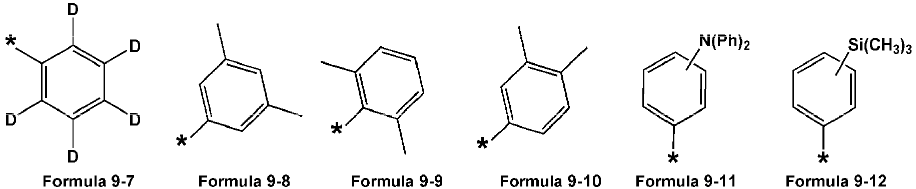

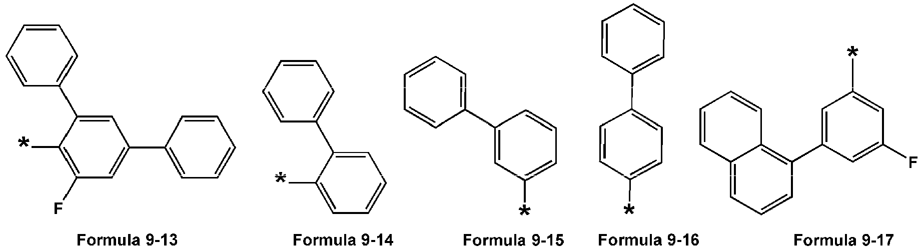

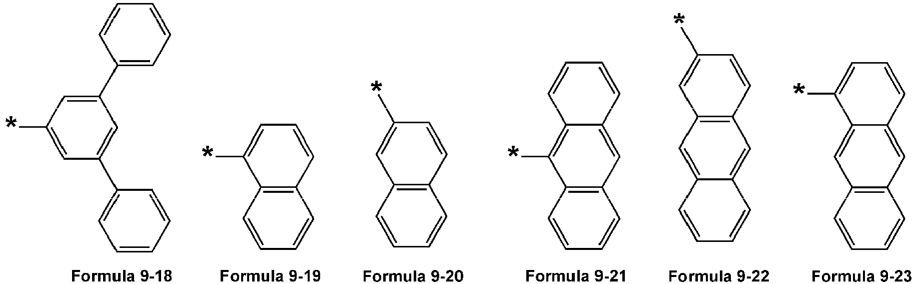

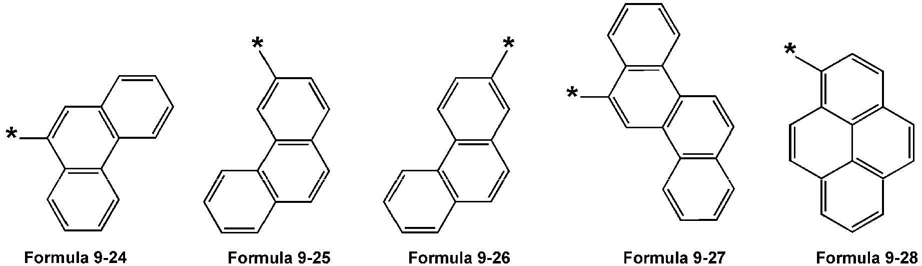

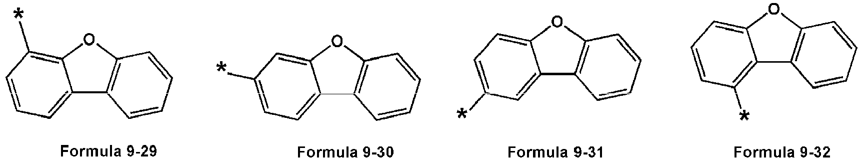

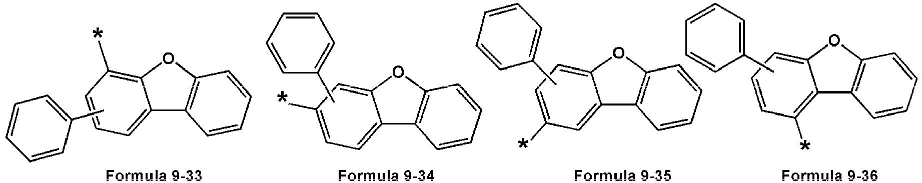

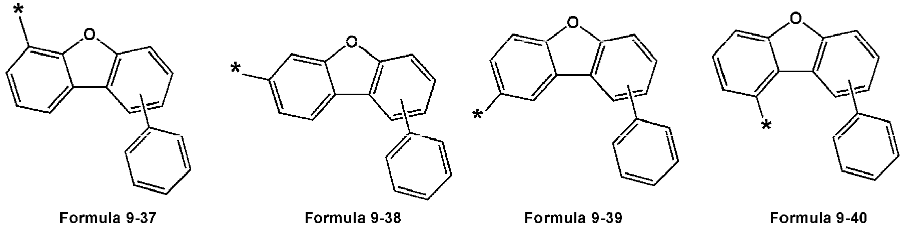

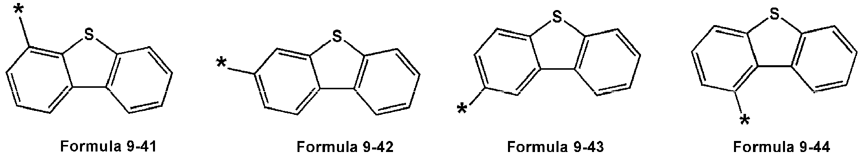

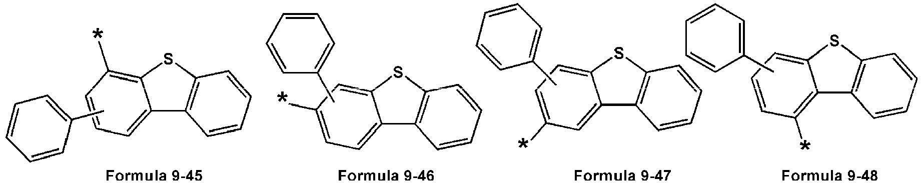

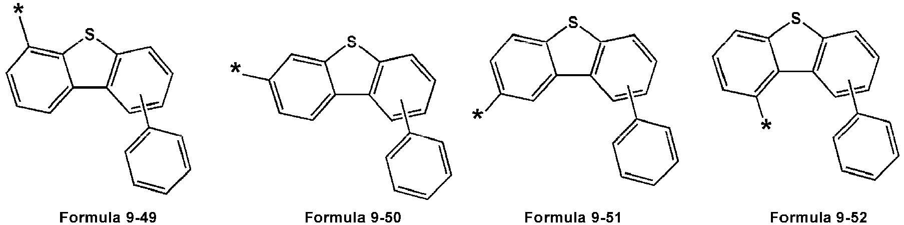

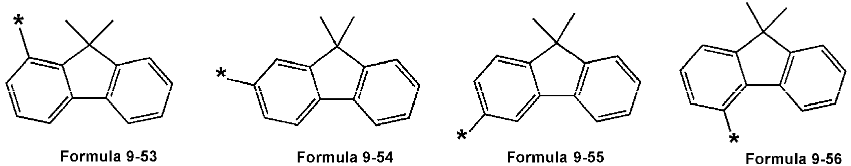

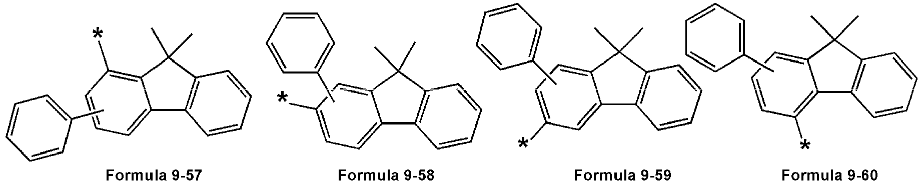

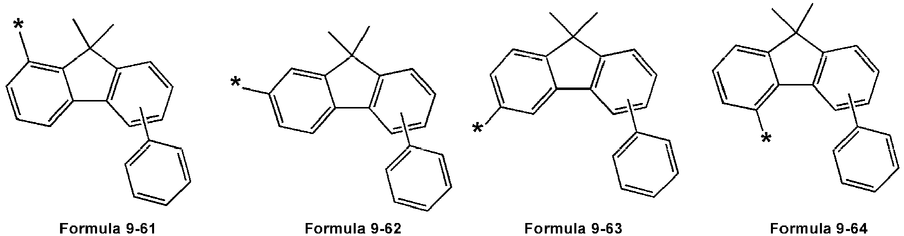

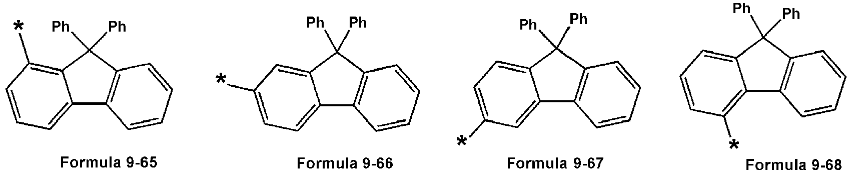

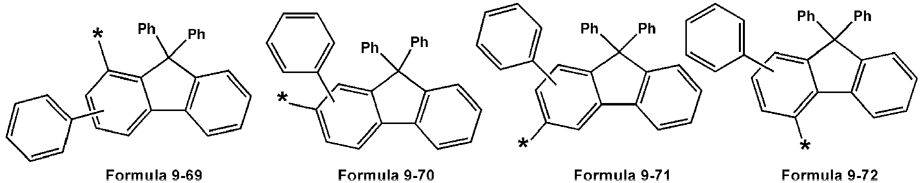

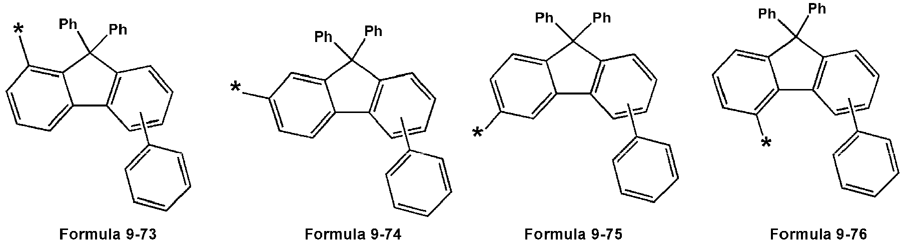

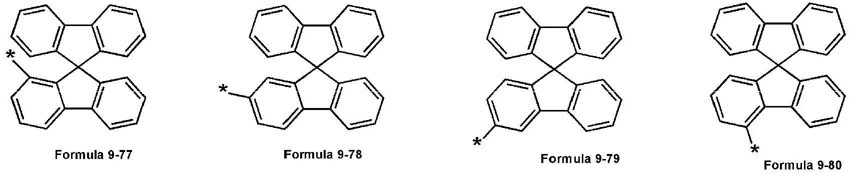

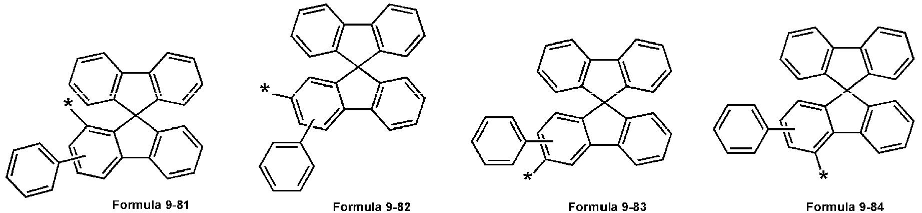

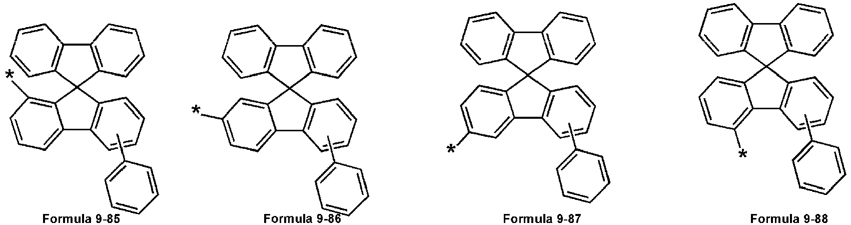

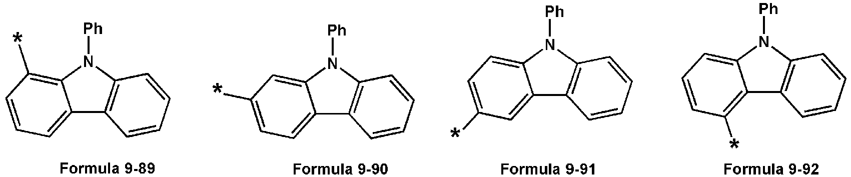

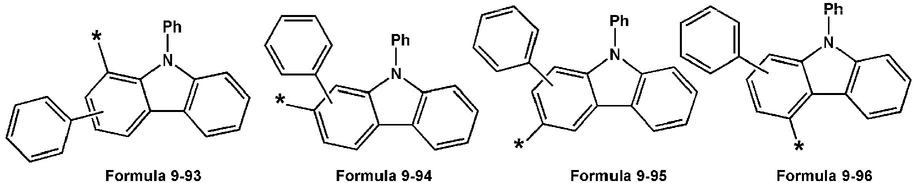

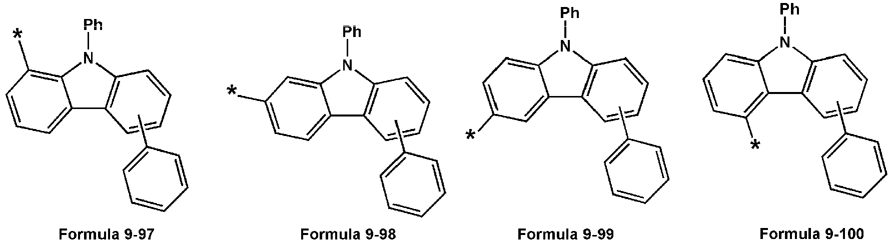

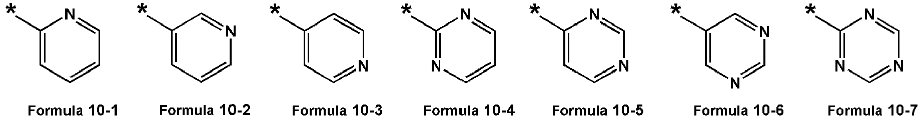

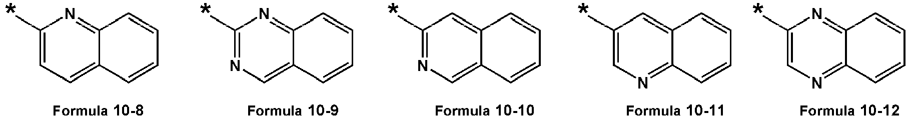

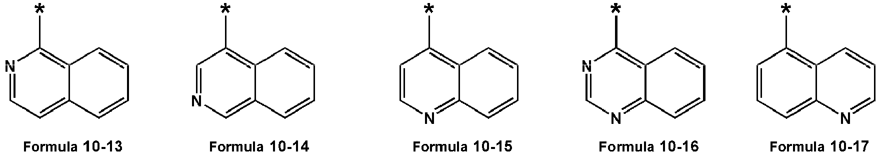

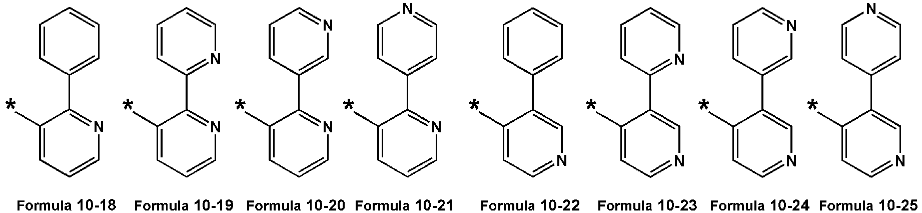

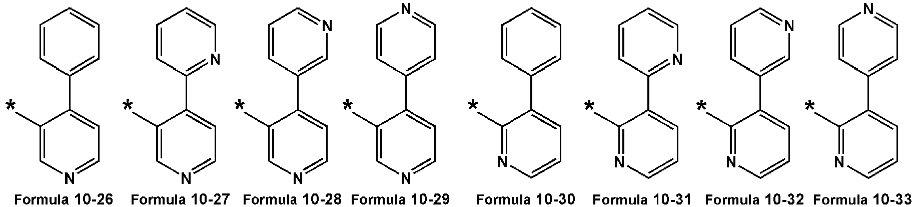

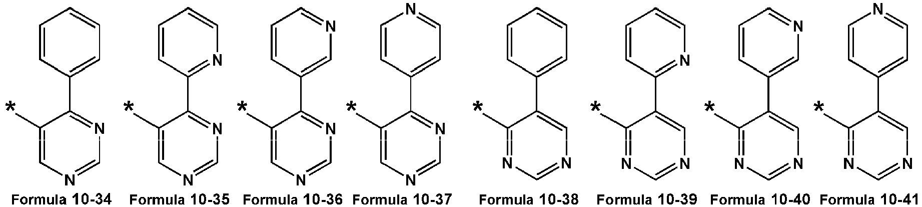

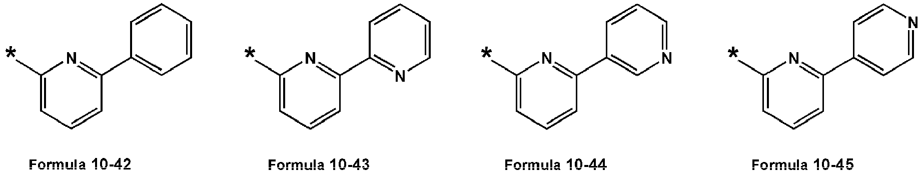

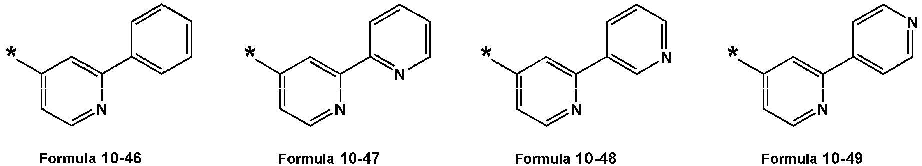

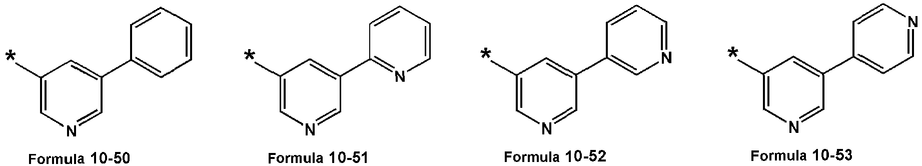

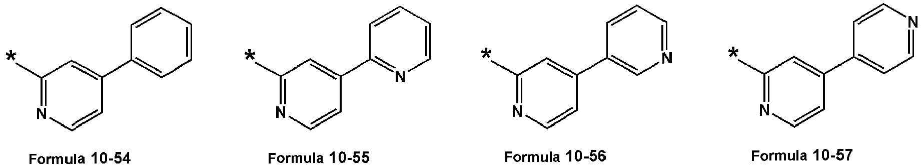

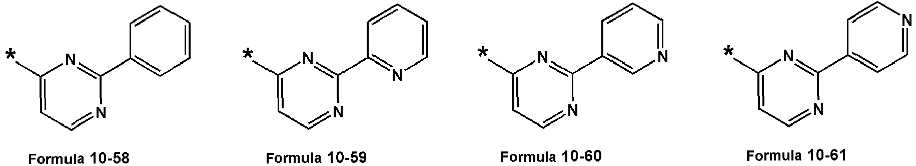

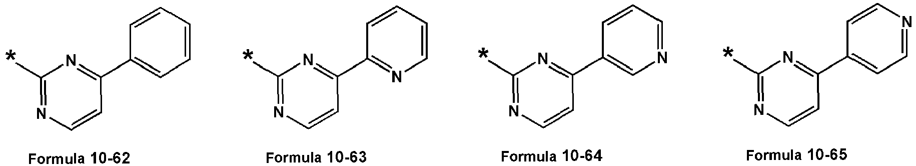

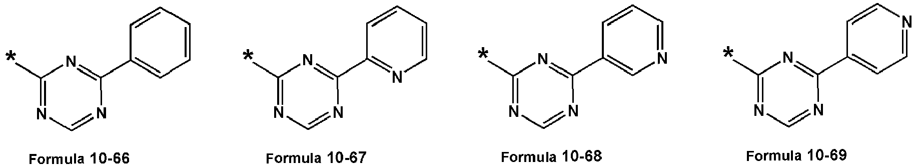

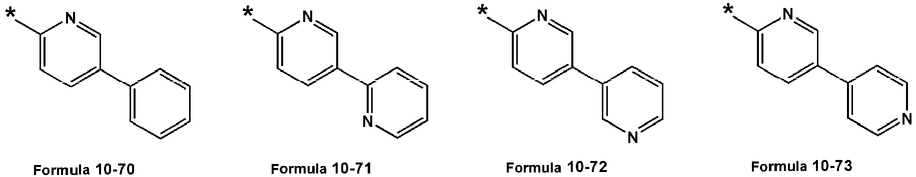

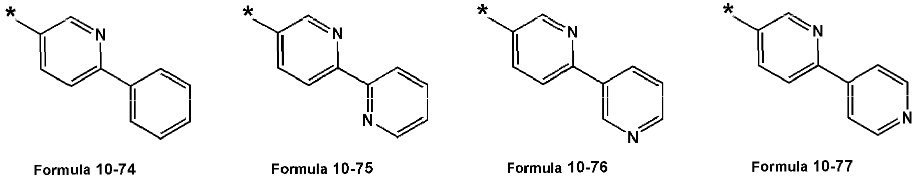

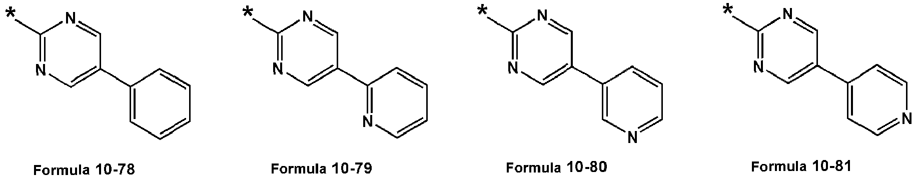

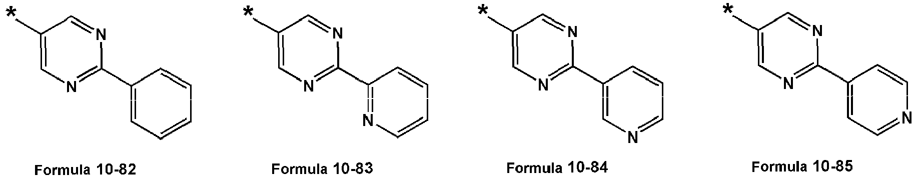

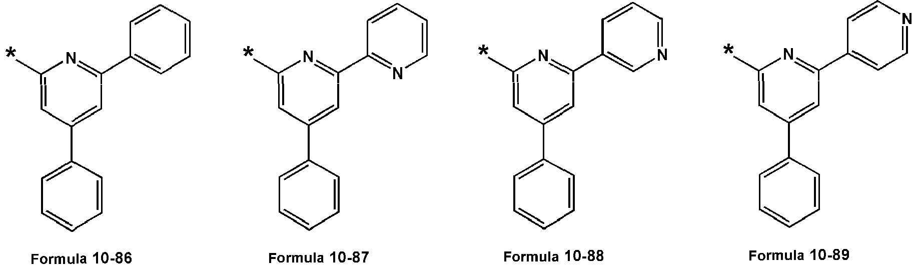

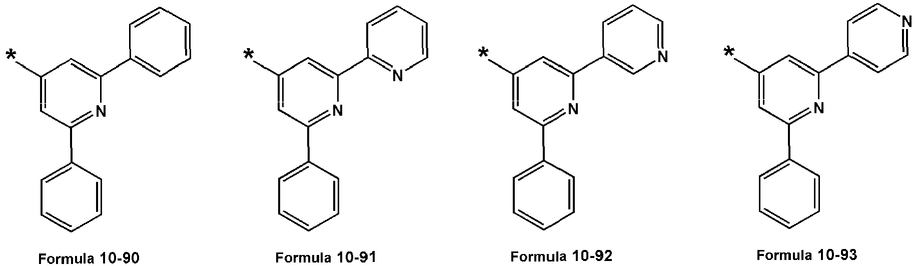

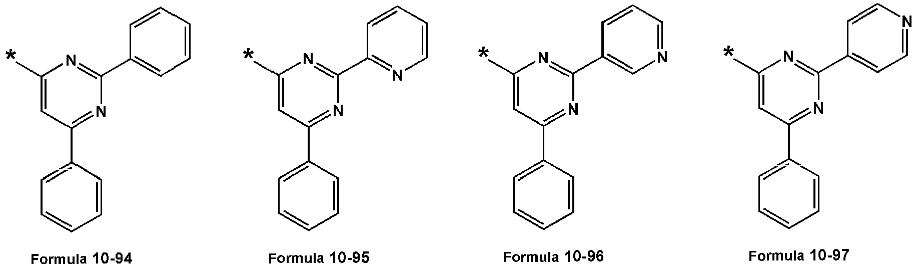

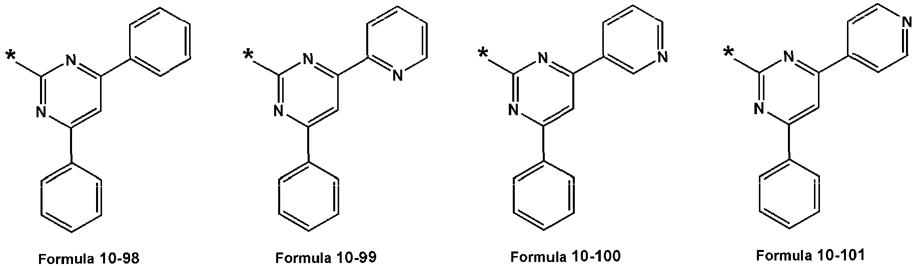

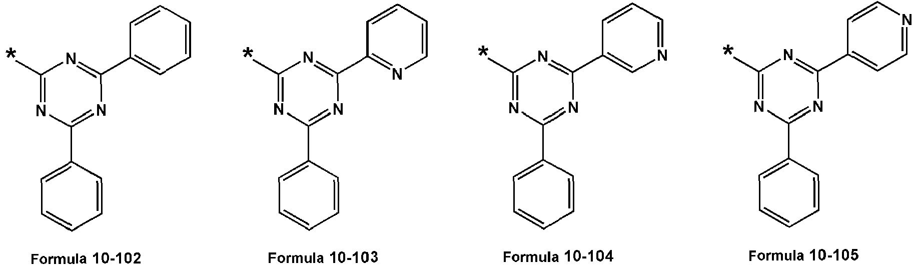

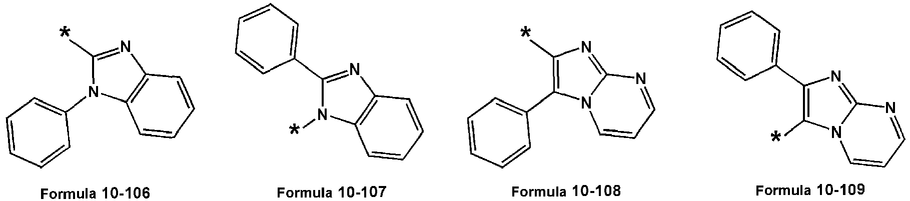

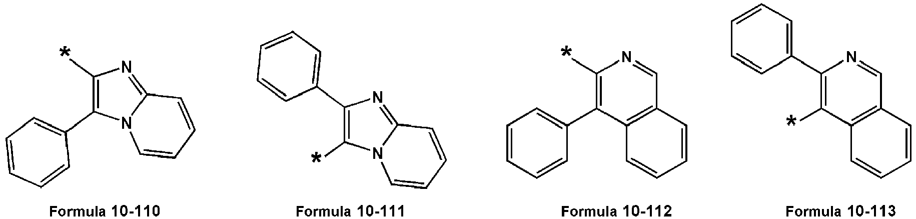

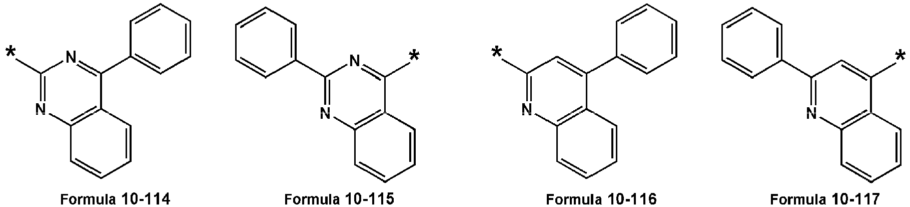

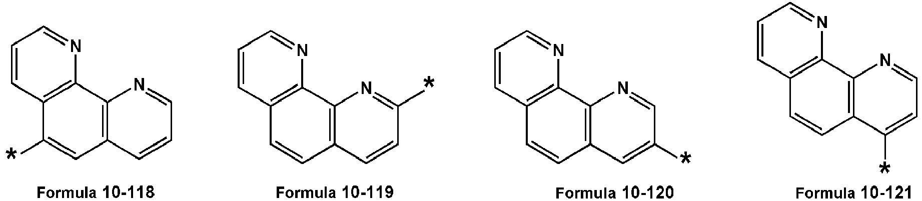

In Formulae 9-1 to 9-100 and 10-1 to 10-121, Ph represents a phenyl group and * indicates a binding site to a neighboring atom.

In Formulae 1A or 1B, when a1 and a4 are both zero, R₁ and R₄ may be optionally connected (e.g., coupled) to form a C₅-C₆₀ carbocyclic group or a C₁-C₃₀ heterocyclic group, and when a1 and a5 are both 0 and when R₁ and R₄ are not linked to form a cyclic group, R₁ and R₅ may be optionally connected (e.g., coupled) to form a C₅-C₆₀ carbocyclic group or a C₁-C₃₀ heterocyclic group.
b1 in Formulae 1A or 1B indicates the number of R₁(s), and when b1 is two or more, two or more R₁(s) may be identical to or different from each other. b2 to b10 may each independently be the same as described herein in connection with b1 and the structures of Formulae 1A or 1B.
b1 to b10 in Formulae 1A or 1B are each independently an integer selected from 1 to 4, provided that each of b1 to b10 is 1 when each respective a1 to a10 is zero. For example, b1 to b10 may each independently be 1, but embodiments of the present disclosure are not limited thereto.
b21 in Formulae 2A and 2B indicates the number of R₂₁(s), and when b21 is two or more, two or more R₂₁(s) may be identical to or different from each other. b22 may be the same as described herein in connection with b21 and the structures of Formulae 2A and 2B.
b21 and b22 in Formulae 2A and 2B are each independently an integer selected from 1 to 4, provided that each of b21 and b22 is 1 when each respective a21 or a22 is zero,. For example, b21 and b22 may each independently be 1 or 2, but embodiments of the present disclosure are not limited thereto.
In one or more embodiments, the first compound represented by one selected from Formulae 1A or 1B may be represented by one selected from Formulae 1A(1) to 1A(3), and 1B(1) to 1B(5):

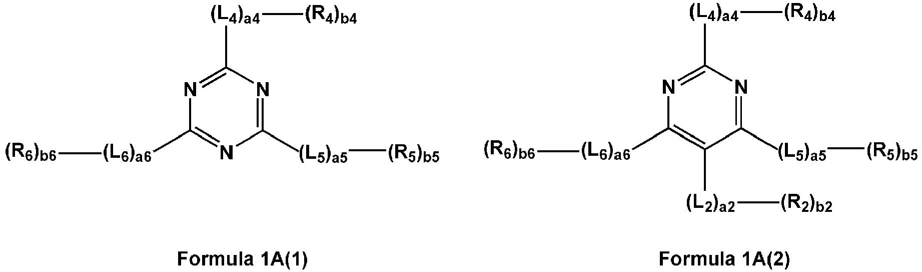

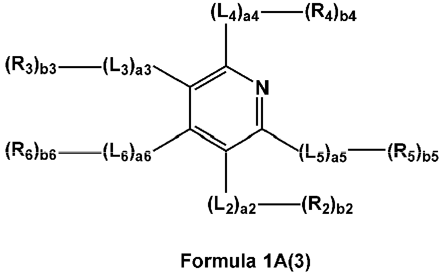

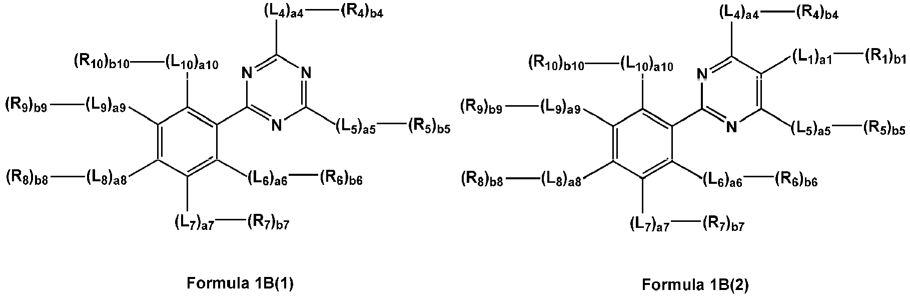

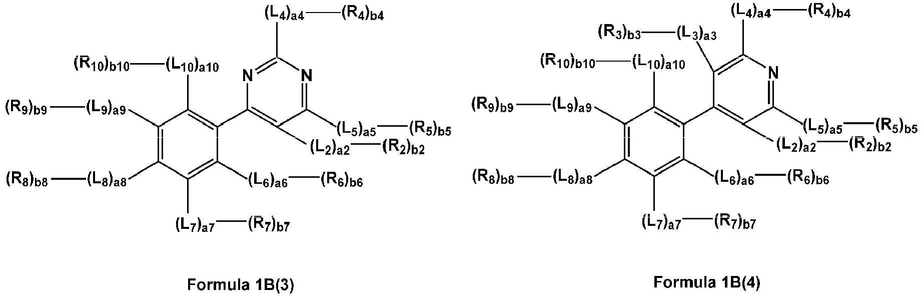

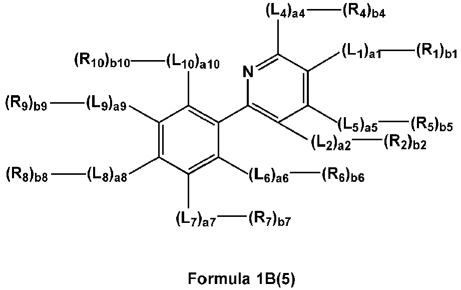

In Formulae 1A(1) to 1A(3), and 1B(1) to 1B(5), L₁ to L₁₀, a1 to a10, R₁ to R₁₀, and b1 to b10 may each independently be the same as described herein in connection with Formulae 1A or 1B.

In one or more embodiments, the first compound represented by one selected from Formulae 1A or 1B may be selected from Compounds 1-1 to 1-329:

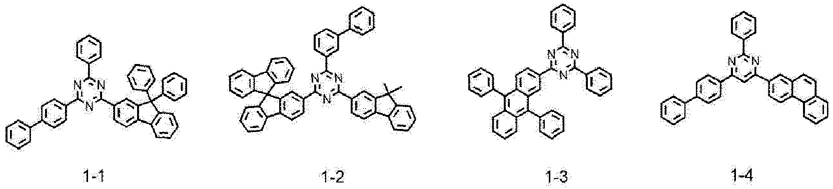

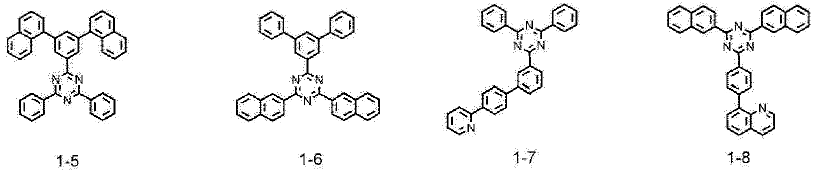

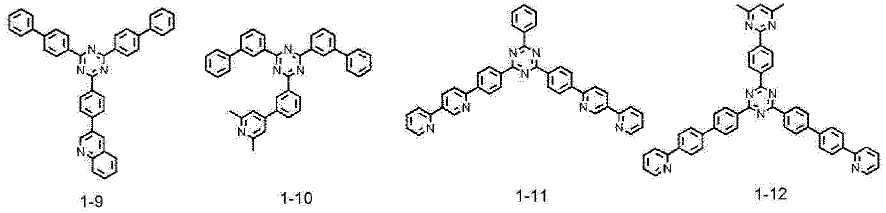

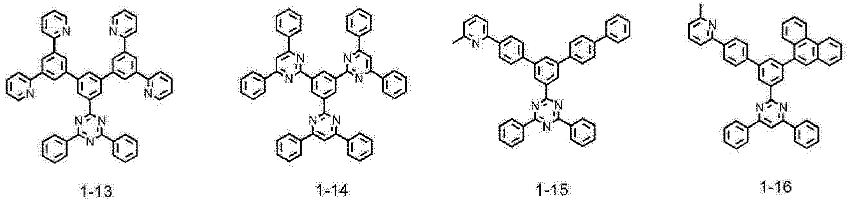

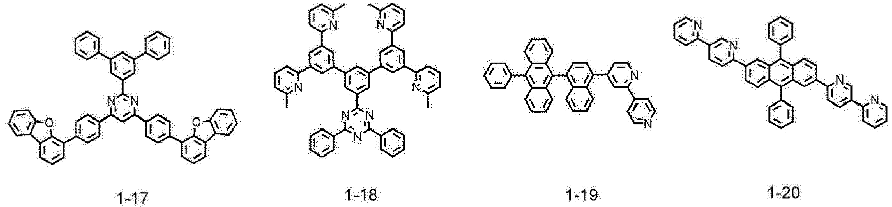

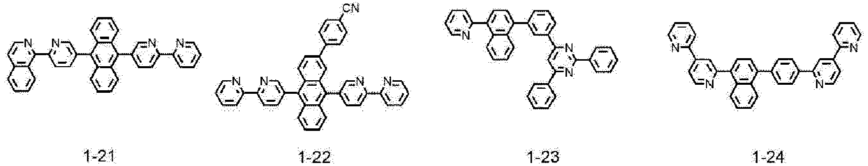

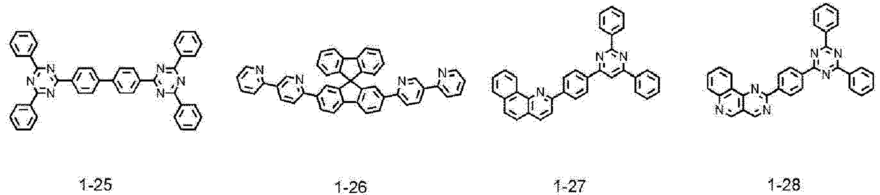

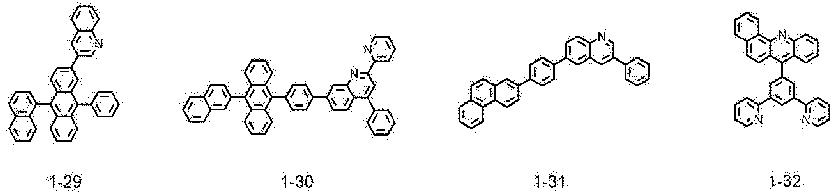

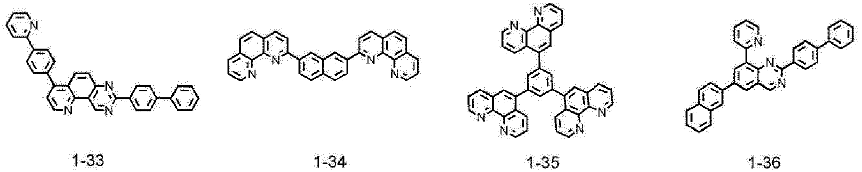

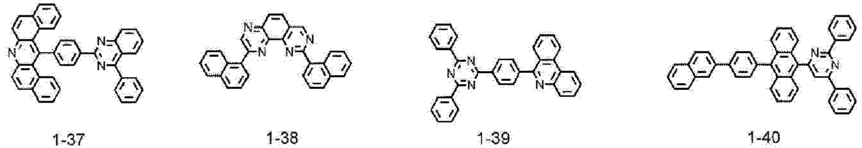

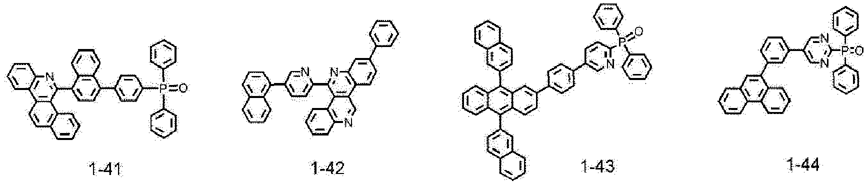

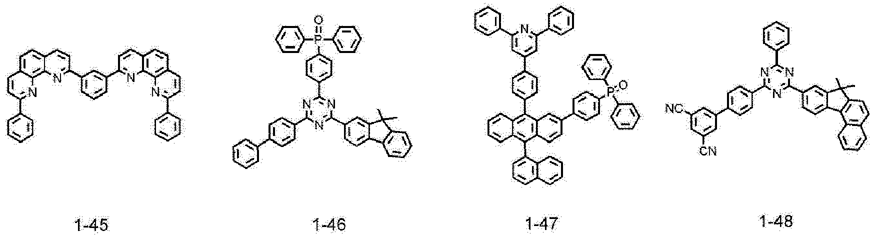

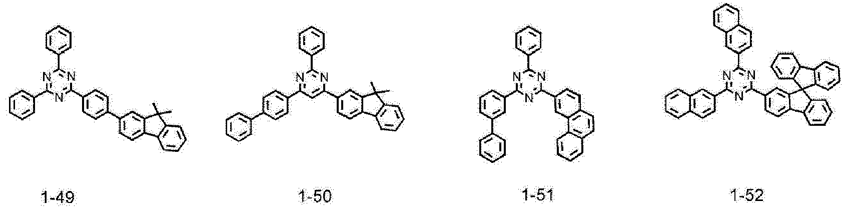

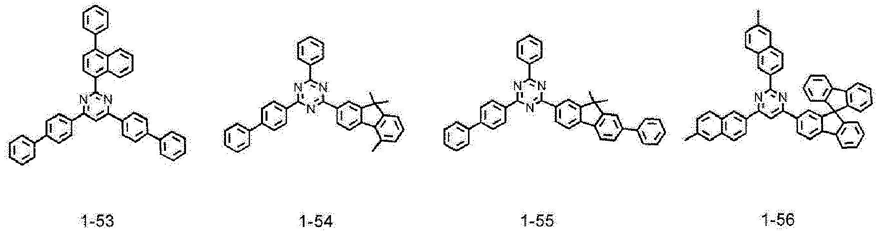

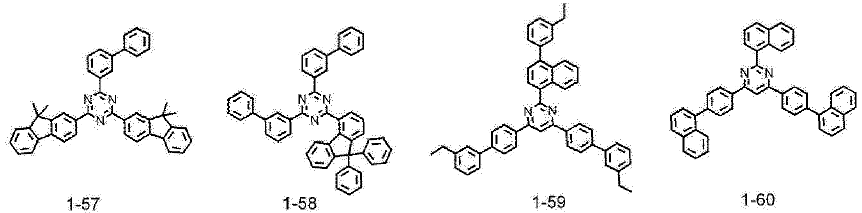

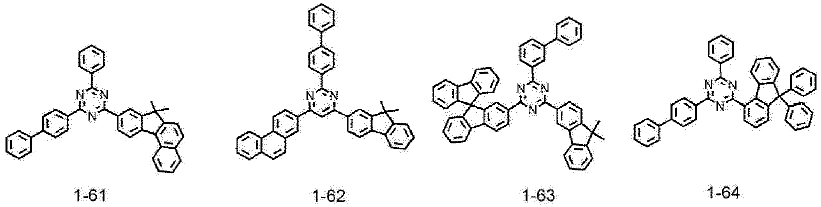

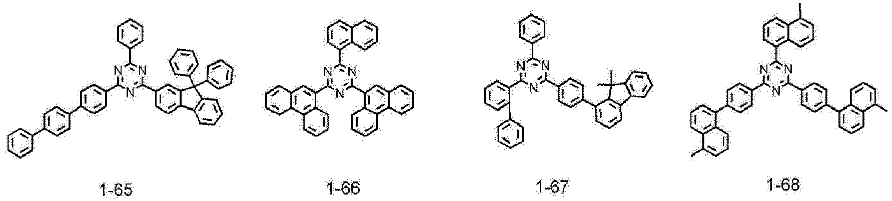

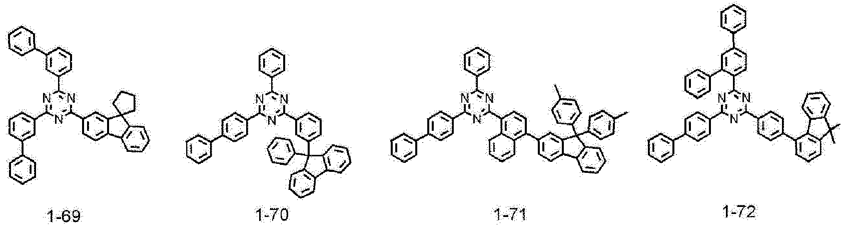

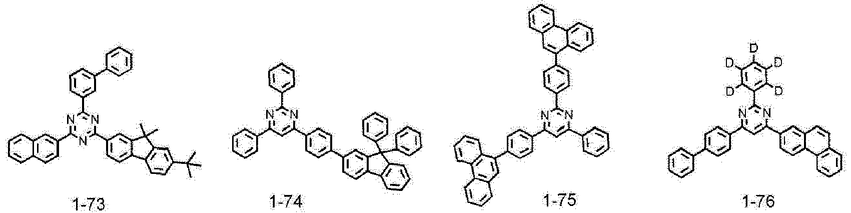

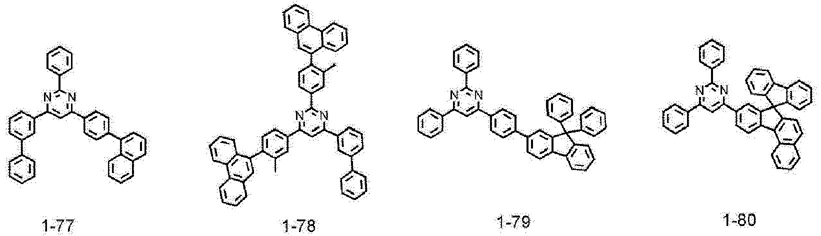

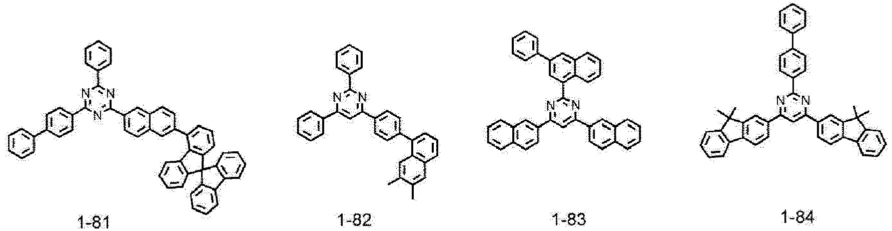

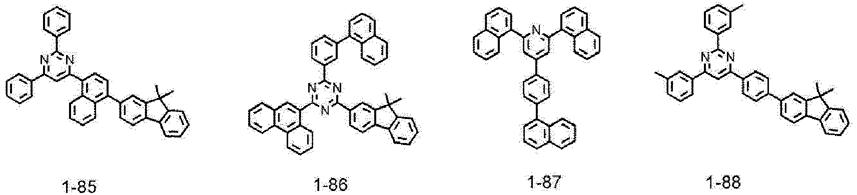

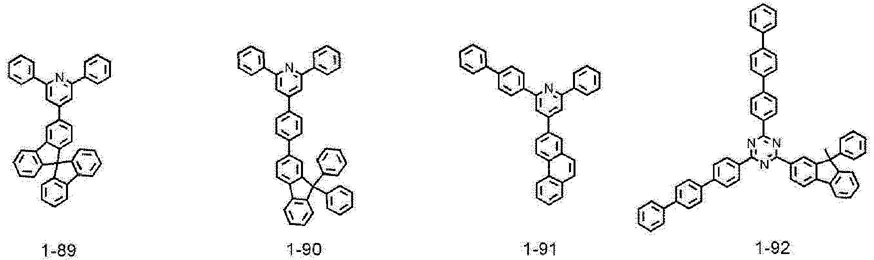

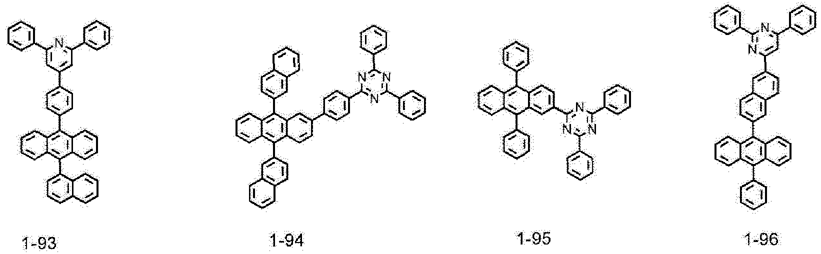

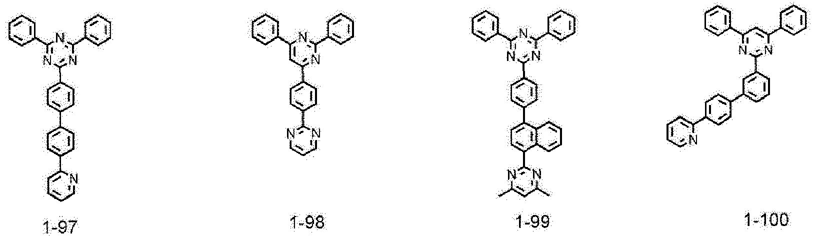

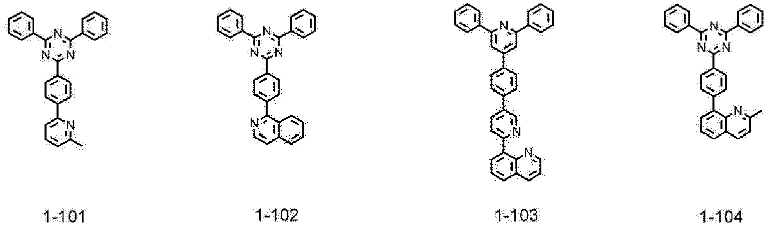

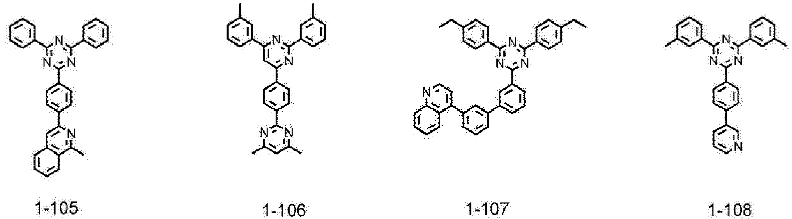

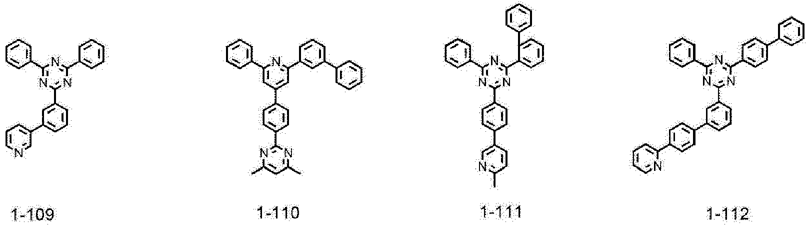

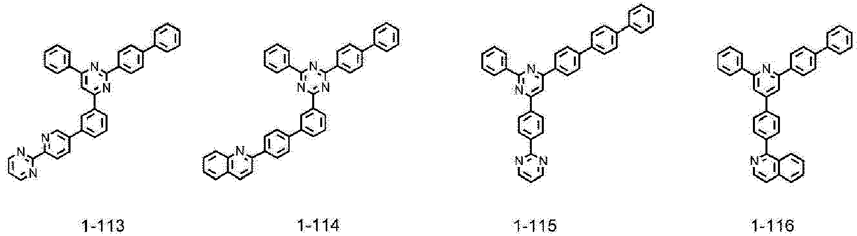

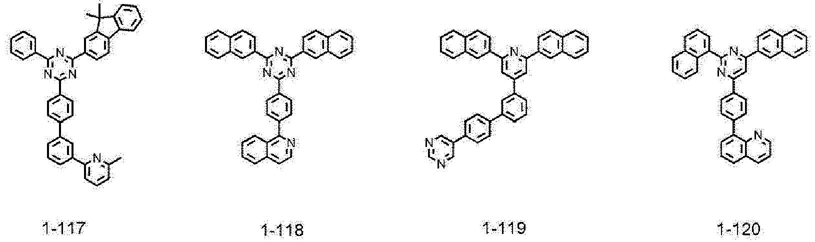

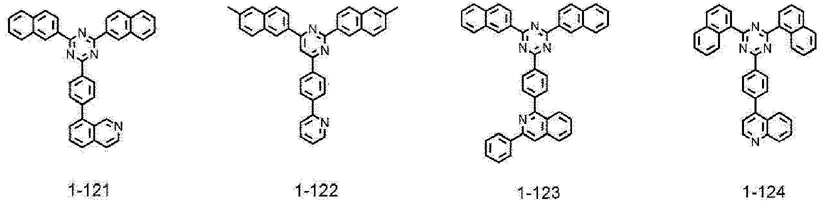

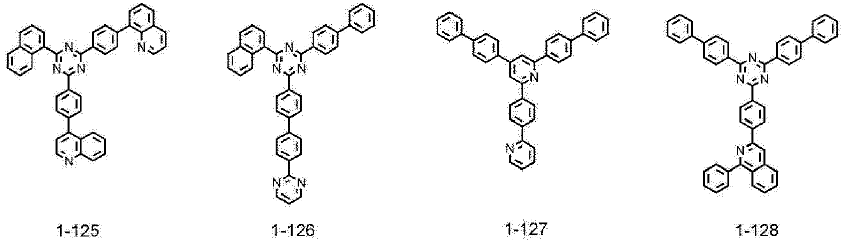

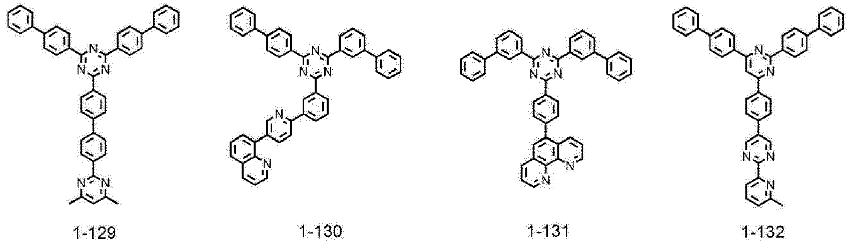

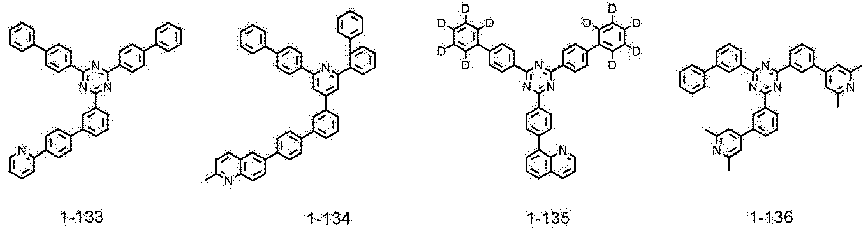

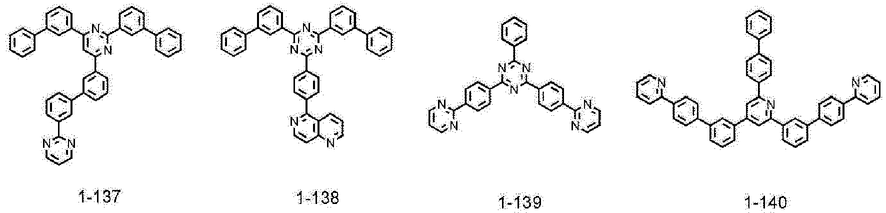

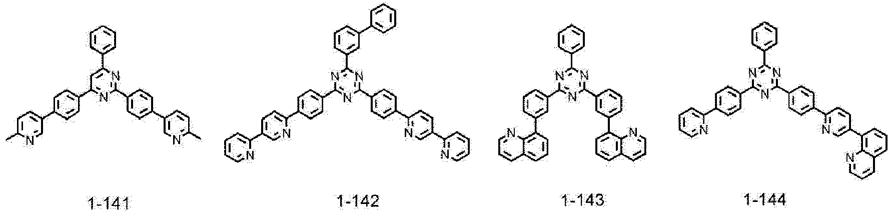

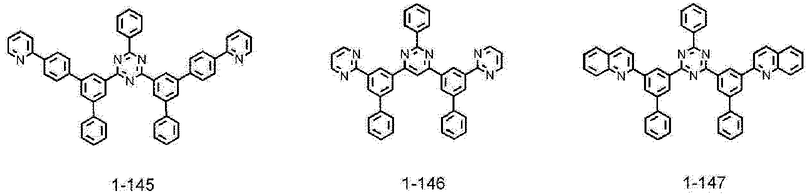

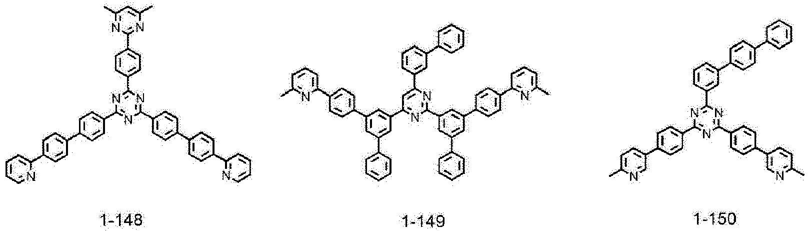

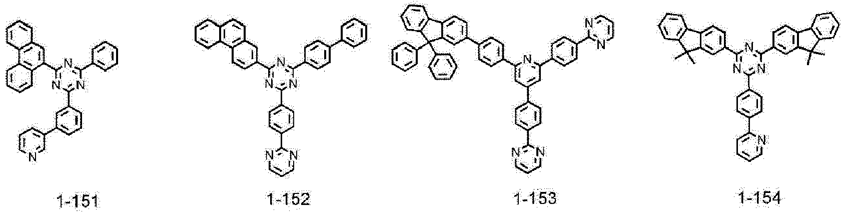

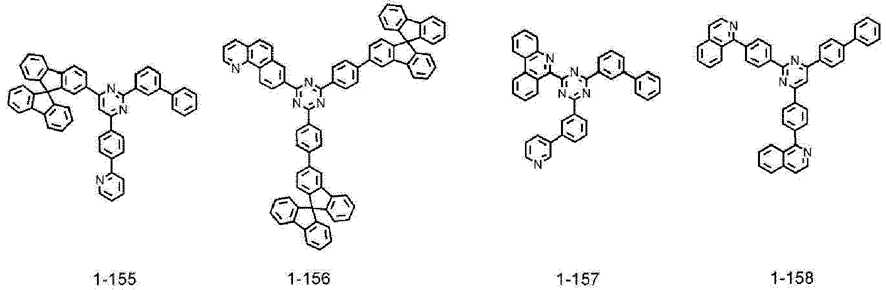

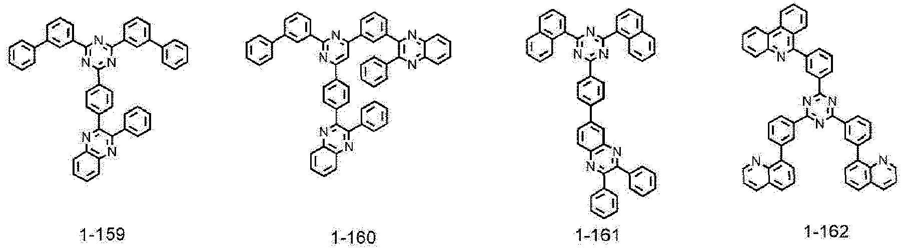

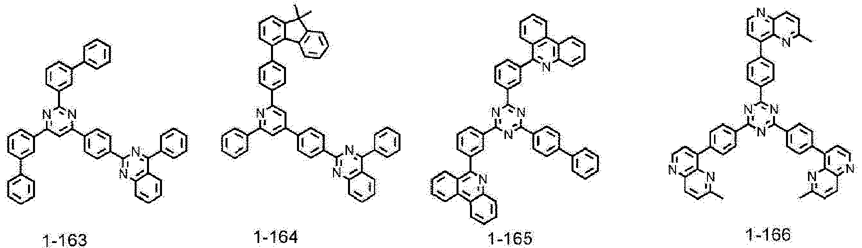

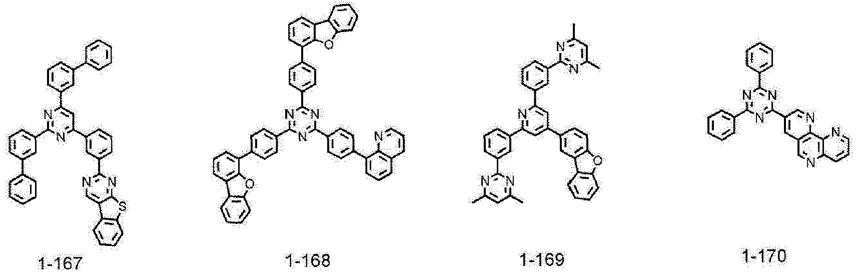

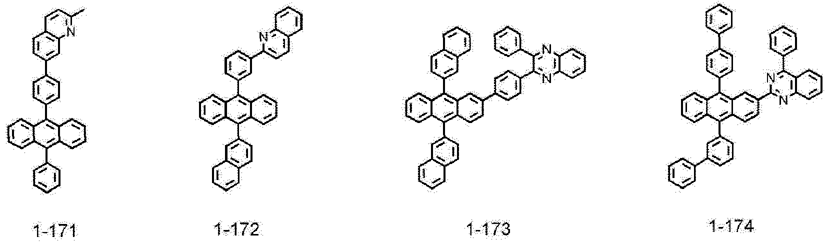

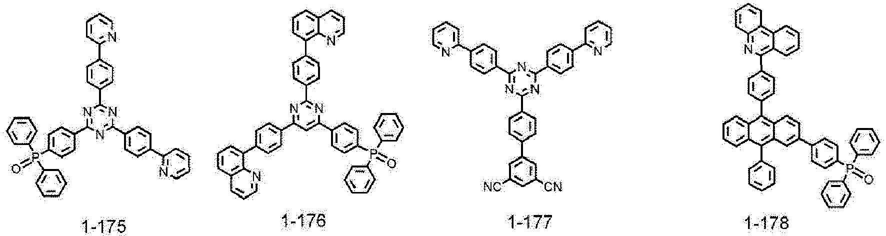

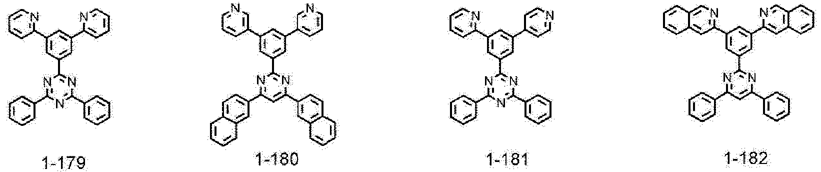

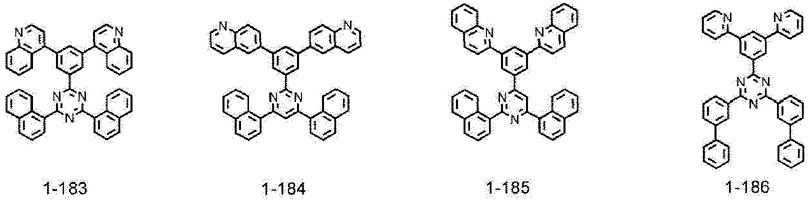

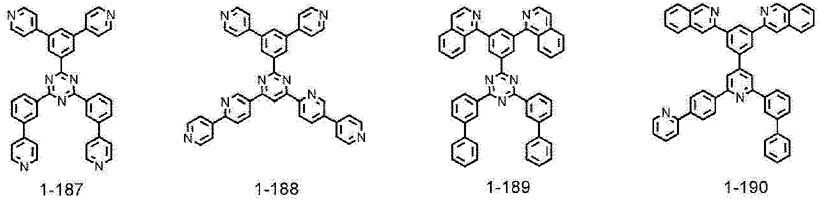

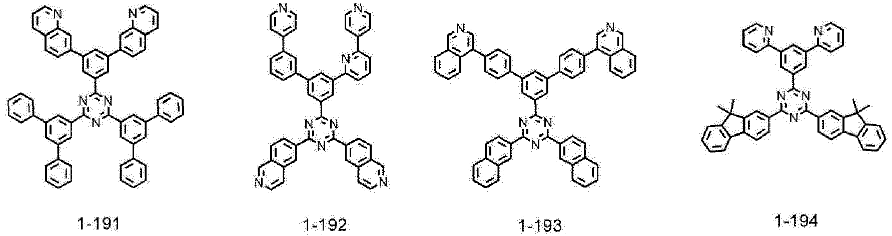

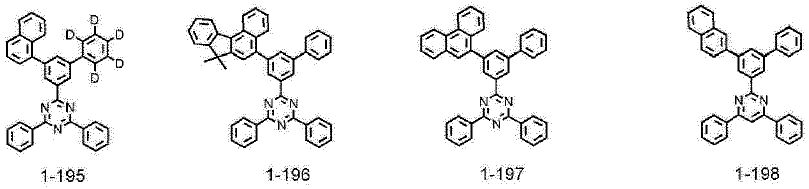

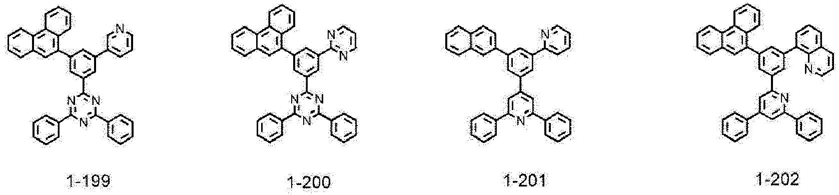

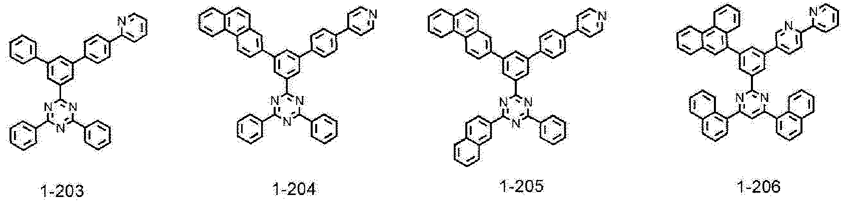

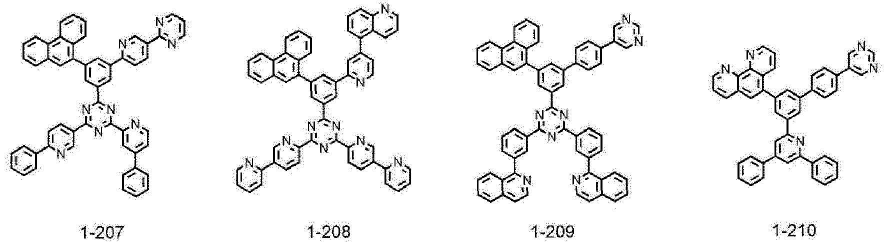

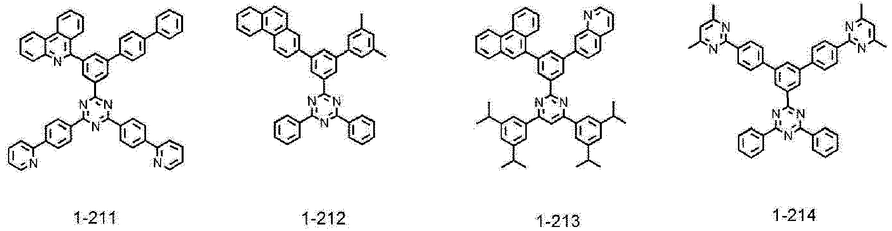

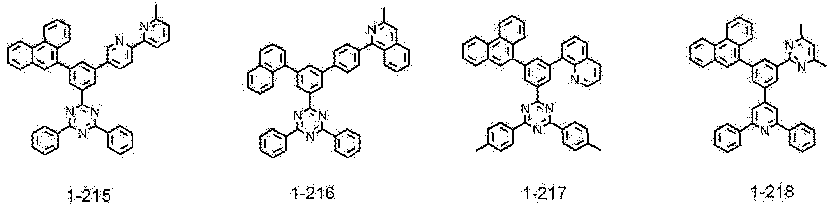

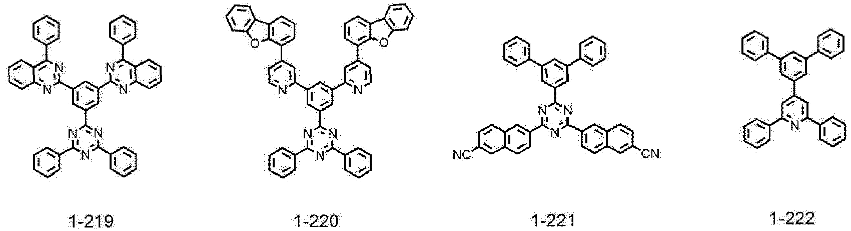

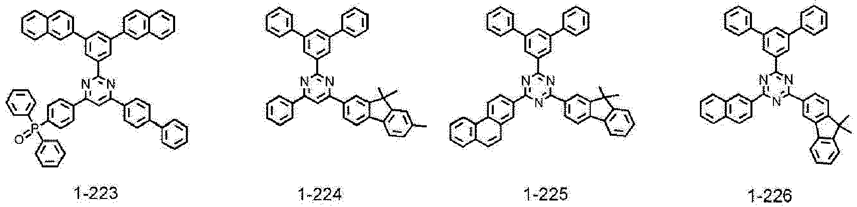

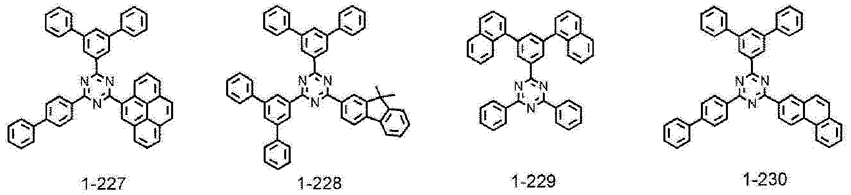

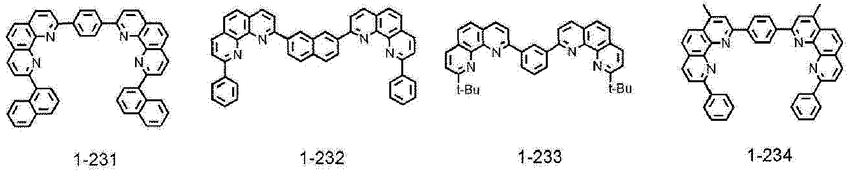

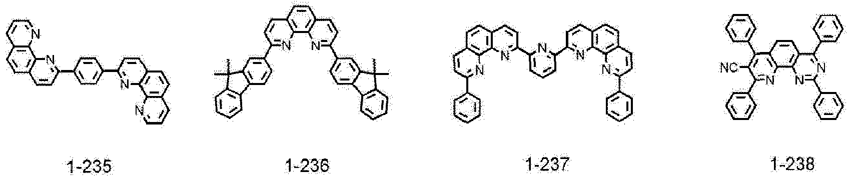

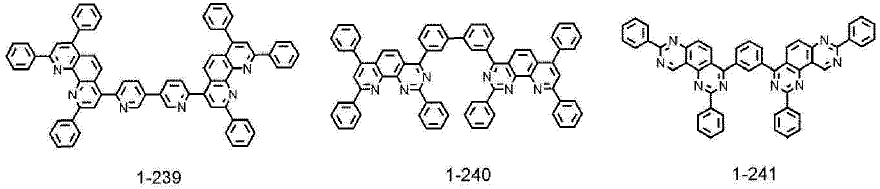

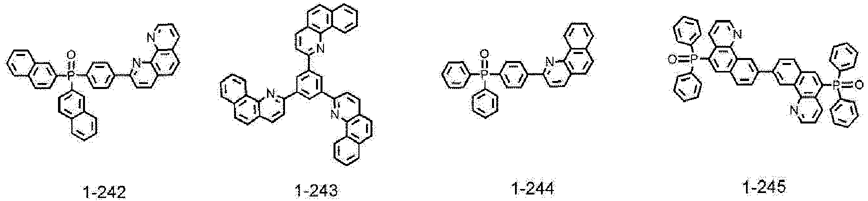

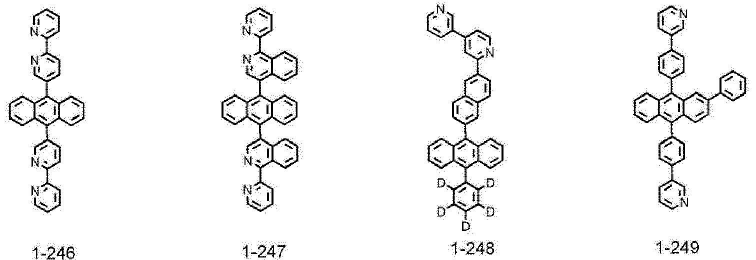

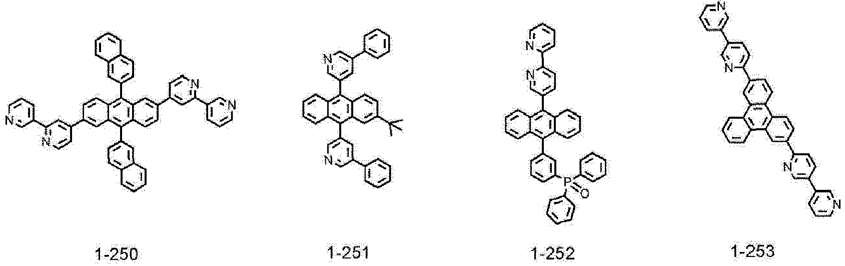

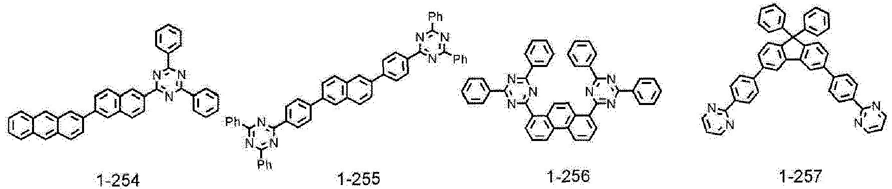

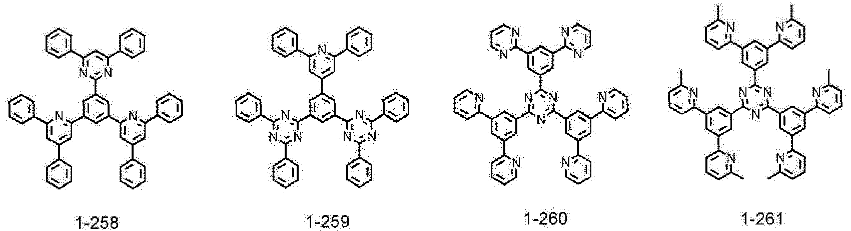

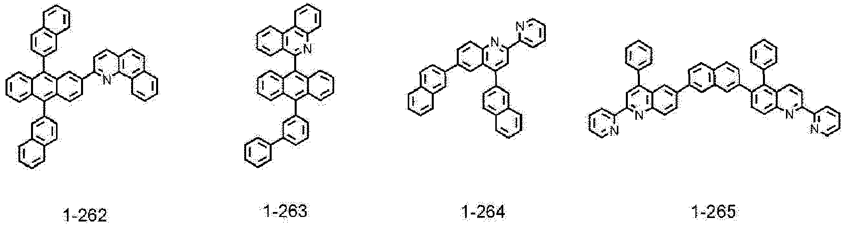

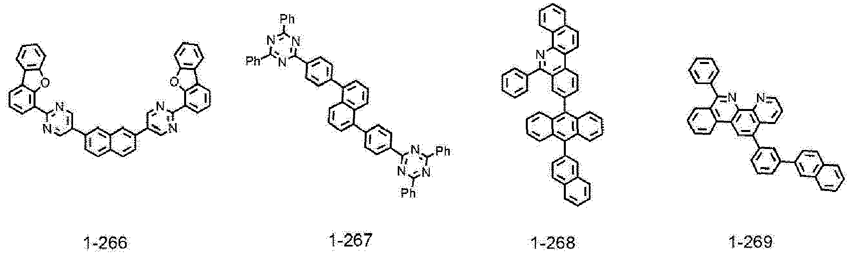

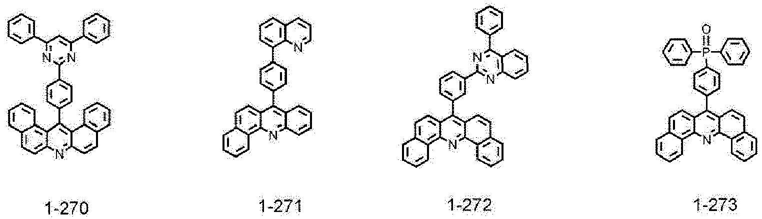

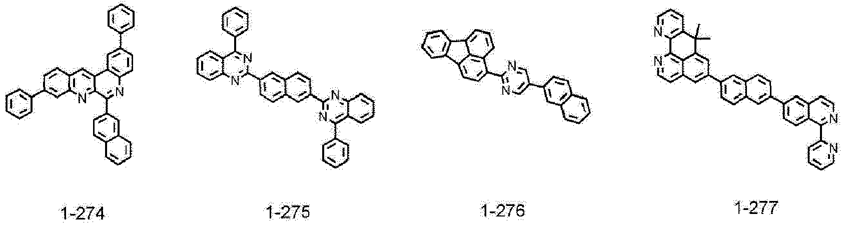

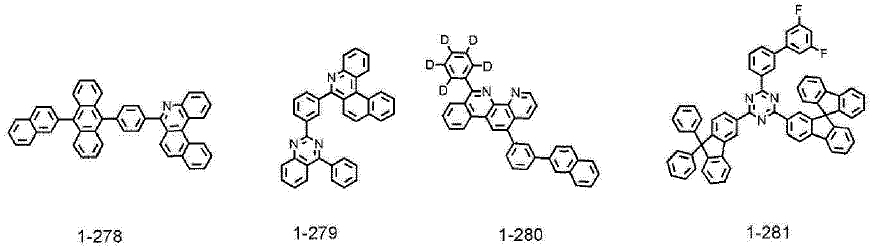

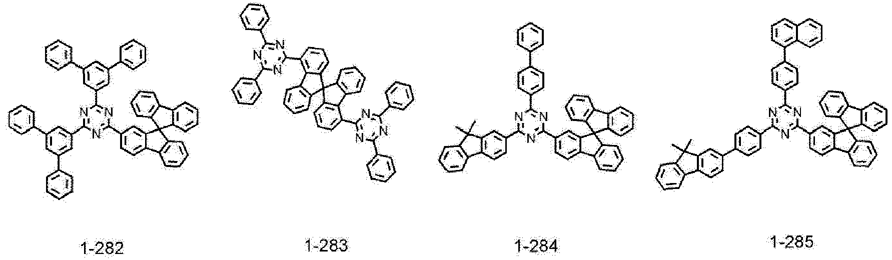

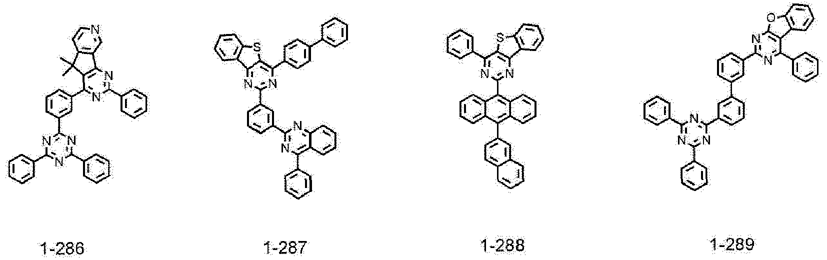

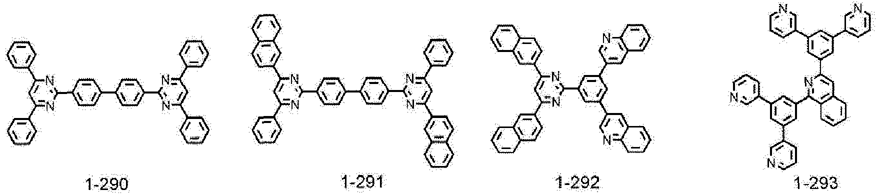

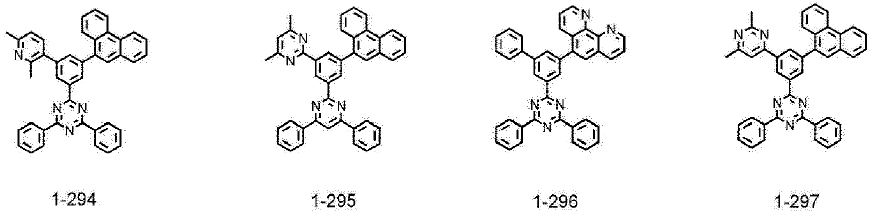

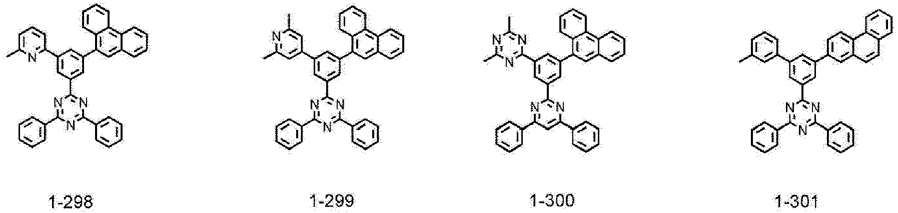

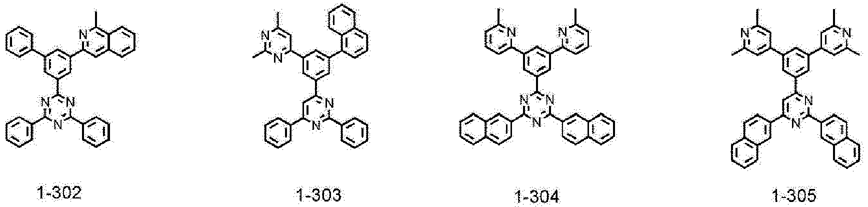

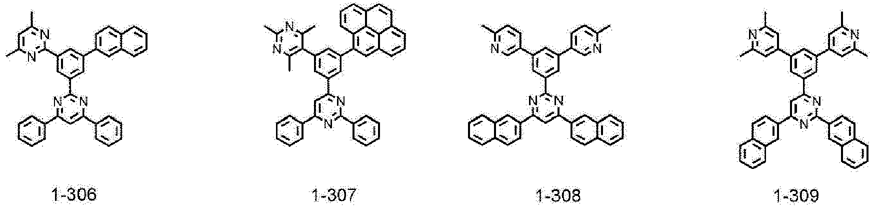

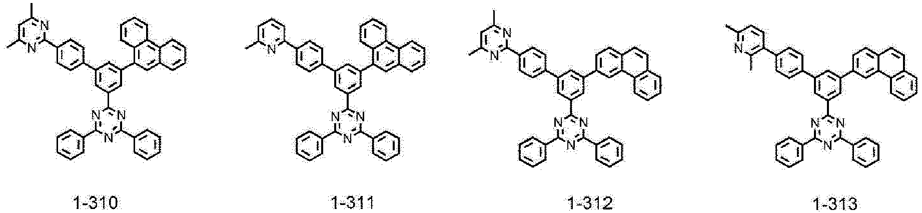

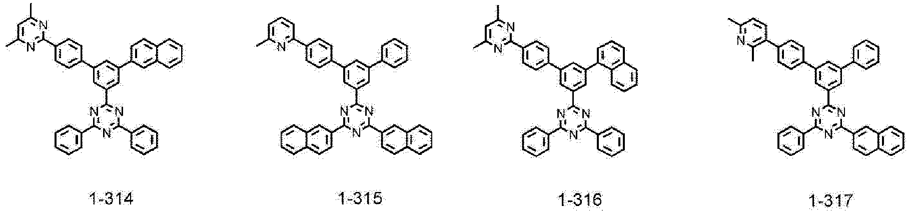

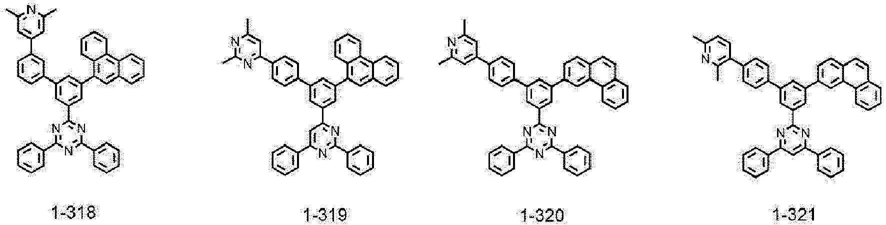

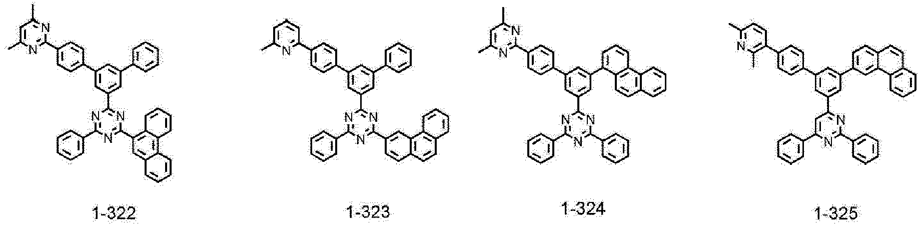

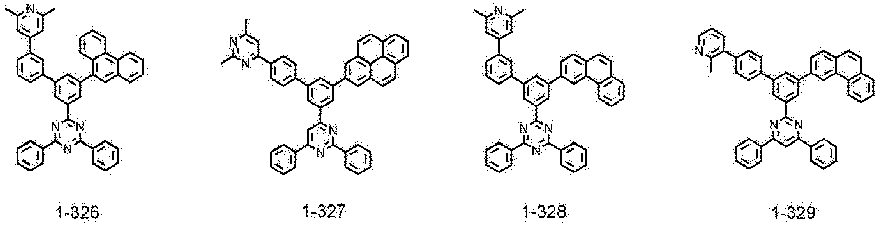

In one or more embodiments, the second compound represented by Formula 2A or 2B may be selected from the following compounds, but embodiments of the present disclosure are not limited thereto:

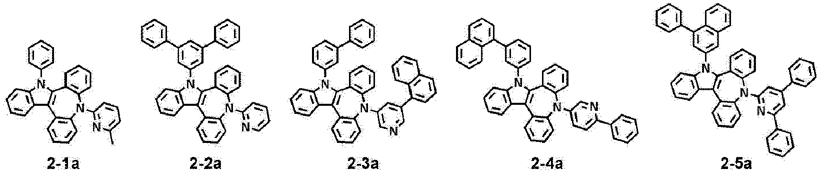

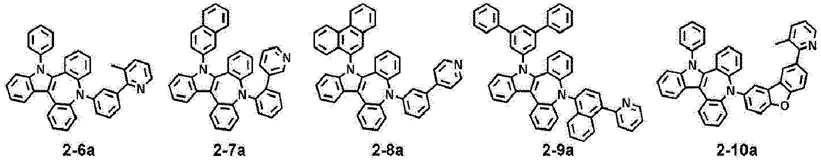

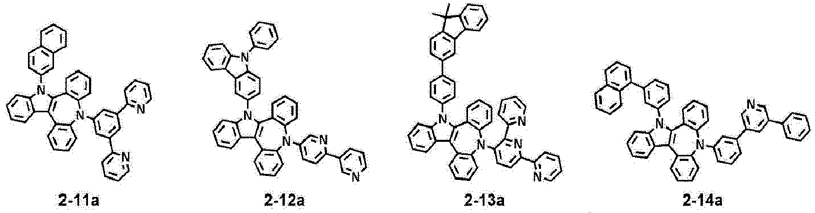

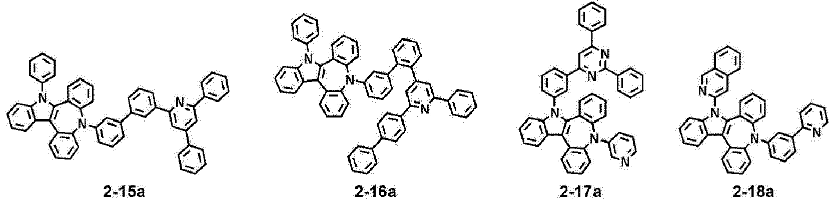

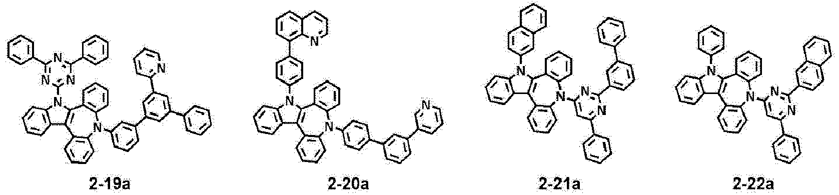

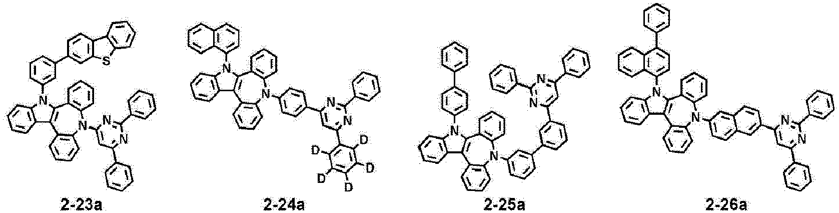

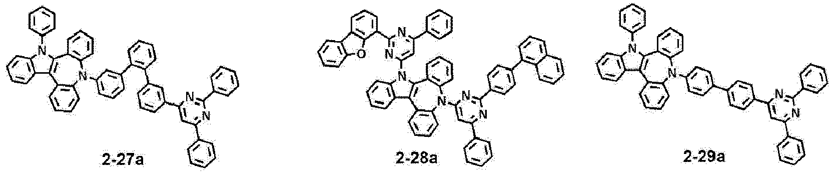

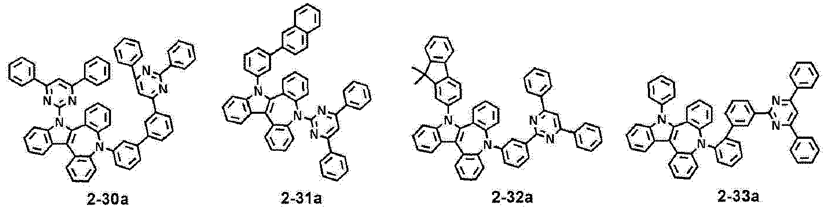

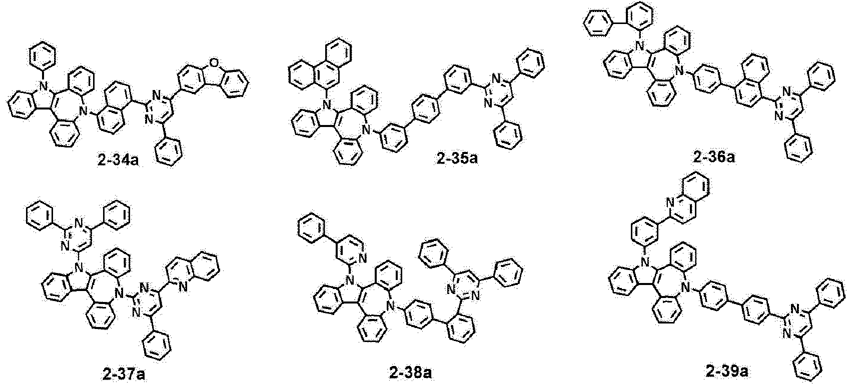

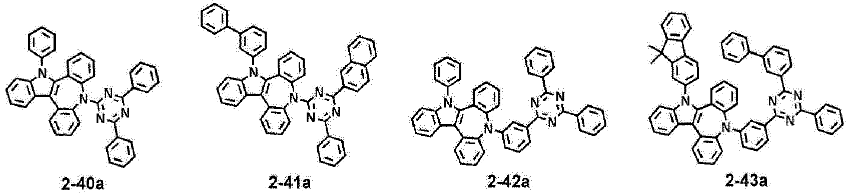

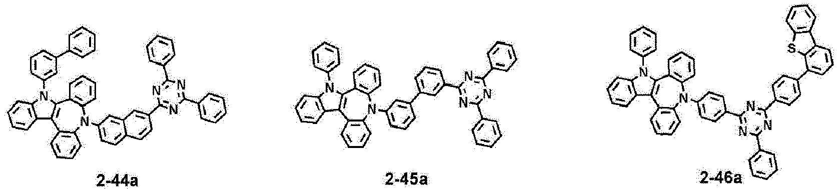

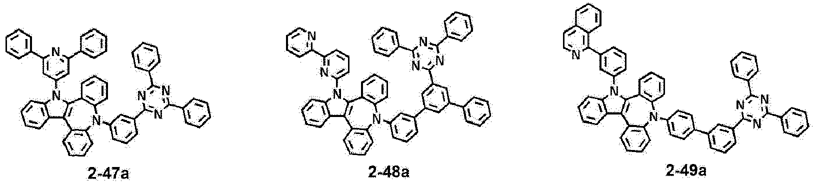

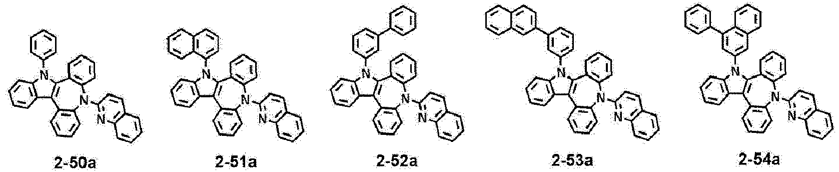

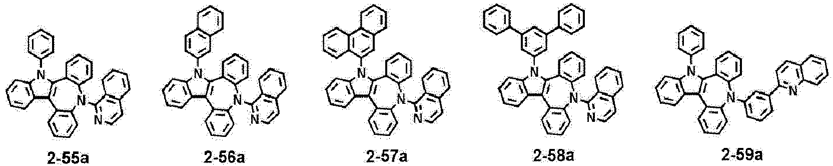

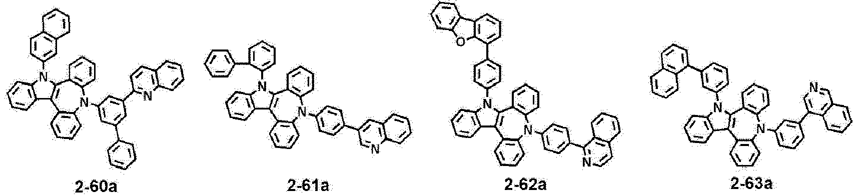

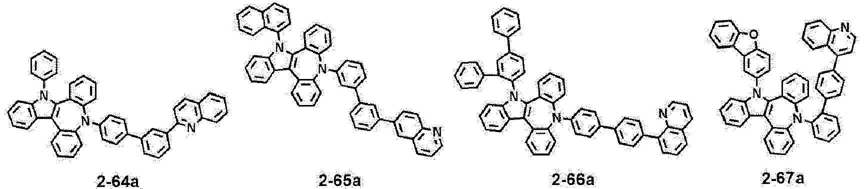

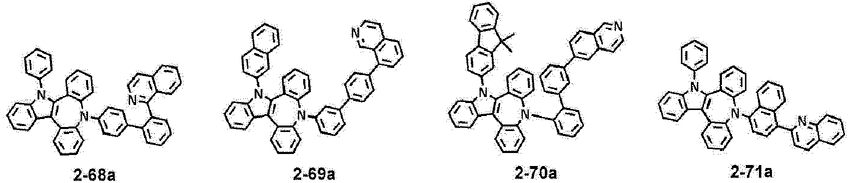

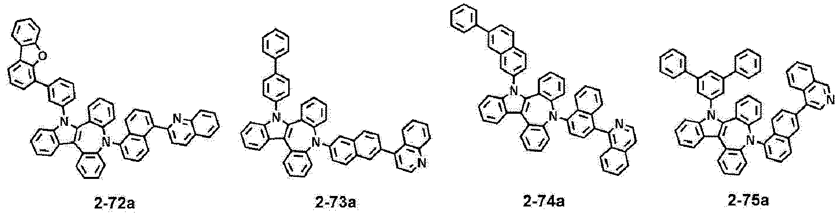

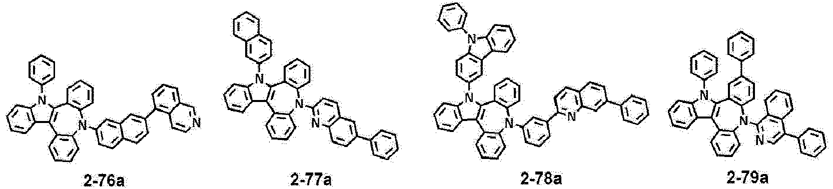

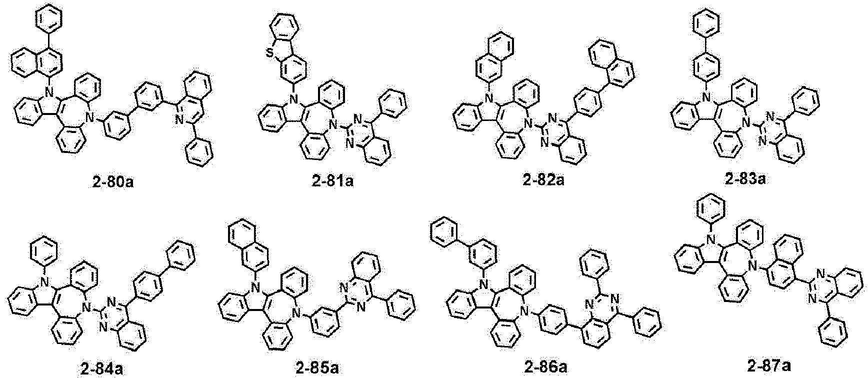

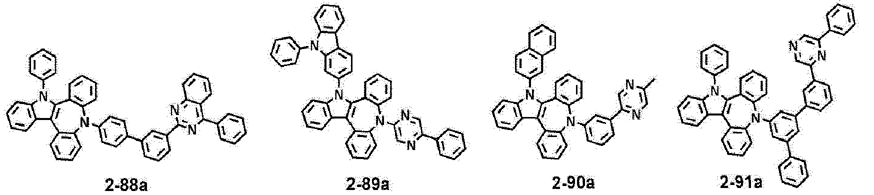

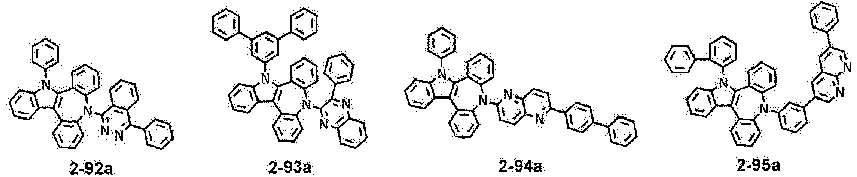

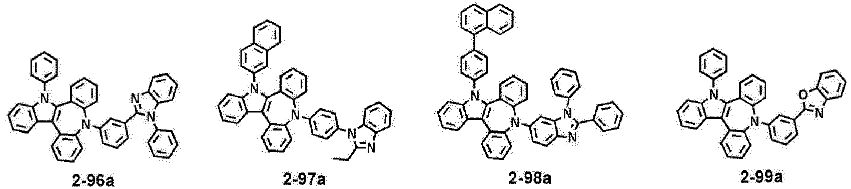

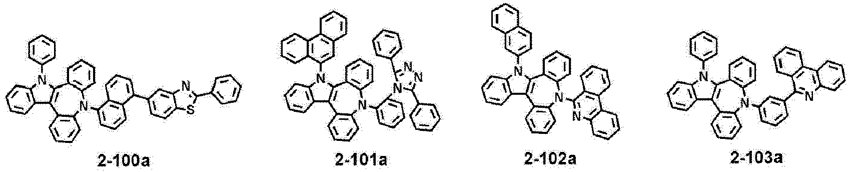

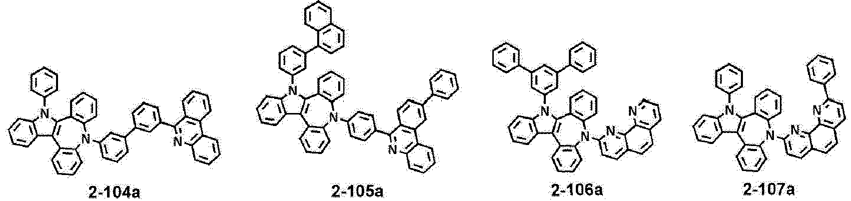

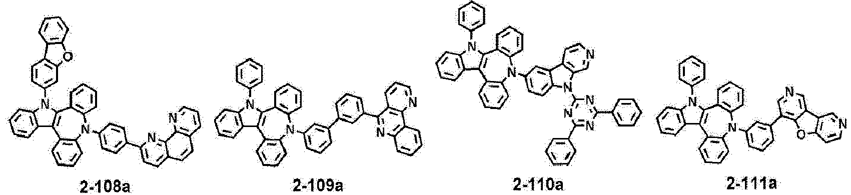

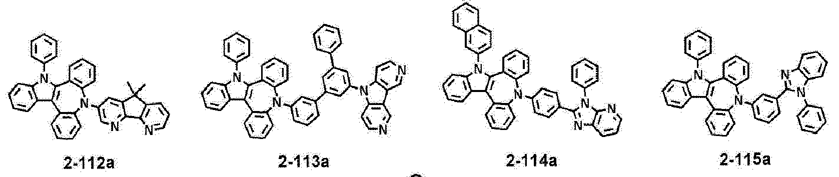

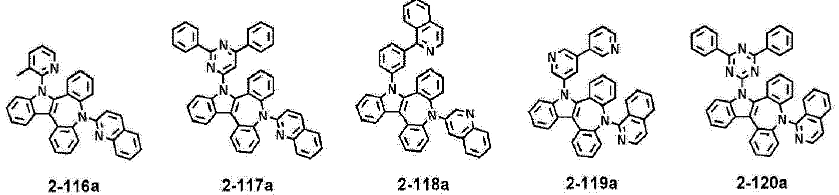

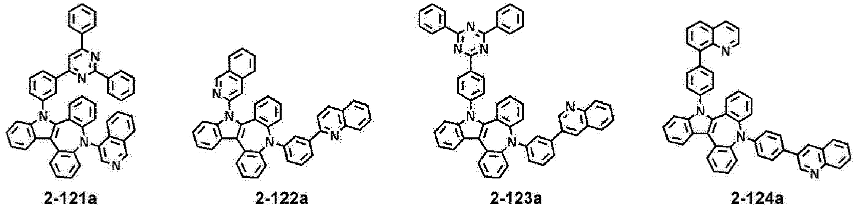

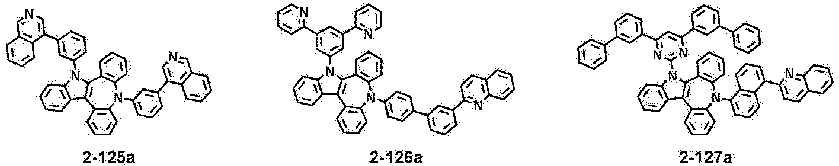

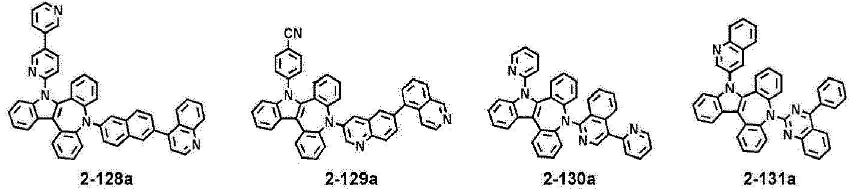

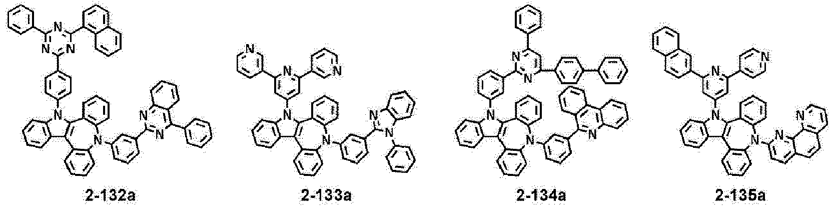

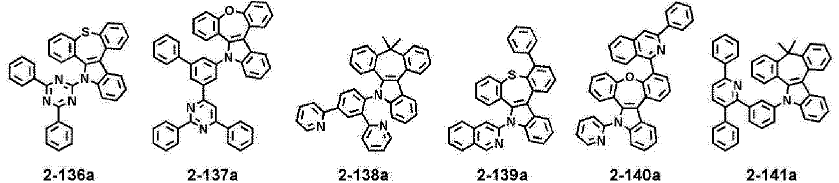

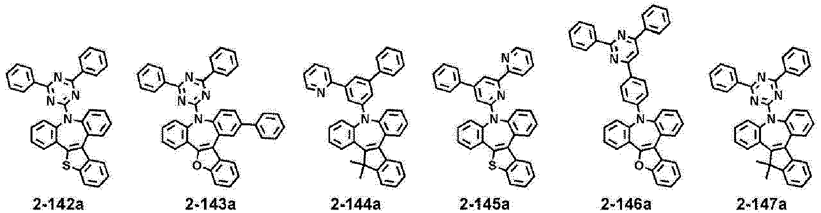

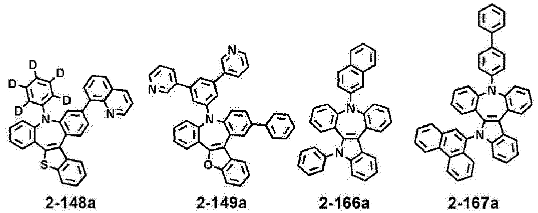

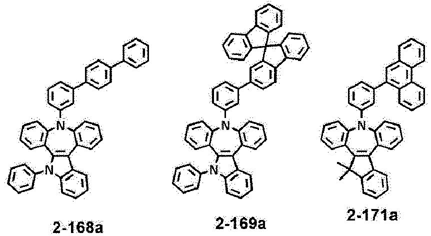

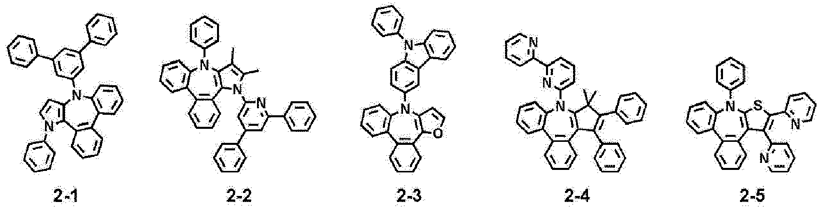

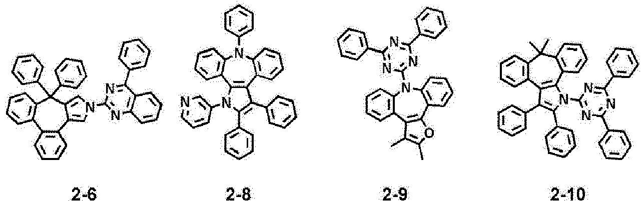

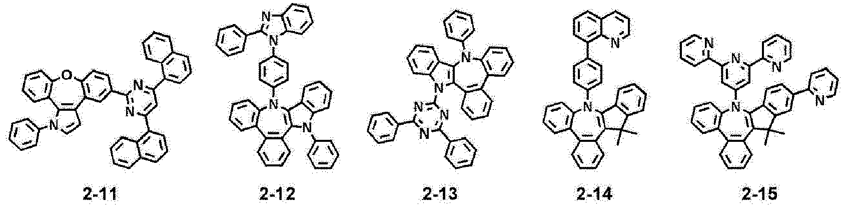

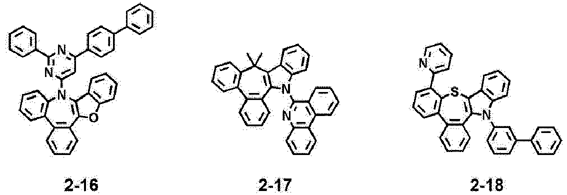

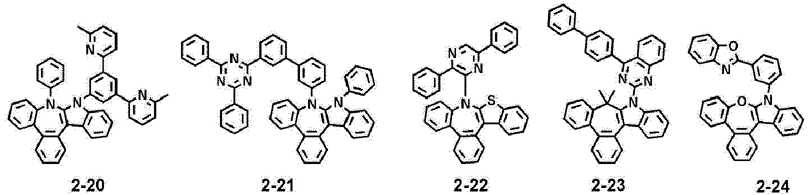

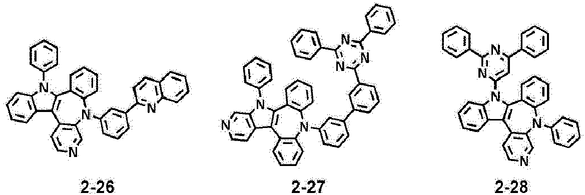

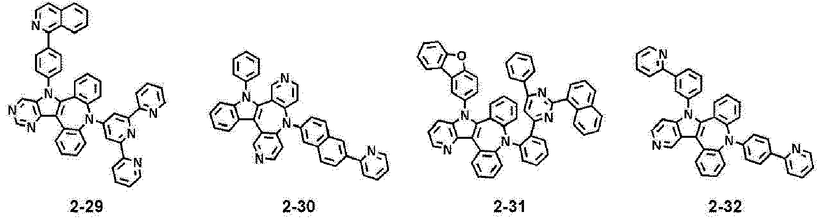

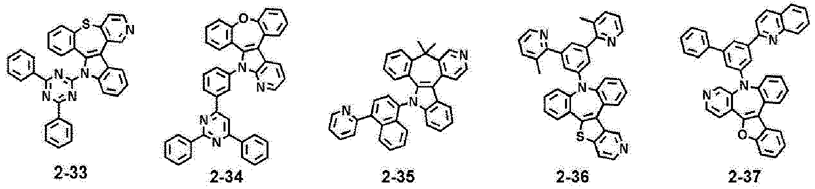

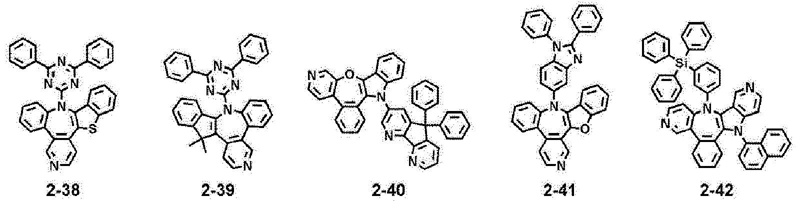

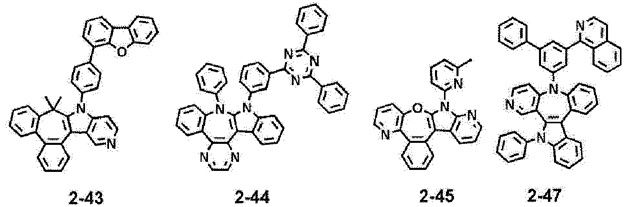

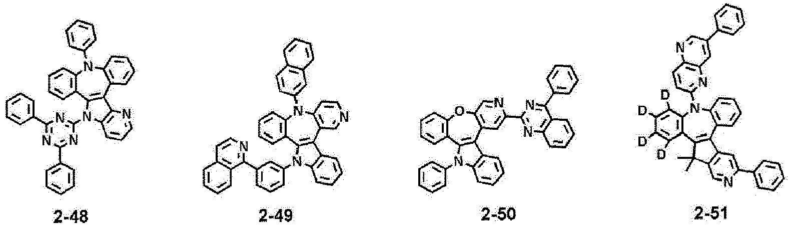

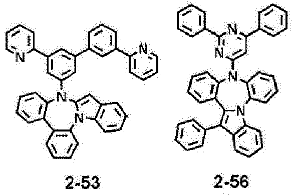

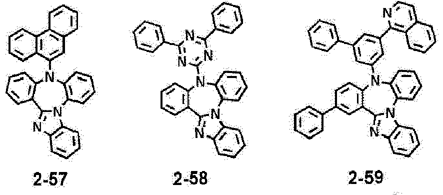

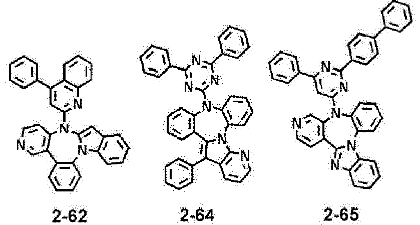

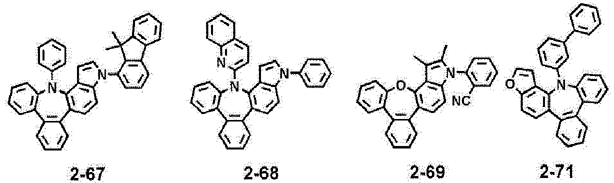

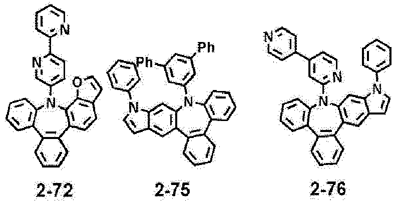

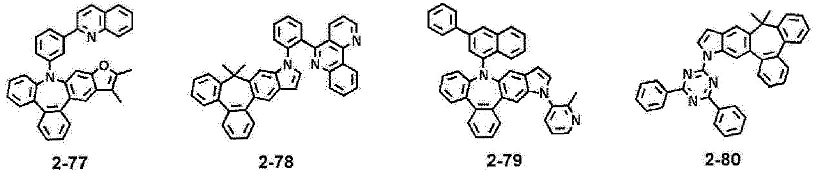

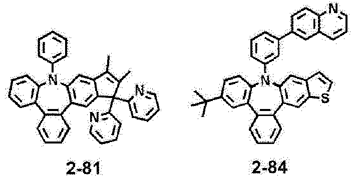

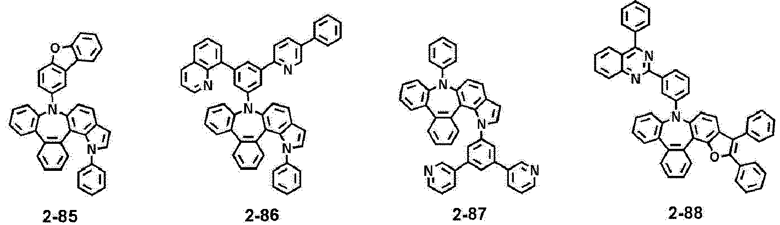

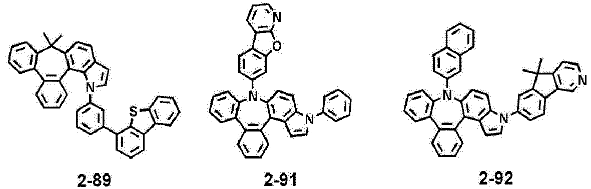

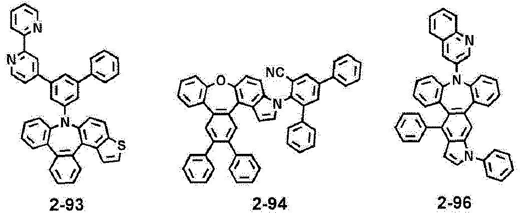

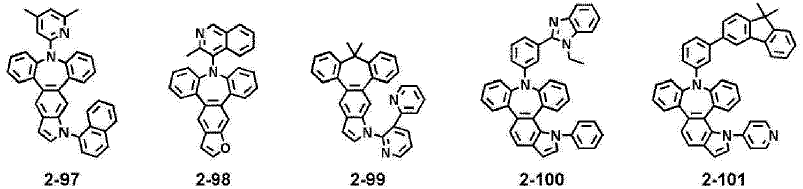

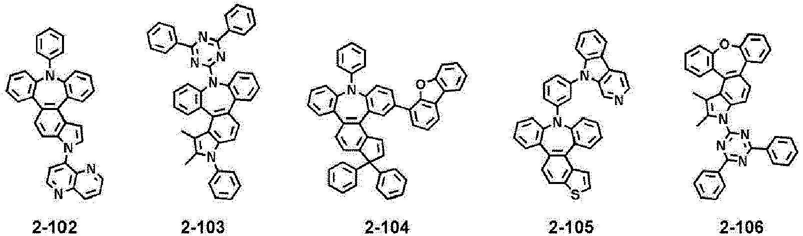

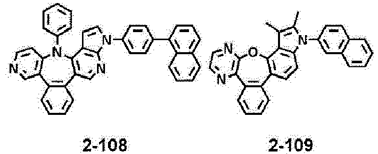

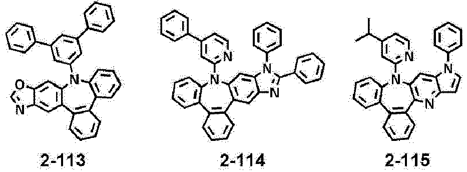

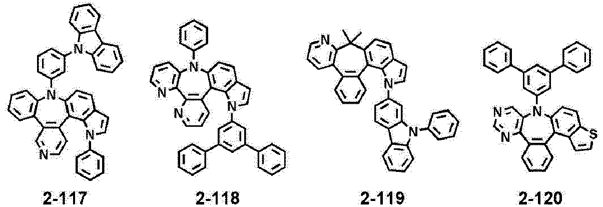

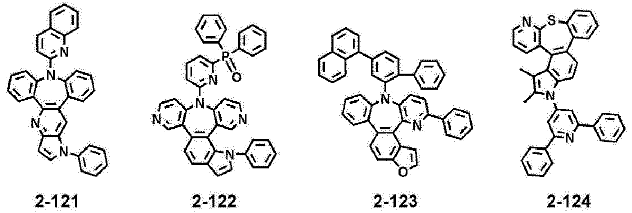

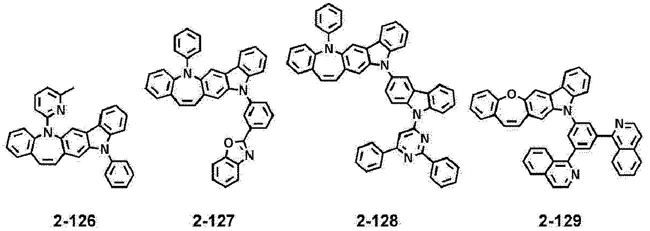

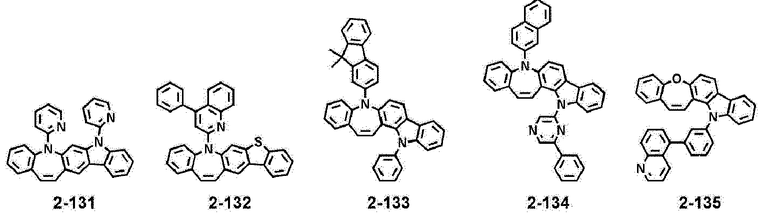

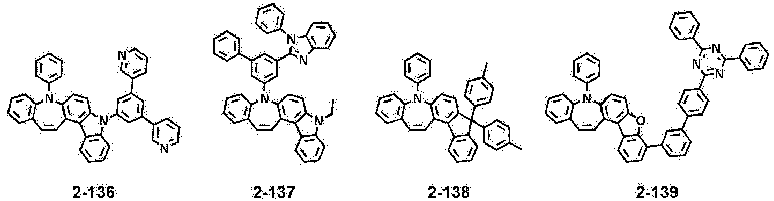

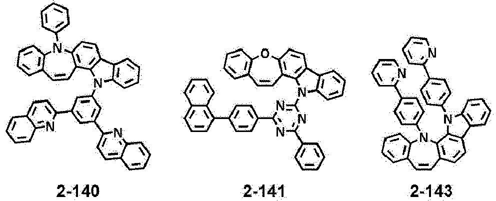

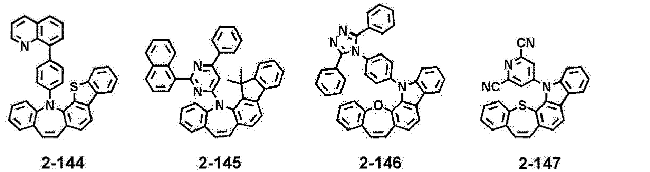

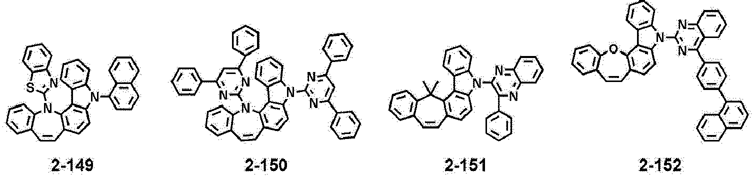

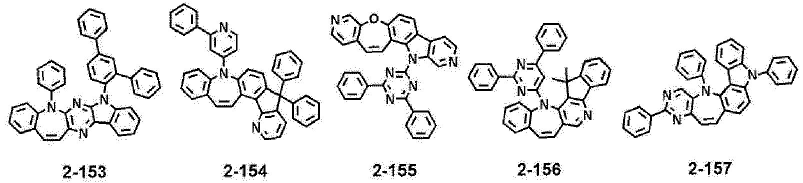

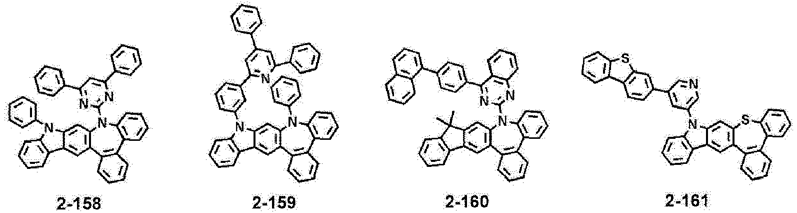

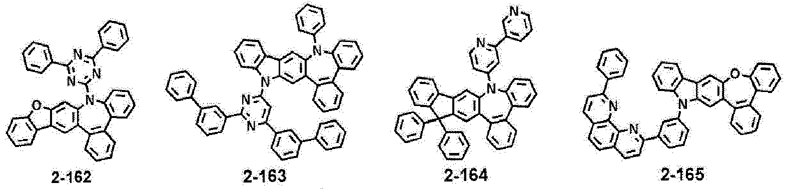

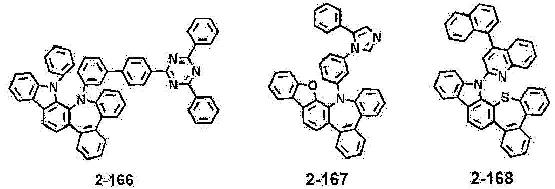

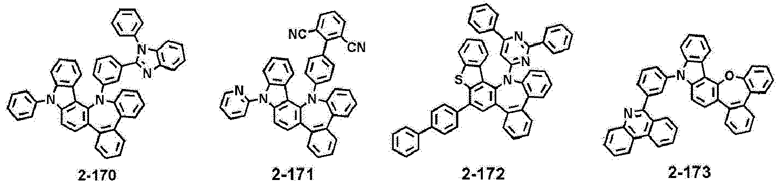

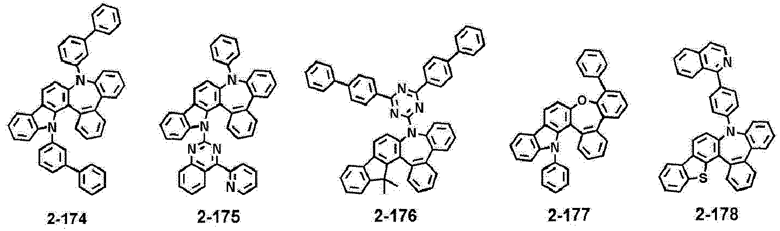

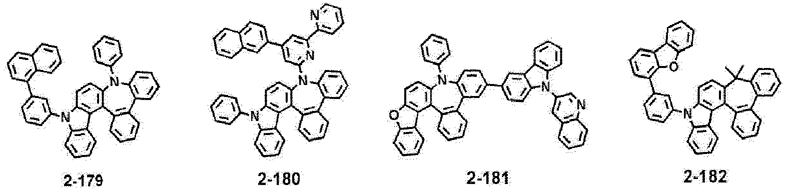

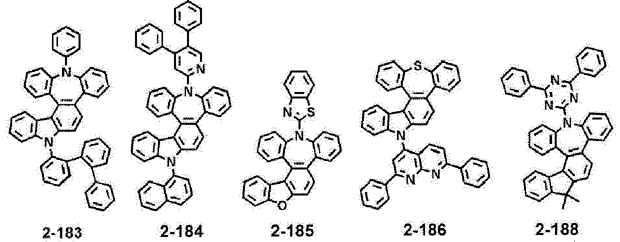

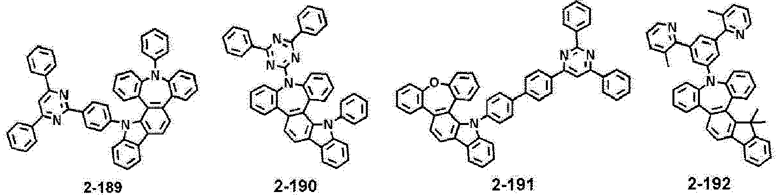

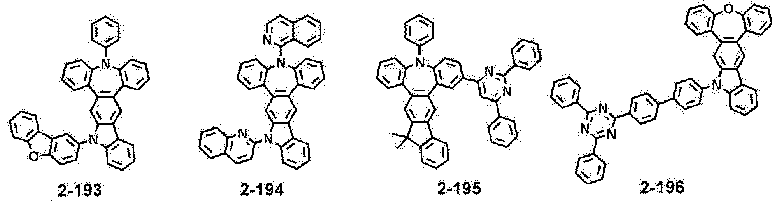

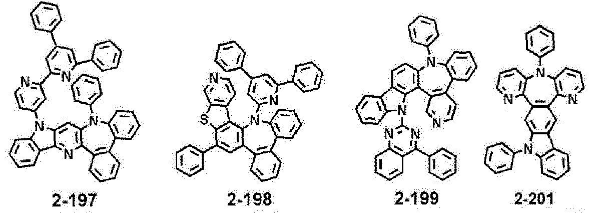

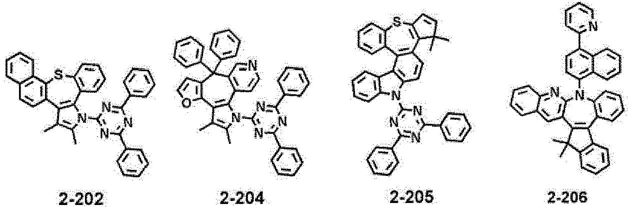

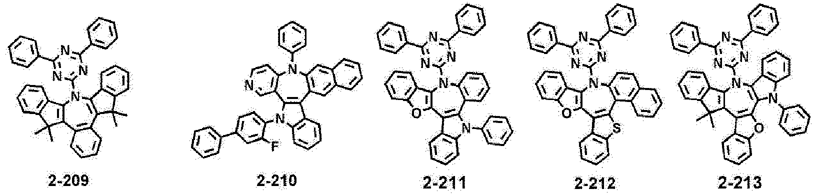

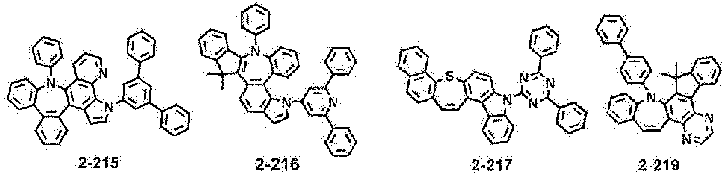

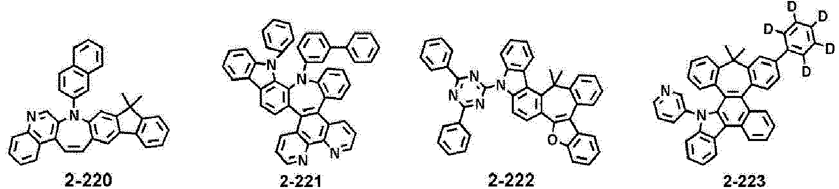

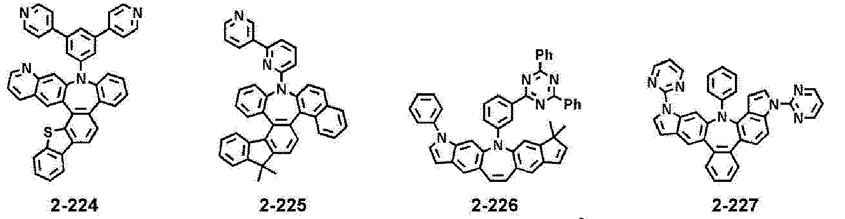

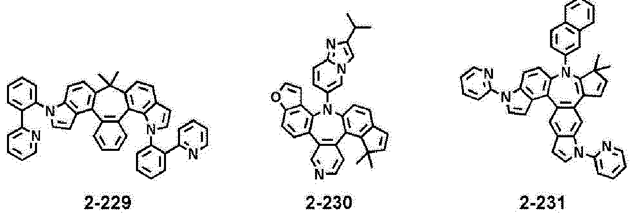

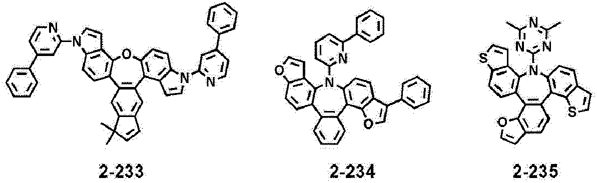

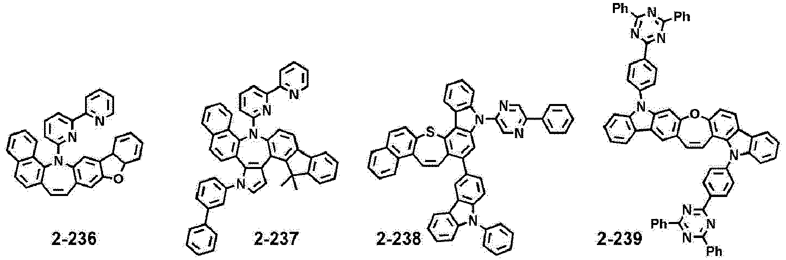

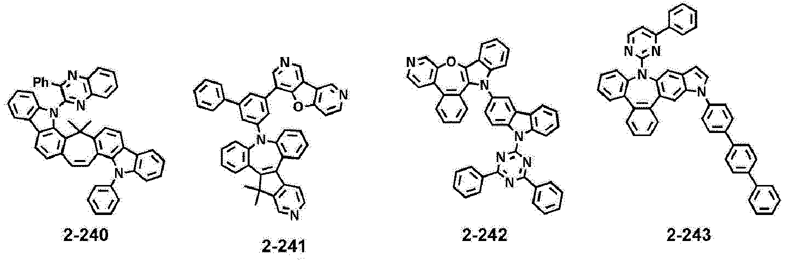

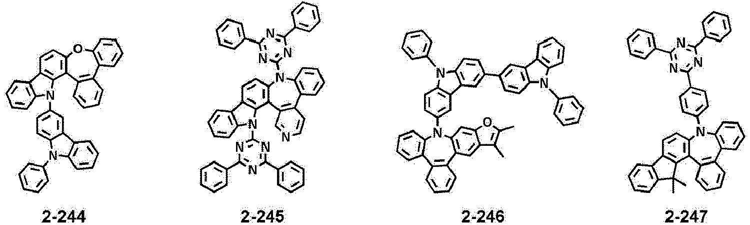

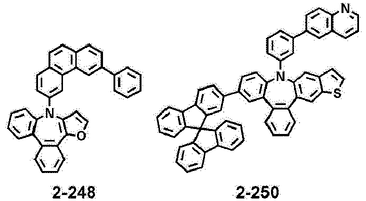

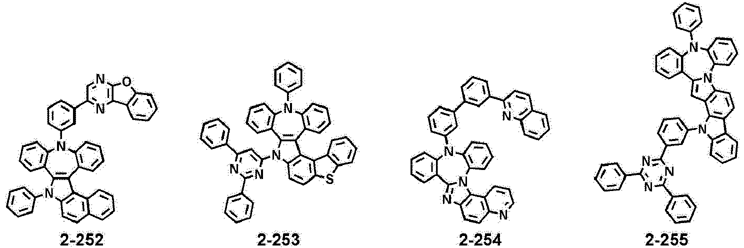

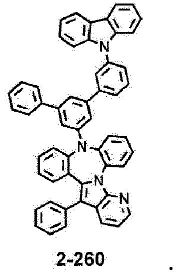

In Formulae 1A or 1B, any suitable combinations of ring A₁, ring A₂, L₁ to L₁₀, a1 to a10, R₁ to R₁₀, and b1 to b10 may be used within the scopes described herein.

In Formulae 2A and 2B, any suitable combinations of ring A₂₁, ring A₂₂, ring A₂₃, X₂₁, and T₁₁ to T₁₄ may be used within the scopes described herein.

Regarding ^{∗}-[(L₂₂)ₐ₂₂-(R₂₂)_{b22}]_{,} C(R₂₃)(R₂₄), Si(R₂₃)(R₂₄), and N-[(L₂₁)ₐ₂₁-(R₂₁)_{b21}], any suitable combinations of L₂₁, L₂₂, a21, a22, R₂₁ to R₂₄, b21, and b22 may be used within the scopes described herein.

In one or more embodiments, the hole transport region may comprise an emission auxiliary layer. The emission auxiliary layer may directly contact the emission layer, and the second compound represented by Formula 2A or 2B may be comprised in the emission auxiliary layer.

In one or more embodiments, the electron transport region may comprise a buffer layer. The buffer layer may directly contact the emission layer, and the second compound represented by Formula 2A or 2B may be comprised in the buffer layer, but embodiments of the present disclosure are not limited thereto.

When both the hole transport region and the electron transport region in the organic light-emitting device comprise the second compound represented by Formula 2A or 2B as described above, the second compound comprised in the hole transport region and the second compound comprised in the electron transport region may be identical to or different from each other.

The electron transport region may comprise an electron transport layer, and the first compound represented by one selected from Formulae 1A or 1B may be comprised in the electron transport layer.

In one or more embodiments, the electron transport region may comprise a buffer layer, as well as an electron transport layer between the buffer layer and the second electrode. The second compound represented by Formula 2A or 2B may be comprised in the buffer layer, and the first compound represented by one selected from Formulae 1A or 1B may be comprised in the electron transport layer.

### Description of FIG. 1

FIG. 1 is a schematic view of an organic light-emitting device 10 according to an embodiment of the present disclosure. The organic light-emitting device 10 may comprise a first electrode 110, an organic layer 150, and a second electrode 190.

Hereinafter, the structure of the organic light-emitting device 10 according to an embodiment of the present disclosure and a method of manufacturing the organic light-emitting device 10 will be described in connection with FIG. 1.

### First electrode 110

In FIG. 1, a substrate may be under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing and/or sputtering a material for forming the first electrode 110 on the substrate. When the first electrode 110 is an anode, the material for forming the first electrode may be selected from materials with a high work function in order to facilitate hole injection.

The first electrode 110 may be a reflective electrode, a semi-transmissive electrode, or a transmissive electrode. When the first electrode 110 is a transmissive electrode, the material for forming the first electrode may be selected from indium tin oxide (ITO), indium zinc oxide (IZO), tin oxide (SnO₂), zinc oxide (ZnO), and combinations thereof, but embodiments of the present disclosure are not limited thereto. In one or more embodiments, when the first electrode 110 is a semi-transmissive electrode or a reflective electrode, the material for forming the first electrode may be selected from magnesium(Mg), silver (Ag), aluminum (Al), aluminum-lithium (Al-Li), calcium (Ca), magnesium-indium (Mg-In), magnesium-silver (Mg-Ag), and combinations thereof, but embodiments of the present disclosure are not limited thereto.

The first electrode 110 may have a single-layered structure, or a multi-layered structure comprising two or more layers. For example, the first electrode 110 may have a three-layered structure of ITO/Ag/ITO, but embodiments of the structure thereof are not limited thereto.

### Organic layer 150

The organic layer 150 is on the first electrode 110. The organic layer 150 may comprise an emission layer.

The organic layer 150 may comprise a hole transport region between the first electrode 110 and the emission layer, and an electron transport region between the emission layer and the second electrode 190.

### Hole transport region in organic layer 150

The hole transport region may have i) a single-layered structure including a single layer including a single material, ii) a single-layered structure including a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

For example, the hole transport region may have a single-layered structure including a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer, or hole injection layer/hole transport layer/electron blocking layer, wherein layers of each structure are sequentially stacked on the first electrode 110 in each stated order, but embodiments of the structure of the hole transport region are not limited thereto.

The hole transport region may comprise the second compound represented by Formula 2A or 2B as described above.

In one or more embodiments, the hole transport region may comprise an emission auxiliary layer. The emission auxiliary layer may directly contact the emission layer.

In one or more embodiments, the hole transport region may comprise a hole injection layer and a hole transport layer stacked in this stated order on the first electrode 110, a hole injection layer and an emission auxiliary layer stacked in this stated order on the first electrode 110, or a hole injection layer, a hole transport layer, and an emission auxiliary layer stacked in this stated order on the first electrode 110, but embodiments of the present disclosure are not limited thereto.

When the hole transport region comprises an emission auxiliary layer, the emission auxiliary layer may further comprise the second compound represented by Formula 2A or 2B.

The hole transport region may comprise at least one selected from m-MTDATA, TDATA, 2-TNATA, NPB(NPD), β-NPB, TPD, Spiro-TPD, Spiro-NPB, methylated NPB, TAPC, HMTPD, 4,4',4"-tris(*N*-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202:

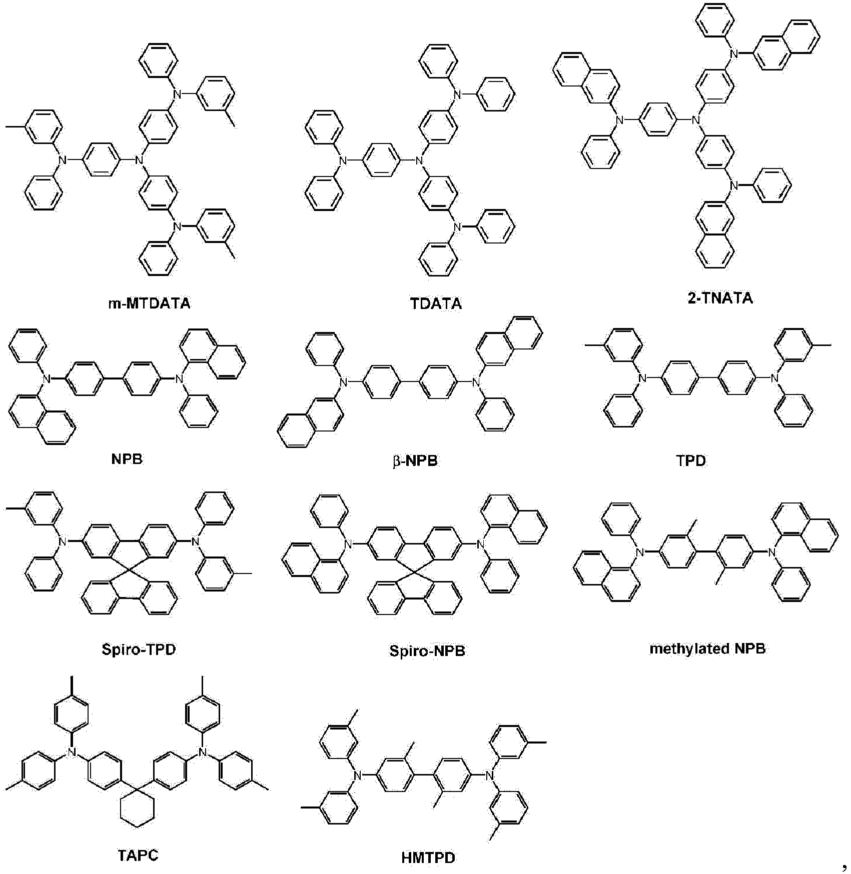

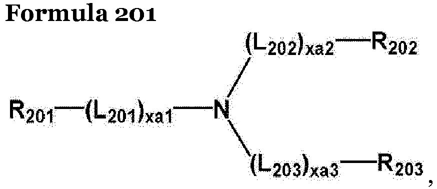

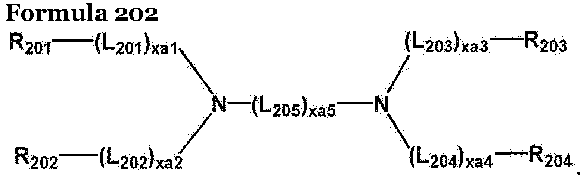

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8- C60 polycyclic group, and a substituted or unsubstituted divalent non-aromatic condensed 8- to 60-membered heteropolycyclic group,
L₂₀₅ may be selected from ^{∗}-O-^{∗}', *-S-*', ^{∗}-N(Q₂₀₁)-^{∗}', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, R₂₀₁ and R₂₀₂ in Formula 202 may be optionally connected (e.g., coupled) via a single bond, a dimethyl-methylene group, or a diphenyl-methylene group, and R₂₀₃ and R₂₀₄ may be optionally connected (e.g., coupled) via a single bond, a dimethyl-methylene group, or a diphenyl-methylene group.

In one or more embodiments, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be the same as described herein.

In one or more embodiments, at least one selected from R₂₀₁ to R₂₀₃ in Formula 201 may be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be connected (e.g., coupled) via a single bond, and/or ii) R₂₀₃ and R₂₀₄ may be connected (e.g., coupled) via a single bond.

In one or more embodiments, at least one selected from R₂₀₁ to R₂₀₄ in Formula 202 may be selected from the group consisting of:
a carbazolyl group; and
a carbazolyl group substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

The compound represented by Formula 201 may be represented by Formula 201A:

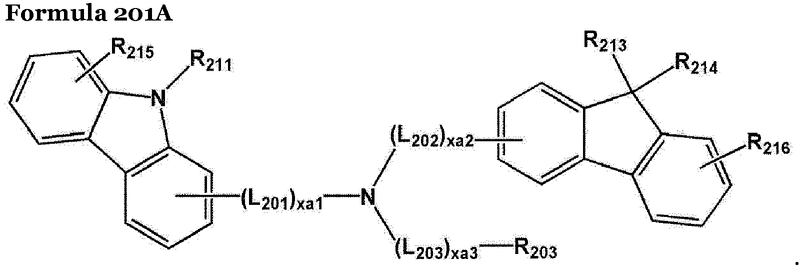

For example, the compound represented by Formula 201 may be represented by Formula 201A(1), but embodiments of the present disclosure are not limited thereto:

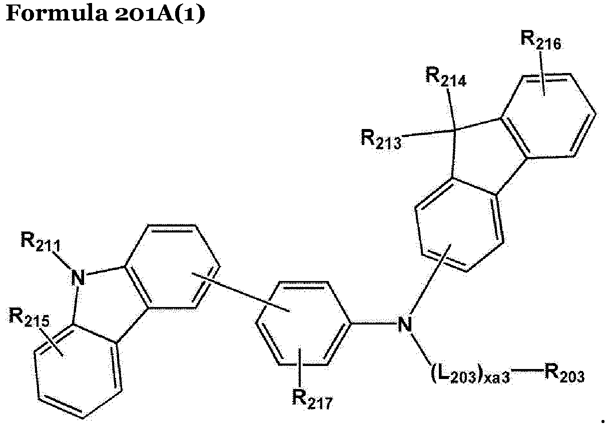

In one or more embodiments, the compound represented by Formula 201 may be represented by Formula 201A-1, but embodiments of the present disclosure are not limited thereto:

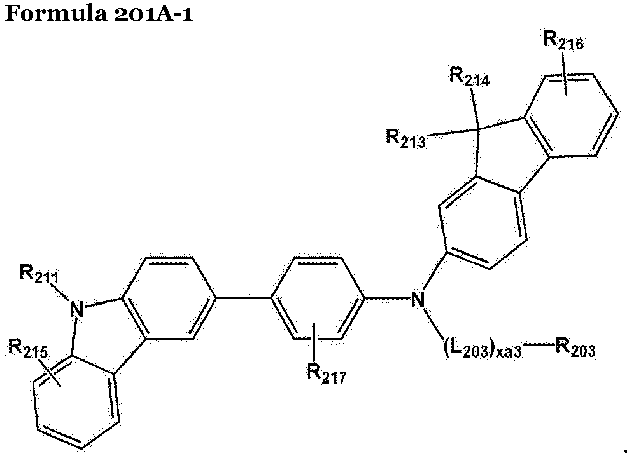

The compound represented by Formula 202 may be represented by Formula 202A:

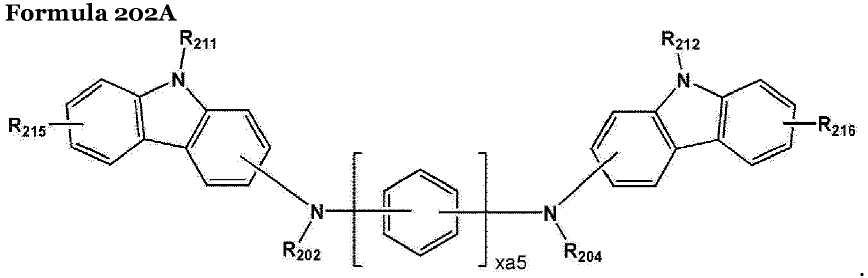

In one or more embodiments, the compound represented by Formula 202 may be represented by Formula 202A-1:

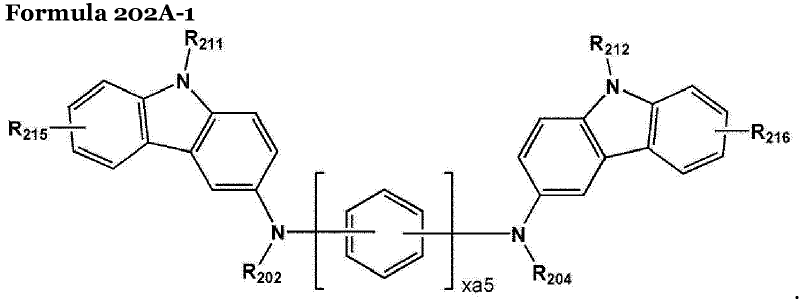

In Formulae 201A, 201A(1), 201A-1, 202A, and 202A-1,
L₂₀₁ to L₂₀₃, xa1 to xa3, xa5, and R₂₀₂ to R₂₀₄ may each independently be the same as described herein,
R₂₁₁ and R₂₁₂ may each independently be the same as described herein in connection with R₂₀₃, and
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to HT39, but embodiments of the present disclosure are not limited thereto:

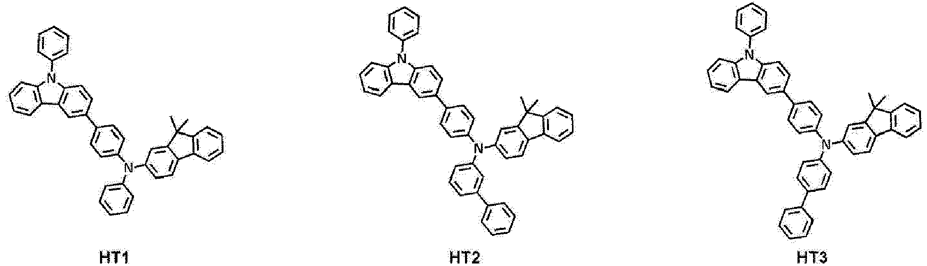

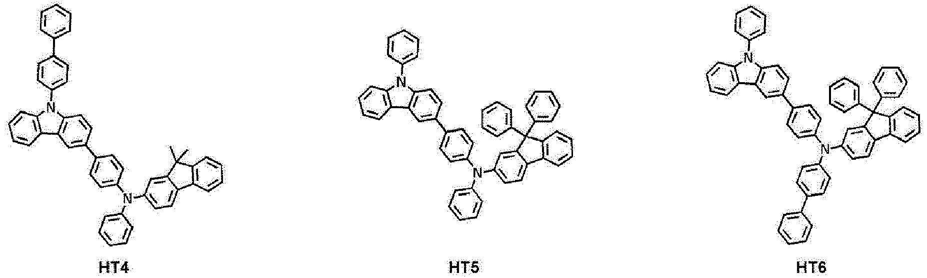

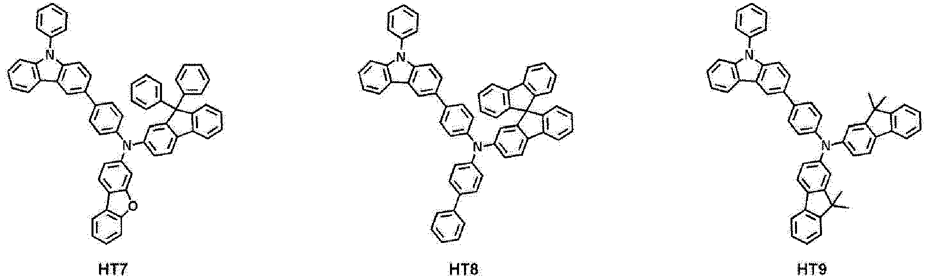

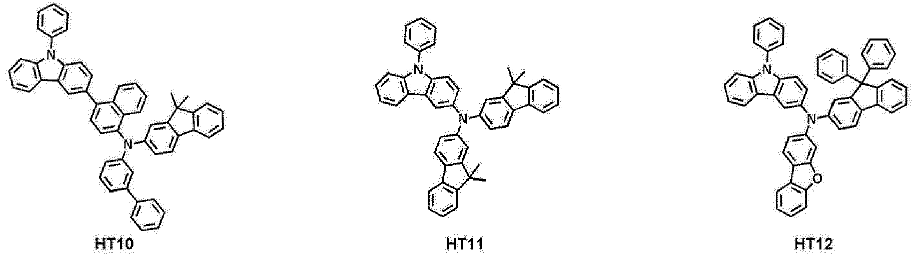

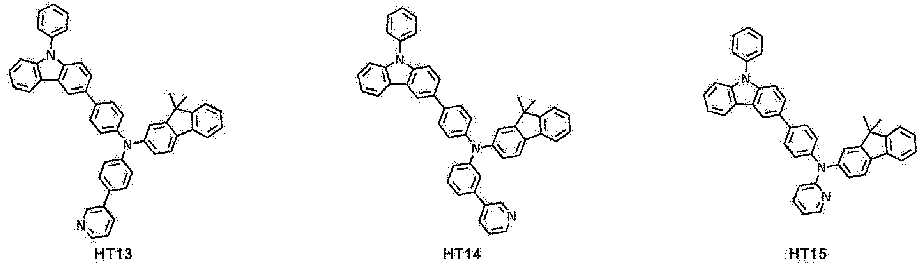

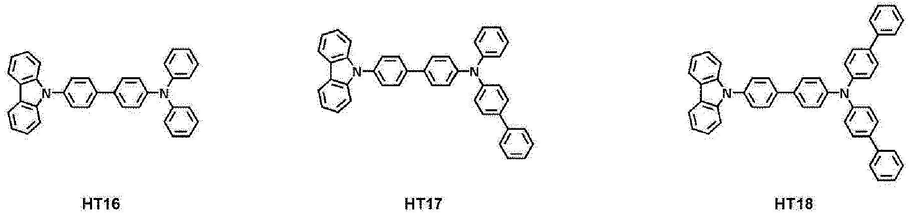

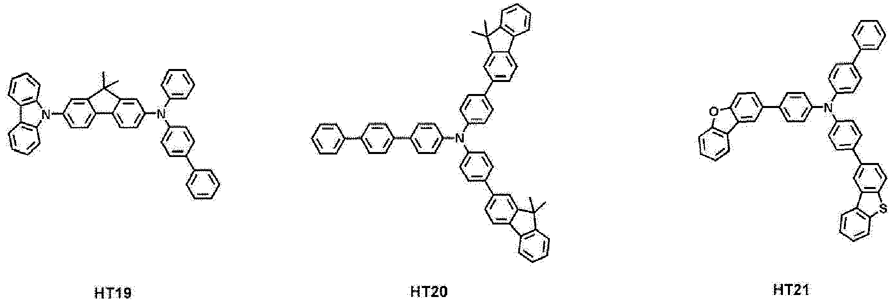

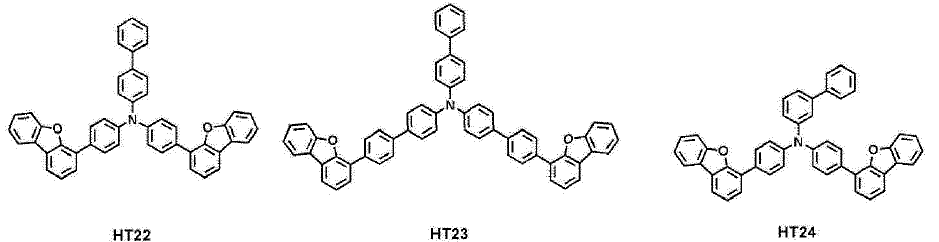

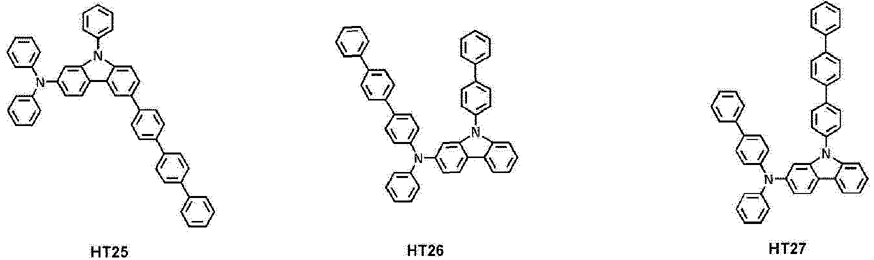

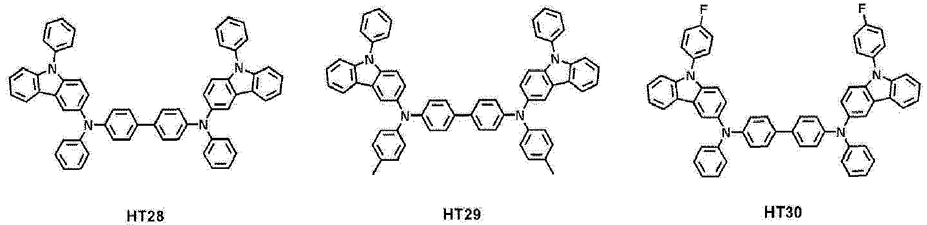

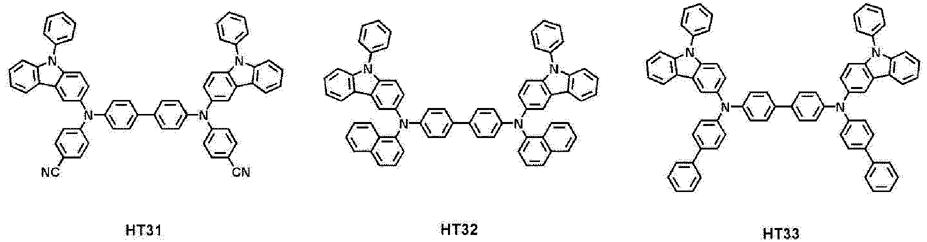

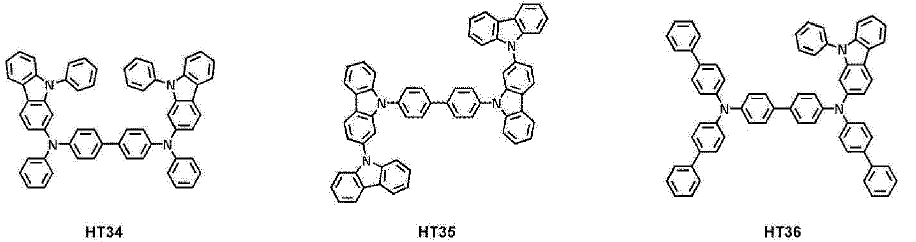

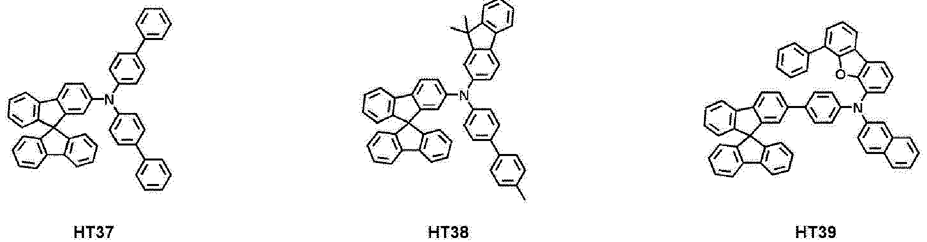

The thickness of the hole transport region may be about 100 Å to about 10,000 Å, and in some embodiments, about 100 Å to about 1,000 Å. When the hole transport region comprises at least one selected from a hole injection layer and a hole transport layer, the thickness of the hole injection layer may be about 100 Å to about 9,000 Å, and in some embodiments, about 100 Å to about 1,000 Å; the thickness of the hole transport layer may be about 50 Å to about 2,000 Å, and in some embodiments, about 100 Å to about 1,500 Å. When the thicknesses of the hole transport region, the hole injection layer and the hole transport layer are each within these ranges, satisfactory hole transporting characteristics may be obtained without a substantial increase in driving voltage.

The emission auxiliary layer may increase the light-emission efficiency of the device by compensating for an optical resonance distance according to the wavelength of light emitted by an emission layer (e.g., by adjusting the optical resonance distance to match the wavelength of light emitted from the emission layer), and the electron blocking layer may block or reduce the flow of electrons from an electron transport region. The emission auxiliary layer and the electron blocking layer may each comprise the materials as described above.

### p-dopant

The hole transport region may further comprise, in addition to these materials, a charge-generation material for the improvement of conductive properties. The charge-generation material may be homogeneously or non-homogeneously dispersed in the hole transport region.

The charge-generation material may be, for example, a p-dopant.

In one or more embodiments, the p-dopant may have a lowest unoccupied molecular orbital (LUMO) energy level of -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,11-hexaazatriphenylene-hexacarbonitrile (HAT-CN); and
a compound represented by Formula 221,
but embodiments of the present disclosure are not limited thereto:

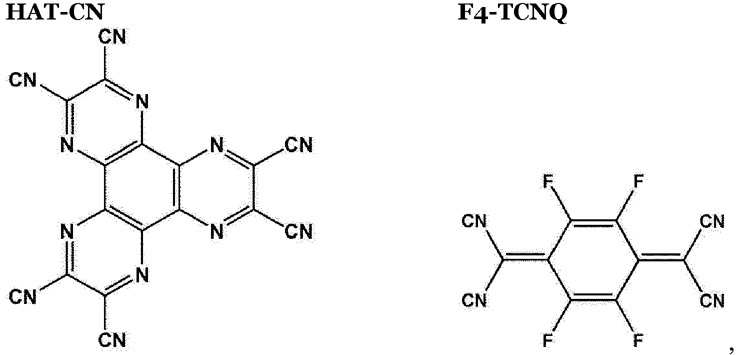

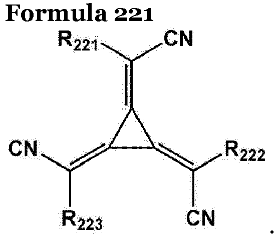

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8- C60 polycyclic group, and a substituted or unsubstituted monovalent non-aromatic condensed 8- to 60-membered heteropolycyclic group, wherein at least one selected from R₂₂₁ to R₂₂₃ has at least one substituent selected from a cyano group, -F, -Cl, -Br, -I, a C₂₀-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers may contact each other or may be separated from each other. In one or more embodiments, the emission layer may comprise two or more materials selected from a red-light emission material, a green-light emission material, and a blue-light emission material, in which the two or more materials may be mixed together in a single layer to thereby emit white light.

In one or more embodiments, the emission layer of the organic light-emitting device 10 may be a first-color-light emission layer,
the organic light-emitting device 10 may further comprise i) at least one second-color-light emission layer or ii) at least one second-color-light emission layer and at least one third-color-light emission layer between the first electrode 110 and the second electrode 190,
a maximum emission wavelength of the first-color-light emission layer, a maximum emission wavelength of the second-color-light emission layer, and a maximum emission wavelength of the third-color-light emission layer may be identical to or different from one another, and
the organic light-emitting device 10 may emit a mixed light comprising a first-color-light and a second-color-light, or a mixed light comprising the first-color-light, the second-color-light, and a third-color-light, but embodiments of the present disclosure are not limited thereto.

For example, the maximum emission wavelength of the first-color-light emission layer may be different from the maximum emission wavelength of the second-color-light emission layer, and the mixed light comprising a first-color-light and a second-color-light may be white light, but embodiments of the present disclosure are not limited thereto.

In one or more embodiments, the maximum emission wavelength of the first-color-light emission layer, the maximum emission wavelength of the second-color-light emission layer, and the maximum emission wavelength of the third-color-light emission layer may be different from one another, and the mixed light comprising the first-color-light, the second-color-light, and the third-color-light may be white light. However, embodiments of the present disclosure are not limited thereto.

As used herein the maximum emission wavelength of an emission layer is the wavelength of light emitted by the emission layer with maximum intensity.

The emission layer may comprise a host and a dopant. The dopant may comprise at least one selected from a phosphorescent dopant and a fluorescent dopant.

The amount of the dopant in the emission layer may be about 0.01 to about 15 parts by weight based on 100 parts by weight of the host, but embodiments of the present disclosure are not limited thereto.

The thickness of the emission layer may be about 100 Å to about 1,000 Å, and in some embodiments, about 200 Å to about 600 Å. When the thickness of the emission layer is within these ranges, excellent light-emission characteristics may be obtained without a substantial increase in driving voltage.

### Host in emission layer

In one or more embodiments, the host may comprise a compound represented by Formula 301:

**Formula 301** [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8- C60 polycyclic group, and a substituted or unsubstituted divalent non-aromatic condensed 8- to 60-membered heteropolycyclic group,
xb1 may be an integer selected from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8- C60 polycyclic group, a substituted or unsubstituted monovalent non-aromatic condensed 8- to 60-membered heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), - S(=O)₂(Q₃₀₁), and -P(=O)(Q₃₀₁)(Q₃₀₂), and
xb21 may be an integer selected from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In one or more embodiments, Ar₃₀₁ in Formula 301 may be selected from the group consisting of:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

When xb11 in Formula 301 is two or more, two or more Ar₃₀₁(s) may be connected (e.g., coupled) via one or more single bonds.

In one or more embodiments, the compound represented by Formula 301 may be represented by Formula 301-1 or 301-2:

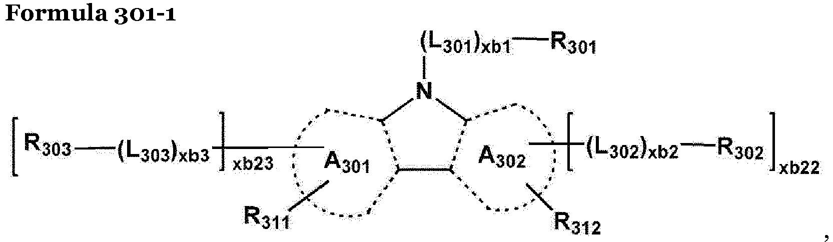

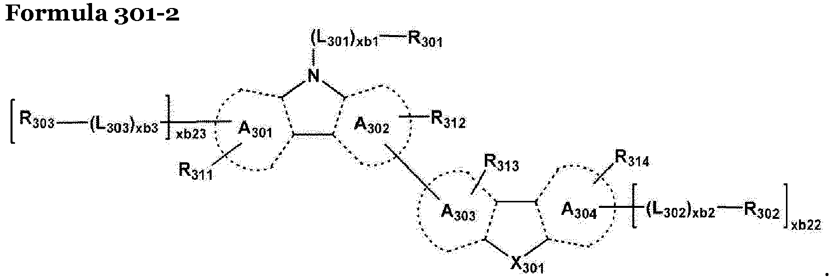

In Formulae 301-1 to 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be O, S or N-[(L₃₀₄)_{xb4}-R₃₀₄],
R₃₁₁ to R₃₁₄ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ may each independently be the same as described herein in connection with Formula 301,
L₃₀₂ to L₃₀₄ may each independently be the same as described herein in connection with L₃₀₁,
xb2 to xb4 may each independently be the same as described herein in connection with xb1, and
R₃₀₂ to R₃₀₄ may each independently be the same as described herein in connection with R₃₀₁.

For example, L₃₀₁ to L₃₀₄ in Formulae 301, 301-1, and 301-2 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be the same as described herein.

In one or more embodiments, R₃₀₁ to R₃₀₄ in Formulae 301, 301-1, and 301-2 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₃₁ to Q₃₃ may each independently be the same as described herein.

In one or more embodiments, the host may comprise an alkaline earth metal complex. For example, the host may be selected from a Be complex (e.g., Compound H55) and a Mg complex. In one or more embodiments, the host may be a Zn complex.

The host may comprise 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(*N*-carbazolyl)-1,1'-biphenyl (CBP), 1,3-di-9-carbazolylbenzene (mCP), 1,3,5-tri(carbazol-9-yl)benzene (TCP), and/or Compounds H1 to H55, but embodiments of the present disclosure are not limited thereto:

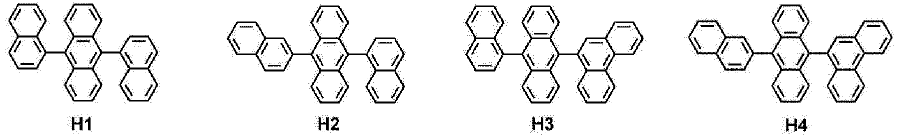

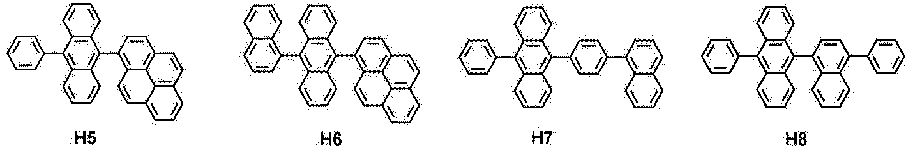

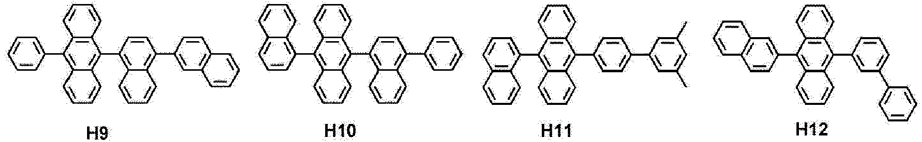

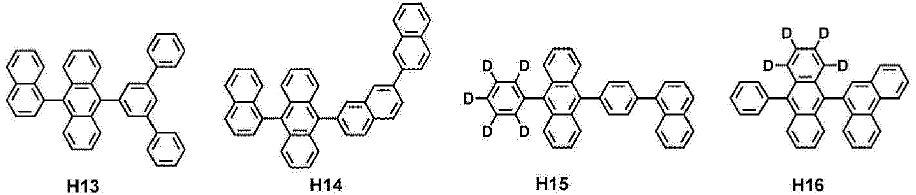

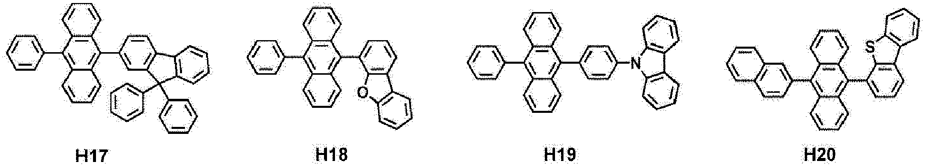

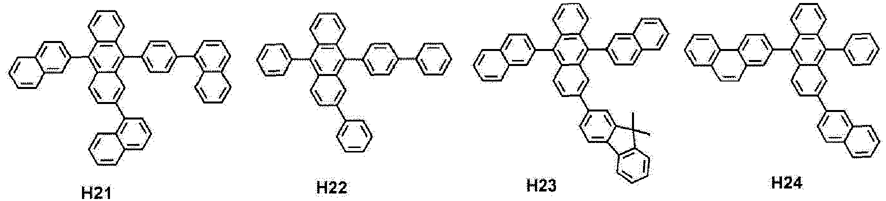

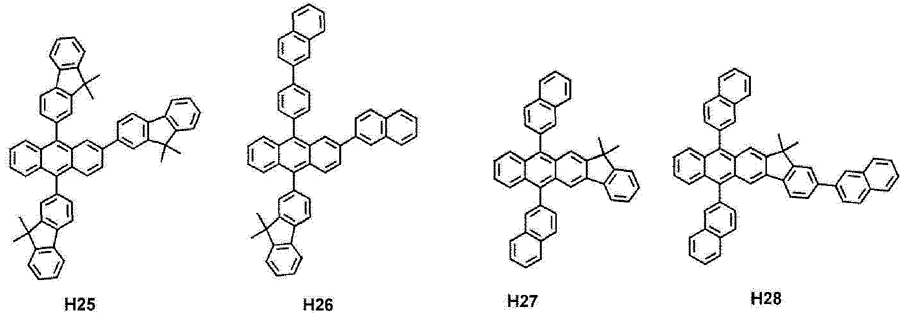

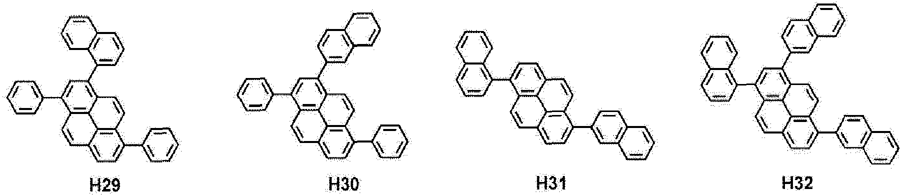

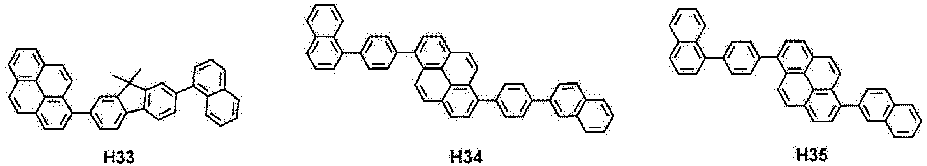

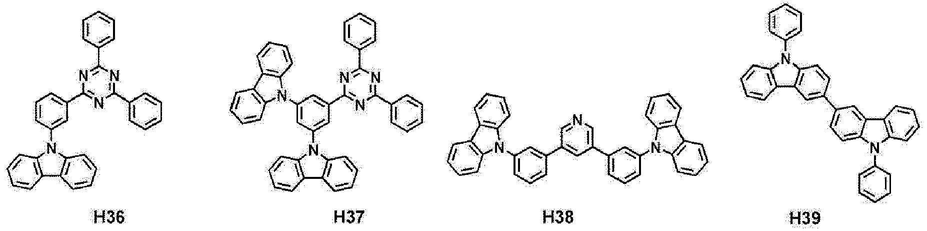

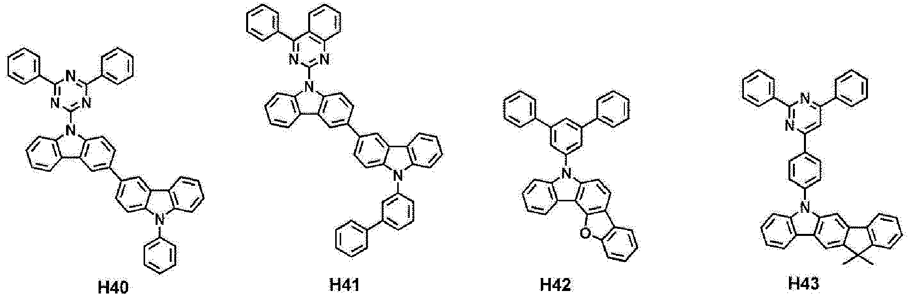

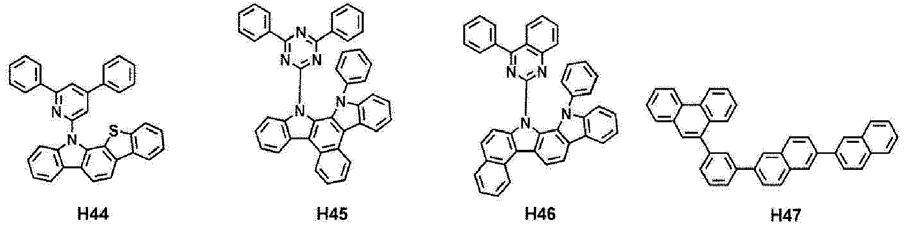

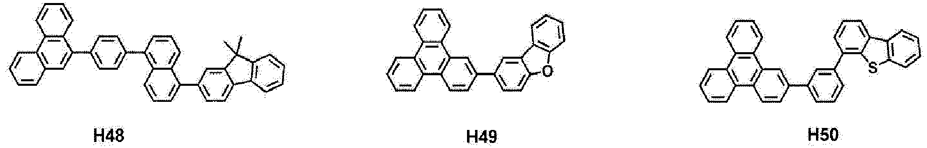

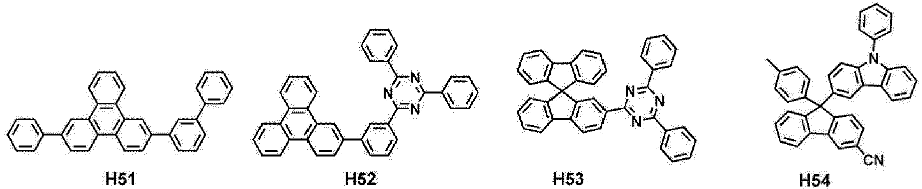

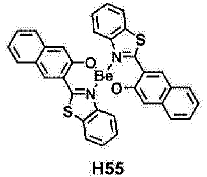

### Phosphorescent dopant included in emission layer in organic layer 150

The phosphorescent dopant may comprise an organometallic complex represented by Formula 401:

Formula **401** M(L₄₀₁)_{xc1}(L₄₀₂)_{xc2},

in which L₄₀₁ may be selected from ligands represented by Formula 402,

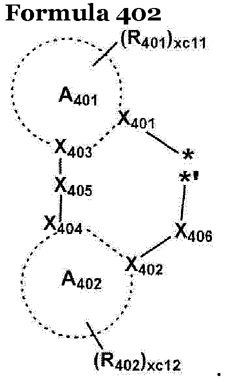

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3, and when xc1 is two or more, two or more L₄₀₁(s) may be identical to or different from each other,
L₄₀₂ may be an organic ligand, xc2 may be an integer selected from 0 to 4, and when xc2 is two or more, two or more L₄₀₂(s) may be identical to or different from each other,
X₄₀₁ to X₄₀₄ may each independently be nitrogen or carbon,
X₄₀₁ and X₄₀₃ may be connected (e.g., coupled) via a single bond or a double bond, and X₄₀₂ and X₄₀₄ may be connected (e.g., coupled) via a single bond or a double bond,
A₄₀₁ and A₄₀₂ may each independently be a C₅-C₆ₒ carbocyclic group or a C₁-C₆₀ heterocyclic group,
X₄₀₅ may be a single bond, ^{∗}-O-^{∗}', ^{∗}-S-^{∗}', ^{∗}-C(=O)-^{∗}', ^{∗}-N(Q₄₁₁)-^{∗}', ^{∗}-C(Q₄₁₁)(Q₄₁₂)-^{∗}', ^{∗}-C(Q₄₁₁)=C(Q₄₁₂)-^{∗}', ^{∗}-C(Q₄₁₁)=^{∗}', or ^{∗}=C(Q₄₁₁)=^{∗}, wherein Q₄₁₁ and Q₄₁₂ may each independently be selected from hydrogen, deuterium, a C₁-C₂₀ alkyl group, a C₁-C₂₀ alkoxy group, a phenyl group, a biphenyl group, a terphenyl group, and a naphthyl group,
X₄₀₆ may be a single bond, O, or S,
R₄₀₁ and R₄₀₂ may each independently be selected from hydrogen, deuterium, -F, - Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8- C60 polycyclic group, a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
* and *' in Formula 402 may each independently indicate a binding site to M in Formula 401.

In one or more embodiments, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen and X₄₀₂ may be carbon, or ii) both X₄₀₁ and X₄₀₂ may be nitrogen.

In one or more embodiments, R₄₀₁ and R₄₀₂ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) selected from two or more L₄₀₁(s) may be optionally connected (e.g., coupled) via a linking group X₄₀₇, and/or two A₄₀₂(s) may be optionally connected (e.g., coupled) via a linking group X₄₀₈ (see Compounds PD1 to PD₄ and PD₇). X₄₀₇ and X₄₀₈ may each independently be a single bond, ^{∗}-O-^{∗}', ^{∗}-S-^{∗}', ^{∗}-C(=O)-^{∗}', ^{∗}-N(Q₄₁₃)-^{∗}', ^{∗}-C(Q₄₁₃)(Q₄₁₄)-^{∗}', or ^{∗}-C(Q₄₁₃)=C(Q₄₁₄)-^{∗}' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be any monovalent, divalent, or trivalent organic ligand. For example, L₄₀₂ may be selected from a halogen, a diketone (for example, an acetylacetonate), a carboxylic acid (for example, a picolinate), -C(=O), an isonitrile, -CN, and a phosphorus-based ligand (for example, a phosphine or a phosphite), but embodiments of the present disclosure are not limited thereto.

In one or more embodiments, the phosphorescent dopant may be selected from, for example, Compounds PD1 to PD25, but embodiments of the present disclosure are not limited thereto:

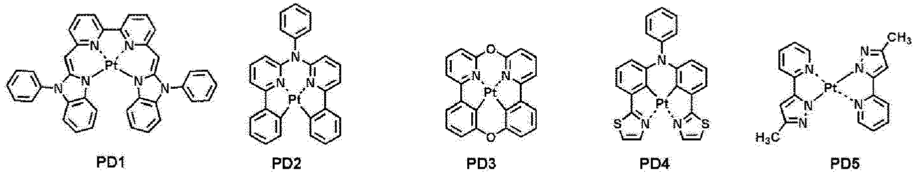

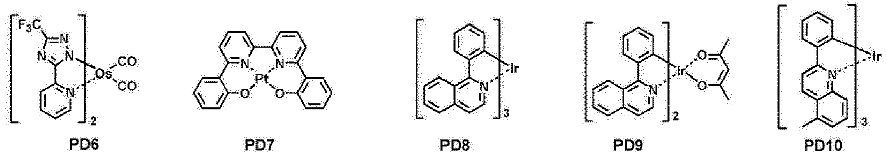

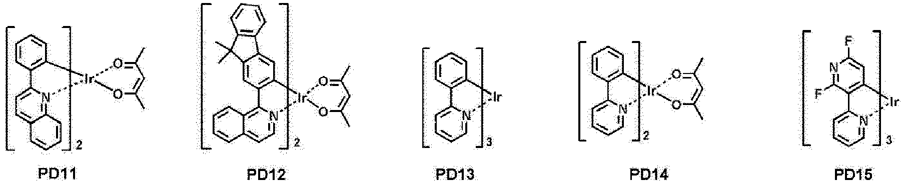

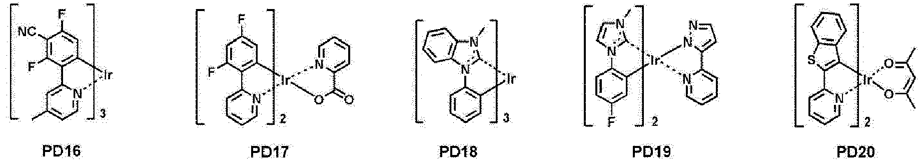

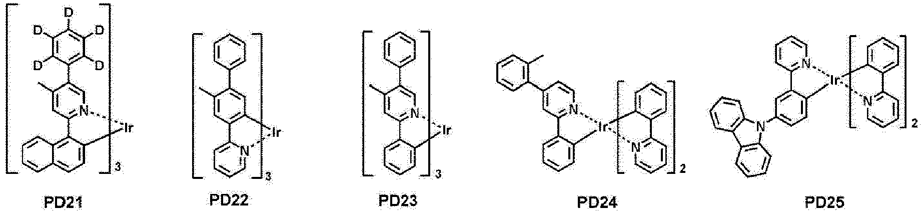

### Fluorescent dopant in emission layer

The fluorescent dopant may comprise an arylamine compound or a styrylamine compound.

In one or more embodiments, the fluorescent dopant may comprise a compound represented by Formula 501:

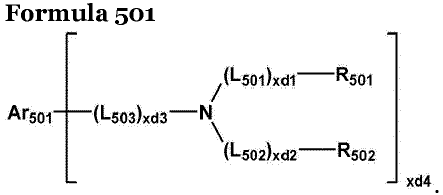

In Formula 501,
Ar₅₀₁ may be a substituted or unsubstituted C₅-C₆ₒ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8- C60 polycyclic group, and a substituted or unsubstituted divalent non-aromatic condensed 8- to 60-membered heteropolycyclic group,
xd1 to xd3 may each independently be an integer selected from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, and
xd4 may be an integer selected from 1 to 6.

In one or more embodiments, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

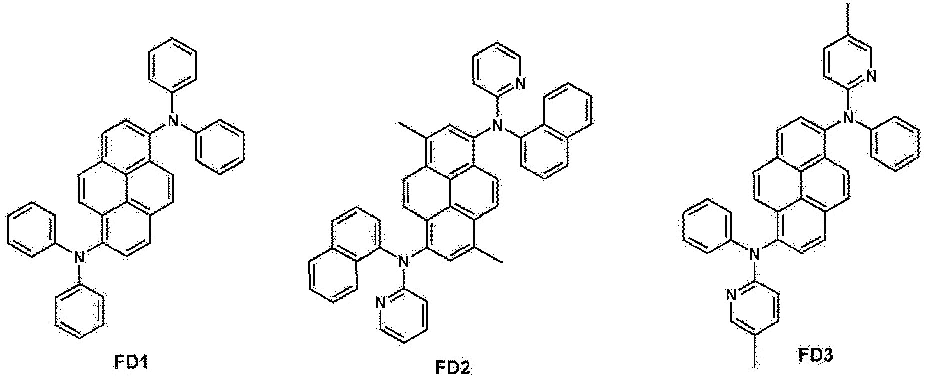

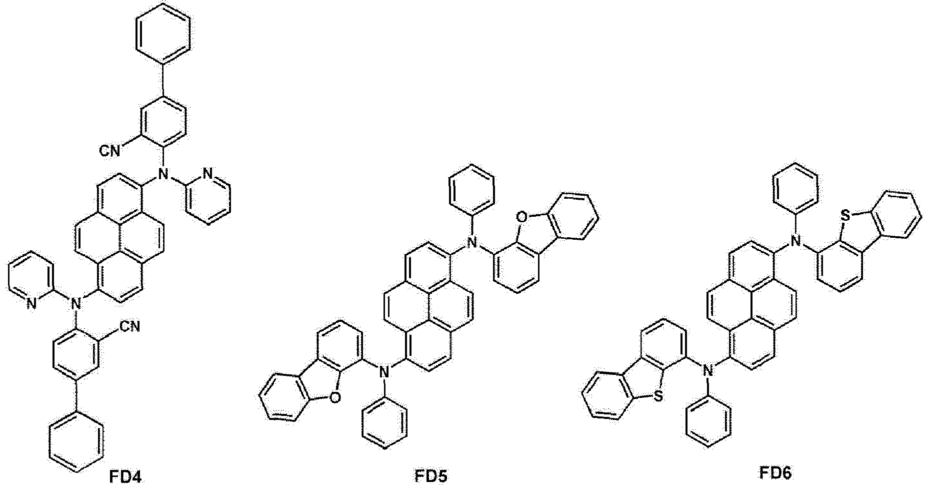

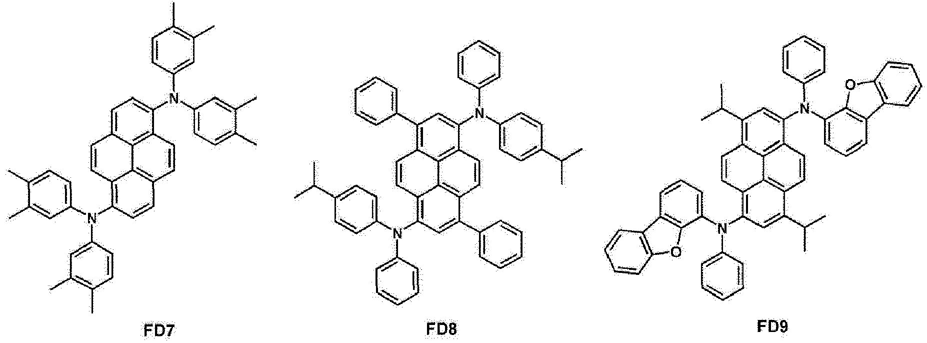

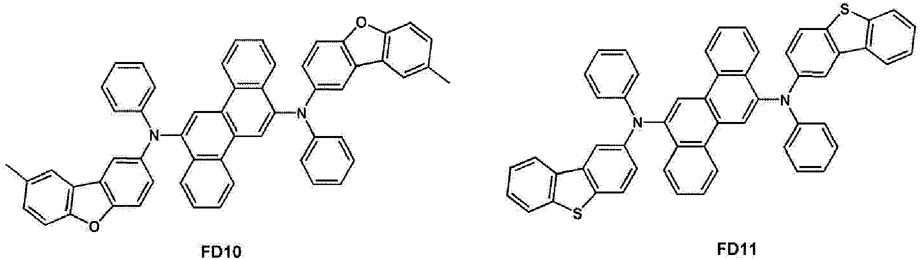

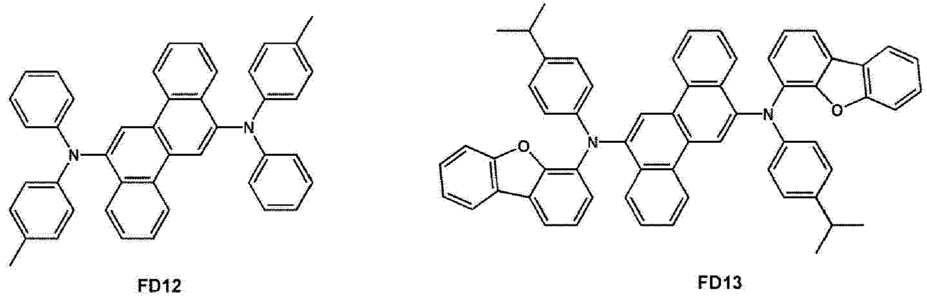

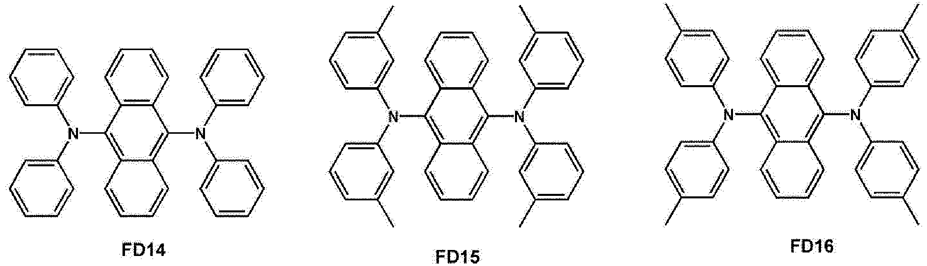

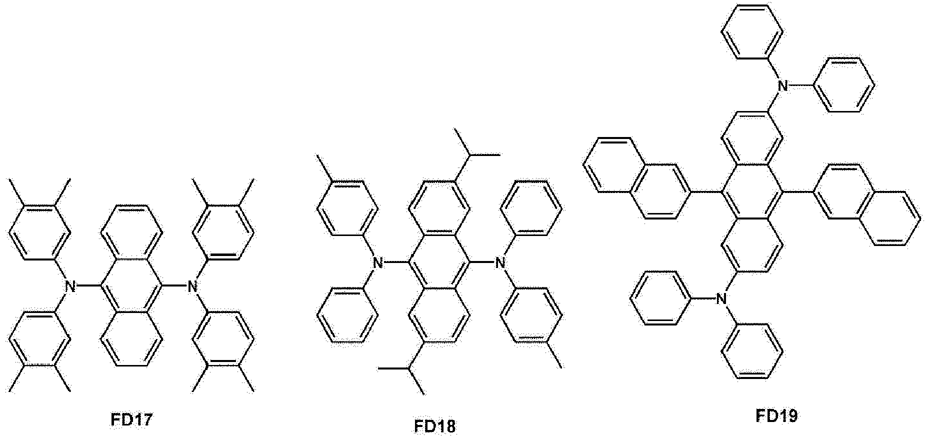

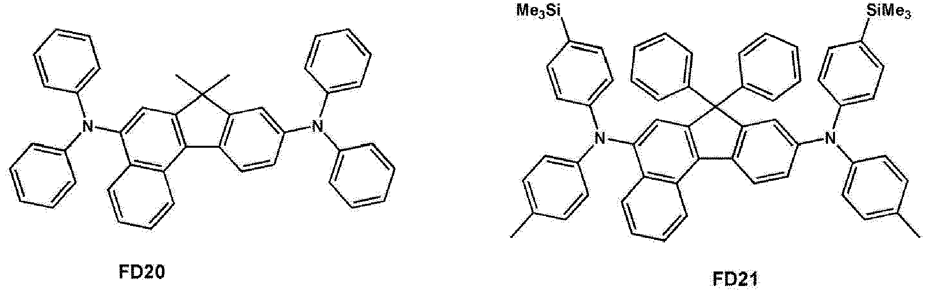

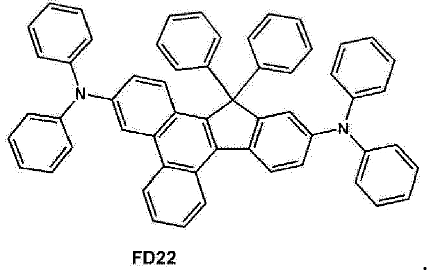

In one or more embodiments, the fluorescent dopant may be selected from the compounds illustrated below, but embodiments of the present disclosure are not limited thereto:

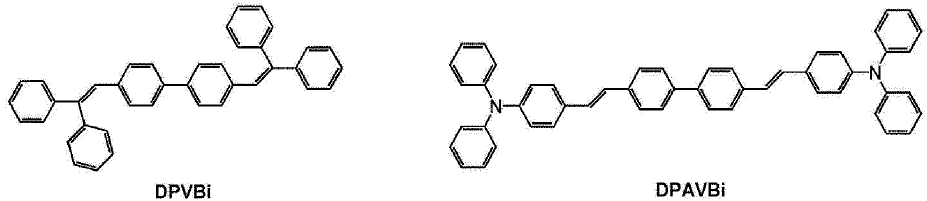

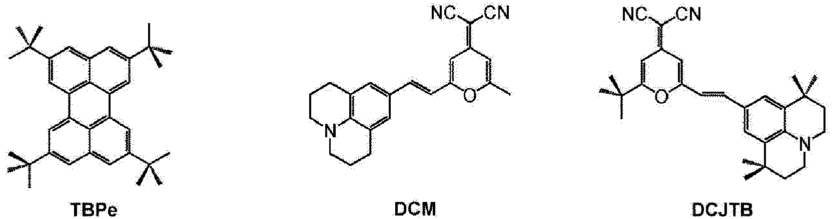

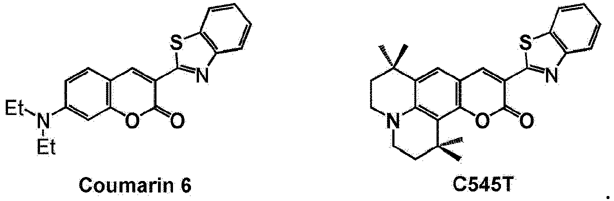

### Electron transport region in organic layer 150

The electron transport region may have i) a single-layered structure including (e.g., consisting of) a single layer including a single material, ii) a single-layered structure including (e.g., consisting of) a single layer comprising a plurality of different materials, or iii) a multi-layered structure having a plurality of layers comprising a plurality of different materials.

The electron transport region may comprise a buffer layer, a hole blocking layer, an electron control layer, an electron transport layer, an electron injection layer, or a combination thereof, but embodiments of the present disclosure are not limited thereto.

In one or more embodiments, the electron transport region may comprise the first compound represented by one selected from Formulae 1A or 1B and the second compound represented by Formula 2A or 2B. The first compound and the second compound may each independently be the same as described herein.

In one or more embodiments, the electron transport region may comprise an electron transport layer, as well as a buffer layer between the emission layer and the electron transport layer. The first compound represented by one selected from Formulae 1A or 1B may be comprised in the electron transport layer, and the second compound represented by Formula 2A or 2B may be comprised in the buffer layer.

In one or more embodiments, the buffer layer may directly contact the emission layer.

In one or more embodiments, the electron transport region may comprise, in addition to the first compound represented by one selected from Formulae 1A or 1B and the second compound represented by Formula 2A or 2B, at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-*tert*-butylphenyl)-4-phenyl-4H-1,2,4-triazole (TAZ), and NTAZ.

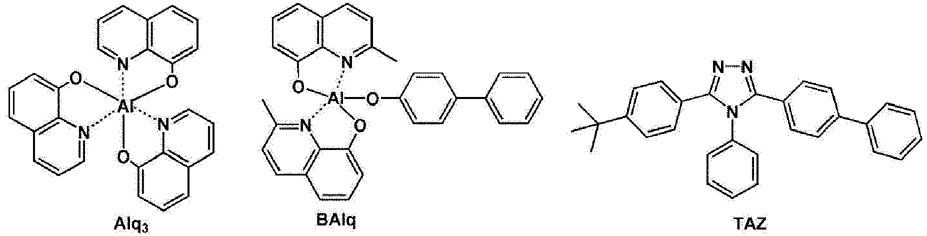

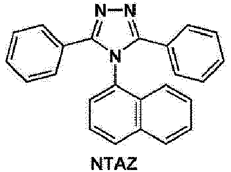

The thicknesses of the buffer layer, the hole blocking layer, and/or the electron control layer may be about 20 Å to about 1,000 Å, and in some embodiments, about 30 Å to about 300 Å. When the thicknesses of the buffer layer, the hole blocking layer, and the electron control layer are within these ranges, the electron blocking layer may have excellent electron blocking characteristics and/or electron control characteristics without a substantial increase in driving voltage.

The thickness of the electron transport layer may be about 100 Å to about 1,000 Å, and in some embodiments, about 150 Å to about 500 Å. When the thickness of the electron transport layer is within these ranges, the electron transport layer may have satisfactory electron transport characteristics without a substantial increase in driving voltage.

The electron transport region (for example, the electron transport layer in the electron transport region) may further comprise, in addition to the materials described above, a metal-containing material.

The metal-containing material may comprise at least one selected from an alkali metal complex and an alkaline earth metal complex. The alkali metal complex may comprise a metal ion selected from a lithium (Li) ion, a sodium (Na) ion, a potassium (K) ion, a rubidium (Rb) ion, and a cesium (Cs) ion, and the alkaline earth metal complex may comprise a metal ion selected from a Be ion, a Mg ion, a calcium (Ca) ion, an strontium (Sr) ion, and a barium (Ba) ion. Each ligand coordinated with the metal ion of the alkali metal complex or the alkaline earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

For example, the metal-containing material may comprise a Li complex. The Li complex may comprise, for example, Compound ET-D1 (lithium quinolate, LiQ) and/or ET-D2:

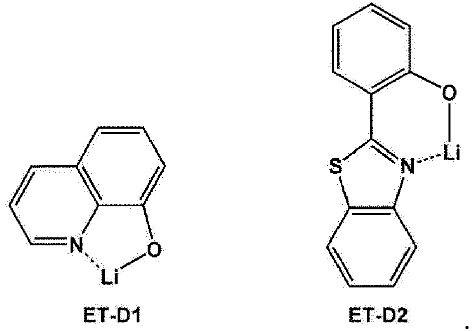

The electron transport region may comprise an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

In one or more embodiments, the electron injection layer may comprise Li, Na, K, Rb, Cs, Mg, Ca, Er, Tm, Yb, or a combination thereof. However, embodiments of the material comprised in the electron injection layer are not limited thereto.

The alkali metal may be selected from Li, Na, K, Rb, and Cs. In one or more embodiments, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from scandium (Sc), yttrium (Y), cerium (Ce), ytterbium (Yb), gadolinium (Gd), and terbium (Tb).

The alkali metal compound, the alkaline earth metal compound, and the rare earth metal compound may be selected from oxides and halides (for example, fluorides, chlorides, bromides, and/or iodides) of the alkali metal, the alkaline earth metal, and the rare earth metal, respectively.

The alkali metal compound may be selected from alkali metal oxides (such as Li₂O, Cs₂O, and/or K₂O) and alkali metal halides (such as LiF, NaF, CsF, KF, LiI, NaI, CsI, and/or KI). In one or more embodiments, the alkali metal compound may be selected from LiF, Li₂O, NaF, LiI, NaI, CsI, and KI, but embodiments of the present disclosure are not limited thereto.

The alkaline earth metal compound may be selected from alkaline earth metal compounds (such as BaO, SrO, CaO, BaₓSr₁₋ₓO(o<x<1), and/or BaₓCa₁₋ₓO(o<x<1)). In one or more embodiments, the alkaline earth metal compound may be selected from BaO, SrO, and CaO, but embodiments of the present disclosure are not limited thereto.

The rare earth metal compound may be selected from YbF₃, ScF₃, ScO₃, Y₂O₃, Ce₂O₃, GdF₃, and TbF₃. In one or more embodiments, the rare earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may respectively comprise an alkali metal ion, an alkaline earth metal ion, and a rare earth metal ion as described above, and each ligand coordinated with the metal ion of the alkali metal complex, the alkaline earth metal complex, and the rare earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In one or more embodiments, the electron injection layer may further comprise an organic material. When the electron injection layer further comprises an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or the combination thereof may be homogeneously or non-homogeneously dispersed in a matrix comprising the organic material.

The thickness of the electron injection layer may be about 1 Å to about 100 Å, and in some embodiments, about 3 Å to about 90 Å. When the thickness of the electron injection layer is within these ranges, the electron injection layer may have satisfactory electron injection characteristics without a substantial increase in driving voltage.

In one or more embodiments, the electron transport region of the organic light-emitting device 10 may comprise a buffer layer, an electron transport layer, and an electron injection layer, and
at least one layer selected from the electron transport layer and the electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

### Second electrode 190

The second electrode 190 may be on the organic layer 150. The second electrode 190 may be a cathode that is an electron injection electrode, and in this regard, the material for forming the second electrode 190 may be selected from a metal, an alloy, an electrically conductive compound, and mixtures thereof, each having a relatively low work function.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure comprising two or more layers.

### Description of FIGS. 2 to 6

FIG. 2 is a schematic view of an organic light-emitting device 20 according to an embodiment of the present disclosure. The organic light-emitting device 20 comprises a first capping layer 210, a first electrode 110, an organic layer 150, and a second electrode 190 sequentially stacked in this stated order. FIG. 3 is a schematic view of an organic light-emitting device 30 according to an embodiment of the present disclosure. The organic light-emitting device 30 comprises a first electrode 110, an organic layer 150, a second electrode 190, and a second capping layer 220 sequentially stacked in this stated order. FIG. 4 is a schematic view of an organic light-emitting device 40 according to an embodiment of the present disclosure. The organic light-emitting device 40 comprises a first capping layer 210, a first electrode 110, an organic layer 150, a second electrode 190, and a second capping layer 220 sequentially stacked in this stated order.

Regarding FIGS. 2 to 4, the first electrode 110, the organic layer 150, and the second electrode 190 may each independently be the same as described herein in connection with FIG. 1.

In the organic layer 150 of each of the organic light-emitting devices 20 and 40, light generated in an emission layer may pass through the first electrode 110 (which is a semi-transmissive electrode or a transmissive electrode) and the first capping layer 210 toward the outside. In the organic layer 150 of each of the organic light-emitting devices 30 and 40, light generated in an emission layer may pass through the second electrode 190 (which is a semi-transmissive electrode or a transmissive electrode) and the second capping layer 220 toward the outside.

The first capping layer 210 and the second capping layer 220 may increase the external luminescent efficiency of the device according to the principle of constructive interference.

In one or more embodiments, the first capping layer 210 and the second capping layer 220 may each independently be an organic capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from carbocyclic compounds, heterocyclic compounds, amine-based compounds, porphyrin derivatives, phthalocyanine derivatives, naphthalocyanine derivatives, alkali metal-based complexes, and alkaline earth metal-based complexes. The carbocyclic compounds, the heterocyclic compounds, and the amine-based compounds may each be optionally substituted with a substituent containing at least one element selected from O, N, sulfur (S), selenium (Se), silicon (Si), fluorine (F), chlorine (Cl), bromine (Br), and iodine (I). In one or more embodiments, at least one selected from the first capping layer 210 and the second capping layer 220 may comprise an amine-based compound.

In one or more embodiments, at least one selected from the first capping layer 210 and the second capping layer 220 may comprise the compound represented by Formula 201 and/or the compound represented by Formula 202.

In one or more embodiments, at least one selected from the first capping layer 210 and the second capping layer 220 may comprise a compound selected from Compounds HT28 to HT33 and Compounds CP1 to CP5, but embodiments of the present disclosure are not limited thereto:

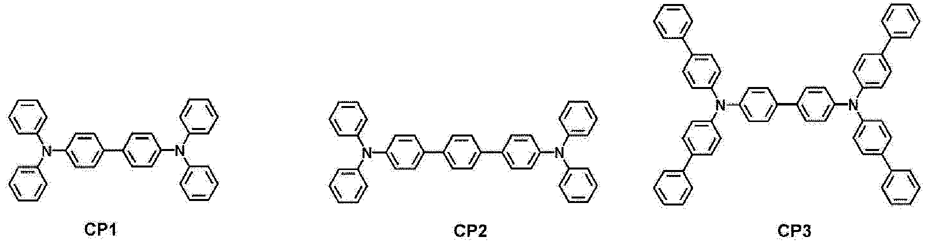

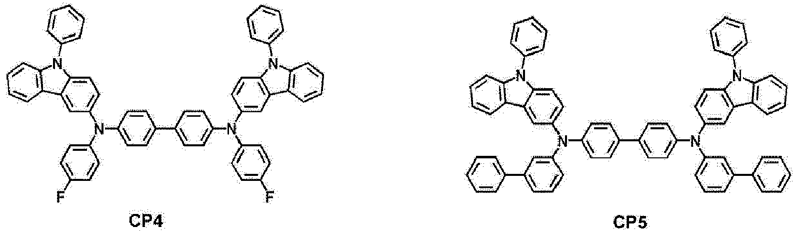

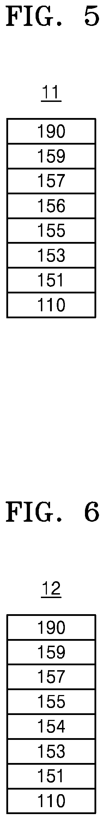

FIG. 5 is a schematic view of an organic light-emitting device 11 according to an embodiment of the present disclosure. The organic light-emitting device 11 may comprise a first electrode 110, a hole injection layer 151, a hole transport layer 153, an emission layer 155, a buffer layer 156, an electron transport layer 157, an electron injection layer 159, and a second electrode 190 sequentially stacked in this stated order.

FIG. 6 is a schematic view of an organic light-emitting device 12 according to an embodiment of the present disclosure. The organic light-emitting device 12 comprises a first electrode 110, a hole injection layer 151, a hole transport layer 153, an emission auxiliary layer 154, an emission layer 155, an electron transport layer 157, an electron injection layer 159, and a second electrode 190 sequentially stacked in this stated order.

Explanations of the layers comprised in organic light-emitting devices 11 and 12 illustrated in FIGS. 5 and 6 may be the same as described above.

Hereinbefore, an organic light-emitting device according to an embodiment of the present disclosure has been described in connection with FIGS. 1-6. However, embodiments of the present disclosure are not limited thereto.

The layers constituting the hole transport region, the emission layer, and the layers constituting the electron transport region may be formed in a specific region using one or more suitable methods selected from vacuum deposition, spin coating, casting, Langmuir-Blodgett (LB) deposition, ink-jet printing, laser-printing, and laser-induced thermal imaging.

When the layers constituting the hole transport region, the emission layer, and the layers constituting the electron transport region are each formed by vacuum deposition, for example, the vacuum deposition may be performed at a deposition temperature of about 100 to about 500°C, at a vacuum degree of about 10⁻⁸ to about 10⁻³ torr, and at a deposition rate of about 0.01 to about 100 Å/sec, depending on the compound to be comprised in each layer, and the structure of each layer to be formed.

When the layers constituting the hole transport region, the emission layer, and the layers constituting the electron transport region are each formed by spin coating, the spin coating may be performed at a coating speed of about 2,000 rpm to about 5,000 rpm and at a heat treatment temperature of about 80°C to 200, depending on the compound to be comprised in each layer, and the structure of each layer to be formed.

### General definitions of substituents

The term "C₁-C₆₀ alkyl group", as used herein, refers to a linear or branched aliphatic saturated hydrocarbon monovalent group having 1 to 60 carbon atoms e.g. 1 to 30 carbon atoms, 1 to 20 carbon atoms, 1 to 10 carbon atoms, 1 to 6 carbon atoms or 1 to 4 carbon atoms. N on-limiting examples thereof may include a methyl group, an ethyl group, a propyl group, an isobutyl group, a see-butyl group, a tert-butyl group, a pentyl group, an iso-amyl group, and a hexyl group. The term "C₁-C₆₀ alkylene group", as used herein, refers to a divalent group having substantially the same structure as the C₁-C₆₀ alkyl group.

The term "C₂-C₆₀ alkenyl group", as used herein, refers to a hydrocarbon group having at least one carbon-carbon double bond in the body (e.g., middle) or at the terminus of the C₂-C₆₀ alkyl group, and non-limiting examples thereof may include an ethenyl group, a propenyl group, and a butenyl group. The term "C₂-C₆₀ alkenylene group", as used herein, refers to a divalent group having substantially the same structure as the C₂-C₆₀ alkenyl group.

The term "C₂-C₆₀ alkynyl group", as used herein, refers to a hydrocarbon group having at least one carbon-carbon triple bond in the body (e.g., middle) or at the terminus of the C₂-C₆₀ alkyl group, and non-limiting examples thereof may include an ethynyl group and a propynyl group. The term "C₂-C₆₀ alkynylene group", as used herein, refers to a divalent group having substantially the same structure as the C₂-C₆₀ alkynyl group.

The term "C₁-C₆₀ alkoxy group", as used herein, refers to a monovalent group represented by -O-A₁₀₁ (wherein A₁₀₁ is a C₁-C₆₀ alkyl group), and non-limiting examples thereof may include a methoxy group, an ethoxy group, and an isopropyloxy group.

The term "C₃-C₁₀ cycloalkyl group", as used herein, refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "C₃-C₁₀ cycloalkylene group", as used herein, refers to a divalent group having substantially the same structure as the C₃-C₁₀ cycloalkyl group.

The term "C₁-C₁₀ heterocycloalkyl group", as used herein, refers to a monovalent monocyclic group having at least one heteroatom (e.g. 1, 2, 3, 4 or 5 hereoatoms) selected from N, O, Si, phosphorus (P), and S as a ring-forming atom and 1 to 10 carbon atoms e.g. 1, 2, 3, 4 or 5 ring carbon atoms. Non-limiting examples thereof may include a 1,2,3,4-oxatriazolidinyl group, a tetrahydrofuranyl group, and a tetrahydrothiophenyl group. The term "C₁-C₁₀ heterocycloalkylene group", as used herein, refers to a divalent group having substantially the same structure as the C₁-C₁₀ heterocycloalkyl group.

The term "C₃-C₁₀ cycloalkenyl group", as used herein, refers to a monovalent saturated monocyclic group that has 3 to 10 carbon atoms and at least one carbon-carbon double bond in the ring thereof and does not have aromaticity, and non-limiting examples thereof may include a cyclopentenyl group, a cyclohexenyl group, and a cycloheptenyl group. The term "C₃-C₁₀ cycloalkenylene group", as used herein, refers to a divalent group having substantially the same structure as the C₃-C₁₀ cycloalkenyl group.

The term "C₁-C₁₀ heterocycloalkenyl group", as used herein, refers to a monovalent monocyclic group that has at least one heteroatom (e.g. 1, 2, 3, 4 or 5 hereoatoms) selected from N, O, Si, P, and S as a ring-forming atom, 1 to 10 carbon atoms, and at least one double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group", as used herein, refers to a divalent group having substantially the same structure as the C₁-C₁₀ heterocycloalkenyl group.

The term "C₆-C₆₀ aryl group", as used herein, refers to a monovalent group having an aromatic system having 6 to 60 carbon atoms e.g. 6 to 20 ring carbon atoms, 6 to 14 ring cabon atoms or 6 to 10 ring carbon atoms. The term "C₆-C₆₀ arylene group", as used herein, refers to a divalent group having an aromatic system having 6 to 60 carbon atoms e.g. 6 to 20 ring carbon atoms, 6 to 14 ring cabon atoms or 6 to 10 ring carbon atoms. Non-limiting examples of the C₆-C₆₀ aryl group may include a phenyl group, a naphthyl group, an anthracenyl group, a phenanthrenyl group, a pyrenyl group, and a chrysenyl group. When the C₆-C₆₀ aryl group and the C₆-C₆₀ arylene group each comprise two or more rings, the rings may be condensed (e.g., fused).

The term "C₁-C₆₀ heteroaryl group", as used herein, refers to a monovalent group having a heterocyclic aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. The term "C₁-C₆₀ heteroarylene group", as used herein, refers to a divalent group having a heterocyclic aromatic system that has at least one heteroatom (e.g. 1, 2, 3, 4 or 5 hereoatoms) selected from N, O, P, and S as a ring-forming atom, and 1 to 60 carbon atoms e.g. 1 to 19 ring carbon atoms, 1 to 13 ring cabon atoms or 1 to 9 ring carbon atoms. Non-limiting examples of the C₁-C₆₀ heteroaryl group may include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each comprise two or more rings, the rings may be condensed (e.g., fused).

The term "C₆-C₆₀ aryloxy group", as used herein, indicates -O-A₁₀₂ (wherein A₁₀₂ is a C₆-C₆₀ aryl group), and the term "C₆-C₆₀ arylthio group", as used herein, indicates -S-A₁₀₃ (wherein A₁₀₃ is a C₆-C₆₀ aryl group).

The term "monovalent non-aromatic condensed C8- C60 polycyclic group", as used herein, refers to a monovalent group that has two or more rings condensed (e.g., fused), 8 to 60 carbon atoms as the only ring-forming atoms (for example, 8 to 20, 8 to 14 or 8 to 10 ring carbon atoms), and non-aromaticity in the entire molecular structure. Non-limiting examples of a monovalent non-aromatic condensed C8- C60 polycyclic group may include a fluorenyl group and a spiro-bifluorenyl group. The term "divalent non-aromatic condensed C8- C60 polycyclic group", as used herein, refers to a divalent group having substantially the same structure as the monovalent non-aromatic condensed C8- C60 polycyclic group.

The term "monovalent non-aromatic condensed 8- to 60-membered heteropolycyclic group", as used herein, refers to a monovalent group having 8- to 60-ring-forming atoms, two or more rings condensed to each other, at least one heteroatom (e.g. 1, 2, 3, 4 or 5 hereoatoms) selected from N, O, Si, P, and S in addition to carbon atoms (for example, 1 to 59, 2 to 59, 2 to 19, 2 to 13 or 2 to 9 ring carbon atoms) as ring-forming atoms, and has non-aromaticity in the entire molecular structure. A non-limiting example of a monovalent non-aromatic condensed 8- to 60-membered heteropolycyclic group may include a carbazolyl group. The term "divalent non-aromatic condensed 8- to 60-membered heteropolycyclic group", as used herein, refers to a divalent group having substantially the same structure as the monovalent non-aromatic condensed 8- to 60-membered heteropolycyclic group.

The term "C₅-C₆₀ carbocyclic group", as used herein, refers to a monocyclic or polycyclic group having 5 to 60 carbon atoms e.g. 5 to 20 ring carbon atoms, 5 to 14 ring cabon atoms or 5 to 10 ring carbon atoms, as the only ring-forming atoms. The C₅-C₆ₒ carbocyclic group may be a saturated carbocyclic group or an unsaturated carbocyclic group. The term "C₅-C₆₀ carbocyclic group", as used herein, refers to an aromatic carbocyclic group or a non-aromatic carbocyclic group. The term "C₅-C₆₀ carbocyclic group", as used herein, refers to a ring (such as a benzene), a monovalent group (such as a phenyl group), or a divalent group (such as a phenylene group). In one or more embodiments, depending on the number of substituents connected to the C₅-C₆ₒ carbocyclic group, the C₅-C₆ₒ carbocyclic group may be a trivalent group or a quadrivalent group.

The term "C₁-C₆₀ heterocyclic group", as used herein, refers to a group having substantially the same structure as the C₁-C₆₀ carbocyclic group, except that at least one heteroatom (e.g. 1, 2, 3, 4 or 5 hereoatoms) selected from N, O, Si, P, Sand Se is used in addition to 1 to 60 ring carbon atoms (for example, 1 to 20 ring carbon atoms, 1 to 14 ring cabon atoms or 1 to 10 ring carbon atoms) as ring-forming atoms.

Certain groups are specified herein as being substituted or unsubstituted. Unless otherwise specified, when a group is substituted it is typically substituted with 1, 2, 3 or 4 substituents. For example, when a group is substituted it may substituted with 1, **2** or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8- to 60-membered heteropolycyclic group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8-to 60-membered heteropolycyclic group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8- C60 polycyclic group, and a monovalent non-aromatic condensed 8- to 60-membered heteropolycyclic group.

The term "Ph" as used herein represents a phenyl group, the term "Me" as used herein represents a methyl group, the term "Et" as used herein represents an ethyl group, the term "ter-Bu" or "Bu^{t,}" as used herein represents a tert-butyl group, and the term "OMe" as used herein represents a methoxy group.

The term "biphenyl group" as used herein refers to a "phenyl group substituted with a phenyl group". In other words, a biphenyl group is a substituted phenyl group having a C₆-C₆₀ aryl group as a substituent.

The term "terphenyl group" as used herein refers to a "phenyl group substituted with a biphenyl group". In other words, a terphenyl group is a substituted phenyl group having a C₆-C₆₀ aryl group substituted with a C₆-C₆₀ aryl group as a substituent.

Symbols ^{∗} and ^{∗}' used herein, unless defined otherwise, refer to a binding site to a neighboring atom in a corresponding formula.

Hereinafter, compounds according to an embodiment of the present disclosure and an organic light-emitting device according to an embodiment of the present disclosure will be described in more detail with reference to Synthesis Examples and Examples. The expression "B was used instead of A" used in describing Synthesis Examples refers to that an identical number of molar equivalents of B was used in place of A.

### Examples

### Example 1

An anode was prepared by cutting an ITO glass substrate (manufactured by Corning), on which ITO was formed to a thickness of 15 Ω/cm² (1,200 Å), to a size of 50 mm x 50 mm x 0.7 mm, ultrasonically cleaning the ITO glass substrate using isopropyl alcohol and pure water for 5 minutes each, and exposing the ITO glass substrate to UV irradiation and ozone for 30 minutes to clean. Then, the ITO glass substrate was loaded into a vacuum deposition apparatus.

m-MTDATA was vacuum-deposited on the ITO glass substrate (anode) to form a hole injection layer having a thickness of 700 Å. Then, NPB was vacuum-deposited on the hole injection layer to form a hole transport layer having a thickness of 100 Å.

ADN (as a host) and FBD (as a dopant) were co-deposited on the hole transport layer at a weight ratio of 95:5 to form an emission layer having a thickness of 300 Å.

Compound 2-48 was deposited on the emission layer to form a buffer layer having a thickness of 100 Å, and Compound 1-1 was deposited on the buffer layer to form an electron transport layer having a thickness of 200 Å. LiF was deposited on the electron transport layer to form an electron injection layer having a thickness of 10 Å. Al was vacuum-deposited on the electron injection layer to form a cathode having a thickness of 2,000 Å, thereby completing the manufacture of an organic light-emitting device.

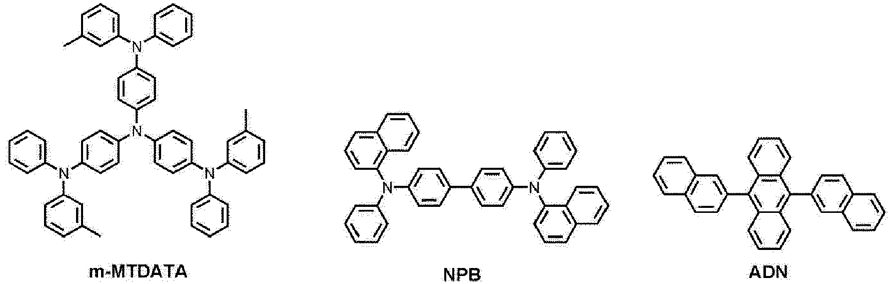

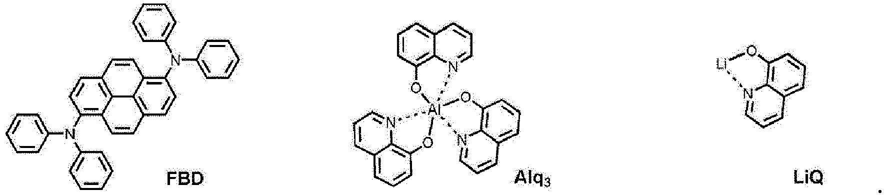

### Examples 2 to 34 and Comparative Examples 1 and 5

Additional organic light-emitting devices were manufactured in substantially the same manner as in Example 1, except that the compounds shown in Table 5 were used instead of Compounds 2-48 and 1-1 in forming each buffer layer and each electron transport layer.

### Evaluation Example 1

The driving voltage and efficiency of each of the organic light-emitting devices of Examples 1 to 34 and Comparative Examples 1 to 5 were evaluated using a Keithley SMU 236 meter. The results thereof are shown in Table 5.

**Table 5**

| | Buffer layer | Electron transport layer (weight ratio) | Driving voltage (V) | Efficiency (cd/A) |
|---|---|---|---|---|
| Example 1 | Compound 2-48 | Compound 1-1 | 4.6 | 4.9 |
| Example 2 | Compound 2-147a | Compound 1-1 | 4.5 | 4.8 |
| Example 3 | Compound 2-162 | Compound 1-1 | 4.3 | 5.0 |
| Example 4 | Compound 2-147a | Compound 1-1:LiQ (5:5) | 4.6 | 5.0 |
| Example 5 | Compound 2-136a | Compound 1-8 | 4.6 | 4.8 |
| Example 6 | Compound 2-58 | Compound 1-8 | 4.6 | 4.9 |
| Example 7 | Compound 2-190 | Compound 1-8 | 4.6 | 5.0 |
| Example 8 | Compound 2-58 | Compound 1-8:LiQ (5:5) | 4.5 | 4.9 |
| Example 9 | Compound 2-48 | Compound 1-9 | 4.7 | 4.6 |
| Example 10 | Compound 2-48 | Compound 1-13 | 4.5 | 5.0 |
| Example 11 | Compound 2-136a | Compound 1-13 | 4.6 | 4.9 |
| Example 12 | Compound 2-64 | Compound 1-13 | 4.5 | 5.0 |
| Example 13 | Compound 2-64 | Compound 1-13:LiQ (5:5) | 4.4 | 5.0 |
| Example 14 | Compound 2-147a | Compound 1-14 | 4.7 | 4.9 |
| Example 15 | Compound 2-58 | Compound 1-14 | 4.5 | 5.2 |
| Example 16 | Compound 2-190 | Compound 1-14 | 4.6 | 5.0 |
| Example 17 | Compound 2-190 | Compound 1-14 LiQ (5:5) | 4.5 | 5.1 |
| Example 18 | Compound 2-58 | Compound 1-15 | 4.6 | 5.0 |
| Example 19 | Compound 2-162 | Compound 1-15 | 4.7 | 5.2 |
| Example 20 | Compound 2-190 | Compound 1-15 | 4.5 | 5.0 |
| Example 21 | Compound 2-64 | Compound 1-15 LiQ (5:5) | 4.6 | 5.0 |
| Example 22 | Compound 2-48 | Compound 1-19 | 4.7 | 4.6 |
| Example 23 | Compound 2-48 | Compound 1-22 | 4.6 | 4.8 |
| Example 24 | Compound 2-190 | Compound 1-25 | 4.6 | 4-7 |
| Example 25 | Compound 2-190 | Compound 1-43 | 4.6 | 4.8 |
| Example 26 | Compound 2-48 | Compound 1-34 | 4.7 | 4.8 |
| Example 27 | Compound 2-48 | Compound 1-34:Li (98:2) | 4.6 | 4.7 |
| Example 28 | Compound 2-58 | Compound 1-37 | 4.7 | 4.8 |
| Example 29 | Compound 2-58 | Compound 1-37:Li (98:2) | 4.5 | 4.8 |
| Example 30 | Compound 2-162 | Compound 1-38 | 4.6 | 4.7 |
| Example 31 | Compound 2-162 | Compound 1-38:Li (98:2) | 4.6 | 4.8 |
| Example 32 | Compound 2-190 | Compound 1-45 | 4.7 | 4.9 |
| Example 33 | Compound 2-190 | Compound 1-45:LiQ (5:5) | 4.6 | 4.8 |
| Example 34 | Compound 2-190 | Compound 1-45:Li (98:2) | 4.5 | 5.0 |
| Comparative Example 1 | Alq₃ | | 4.9 | 4.4 |
| Comparative Example 2 | Compound 1-8 | | 4.6 | 4.6 |
| Comparative Example 3 | Compound 1-13 | | 4.7 | 4.55 |
| Comparative Example 4 | Compound 2-48 | Alq₃ | 4.7 | 4.5 |
| Comparative Example 5 | Compound 2-190 | Alq₃ | 4.7 | 4.5 |

Referring to Table 5, each of the organic light-emitting devices of Examples 1 to 34 had a low driving voltage and high efficiency compared to each of the organic light-emitting devices of Comparative Examples 1 to 5.

### Example 35

An anode was prepared by cutting an ITO glass substrate (manufactured by Corning), on which ITO was formed to a thickness of 15 Ω/cm² (1,200 Å), to a size of 50 mm x 50 mm x 0.7 mm, ultrasonically cleaning the ITO glass substrate using isopropyl alcohol and pure water for 5 minutes each, and exposing to UV irradiation and ozone for 30 minutes to clean. Then, the ITO glass substrate was loaded into a vacuum deposition apparatus.

m-MTDATA was vacuum-deposited on the ITO glass substrate (anode) to form a hole injection layer having a thickness of 700 Å. Then, TCTA was vacuum-deposited on the hole injection layer to form a hole transport layer having a thickness of 100 Å.

CBP (as a host) and Ir(ppy)₃ (as a dopant) were co-deposited on the hole transport layer at a weight ratio of 90:10 to form an emission layer having a thickness of 300 Å.

Compound 2-147a was deposited on the emission layer to form a buffer layer having a thickness of 100 Å, and Compound 1-1 was deposited on the buffer layer to form an electron transport layer having a thickness of 200 Å. LiF was deposited on the electron transport layer to form an electron injection layer having a thickness of 10 Å. Al was vacuum-deposited on the electron injection layer to form a cathode having a thickness of 2,000Å, thereby completing the manufacture of an organic light-emitting device.

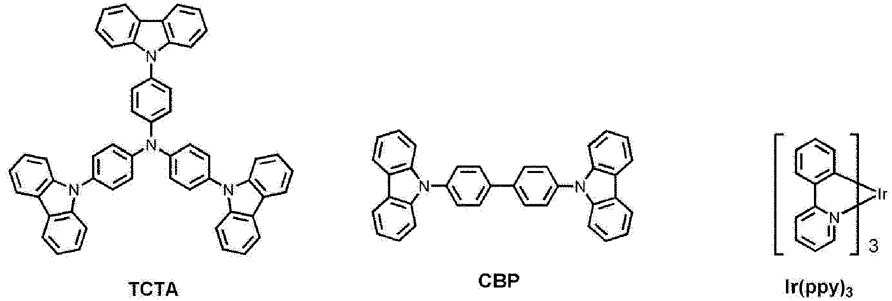

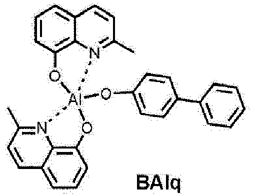

### Examples 36 to 57 and Comparative Examples 6 to 10

Additional organic light-emitting devices were manufactured in substantially the same manner as in Example 35, except that the compounds shown in Table 6 were used instead of Compounds 2-147a and 1-1 in forming each buffer layer and each electron transport layer.

### Evaluation Example 2

The driving voltage and efficiency of each of the organic light-emitting devices of Examples 35 to 57 and Comparative Examples 6 to 10 were evaluated using a Keithley SMU 236 meter. The results thereof are shown in Table 6.

**Table 6**

| | Buffer layer | Electron transport layer (weight ratio) | Driving voltage (V) | Efficiency (cd/A) |
|---|---|---|---|---|
| Example 35 | Compound 2-147a | Compound 1-1 | 5.6 | 39.0 |
| Example 36 | Compound 2-58 | Compound 1-1 | 5.7 | 39.2 |
| Example 37 | Compound 2-58 | Compound 1-1:LiQ (5:5) | 5.6 | 40.5 |
| Example 38 | Compound 2-64 | Compound 1-8 | 5.6 | 40.0 |
| Example 39 | Compound 2-162 | Compound 1-8 | 5.6 | 41.0 |
| Example 40 | Compound 2-162 | Compound 1-8:LiQ (5:5) | 5.6 | 41.5 |
| Example 41 | Compound 2-147a | Compound 1-9 | 5.8 | 39.0 |
| Example 42 | Compound 2-136a | Compound 1-13 | 5.6 | 40.5 |
| Example 43 | Compound 2-162 | Compound 1-13 | 5.7 | 40.2 |
| Example 44 | Compound 2-162 | Compound 1-13:LiQ (5:5) | 5.6 | 41.2 |
| Example 45 | Compound 2-58 | Compound 1-14 | 5.6 | 40.1 |
| Example 46 | Compound 2-162 | Compound 1-14 | 5.6 | 41.5 |
| Example 47 | Compound 2-58 | Compound 1-14:LiQ (5:5) | 5.7 | 40.5 |
| Example 48 | Compound 2-48 | Compound 1-15 | 5.7 | 39.5 |
| Example 49 | Compound 2-190 | Compound 1-15 | 5.8 | 39-7 |
| Example 50 | Compound 2-190 | Compound 1-15:LiQ (5:5) | 5.7 | 39.0 |
| Example 51 | Compound 2-136a | Compound 1-19 | 5.8 | 39.5 |
| Example 52 | Compound 2-64 | Compound 1-43 | 5.7 | 39.0 |
| Example 53 | Compound 2-48 | Compound 1-34 | 5.7 | 39.2 |
| Example 54 | Compound 2-48 | Compound 1-34:Li (98:2) | 5.6 | 40.0 |
| Example 55 | Compound 2-64 | Compound 1-45 | 5.8 | 38.5 |
| Example 56 | Compound 2-64 | Compound 1-45:LiQ. (5:5) | 5.7 | 38.8 |
| Example 57 | Compound 2-64 | Compound 1-45:Li (98:2) | 5.6 | 40.0 |
| Comparative Example 6 | BAlq | Alq₃ | 6.1 | 36.1 |
| Comparative Example 7 | BAlq | Compound 1-8 | 5.8 | 37.5 |
| Comparative Example 8 | BAlq | Compound 1-13 | 5.7 | 38.0 |
| Comparative Example 9 | Compound 2-136a | Alq₃ | 6.0 | 38.0 |
| Comparative Example 10 | Compound 2-58 | Alq₃ | 5.9 | 37.3 |

Referring to Table 6, each of the organic light-emitting devices of Examples 35 to 57 had a low driving voltage and high efficiency compared to each of the organic light-emitting devices of Comparative Examples 6 to 10.

### Example 58

An anode was prepared by cutting an ITO glass substrate (manufactured by Corning), on which ITO was formed to a thickness of 15 Ω/cm² (1,200 Å), to a size of 50 mm x 50 mm x 0.7 mm, ultrasonically cleaning the ITO glass substrate using isopropyl alcohol and pure water for 5 minutes each, and exposing to UV irradiation and ozone for 30 minutes to clean. Then, the ITO glass substrate was loaded into a vacuum deposition apparatus.

m-MTDATA was vacuum-deposited on the ITO glass substrate (anode) to form a hole injection layer having a thickness of 700 Å. Then, TCTA was vacuum-deposited on the hole injection layer to form a hole transport layer having a thickness of 100 Å.

CBP (as a host) and Ir(bzq)₃ (as a dopant) were co-deposited on the hole transport layer at a weight ratio of 96:4 to form an emission layer having a thickness of 300 Å.

Compound 2-136a was deposited on the emission layer to form a buffer layer having a thickness of 100 Å, and Compound 1-1 was deposited on the buffer layer to form an electron transport layer having a thickness of 200 Å. LiF was deposited on the electron transport layer to form an electron injection layer having a thickness of 10 Å. Al was vacuum-deposited on the electron injection layer to form a cathode having a thickness of 2,000 Å, thereby completing the manufacture of an organic light-emitting device.

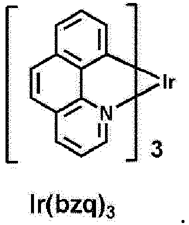

### Example 59 to 75 and Comparative Example 11 to 15

Additional organic light-emitting devices were manufactured in substantially the same manner as in Example 35, except that the compounds shown in Table 7 were each used instead of Compounds 2-136a and 1-1 in forming a buffer layer and an electron transport layer.

### Evaluation Example 3

The driving voltage and efficiency of each of the organic light-emitting devices of Examples 58 to 75 and Comparative Examples 11 to 15 were evaluated using a Keithley SMU 236 meter. The results thereof are shown in Table 7.

**Table 7**

| | Buffer layer | Electron transport layer (weight ratio) | Driving voltage (V) | Efficiency (cd/A) |
|---|---|---|---|---|
| Example 58 | Compound 2-136a | Compound 1-1 | 5.9 | 24 |
| Example 59 | Compound 2-64 | Compound 1-1 | 5.8 | 23.7 |
| Example 60 | Compound 2-64 | Compound 1-1:LiQ 5:5 | 5.7 | 24.2 |
| Example 61 | Compound 2-48 | Compound 1-8 | 5.8 | 24.1 |
| Example 62 | Compound 2-147a | Compound 1-8 | 5.8 | 23.5 |
| Example 63 | Compound 2-48 | Compound 1-8:LiQ (5:5) | 5.6 | 24.0 |
| Example 64 | Compound 2-147a | Compound 1-9 | 5.7 | 23.5 |
| Example 65 | Compound 2-147a | Compound 1-13 | 5.6 | 24.0 |
| Example 66 | Compound 2-190 | Compound 1-13 | 5.6 | 24.1 |
| Example 67 | Compound 2-147a | Compound 1-13:LiQ (5:5) | 5.6 | 24.5 |
| Example 68 | Compound 2-136a | Compound 1-14 | 5.7 | 23.2 |
| Example 69 | Compound 2-64 | Compound 1-14 | 5.7 | 24.2 |
| Example 70 | Compound 2-136a | Compound 1-14:LiQ (5:5) | 5.6 | 24.0 |
| Example 71 | Compound 2-136a | Compound 1-15 | 5.7 | 24.5 |
| Example 72 | Compound 2-162 | Compound 1-15 | 5.7 | 24.0 |
| Example 73 | Compound 2-136a | Compound 1-15:LiQ (5:5) | 5.6 | 24.2 |
| Example 74 | Compound 2-64 | Compound 1-45 | 5.8 | 23.5 |
| Example 75 | Compound 2-64 | Compound 1-45:Li (98:2) | 5.8 | 23.3 |
| Comparative Example 11 | BAlq | Alq₃ | 6.2 | 21.6 |
| Comparative Example 12 | BAlq | Compound 1-8 | 6.0 | 22.5 |
| Comparative Example 13 | BAlq | Compound 1-13 | 6.1 | 23.0 |
| Comparative Example 14 | Compound 2-136a | Alq₃ | 6.1 | 23.1 |
| Comparative Example 15 | Compound 2-58 | Alq₃ | 6.0 | 23.3 |

Referring to Table 7, each of the organic light-emitting devices of Examples 58 to 75 had a low driving voltage and high efficiency compared to each of the organic light-emitting devices of Comparative Examples 11 to 15.

### Example 76

An anode was prepared by cutting an ITO glass substrate (manufactured by Corning), on which ITO was formed to a thickness of 15 Ω/cm² (1,200 Å), to a size of 50 mm x 50 mm x 0.7 mm, ultrasonically cleaning the ITO glass substrate using isopropyl alcohol and pure water for 5 minutes each, and exposing to UV irradiation and ozone for 30 minutes to clean. Then, the ITO glass substrate was loaded into a vacuum deposition apparatus.

m-MTDATA was vacuum-deposited on the ITO glass substrate (anode) to form a hole injection layer having a thickness of 700 Å. Then, TCTA was vacuum-deposited on the hole injection layer to form a hole transport layer having a thickness of 100 Å.

CBP (as a host) and Ir(pq)₂(acac) (as a dopant) were co-deposited on the hole transport layer at a weight ratio of 96:4 to form an emission layer having a thickness of 300 Å.

Compound 2-48 was deposited on the emission layer to form a buffer layer having a thickness of 100 Å, and Compound 1-13 was deposited on the buffer layer to form an electron transport layer having a thickness of 200 Å. LiF was deposited on the electron transport layer to form an electron injection layer having a thickness of 10 Å. Al was vacuum-deposited on the electron injection layer to form a cathode having a thickness of 2,000 Å, thereby completing the manufacture of an organic light-emitting device.

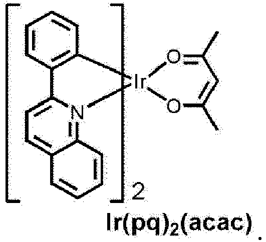

### Comparative Example 16

An additional organic light-emitting device was manufactured in substantially the same manner as in Example 76, except that the compounds shown in Table 8 were each used instead of Compounds 2-48 and 1-13 in forming a buffer layer and an electron transport layer.

### Evaluation Example 4

The driving voltage and efficiency of each of the organic light-emitting devices of Example 76 and Comparative Example 16 were evaluated using a Keithley SMU 236 meter. The results thereof are shown in Table 8.

**Table 8**

| | Buffer layer | Electron transport layer | Driving voltage (V) | Efficiency (cd/A) |
|---|---|---|---|---|
| Example 76 | Compound 2-48 | Compound 1-13 | 5.7 | 28.0 |
| Comparative Example 16 | BAlq | Alq₃ | 6.2 | 25-4 |

Referring to Table 8, the organic light-emitting device of Example 76 had a low driving voltage and high efficiency compared to the organic light-emitting device of Comparative Example 16.

According to one or more embodiments of the present disclosure, an organic light-emitting device may have a low driving voltage and high efficiency.

It should be understood that the example embodiments described herein should be considered in a descriptive sense only and not for purposes of limitation. Descriptions of features or aspects within each embodiment should typically be considered as being available for other similar features or aspects in other embodiments.

As used herein, the terms "use", "using", and "used" may be considered synonymous with the terms "utilize", "utilizing", and "utilized", respectively. Further, the use of "may" when describing embodiments of the present disclosure refers to "one or more embodiments of the present disclosure".

As used herein, the terms "substantially", "about", and similar terms are used as terms of approximation and not as terms of degree, and are intended to account for the inherent deviations in measured or calculated values that would be recognized by those of ordinary skill in the art.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, For example, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

While one or more embodiments have been described with reference to the drawings, it will be understood by those of ordinary skill in the art that various changes in form and details may be made therein without departing from the scope of the present disclosure as defined by the following claims.

## Claims

1. An organic light-emitting device (12) comprising:
a first electrode (110);
a second electrode (190) facing the first electrode (110);
an emission layer (155) between the first electrode (110) and the second electrode (190);
a hole transport region between the first electrode (110) and the emission layer (155); and
an electron transport region between the emission layer (155) and the second electrode (190),
wherein the electron transport region comprises a first compound,
at least one selected from the hole transport region and the electron transport region comprises a second compound,
the first compound is represented by Formulae 1A or 1B, and
the second compound is represented by Formula 2A or 2B: 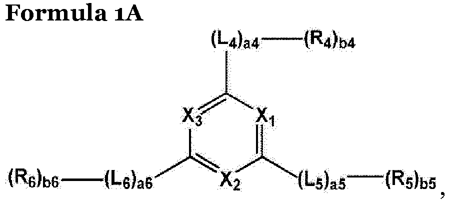 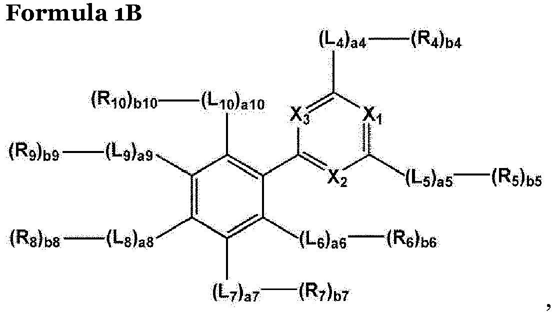 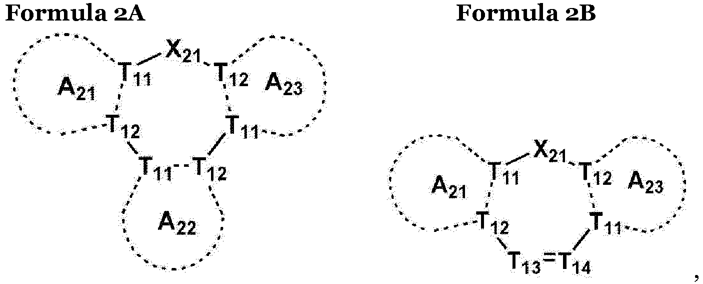
wherein, in Formulae 1A, 1B, 2A, and 2B,
rings A₂₁, A₂₂, and A₂₃ are each independently a C₅-C₆₀ carbocyclic group or a C₁-C₃₀ heterocyclic group, each substituted with at least one ^{∗}-[(L₂₂)ₐ₂₂-(R₂₂)_{b22}], in which * is a bonding site to the A₂₁, A₂₂, or A₂₃ ring,
each T₁₁ is independently carbon or nitrogen,
each T₁₂ is ndependently carbon or nitrogen,
T₁₃ is N or C(R₂₇),
T₁₄ is N or C(R₂₈),
each bond between T₁₁ and T₁₂ represented as a dashed line in formulae 2A and 2B is a single bond or a double bond;
the six atoms represented by the three T₁₁(s) and three T₁₂(s) in Formula 2A are not all nitrogen, and the six atoms represented by the two T₁₁(s), two T₁₂(s), T₁₃, and T₁₄ in Formula 2B are not all nitrogen,
rings A₂₁, A₂₂, and A₂₃ are each condensed with the central 7-membered ring in Formulae 2A and 2B, such that they each share a T₁₁ and a T₁₂ with the central 7-membered ring,
X₁ is N or C-(L₁)ₐ₁-(R₁)_{b1}, X₂ is N or C-(L₂)ₐ₂-(R₂)_{b2}, X₃ is N or C-(L₃)ₐ₃-(R₃)_{b3}, and at least one selected from X₁ to X₃ is N,
X₂₁ is N-[(L₂₁)ₐ₂₁-(R₂₁)_{b21}],
or X₂₁ is O, S, Se, C(R₂₃)(R₂₄), or Si(R₂₃)(R₂₄) and at least one selected from rings A₂₁, A₂₂, and A₂₃ in Formula 2A and at least one selected from rings A₂₁ and A₂₃ in Formula 2B are each independently selected from groups represented by Formulae 2-1 to 2-3, 2-10 to 2-27, and 2-33 to 2-36, wherein in Formulae 2-1 to 2-3, 2-10 to 2-27, and 2-33 to 2-36 at least one of X₂₂ and X₂₃ is N-[(L₂₂)ₐ₂₂-(R₂₂)_{b22}], 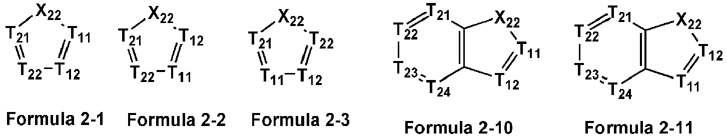 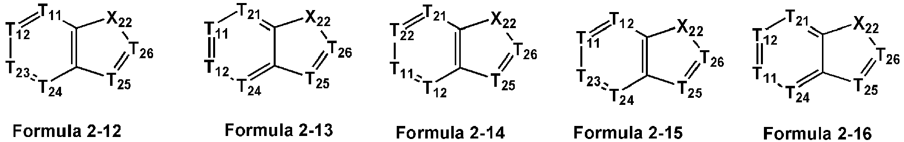 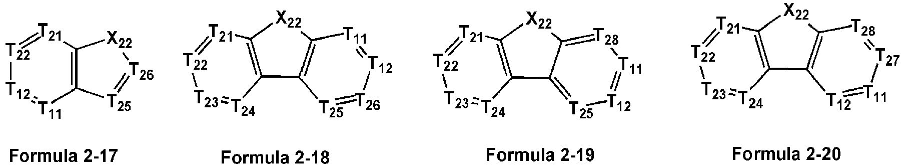 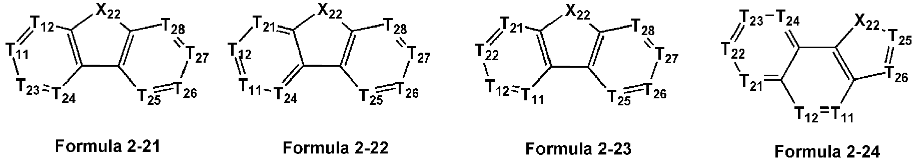 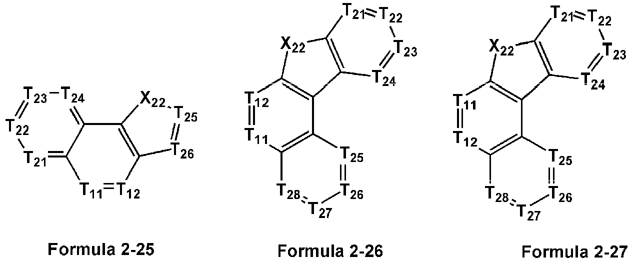 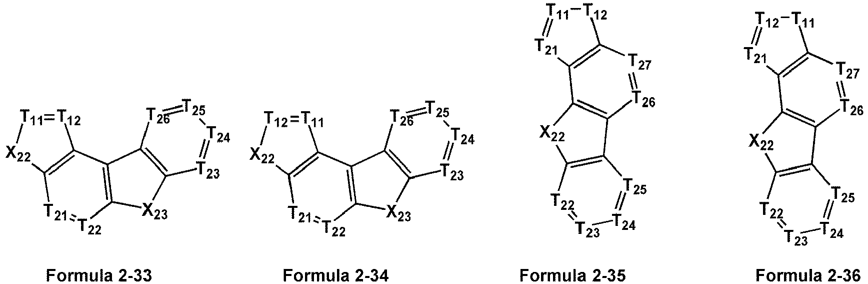
X₂₂ and X₂₃ are each independently O, S, Se, or a moiety comprising C, N, and/or Si, and
T₂₁ to T₂₈ are each independently N or a moiety comprising C,
L₁ to L₁₀, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8- C60 polycyclic group, and a substituted or unsubstituted divalent non-aromatic condensed 8- to 60-membered heteropolycyclic group,
a1 to a10, a21, and a22 are each independently an integer selected from 0 to 5,
R₂, R₃ and R₆ to R₁₀, R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
b1 to b10, b21, and b22 are each independently an integer selected from 1 to 4, provided that each of b1 to b10, b21, and b22 is 1 when each respective a1 to a10, a21, or a22 is zero,
R₁ and R₄ are are each independently as defined for R₂, or when a1 and a4 are both 0, may optionally be connected to form a C₅-C₆₀ carbocyclic group or a C₁-C₃₀ heterocyclic group,
R₅ is as defined for R₂, or when a1 and a5 are both 0 and when R₁ and R₄ are not linked to form a cyclic group, R₅ may optionally connected to R₁ to form a C₅-C₆₀ carbocyclic group or a C₁-C₃₀ heterocyclic group, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8- C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8- C60 polycyclic group, and the substituted monovalent non-aromatic condensed 8- to 60-membered heteropolycyclic group is each independently substituted with one or more substituents selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8- to 60-membered heteropolycyclic group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8- C60 polycyclic group, a monovalent non-aromatic condensed 8-to 60-membered heteropolycyclic group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8- C60 polycyclic group, and a monovalent non-aromatic condensed 8- to 60-membered heteropolycyclic group.

2. The organic light-emitting device (12) of claim 1, wherein:
rings A₂₁, A₂₂, and A₂₃ in Formulae 2A and 2B are each independently selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrolene group, a cyclopentanaphthalene group, a naphthosilole group, a naphthoselenophene group, a naphthofuran group, a naphthothienophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and an naphthoindole group, each substituted with at least one ^{∗}-[(L₂₂)ₐ₂₂-(R₂₂)b₂₂].

3. The organic light-emitting device (12) of claim 1 or claim 2, wherein:
rings A₂₁, A₂₂, and A₂₃ in Formulae 2A and 2B are each independently selected from groups represented by Formulae 2-1 to 2-36, each substituted with at least one ^{∗}-[(L₂₂)ₐ₂₂-(R₂₂)_{b22}]: 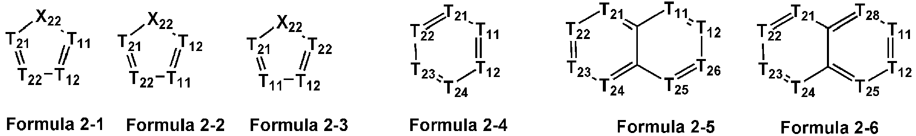 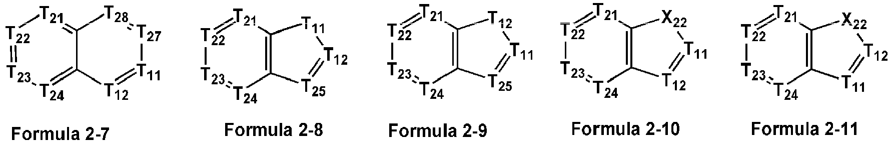 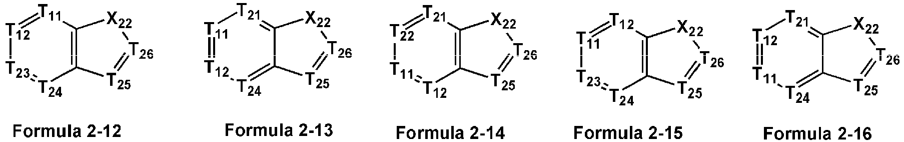 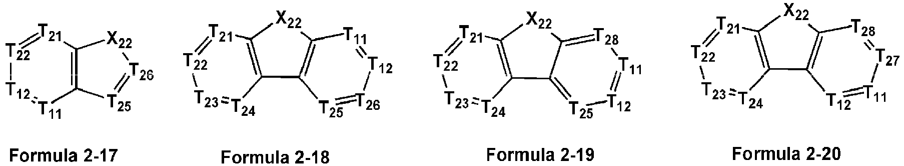 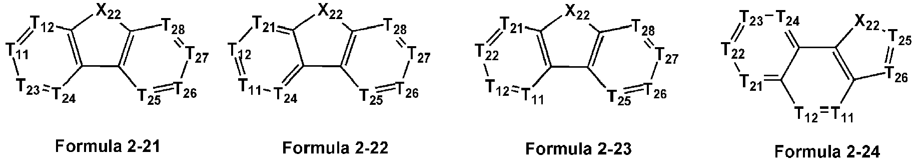 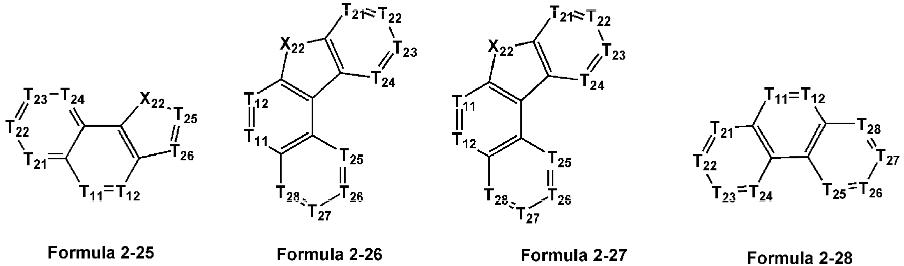 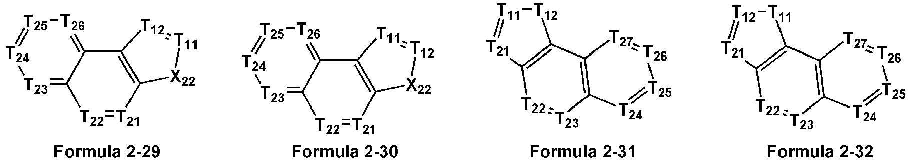 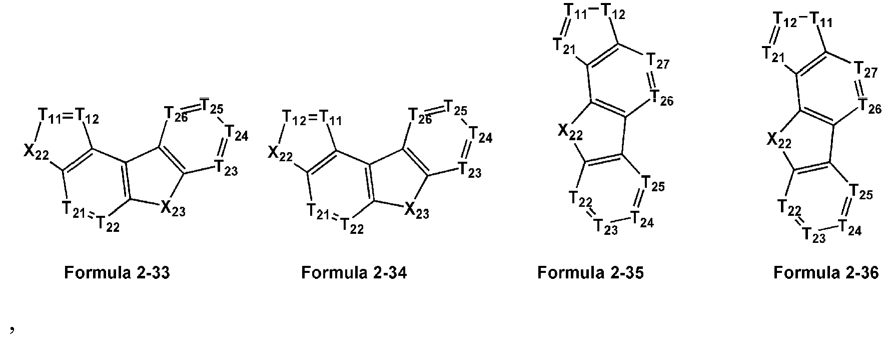
wherein, in Formulae 2-1 to 2-36,
T₁₁, T₁₂ and T₂₁ to T₂₈ are as defined in claim 1, and
X₂₂ and X₂₃ are each independently O, S, Se, or a moiety comprising C, N, and/or Si.

4. The organic light-emitting device (12) of any one of the preceding claims, wherein:
i) in Formulae 1A and 1B,
X₁ is N, X₂ is C-(L₂)ₐ₂-(R₂)_{b2}, and X₃ is C-(L₃)ₐ₃-(R₃)_{b3},
X₁ is N, X₂ is N, and X₃ is C-(L₃)ₐ₃-(R₃)_{b3}, or
X₁, X₂, and X₃ are N.

5. The organic light-emitting device (12) of any one of the preceding claims wherein:
L₁ to L₁₀ are each independently selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyridinylene group, a pyrazinylene group, a pyrimidinylene group, a pyridazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a triazinylene group, a dibenzofuranylene group, a dibenzothiophenylene group, a dibenzosilolylene group, a carbazolylene group, a benzocarbazolylene group, a dibenzocarbazolylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyridinylene group, a pyrazinylene group, a pyrimidinylene group, a pyridazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a triazinylene group, a dibenzofuranylene group, a dibenzothiophenylene group, a dibenzosilolylene group, a carbazolylene group, a benzocarbazolylene group, a dibenzocarbazolylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), and
L₂₁ and L₂₂ are each independently selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

6. The organic light-emitting device (12) of any one of the preceding claims, wherein:
R₁ to R₁₀ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, and a hydrazono group;
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a tetraphenyl group, a pyridinyl group, a pyrazinyl group, a pyrimidinyl group, a pyridazinyl group, a quinolinyl group, an isoquinolinyl group, a benzoquinolinyl group, a phthalazinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, a benzocarbazolyl group, a dibenzocarbazolyl group, a dibenzosilolyl group, an azafluorenyl group, an azaspiro-bifluorenyl group, an azacarbazolyl group, an azadibenzofuranyl group, an azadibenzothiophenyl group, an azadibenzosilolyl group, a benzofuranopyrimidinyl group, a benzothienopyrimidyl group, a pyrimidinoquinoxalinyl group, and an azaindenopyridinyl group; and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a tetraphenyl group, a pyridinyl group, a pyrazinyl group, a pyrimidinyl group, a pyridazinyl group, a quinolinyl group, an isoquinolinyl group, a benzoquinolinyl group, a phthalazinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, a benzocarbazolyl group, a dibenzocarbazolyl group, a dibenzosilolyl group, an azafluorenyl group, an azaspiro-bifluorenyl group, an azacarbazolyl group, an azadibenzofuranyl group, an azadibenzothiophenyl group, an azadibenzosilolyl group, a benzofuranopyrimidinyl group, a benzothienopyrimidyl group, a pyrimidinoquinoxalinyl group, and an azaindenopyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

7. The organic light-emitting device (12) of any one of the preceding claims, wherein:
R₂₁ to R₂₄, R₂₇, and R₂₈ are each independently selected from the group consisting of:
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an aza fluorenyl group, an azaspiro-bifluorenyl group, an azacarbazolyl group, an azadibenzofuranyl group, an azadibenzothiophenyl group, and an azadibenzosilolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8- C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), or
R₂₂ is selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₁)(Q₂)(Q₃), -S(=O)₂(Q₁), and -P(=O)(Q₁)(Q₂),
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with a C₁-C₁₀ alkyl group, a C₁-C₁₀ alkoxy group, and a phenyl group.

8. The organic light-emitting device (12) of any one of the preceding claims, wherein:
the first compound is represented by one selected from Formulae 1A(1) to 1A(3), and 1B(1) to 1B(5): 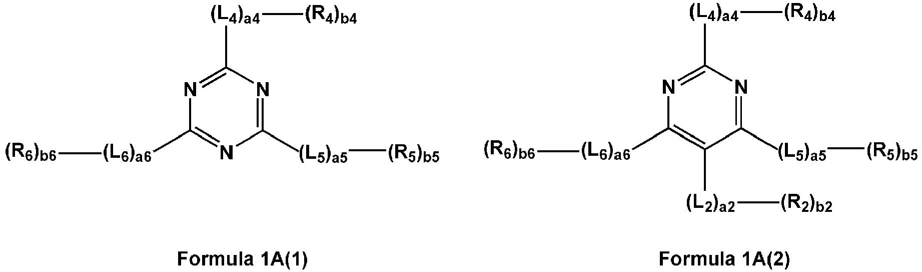 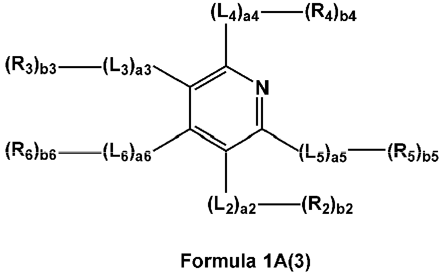 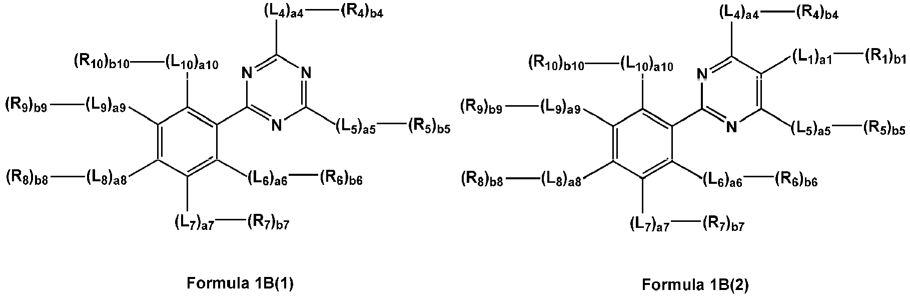 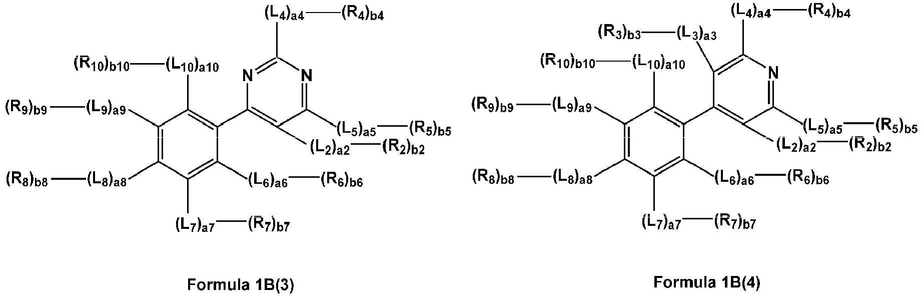 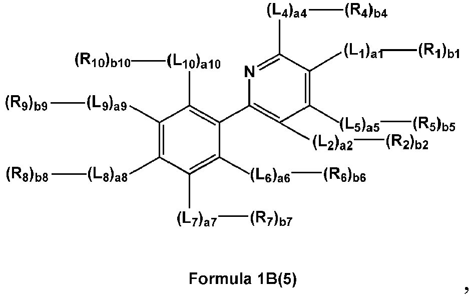
wherein L₁ to L₁₀, a1 to a10, R₁ to R₁₀, b1 to b10, in Formulae 1A(1) to 1A(3), and 1B(1) to 1B(5), are as defined in any of claims 1, 5 and 6.

9. The organic light-emitting device (12) of any one of the preceding claims, wherein:
(a) the hole transport region comprises an emission auxiliary layer (154), the emission auxiliary layer (154) directly contacts the emission layer (155), and the second compound is comprised in the emission auxiliary layer (154); and/or
(b) the electron transport region comprises a buffer layer (156), the buffer layer (156) directly contacts the emission layer (155), and the second compound is comprised in the buffer layer (156).

10. The organic light-emitting device (12) of any one of the preceding claims, wherein:
the electron transport region comprises a buffer layer (156), an electron transport layer (157), and an electron injection layer (159), and
the first compound is comprised in the electron transport layer (157).

11. The organic light-emitting device (12) of claim 10, wherein:
(a) the electron transport layer (157) comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof; or
(b) the electron injection layer (159) comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof; preferably wherein the electron injection layer (159) comprises Li, Na, K, Rb, Cs, Mg, Ca, Er, Tm, Yb, or a combination thereof.

12. The organic light-emitting device (12) of any one of the preceding claims, wherein:
the hole transport region comprises a p-dopant, and
the p-dopant has a lowest unoccupied molecular orbital (LUMO) energy level of about -3.5 eV or less;
preferably wherein the p-dopant comprises a cyano group-containing compound.

13. The organic light-emitting device (12) of any one of the preceding claims, wherein:
the emission layer (155) is a first-color-light emission layer,
the organic light-emitting device (12) further comprises i) at least one second-color-light emission layer or ii) at least one second-color-light emission layer and at least one third-color-light emission layer, each between the first electrode (110) and the second electrode (190),
a maximum emission wavelength of the first-color-light emission layer, a maximum emission wavelength of the second-color-light emission layer, and a maximum emission wavelength of the third-color-light emission layer are identical to or different from one another, and
the organic light-emitting device (12) emits a mixed light comprising a first-color-light and a second-color-light, or a mixed light comprising the first-color-light, the second-color-light, and a third-color-light.

## Patentansprüche

1. Organische lichtemittierende Vorrichtung (12), umfassend:
eine erste Elektrode (110);
eine zweite Elektrode (190), die der ersten Elektrode (110) gegenüberliegt;
eine Emissionsschicht (155) zwischen der ersten Elektrode (110) und der zweiten Elektrode (190);
einen Lochtransportbereich zwischen der ersten Elektrode (110) und der Emissionsschicht (155); und
einen Elektronentransportbereich zwischen der Emissionsschicht (155) und der zweiten Elektrode (190);
wobei der Elektronentransportbereich eine erste Verbindung umfasst,
mindestens einer, ausgewählt aus dem Lochtransportbereich und dem Elektronentransportbereich, eine zweite Verbindung umfasst,
die erste Verbindung durch Formel 1A oder 1B dargestellt wird, und
die zweite Verbindung durch Formel 2A oder 2B dargestellt wird: 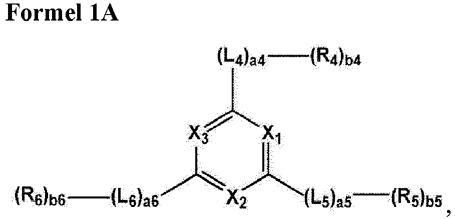 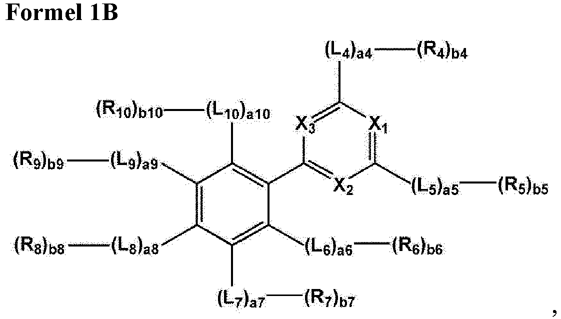 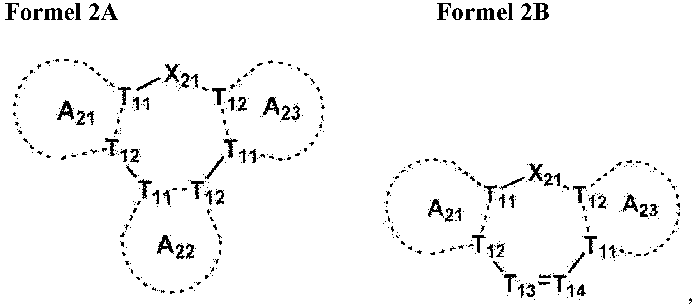
wobei, in den Formeln 1A, 1B, 2A und 2B,
die Ringe A₂₁, A₂₂ und A₂₃ jeweils unabhängig voneinander ein carbocyclischer C₅-C₆₀-Rest oder ein heterocyclischer C₁-C₃₀-Rest sind, jeweils substituiert mit mindestens einem ^{∗}-[(L₂₂)ₐ₂₂-(R₂₂)_{b22}], bei dem * eine Bindungsstelle zu dem Ring A₂₁, A₂₂ oder A₂₃ ist,
jedes T₁₁ unabhängig Kohlenstoff oder Stickstoff ist,
jedes T₁₂ unabhängig Kohlenstoff oder Stickstoff ist,
T₁₃ N oder C(R₂₇) ist,
T₁₄ N oder C(R₂₈) ist,
jede Bindung zwischen T₁₁ und T₁₂, dargestellt durch eine gestrichelte Linie in den Formeln 2A und 2B, eine Einfachbindung oder eine Doppelbindung ist;
die sechs Atome, dargestellt durch die drei T₁₁ und drei T₁₂ in Formel 2A, nicht alle Stickstoff sind, und die sechs Atome, dargestellt durch die zwei T₁₁, zwei T₁₂, T₁₃ und T₁₄ in Formel 2B, nicht alle Stickstoff sind,
die Ringe A₂₁, A₂₂ und A₂₃ in den Formeln 2A und 2B jeweils mit dem zentralen 7-gliedrigen Ring kondensiert sind, derart, dass sie jeweils ein T₁₁ und ein T₁₂ mit dem zentralen 7-gliedrigen Ring teilen,
X₁ N oder C-(L₁)ₐ₁-(R₁)_{b1} ist, X₂ N oder C-(L₂)ₐ₂-(R₂)_{b2} ist, X₃ N oder C-(L₃)ₐ₃-(R₃)_{b3} ist, und mindestens eines, ausgewählt aus X₁ bis X₃, N ist,
X₂₁ N-[(L₂₁)ₐ₂₁-(R₂₁)_{b21}] ist,
oder X₂₁ O, S, Se, C(R₂₃)(R₂₄) oder Si(R₂₃)(R₂₄) ist, und mindestens einer, ausgewählt aus den Ringen A₂₁, A₂₂ und A₂₃ in Formel 2A, und mindestens einer, ausgewählt aus den Ringen A₂₁ und A₂₃ in Formel 2B, jeweils unabhängig voneinander ausgewählt sind aus Gruppen, dargestellt durch die Formeln 2-1 bis 2-3, 2-10 bis 2-27 und 2-33 bis 2-36, wobei in den Formeln 2-1 bis 2-3, 2-10 bis 2-27 und 2-33 bis 2-36 mindestens eines von X₂₂ und X₂₃ N-[(L₂₂)ₐ₂₂-(R₂₂)_{b22}] ist, 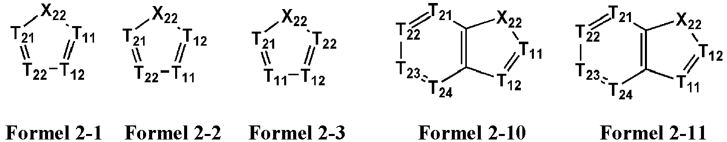 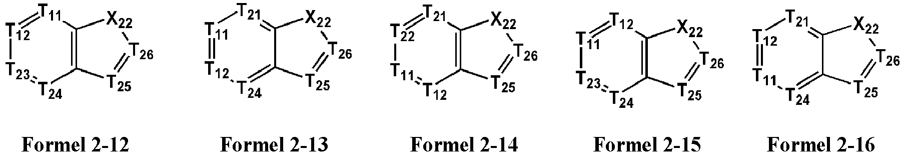 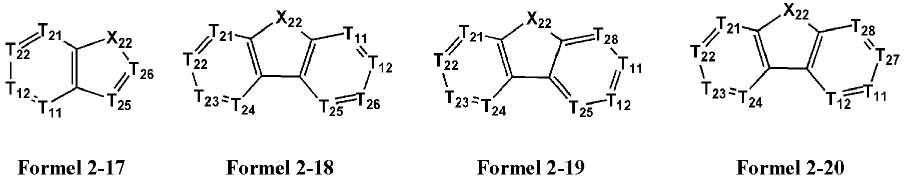 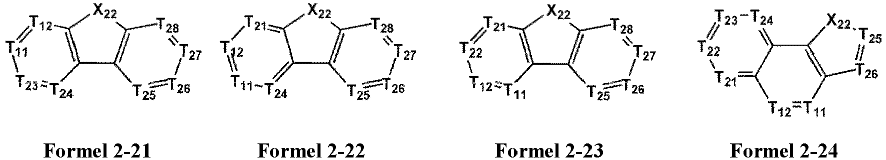 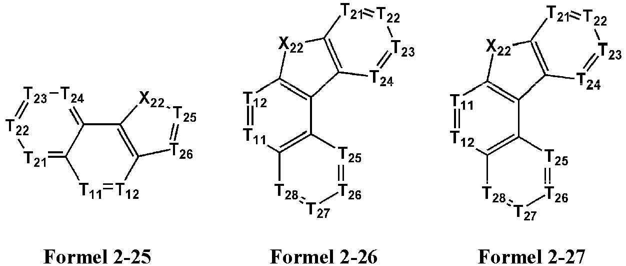 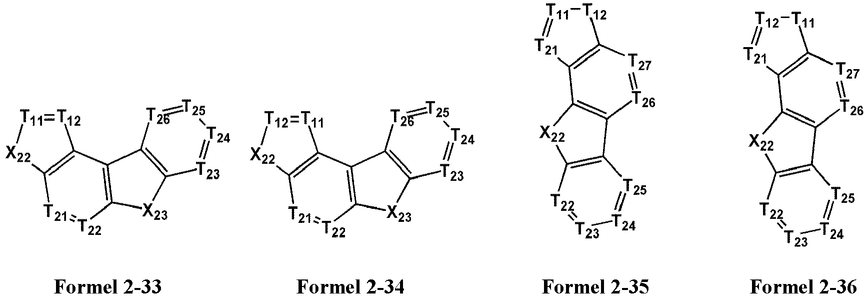
X₂₂ und X₂₃ jeweils unabhängig voneinander O, S, Se oder eine C, N und/oder Si umfassende Einheit sind, und
T₂₁ bis T₂₈ jeweils unabhängig voneinander N oder eine C umfassende Einheit sind,
L₁ bis L₁₀, L₂₁ und L₂₂ jeweils unabhängig voneinander ausgewählt sind aus einem substituierten oder unsubstituierten C₃-C₁₀-Cycloalkylenrest, einem substituierten oder unsubstituierten C₁-C₁₀-Heterocycloalkylenrest, einem substituierten oder unsubstituierten C₃-C₁₀-Cycloalkenylenrest, einem substituierten oder unsubstituierten C₁-C₁₀-Heterocycloalkenylenrest, einem substituierten oder unsubstituierten C₆-C₆₀-Arylenrest, einem substituierten oder unsubstituierten C₁-C₆₀-Heteroarylenrest, einem substituierten oder unsubstituierten zweiwertigen, nichtaromatischen, kondensierten polycyclischen C₈-C₆₀-Rest und einem substituierten oder unsubstituierten zweiwertigen, nichtaromatischen, kondensierten heteropolycyclischen 8- bis 60-gliedrigen Rest,
a1 bis a10, a21 und a22 jeweils unabhängig voneinander eine aus 0 bis 5 ausgewählte ganze Zahl sind,
R₂, R₃ und R₆ bis R₁₀, R₂₁ bis R₂₄, R₂₇ und R₂₈ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem substituierten oder unsubstituierten C₁-C₆₀-Alkylrest, einem substituierten oder unsubstituierten C₂-C₆₀-Alkenylrest, einem substituierten oder unsubstituierten C₂-C₆₀-Alkinylrest, einem substituierten oder unsubstituierten C₁-C₆₀-Alkoxyrest, einem substituierten oder unsubstituierten C₃-C₁₀-Cycloalkylrest, einem substituierten oder unsubstituierten C₁-C₁₀-Heterocycloalkylrest, einem substituierten oder unsubstituierten C₃-C₁₀-Cycloalkenylrest, einem substituierten oder unsubstituierten C₁-C₁₀-Heterocycloalkenylrest, einem substituierten oder unsubstituierten C₆-C₆₀-Arylrest, einem substituierten oder unsubstituierten C₆-C₆₀-Aryloxyrest, einem substituierten oder unsubstituierten C₆-C₆₀-Arylthiorest, einem substituierten oder unsubstituierten C₁-C₆₀-Heteroarylrest, einem substituierten oder unsubstituierten einwertigen, nichtaromatischen, kondensierten polycyclischen C₈-C₆₀-Rest, einem substituierten oder unsubstituierten einwertigen, nichtaromatischen, kondensierten heteropolycyclischen 8- bis 60-gliedrigen Rest, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂),
b1 bis b10, b21 und b22 jeweils unabhängig voneinander eine aus 1 bis 4 ausgewählte ganze Zahl sind, mit der Maßgabe, dass jedes von b 1 bis b 10, b21 und b22 1 ist, wenn jedes entsprechende a1 bis a10, a21 oder a22 Null ist,
R₁ und R₄ jeweils unabhängig voneinander die für R₂ angegebene Bedeutung haben, oder wenn a1 und a4 beide 0 sind, gegebenenfalls verbunden sein können, um einen carbocyclischen C₅-C₆₀-Rest oder einen heterocyclischen C₁-C₃₀-Rest zu bilden, und
R₅ die für R₂ angegebene Bedeutung hat, oder wenn a1 und a5 beide 0 sind und wenn R₁ und R₄ nicht verbunden sind, um einen cyclischen Rest zu bilden, R₅ gegebenenfalls mit R₁ verbunden sein kann, um einen carbocyclischen C₅-C₆₀-Rest oder einen heterocyclischen C₁-C₃₀-Rest zu bilden, und
der substituierte C₃-C₁₀-Cycloalkylenrest, der substituierte C₁-C₁₀-Heterocycloalkylenrest, der substituierte C₃-C₁₀-Cycloalkenylenrest, der substituierte C₁-C₁₀-Heterocycloalkenylenrest, der substituierte C₆-C₆₀-Arylenrest, der substituierte C₁-C₆₀-Heteroarylenrest, der substituierte zweiwertige, nichtaromatische, kondensierte polycyclische C₈-C₆₀-Rest, der substituierte zweiwertige, nichtaromatische, kondensierte heteropolycyclische 8- bis 60-gliedrige Rest, der substituierte C₁-C₆₀-Alkylrest, der substituierte C₂-C₆₀-Alkenylrest, der substituierte C₂-C₆₀-Alkinylrest, der substituierte C₁-C₆₀-Alkoxyrest, der substituierte C₃-C₁₀-Cycloalkylrest, der substituierte C₁-C₁₀-Heterocycloalkylrest, der substituierte C₃-C₁₀-Cycloalkenylrest, der substituierte C₁-C₁₀-Heterocycloalkenylrest, der substituierte C₆-C₆₀-Arylrest, der substituierte C₆-C₆₀-Aryloxyrest, der substituierte C₆-C₆₀-Arylthiorest, der substituierte C₁-C₆₀-Heteroarylrest, der substituierte einwertige, nichtaromatische, kondensierte polycyclische C₈-C₆₀-Rest und der substituierte einwertige, nichtaromatische, kondensierte heteropolycyclische 8- bis 60-gliedrige Rest jeweils unabhängig substituiert ist mit einem oder mehreren Substituenten, ausgewählt aus der Gruppe bestehend aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest und einem C₁-C₆₀-Alkoxyrest;
einem C₁-C₆₀-Alkylrest, einem C₂-C₆₀-Alkenylrest, einem C₂-C₆₀-Alkinylrest und einem C₁-C₆₀-Alkoxyrest, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, einer Biphenylgruppe und einer Terphenylgruppe,
einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteroarylrest, einem einwertigen, nichtaromatischen, kondensierten polycyclischen C₈-C₆₀-Rest und einem einwertigen, nichtaromatischen, kondensierten heteropolycyclischen 8- bis 60-gliedrigen Rest, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest, einem C₁-C₆₀-Alkoxyrest, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest, einem C₁-C₆₀-Alkoxyrest, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem mit einem C₁-C₆₀-Alkylrest substituierten C₆-C₆₀-Arylrest, einem mit einem C₆-C₆₀-Arylrest substituierten C₆-C₆₀-Arylrest, einer Terphenylgruppe, einem C₁-C₆₀-Heteroarylrest, einem mit einem C₁-C₆₀-Alkylrest substituierten C₁-C₆₀-Heteroarylrest, einem mit einem C₆-C₆₀-Arylrest substituierten C₁-C₆₀-Heteroarylrest, einem einwertigen, nichtaromatischen, kondensierten polycyclischen C₈-C₆₀-Rest und einem einwertigen, nichtaromatischen, kondensierten heteropolycyclischen 8- bis 60-gliedrigen Rest.

2. Organische lichtemittierende Vorrichtung (12) nach Anspruch 1, wobei:
die Ringe A₂₁, A₂₂ und A₂₃ in den Formeln 2A und 2B jeweils unabhängig voneinander ausgewählt sind aus einer Benzolgruppe, einer Naphthalingruppe, einer Anthracengruppe, einer Indengruppe, einer Fluorengruppe, einer Pyridingruppe, einer Pyrimidingruppe, einer Pyrazingruppe, einer Pyridazingruppe, einer Chinolingruppe, einer Isochinolingruppe, einer Pyrrolgruppe, einer Pyrazolgruppe, einer Imidazolgruppe, einer Oxazolgruppe, einer Thiazolgruppe, einer Cyclopentadiengruppe, einer Silolgruppe, einer Selenophengruppe, einer Furangruppe, einer Thiophengruppe, einer Indolgruppe, einer Benzimidazolgruppe, einer Benzoxazolgruppe, einer Benzothiazolgruppe, einer Indengruppe, einer Benzosilolgruppe, einer Benzoselenophengruppe, einer Benzofurangruppe, einer Benzothiophengruppe, einer Carbazolgruppe, einer Fluorengruppe, einer Dibenzosilolgruppe, einer Dibenzoselenophengruppe, einer Dibenzofurangruppe, einer Dibenzothiophengruppe, einer Pyrrolopyridingruppe, einer Cyclopentapyridingruppe, einer Silolopyridingruppe, einer Selenophenopyridingruppe, einer Furopyridingruppe, einer Thienopyridingruppe, einer Pyrrolopyrimidingruppe, einer Cyclopentapyrimidingruppe, einer Silolopyrimidingruppe, einer Selenophenopyrimidingruppe, einer Furopyrimidingruppe, einer Thienopyrimidingruppe, einer Pyrrolopyrazingruppe, einer Cyclopentapyrazingruppe, einer Silolopyrazingruppe, einer Selenophenopyrazingruppe, einer Furopyrazingruppe, einer Thienopyrazingruppe, einer Naphthopyrrolengruppe, einer Cyclopentanaphthalingruppe, einer Naphthosilolgruppe, einer Naphthoselenophengruppe, einer Naphthofurangruppe, einer Naphthothienophengruppe, einer Pyrrolochinolingruppe, einer Cyclopentachinolingruppe, einer Silolochinolingruppe, einer Selenophenochinolingruppe, einer Furochinolingruppe, einer Thienochinolingruppe, einer Pyrroloisochinolingruppe, einer Cyclopentaisochinolingruppe, einer Siloloisochinolingruppe, einer Selenophenoisochinolingruppe, einer Furoisochinolingruppe, einer Thienoisochinolingruppe, einer Azacarbazolgruppe, einer Azafluorengruppe, einer Azadibenzosilolgruppe, einer Azadibenzoselenophengruppe, einer Azadibenzofurangruppe, einer Azadibenzothiophengruppe, einer Indenochinolingruppe, einer Indenoisochinolingruppe, einer Indenochinoxalingruppe, einer Phenanthrolingruppe und einer Naphthoindolgruppe, jeweils substituiert mit mindestens einem ^{∗}-[(L₂₂)ₐ₂₂-(R₂₂)_{b22}].

3. Organische lichtemittierende Vorrichtung (12) nach Anspruch 1 oder Anspruch 2, wobei:
die Ringe A₂₁, A₂₂ und A₂₃ in den Formeln 2A und 2B jeweils unabhängig voneinander ausgewählt sind aus durch die Formeln 2-1 bis 2-36 dargestellten Gruppen, jeweils substituiert mit mindestens einem ^{∗}-[(L₂₂)ₐ₂₂-(R₂₂)_{b22}]: 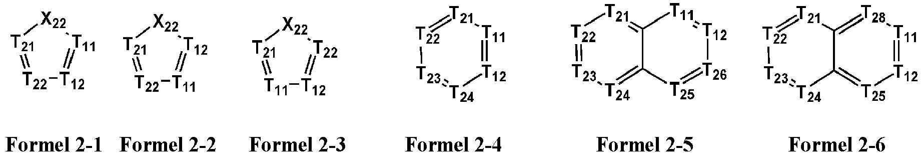 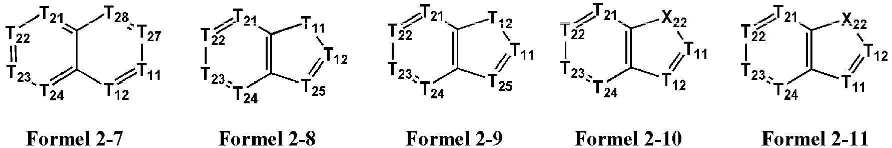 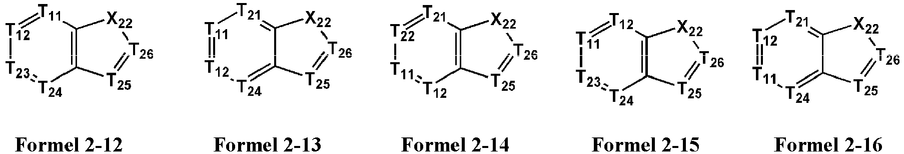 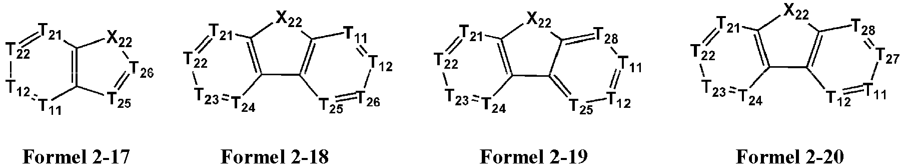 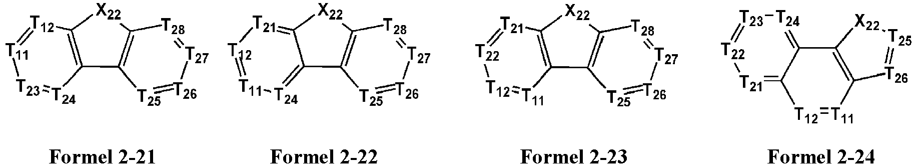 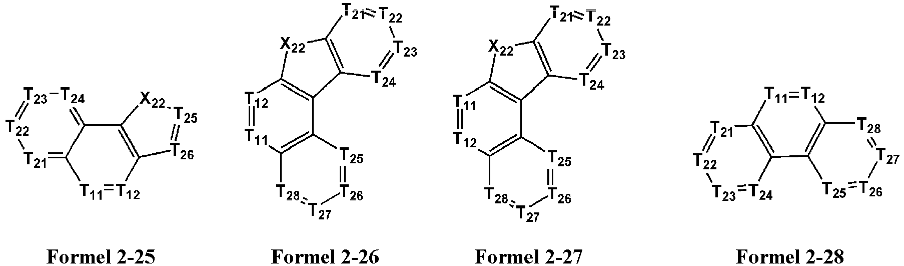 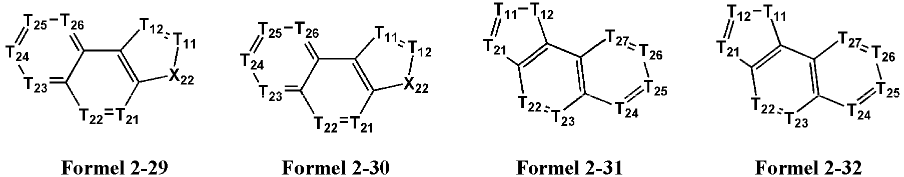 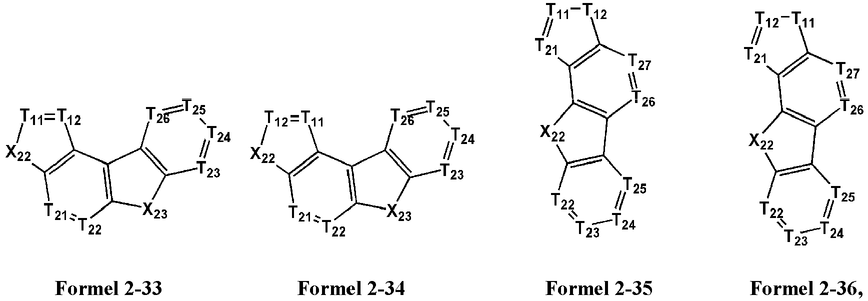
wobei, in den Formeln 2-1 bis 2-36,
T₁₁, T₁₂ und T₂₁ bis T₂₈ wie in Anspruch 1 definiert sind, und
X₂₂ und X₂₃ jeweils unabhängig voneinander O, S, Se oder eine C, N und/oder Si umfassende Einheit sind.

4. Organische lichtemittierende Vorrichtung (12) nach einem der vorangehenden Ansprüche, wobei:
i) in den Formeln 1A und 1B,
X₁ N ist, X₂ C-(L₂)ₐ₂-(R₂)_{b2} ist und X₃ C-(L₃)ₐ₃-(R₃)_{b3} ist,
X₁ N ist, X₂ N ist und X₃ C-(L₃)ₐ₃-(R₃)_{b3} ist, oder
X₁, X₂ und X₃ N sind.

5. Organische lichtemittierende Vorrichtung (12) nach einem der vorangehenden Ansprüche, wobei:
L₁ bis L₁₀ jeweils unabhängig voneinander ausgewählt sind aus der Gruppe bestehend aus:
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Spirobenzofluorenfluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Spirobenzofluorenfluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
L₂₁ und L₂₂ jeweils unabhängig voneinander ausgewählt sind aus der Gruppe bestehend aus:
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Spirobenzofluorenfluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Spirobenzofluorenfluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einem Cs-Cio-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₃₁ bis Q₃₃ jeweils unabhängig voneinander ausgewählt sind aus der Gruppe bestehend aus:
einem C₁-C₁₀-Alkylrest, einem C₁-C₁₀-Alkoxyrest, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einem, ausgewählt aus einem C₁-C₁₀-Alkylrest, einem C₁-C₁₀-Alkoxyrest und einer Phenylgruppe.

6. Organische lichtemittierende Vorrichtung (12) nach einem der vorangehenden Ansprüche, wobei:
R₁ bis R₁₀ jeweils unabhängig voneinander ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest und einem C₁-C₂₀-Alkoxyrest;
einem C₁-C₂₀-Alkylrest und einem C₁-C₂₀-Alkoxyrest, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe und einer Hydrazonogruppe,
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Spirobenzofluorenfluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Tetraphenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Carbazolylgruppe, einer Phenanthridinylgruppe, einer Acridinylgruppe, einer Phenanthrolinylgruppe, einer Phenazinylgruppe, einer Triazinylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Azafluorenylgruppe, einer Azaspirobifluorenylgruppe, einer Azacarbazolylgruppe, einer Azadibenzofuranylgruppe, einer Azadibenzothiophenylgruppe, einer Azadibenzosilolylgruppe, einer Benzofuranopyrimidinylgruppe, einer Benzothienopyrimidylgruppe, einer Pyrimidinochinoxalinylgruppe und einer Azaindenopyridinylgruppe; und
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Spirobenzofluorenfluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Tetraphenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Carbazolylgruppe, einer Phenanthridinylgruppe, einer Acridinylgruppe, einer Phenanthrolinylgruppe, einer Phenazinylgruppe, einer Triazinylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Azafluorenylgruppe, einer Azaspirobifluorenylgruppe, einer Azacarbazolylgruppe, einer Azadibenzofuranylgruppe, einer Azadibenzothiophenylgruppe, einer Azadibenzosilolylgruppe, einer Benzofuranopyrimidinylgruppe, einer Benzothienopyrimidylgruppe, einer Pyrimidinochinoxalinylgruppe und einer Azaindenopyridinylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einem C₃-C₂₀-Cycloalkylrest, einem C₆-C₂₀-Arylrest, einem C₃-C₂₀-Heteroarylrest, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₃₁ bis Q₃₃ jeweils unabhängig voneinander ausgewählt sind aus der Gruppe bestehend aus:
einem C₁-C₁₀-Alkylrest, einem C₁-C₁₀-Alkoxyrest, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einem, ausgewählt aus einem C₁-C₁₀-Alkylrest, einem C₁-C₁₀-Alkoxyrest und einer Phenylgruppe.

7. Organische lichtemittierende Vorrichtung (12) nach einem der vorangehenden Ansprüche, wobei:
R₂₁ bis R₂₄, R₂₇ und R₂₈ jeweils unabhängig voneinander ausgewählt sind aus der Gruppe bestehend aus:
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Spirobenzofluorenfluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspirobifluorenylgruppe, einer Azacarbazolylgruppe, einer Azadibenzofuranylgruppe, einer Azadibenzothiophenylgruppe und einer Azadibenzosilolylgruppe, und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Spirobenzofluorenfluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspirobifluorenylgruppe, einer Azacarbazolylgruppe, einer Azadibenzofuranylgruppe, einer Azadibenzothiophenylgruppe und einer Azadibenzosilolylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einem Cs-Cio-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₁-C₆₀-Heteroarylrest, einem einwertigen, nichtaromatischen, kondensierten polycyclischen C₈-C₆₀-Rest, einem einwertigen, nichtaromatischen, kondensierten heteropolycyclischen 8- bis 60-gliedrigen Rest, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), oder
R₂₂ ausgewählt ist aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, -Si(Q₁)(Q₂)(Q₃), -S(=O)₂(Q₁) und -P(=O)(Q₁)(Q₂),
wobei Q₁ bis Q₃ und Q₃₁ bis Q₃₃ jeweils unabhängig voneinander ausgewählt sind aus der Gruppe bestehend aus:
einem C₁-C₁₀-Alkylrest, einem C₁-C₁₀-Alkoxyrest, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit einem C₁-C₁₀-Alkylrest, einem C₁-C₁₀-Alkoxyrest und einer Phenylgruppe.

8. Organische lichtemittierende Vorrichtung (12) nach einem der vorangehenden Ansprüche, wobei:
die erste Verbindung dargestellt wird durch eine, ausgewählt aus den Formeln 1A(1) bis 1A(3) und 1B(1) bis 1B(5): 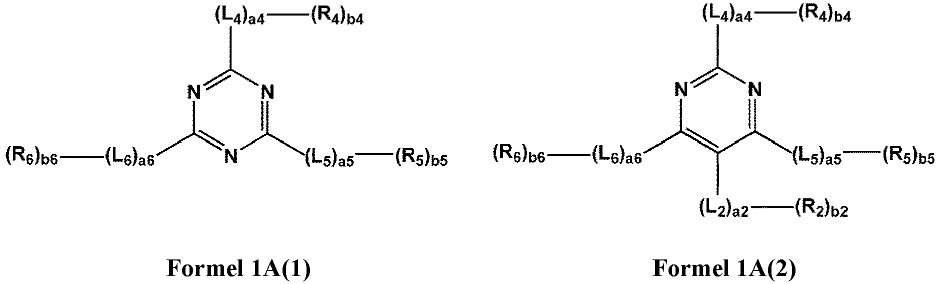 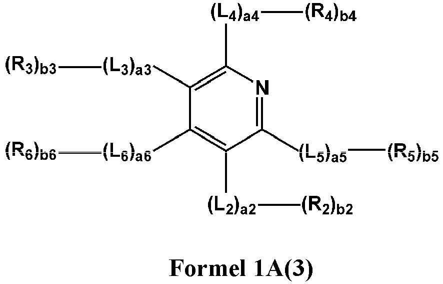 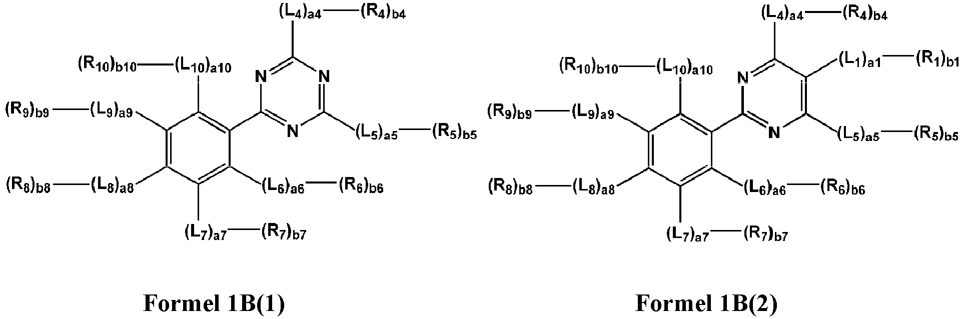 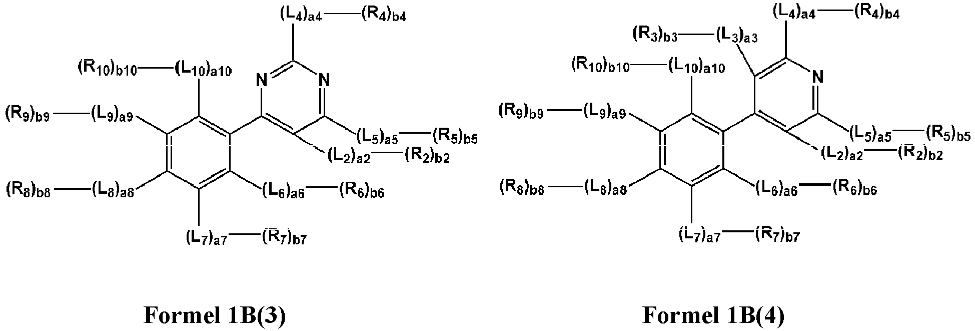 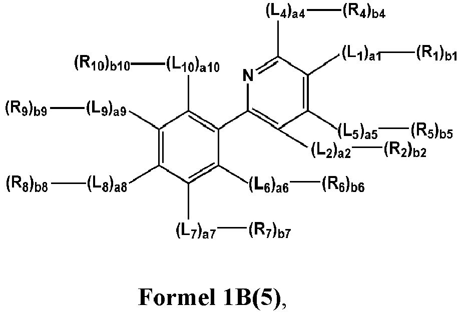
wobei L₁ bis L₁₀, a1 bis a10, R₁ bis R₁₀, b1 bis b10, in den Formeln 1A(1) bis 1A(3) und 1B(1) bis 1B(5), wie in einem der Ansprüche 1, 5 und 6 definiert sind.

9. Organische lichtemittierende Vorrichtung (12) nach einem der vorangehenden Ansprüche, wobei:
(a) der Lochtransportbereich eine Emissionshilfsschicht (154) umfasst, die Emissionshilfsschicht (154) in direktem Kontakt mit der Emissionsschicht (155) ist, und die zweite Verbindung in der Emissionshilfsschicht (154) enthalten ist; und/oder
(b) der Elektronentransportbereich eine Pufferschicht (156) umfasst, die Pufferschicht (156) in direktem Kontakt mit der Emissionsschicht (155) ist, und die zweite Verbindung in der Pufferschicht (156) enthalten ist.

10. Organische lichtemittierende Vorrichtung (12) nach einem der vorangehenden Ansprüche, wobei:
der Elektronentransportbereich eine Pufferschicht (156), eine Elektronentransportschicht (157) und eine Elektroneninjektionsschicht (159) umfasst, und
die erste Verbindung in der Elektronentransportschicht (157) enthalten ist.

11. Organische lichtemittierende Vorrichtung (12) nach Anspruch 10, wobei:
(a) die Elektronentransportschicht (157) ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex, oder eine Kombination davon umfasst; oder
(b) die Elektroneninjektionsschicht (159) ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex, oder eine Kombination davon umfasst; vorzugsweise wobei die Elektroneninjektionsschicht (159) Li, Na, K, Rb, Cs, Mg, Ca, Er, Tm, Yb, oder eine Kombination davon umfasst.

12. Organische lichtemittierende Vorrichtung (12) nach einem der vorangehenden Ansprüche, wobei:
der Lochtransportbereich einen p-Dotanten umfasst, und
der p-Dotant ein Energieniveau des niedrigsten unbesetzten Molekülorbitals (LUMO) von etwa -3,5 eV oder weniger aufweist;
vorzugsweise wobei der p-Dotant eine Cyanogruppen enthaltende Verbindung umfasst.

13. Organische lichtemittierende Vorrichtung (12) nach einem der vorangehenden Ansprüche, wobei:
die Emissionsschicht (155) eine Schicht zur Emission von Licht einer ersten Farbe ist,
die organische lichtemittierende Vorrichtung (12) ferner umfasst: i) mindestens eine Schicht zur Emission von Licht einer zweiten Farbe oder ii) mindestens eine Schicht zur Emission von Licht einer zweiten Farbe und mindestens eine Schicht zur Emission von Licht einer dritten Farbe, jeweils zwischen der ersten Elektrode (110) und der zweiten Elektrode (190),
eine Wellenlänge der maximalen Emission der Schicht zur Emission von Licht einer ersten Farbe, eine Wellenlänge der maximalen Emission der Schicht zur Emission von Licht einer zweiten Farbe und eine Wellenlänge der maximalen Emission der Schicht zur Emission von Licht einer dritten Farbe miteinander identisch sind oder sich voneinander unterscheiden, und
die organische lichtemittierende Vorrichtung (12) ein Mischlicht, umfassend ein Licht einer ersten Farbe und ein Licht einer zweiten Farbe, oder ein Mischlicht, umfassend das Licht einer ersten Farbe, das Licht einer zweiten Farbe und ein Licht einer dritten Farbe, emittiert.

## Revendications

1. Dispositif électroluminescent organique (12) comprenant :
une première électrode (110) ;
une seconde électrode (190) faisant face à la première électrode (110) ;
une couche d'émission (155) entre la première électrode (110) et la seconde électrode (190) ;
une région de transport de trous entre la première électrode (110) et la couche d'émission (155) ; et
une région de transport d'électrons entre la couche d'émission (155) et la seconde électrode (190),
dans lequel la région de transport d'électrons comprend un premier composé,
au moins une sélectionnée parmi la région de transport de trous et la région de transport d'électrons comprend un second composé,
le premier composé est représenté par la formule 1A ou 1B, et
le second composé est représenté par la formule 2A ou 2B : 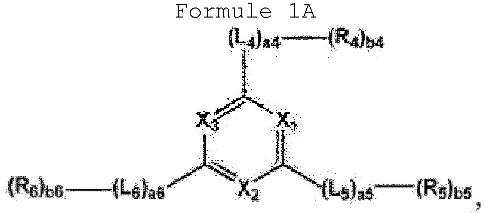 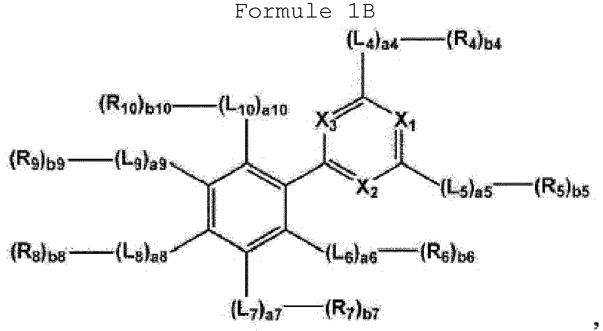 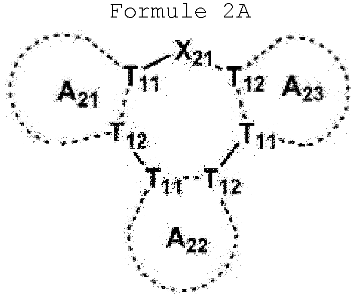 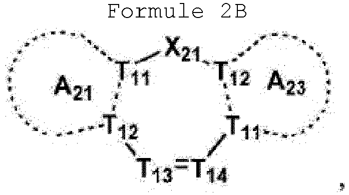
dans lequel, dans les formules 1A, 1B, 2A, et 2B,
les cycles A₂₁, A₂₂, et A₂₃ sont chacun indépendamment un groupe carbocyclique en C₅ à C₆₀ ou un groupe hétérocyclique en C₁ à C₃₀, chacun substitué avec au moins un *-[(L₂₂)ₐ₂₂-(R₂₂)_{b22}], dans lequel * est un site de liaison au cycle A₂₁, A₂₂, ou A₂₃,
chaque T₁₁ est indépendamment un carbone ou un azote,
chaque T₁₂ est indépendamment un carbone ou un azote,
T₁₃ est N ou C(R₂₇) ,
T₁₄ est N ou C(R₂₈) ,
chaque liaison entre T₁₁ et T₁₂ représentée en pointillé dans les formules 2A et 2B est une liaison simple ou une liaison double ;
les six atomes représentés par les trois T₁₁ et les trois T₁₂ dans la formule 2A ne sont pas tous des azotes, et les six atomes représentés par les deux T₁₁, les deux T₁₂, T₁₃, et T₁₄ dans la formule 2B ne sont pas tous des azotes,
les cycles A₂₁, A₂₂ et A₂₃ sont chacun condensés avec le cycle central à 7 chaînons dans les formules 2A et 2B, de sorte qu'ils partagent chacun un T₁₁ et un T₁₂ avec le cycle central à 7 chaînons,
X₁ est N ou C-(L₁)ₐ₁-(R₁)_{b1}, X₂ est N ou C-(L₂)ₐ₂-(R₂)_{b2}, X₃ est N ou C-(L₃)ₐ₃-(R₃)_{b3}, et au moins un sélectionné parmi X₁ à X₃ est N,
X₂₁ est N-[(L₂₁)ₐ₂₁-(R₂₁)_{b21}] ,
ou X₂₁ est O, S, Se, C(R₂₃)(R₂₄), ou Si(R₂₃)(R₂₄) et au moins un sélectionné parmi les cycles A₂₁, A₂₂, et A₂₃ dans la formule 2A et au moins un sélectionné parmi les cycles A₂₁ et A₂₃ dans la formule 2B sont sélectionnés chacun indépendamment parmi les groupes représentés par les formules 2-1 à 2-3, 2-10 à 2-27, et 2-33 à 2-36, dans lequel dans les formules 2-1 à 2-3, 2-10 à 2-27, et 2-33 à 2-36, au moins un parmi X₂₂ et X₂₃ est N-[(L₂₂)ₐ₂₂-(R₂₂)_{b22}] , 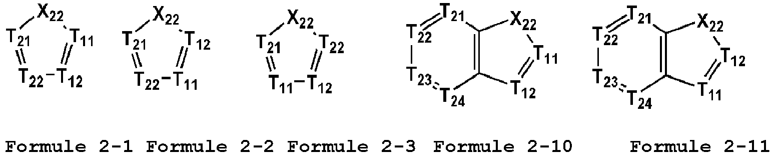 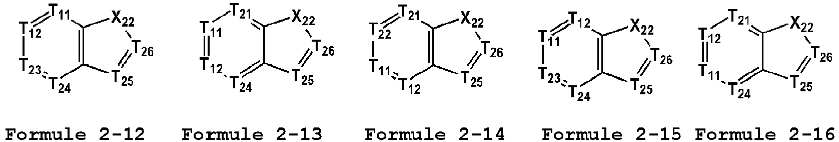 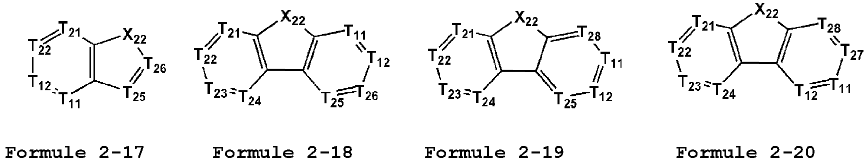 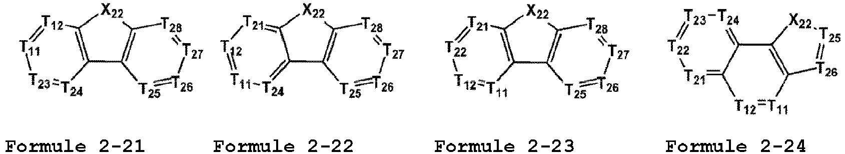 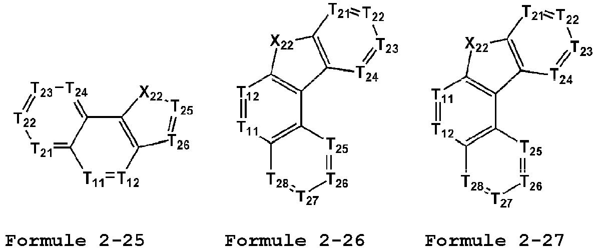 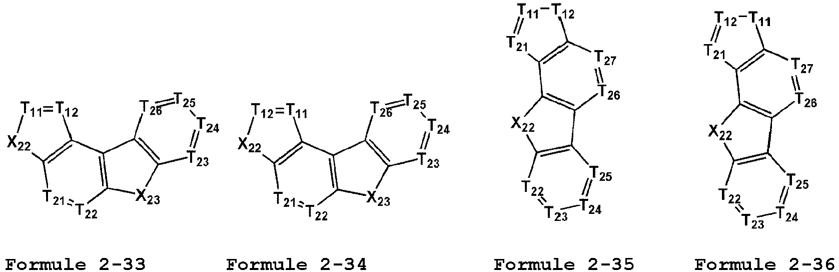
X₂₂ et X₂₃ sont chacun indépendamment O, S, Se, ou un fragment comprenant C, N, et/ou Si, et
T₂₁ à T₂₈ sont chacun indépendamment N ou un fragment comprenant C,
L₁ à L₁₀, L₂₁, et L₂₂ sont sélectionnés chacun indépendamment parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique en C₈ à C₆₀ condensé divalent non aromatique substitué ou non substitué, et un groupe hétéropolycyclique de 8 à 60 chaînons condensé divalent non aromatique substitué ou non substitué,
a1 à a10, a21, et a22 sont chacun indépendamment un nombre entier sélectionné parmi 0 à 5,
R₂, R₃ et R₆ à R₁₀, R₂₁ à R₂₄, R₂₇, et R₂₈ sont sélectionnés chacun indépendamment parmi un hydrogène, un deutérium,-F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé monovalent non aromatique substitué ou non substitué, un groupe hétéropolycyclique de 8 à 60 chaînons condensé monovalent non aromatique substitué ou non substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
b1 à b10, b21, et b22 sont chacun indépendamment un nombre entier sélectionné parmi 1 à 4, à condition que chacun parmi b1 à b10, b21, et b22 soit 1 quand chaque a1 à a10, a21, ou a22 respectif est zéro,
R₁ et R₄ sont chacun indépendamment tels que définis pour R₂, ou quand a1 et a4 sont tous les deux 0, peuvent facultativement être reliés pour former un groupe carbocyclique en C₅ à C₆₀ ou un groupe hétérocyclique en C₁ à C₃₀,
R₅ est tel que défini pour R₂, ou quand a1 et a5 sont tous deux 0 et quand R₁ et R₄ ne sont pas liés pour former un groupe cyclique, R₅ peut facultativement être relié à R₁ pour former un groupe carbocyclique en C₅ à C₆₀ ou un groupe hétérocyclique en C₁ à C₃₀, et
le groupe cycloalkylène en C₃ à C₁₀ substitué, le groupe hétérocycloalkylène en C₁ à C₁₀ substitué, le groupe cycloalcénylène en C₃ à C₁₀ substitué, le groupe hétérocycloalcénylène en C₁ à C₁₀ substitué, le groupe arylène en C₆ à C₆₀ substitué, le groupe hétéroarylène en C₁ à C₆₀ substitué, le groupe polycyclique en C₈ à C₆₀ condensé divalent non aromatique substitué, le groupe hétéropolycyclique de 8 à 60 chaînons condensé divalent non aromatique substitué, le groupe alkyle en C₁ à C₆₀ substitué, le groupe alcényle en C₂ à C₆₀ substitué, le groupe alcynyle en C₂ à C₆₀ substitué, le groupe alcoxy en C₁ à C₆₀ substitué, le groupe cycloalkyle en C₃ à C₁₀ substitué, le groupe hétérocycloalkyle en C₁ à C₁₀ substitué, le groupe cycloalcényle en C₃ à C₁₀ substitué, le groupe hétérocycloalcényle en C₁ à C₁₀ substitué, le groupe aryle en C₆ à C₆₀ substitué, le groupe aryloxy en C₆ à C₆₀ substitué, le groupe arylthio en C₆ à C₆₀ substitué, le groupe hétéroaryle en C₁ à C₆₀ substitué, le groupe polycyclique en C₈ à C₆₀ condensé monovalent non aromatique substitué, et le groupe hétéropolycyclique de 8 à 60 chaînons condensé monovalent non aromatique substitué sont chacun indépendamment substitués avec un ou plusieurs substituants sélectionnés dans le groupe consistant en :
un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, et un groupe alcoxy en C₁ à C₆₀ ;
un groupe alkyle en C₁ à C₆₀, un groupe alcényle en C₂ à C₆₀, un groupe alcynyle en C₂ à C₆₀, et un groupe alcoxy en C₁ à C₆₀, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique,-Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), et -P(=O)(Q₁₁)(Q₁₂),
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique, un groupe biphényle, et un groupe terphényle ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé monovalent non aromatique, et un groupe hétéropolycyclique de 8 à 60 chaînons condensé monovalent non aromatique, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique,-Si(Q₂₁)(Q₂₂)(Q₂₃), -N(Q₂₁)(Q₂₂), -B(Q₂₁)(Q₂₂), -C(=O)(Q₂₁)-S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂),
dans lequel Q₁ à Q₃, Q₁₁ à Q₁₃, Q₂₁ à Q₂₃, et Q₃₁ à Q₃₃ sont sélectionnés chacun indépendamment parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₃ à C₁₀, un groupe cycloalcényle en C₃ à C₁₀, un groupe hétérocycloalcényle en C₁ à C₁₀, un groupe aryle en C₆ à C₆₀, un groupe aryle en C₆ à C₆₀ substitué avec un groupe alkyle en C₁ à C₆₀, un groupe aryle en C₆ à C₆₀ substitué avec un groupe aryle en C₆ à C₆₀, un groupe terphényle, un groupe hétéroaryle en C₁ à C₆₀, un groupe hétéroaryle en C₁ à C₆₀ substitué avec un groupe alkyle en C₁ à C₆₀, un groupe hétéroaryle en C₁ à C₆₀ substitué avec un groupe aryle en C₆ à C₆₀, un groupe polycyclique en C₈ à C₆₀ condensé monovalent non aromatique, et un groupe hétéropolycyclique de 8 à 60 chaînons condensé monovalent non aromatique.

2. Dispositif électroluminescent organique (12) selon la revendication 1, dans lequel :
les cycles A₂₁, A₂₂, et A₂₃ dans les formules 2A et 2B sont sélectionnés chacun indépendamment parmi un groupe benzène, un groupe naphtalène, un groupe anthracène, un groupe indène, un groupe fluorène, un groupe pyridine, un groupe pyrimidine, un groupe pyrazine, un groupe pyridazine, un groupe quinoléine, un groupe isoquinoléine, un groupe pyrrole, un groupe pyrazole, un groupe imidazole, un groupe oxazole, un groupe thiazole, un groupe cyclopentadiène, un groupe silole, un groupe sélénophène, un groupe furane, un groupe thiophène, un groupe indole, un groupe benzimidazole, un groupe benzoxazole, un groupe benzothiazole, un groupe indène, un groupe benzosilole, un groupe benzosélénophène, un groupe benzofurane, un groupe benzothiophène, un groupe carbazole, un groupe fluorène, un groupe dibenzosilole, un groupe dibenzosélénophène, un groupe dibenzofurane, un groupe dibenzothiophène, un groupe pyrrolopyridine, un groupe cyclopentapyridine, un groupe silolopyridine, un groupe sélénophénopyridine, un groupe furopyridine, un groupe thiénopyridine, un groupe pyrrolopyrimidine, un groupe cyclopentapyrimidine, un groupe silolopyrimidine, un groupe sélénophénopyrimidine, un groupe furopyrimidine, un groupe thiénopyrimidine, un groupe pyrrolopyrazine, un groupe cyclopentapyrazine, un groupe silolopyrazine, un groupe sélénophénopyrazine, un groupe furopyrazine, un groupe thiénopyrazine, un groupe naphtopyrrolène, un groupe cyclopentanaphtalène, un groupe naphtosilole, un groupe naphtosélénophène, un groupe naphtofurane, un groupe naphtothiénophène, un groupe pyrroloquinoléine, un groupe cyclopentaquinoléine, un groupe siloloquinoléine, un groupe sélénophénoquinoléine, un groupe furoquinoléine, un groupe thiénoquinoléine, un groupe pyrroloisoquinoléine, un groupe cyclopentaisoquinoléine, un groupe siloloisoquinoléine, un groupe sélénophénoisoquinoléine, un groupe furoisoquinoléine, un groupe thiénoisoquinoléine, un groupe azacarbazole, un groupe azafluorène, un groupe azadibenzosilole, un groupe azadibenzosélénophène, un groupe azadibenzofurane, un groupe azadibenzothiophène, un groupe indénoquinoléine, un groupe indénoisoquinoléine, un groupe indénoquinoxaline, un groupe phénanthroline, et un groupe naphtoindole, chacun substitué avec au moins un *-[(L₂₂)ₐ₂₂-(R₂₂)_{b22}].

3. Dispositif électroluminescent organique (12) selon la revendication 1 ou la revendication 2, dans lequel :
les cycles A₂₁, A₂₂, et A₂₃ dans les formules 2A et 2B sont sélectionnés chacun indépendamment parmi les groupes représentés par les formules 2-1 à 2-36, chacun substitué avec au moins un *-[(L₂₂)ₐ₂₂-(R₂₂)_{b22}]: 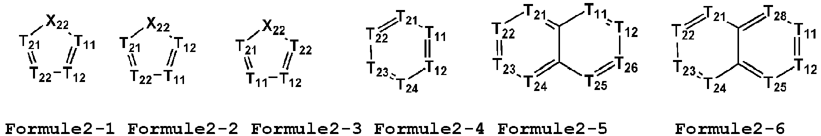 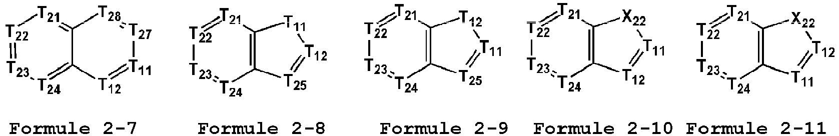 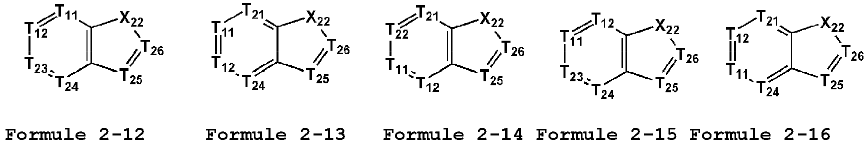 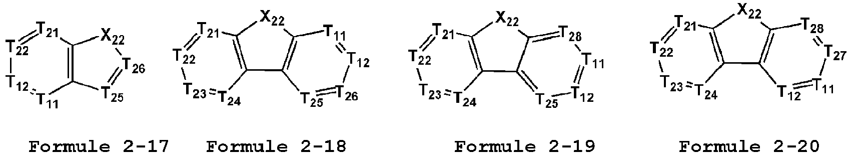 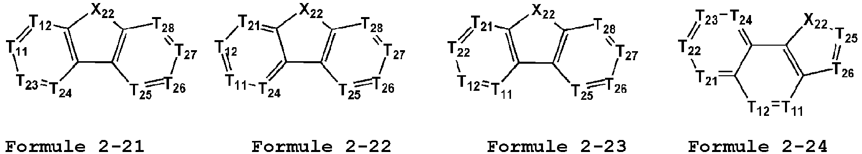 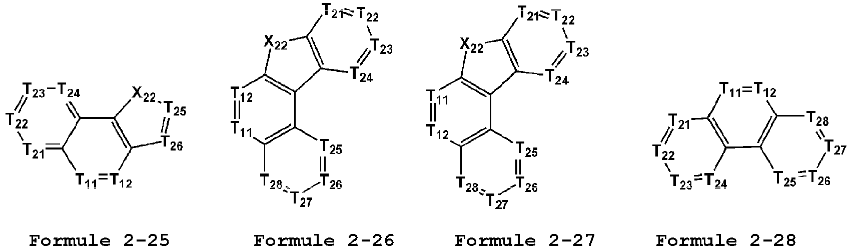 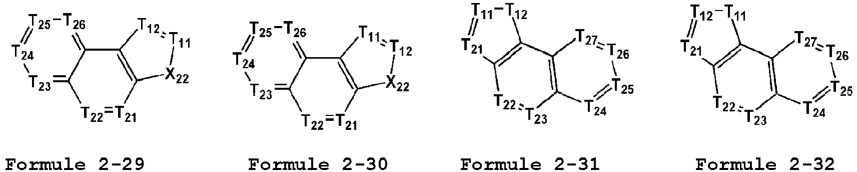 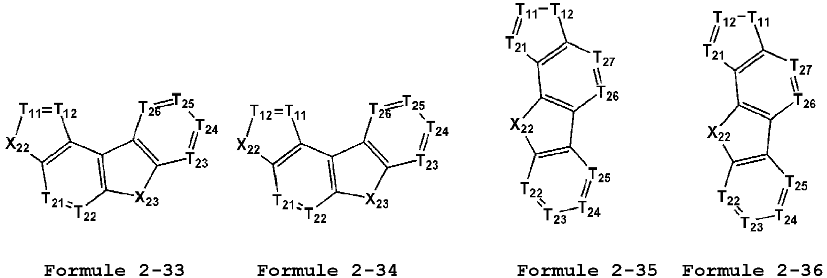
dans lequel, dans les formules 2-1 à 2-36,
T₁₁, T₁₂ et T₂₁ à T₂₈ sont tels que définis dans la revendication 1, et
X₂₂ et X₂₃ sont chacun indépendamment O, S, Se, ou un fragment comprenant C, N, et/ou Si.

4. Dispositif électroluminescent organique (12) selon l'une quelconque des revendications précédentes, dans lequel :
i) dans les formules 1A et 1B,
X₁ est N, X₂ est C-(L₂)ₐ₂- (R₂)_{b2}, et X₃ est C-(L₃)ₐ₃-(R₃)_{b3},
X₁ est N, X₂ est N, et X₃ est C-(L₃)ₐ₃-(R₃)_{b3}, ou
X₁, X₂ et X₃ sont N.

5. Dispositif électroluminescent organique (12) selon l'une quelconque des revendications précédentes, dans lequel :
L₁ à L₁₀ sont sélectionnés chacun indépendamment dans le groupe consistant en :
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spirobifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène un groupe hexacénylène, un groupe pentacénylène, un groupe rubicénylène, un groupe coronénylène, un groupe ovalénylène, un groupe pyridinylène, un groupe pyrazinylène, un groupe pyrimidinylène, un groupe pyridazinylène, un groupe quinoléinylène, un groupe isoquinoléinylène, un groupe benzoquinoléinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène ; et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spirobifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène un groupe hexacénylène, un groupe pentacénylène, un groupe rubicénylène, un groupe coronénylène, un groupe ovalénylène, un groupe pyridinylène, un groupe pyrazinylène, un groupe pyrimidinylène, un groupe pyridazinylène, un groupe quinoléinylène, un groupe isoquinoléinylène, un groupe benzoquinoléinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique, un groupe biphényle, un groupe terphényle, -Si(Q₃₁)(Q₃₂)(Q₃₃), -N(Q₃₁)(Q₃₂), -B(Q₃₁)(Q₃₂), -C(=O)(Q₃₁),-S(=O)₂(Q₃₁), et -P(=O)(Q₃₁)(Q₃₂), et
L₂₁ et L₂₂ sont sélectionnés chacun indépendamment dans le groupe consistant en :
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spirobifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinoléinylène, un groupe isoquinoléinylène, un groupe benzoquinoléinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène ; et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spirobifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinoléinylène, un isoquinoléinylène un groupe benzoquinoléinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique, un groupe biphényle, un groupe terphényle, -Si(Q₃₁)(Q₃₂)(Q₃₃),-N(Q₃₁)(Q₃₂), -B(Q₃₁)(Q₃₂), -C(=O)(Q₃₁), -S(=O)₂(Q₃₁), et-P(=O)(Q₃₁)(Q₃₂),
dans lequel Q₃₁ à Q₃₃ sont sélectionnés chacun indépendamment dans le groupe consistant en :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle, chacun substitué avec au moins un sélectionné parmi un groupe alkyle en C₁ à C₁₀, un groupe alcoxy en C₁ à C₁₀, et un groupe phényle.

6. Dispositif électroluminescent organique (12) selon l'une quelconque des revendications précédentes, dans lequel :
R₁ à R₁₀ sont sélectionnés chacun indépendamment dans le groupe consistant en :
un hydrogène, un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, et un groupe alcoxy en C₁ à C₂₀ ;
un groupe alkyle en C₁ à C₂₀ et un groupe alcoxy en C₁ à C₂₀, chacun substitué avec au moins un sélectionné parmi un deutérium, -F, -Cl, -Br, -I, un groupe hydroxyle, un groupe cyano, un groupe nitro, un amidino, un groupe hydrazino, et un groupe hydrazono ;
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spirobifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe tétraphényle, un groupe pyridinyle, un groupe pyrazinyle, un groupe pyrimidinyle, un groupe pyridazinyle, un groupe quinoléinyle, un groupe isoquinoléinyle, un groupe benzoquinoléinyle, un groupe phtalazinyle, un groupe naphtyridinyle, un groupe quinoxalinyle, un groupe quinazolinyle, un groupe carbazolyle, un groupe phénanthridinyle, un groupe acridinyle, un groupe phénanthrolinyle, un groupe phénazinyle, un groupe triazinyle, un groupe dibenzofuranyle, un groupe dibenzothiophényle, un groupe benzocarbazolyle, un groupe dibenzocarbazolyle, un groupe dibenzosilolyle, un groupe azafluorényle, un groupe azaspiro-bifluorényle, un groupe azacarbazolyle, un groupe azadibenzofuranyle, un groupe azadibenzothiophényle, un groupe azadibenzosilolyle, un groupe benzofuranopyrimidinyle, un groupe benzothiénopyrimidyle, un groupe pyrimidinoquinoxalinyle, et un groupe azaindénopyridinyle ; et
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spirobifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe tétraphényle, un groupe pyridinyle, un groupe pyrazinyle, un groupe pyrimidinyle, un groupe pyridazinyle, un groupe quinoléinyle, un groupe isoquinoléinyle, un groupe benzoquinoléinyle, un groupe phtalazinyle, un groupe naphtyridinyle, un groupe quinoxalinyle, un groupe quinazolinyle, un groupe carbazolyle, un groupe phénanthridinyle, un groupe acridinyle, un groupe phénanthrolinyle, un groupe phénazinyle, un groupe triazinyle, un groupe dibenzofuranyle, un groupe dibenzothiophényle, un groupe benzocarbazolyle, un groupe dibenzocarbazolyle, un groupe dibenzosilolyle, un groupe azafluorényle, un groupe azaspiro-bifluorényle, un groupe azacarbazolyle, un groupe azadibenzofuranyle, un groupe azadibenzothiophényle, un groupe azadibenzosilolyle, un groupe benzofuranopyrimidinyle, un groupe benzothiénopyrimidyle, un groupe pyrimidinoquinoxalinyle, et un groupe azaindénopyridinyle, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₂₀, un groupe aryle en C₆ à C₂₀, un groupe hétéroaryle en C₃ à C₂₀, -Si(Q₃₁)(Q₃₂)(Q₃₃),-N(Q₃₁)(Q₃₂), -B(Q₃₁)(Q₃₂), -C(=O)(Q₃₁), -S(=O)₂(Q₃₁), et-P(=O)(Q₃₁)(Q₃₂),
dans lequel Q₃₁ à Q₃₃ sont sélectionnés chacun indépendamment dans le groupe consistant en :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle, chacun substitué avec au moins un sélectionné parmi un groupe alkyle en C₁ à C₁₀, un groupe alcoxy en C₁ à C₁₀, et un groupe phényle.

7. Dispositif électroluminescent organique (12) selon l'une quelconque des revendications précédentes, dans lequel :
R₂₁ à R₂₄, R₂₇, et R₂₈ sont sélectionnés chacun indépendamment dans le groupe consistant en :
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spirobifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, et un groupe azadibenzosilolyle ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spirobifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, et un groupe azadibenzosilolyle, chacun substitué avec au moins un sélectionné parmi un deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique en C₈ à C₆₀ condensé monovalent non aromatique, un groupe hétéropolycyclique de 8 à 60 chaînons condensé monovalent non aromatique, un groupe biphényle, un groupe terphényle, -Si(Q₃₁)(Q₃₂)(Q₃₃),-N(Q₃₁)(Q₃₂), -B(Q₃₁)(Q₃₂), -C(=O)(Q₃₁), -S(=O)₂(Q₃₁), et-P(=O)(Q₃₁)(Q₃₂), ou
R₂₂ est sélectionné parmi un hydrogène, un deutérium, - F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, -Si(Q₁)(Q₂)(Q₃), -S(=O)₂(Q₁) et - P(=O)(Q₁)(Q₂),
dans lequel Q₁ à Q₃ et Q₃₁ à Q₃₃ sont sélectionnés chacun indépendamment dans le groupe consistant en :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, et un groupe quinazolinyle, chacun substitué avec un groupe alkyle en C₁ à C₁₀, un groupe alcoxy en C₁ à C₁₀, et un groupe phényle.

8. Dispositif électroluminescent organique (12) selon l'une quelconque des revendications précédentes, dans lequel :
le premier composé est représenté par l'une sélectionnée parmi les formules 1A(1) à 1A(3), et 1B(1) à 1B(5) : 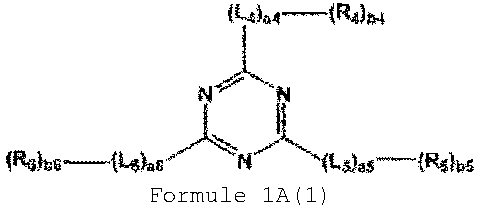 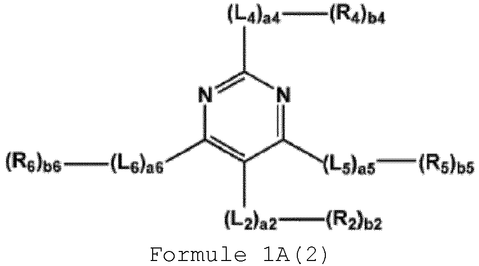 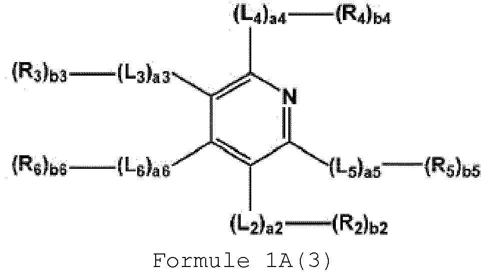 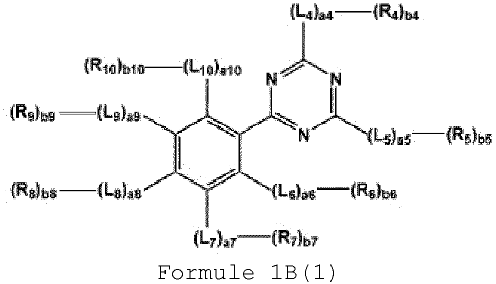 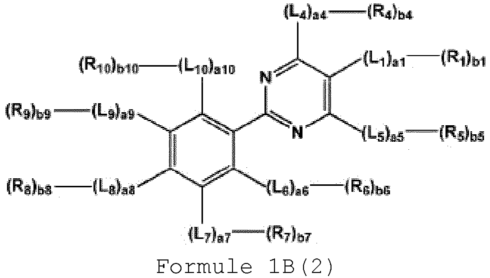 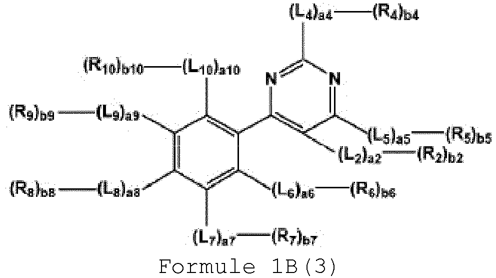 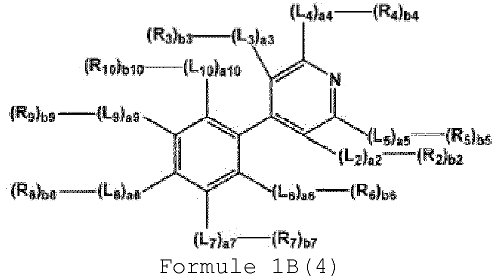 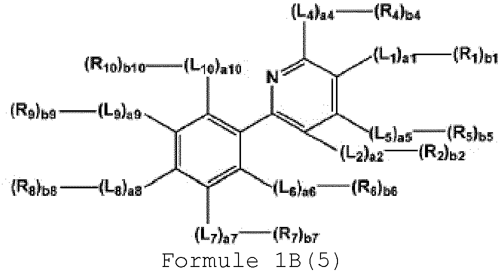
dans lequel L₁ à L₁₀, a1 à a10, R₁ à R₁₀, b1 à b10, dans les formules 1A(1) à 1A(3), et 1B(1) à 1B(5), sont tels que définis dans l'une quelconque des revendications 1, 5 et 6.

9. Dispositif électroluminescent organique (12) selon l'une quelconque des revendications précédentes, dans lequel :
(a) la région de transport de trous comprend une couche auxiliaire d'émission (154), la couche auxiliaire d'émission (154) est directement en contact avec la couche d'émission (155), et le second composé est compris dans la couche auxiliaire d'émission (154) ; et/ou
(b) la région de transport d'électrons comprend une couche tampon (156), la couche tampon (156) est directement en contact avec la couche d'émission (155), et le second composé est compris dans la couche tampon (156).

10. Dispositif électroluminescent organique (12) selon l'une quelconque des revendications précédentes, dans lequel :
la région de transport d'électrons comprend une couche tampon (156), une couche de transport d'électrons (157), et une couche d'injection d'électrons (159), et
le premier composé est compris dans la couche de transport d'électrons (157).

11. Dispositif électroluminescent organique (12) selon la revendication 10, dans lequel :
(a) la couche de transport d'électrons (157) comprend un métal alcalin, un métal alcalino-terreux, un métal de terre rare, un composé de métal alcalin, un composé de métal alcalino-terreux, un composé de métal de terre rare, un complexe de métal alcalin, un complexe de métal alcalino-terreux, un complexe de métal de terre rare, ou une combinaison de ceux-ci ; ou
(b) la couche d'injection d'électrons (159) comprend un métal alcalin, un métal alcalino-terreux, un métal de terre rare, un composé de métal alcalin, un composé de métal alcalino-terreux, un composé de métal de terre rare, un complexe de métal alcalin, un complexe de métal alcalino-terreux, un complexe de métal de terre rare, ou une combinaison de ceux-ci ; de préférence dans lequel la couche d'injection d'électrons (159) comprend Li, Na, K, Rb, Cs, Mg, Ca, Er, Tm, Yb, ou une combinaison de ceux-ci.

12. Dispositif électroluminescent organique (12) selon l'une quelconque des revendications précédentes, dans lequel :
la région de transport de trous comprend un dopant p, et
le dopant p présente un niveau d'énergie d'orbite moléculaire inoccupée la plus basse (LUMO) d'environ -3,5 eV ou moins ;
de préférence dans lequel le dopant p comprend un composé contenant un groupe cyano.

13. Dispositif électroluminescent organique (12) selon l'une quelconque des revendications précédentes, dans lequel :
la couche d'émission (155) est une couche d'émission de lumière d'une première couleur,
le dispositif électroluminescent organique (12) comprend en outre i) au moins une couche d'émission de lumière d'une deuxième couleur ou ii) au moins une couche d'émission de lumière d'une deuxième couleur et au moins une couche d'émission de lumière d'une troisième couleur, chacune entre la première électrode (110) et la seconde électrode (190),
une longueur d'onde d'émission maximale de la couche d'émission de lumière d'une première couleur, une longueur d'onde d'émission maximale de la couche d'émission de lumière d'une deuxième couleur, et une longueur d'onde d'émission maximale de la couche d'émission de lumière d'une troisième couleur sont identiques ou différentes les unes des autres, et
le dispositif électroluminescent organique (12) émet une lumière mélangée comprenant une lumière d'une première couleur et une lumière d'une deuxième couleur, ou une lumière mélangée comprenant la lumière d'une première couleur, la lumière d'une deuxième couleur, et une lumière d'une troisième couleur.
